# EUROPEAN PATENT APPLICATION

(11) **EP 4 322 730 A2**
(43) Date of publication of application: **14.02.2024**
(21) Application number: 23219484.5
(22) Date of filing: 09.09.2022
(51) Int. Cl.: H10K 85/30

(54) **ORGANIC ELECTROLUMINESCENCE DEVICE AND FUSED POLYCYCLIC COMPOUND FOR ORGANIC ELECTROLUMINESCENCE DEVICE**

(30) Priority: 16.09.2021 KR 20210123929
(62) Divisional of application: 22194890.4
(71) Applicant: Samsung Display Co., Ltd., Yongin-si, Gyeonggi-do 17113 (KR)
(72) Inventor: KIM, Taeil, 17113 Yongin-si (KR); BAEK, Jang Yeol, 17113 Yongin-si (KR); PAK, Sun Young, 17113 Yongin-si (KR); PARK, Junha, 17113 Yongin-si (KR); SUNWOO, Kyoung, 17113 Yongin-si (KR); SIM, Mun-Ki, 17113 Yongin-si (KR); OH, Chanseok, 17113 Yongin-si (KR); JUNG, Minjung, 17113 Yongin-si (KR)
(74) Representative: Newcombe, Christopher David

(57) **Abstract**

A fused polycyclic compound represented by Formula 1.

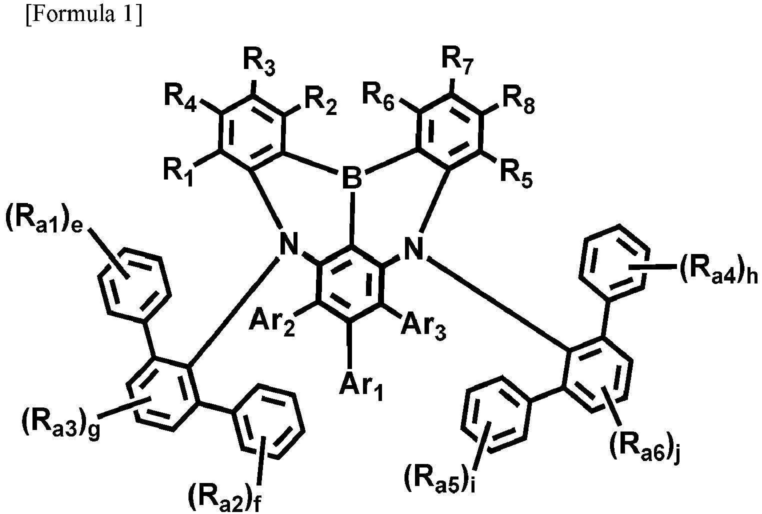

## Description

### CROSS-REFERENCE TO RELATED APPLICATION(S)

This application claims priority to and benefits of Korean Patent Application No. 10-2021-0123929 under 35 U.S.C. §119, filed on September 16, 2021 in the Korean Intellectual Property Office.

### BACKGROUND

### 1. Technical Field

The disclosure relates to a fused polycyclic compound used as an emission layer material, and an organic electroluminescence device including the same.

### 2. Description of the Related Art

Active development continues for organic electroluminescence displays as image display apparatuses. In contrast to liquid crystal displays and the like, the organic electroluminescence displays are so-called self-luminescent display apparatuses in which holes and electrons respectively injected from a first electrode and a second electrode recombine in an emission layer, so that a luminescent material including an organic compound in the emission layer emits light to achieve display.

In the application of an organic electroluminescence device to a display apparatus, there is a demand for an organic electroluminescence device having a low driving voltage, high luminous efficiency, and a long life, and continuous development is required on materials for an organic electroluminescence device which are capable of stably achieving such characteristics.

In order to implement a highly efficient organic electroluminescence device, technologies pertaining to phosphorescence emission using triplet state energy or delayed fluorescence using triplet-triplet annihilation (TTA) in which singlet excitons are generated by collision of triplet excitons are being developed, as well as thermally activated delayed fluorescence (TADF) materials using a delayed fluorescence phenomenon.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides an organic electroluminescence device having increased luminous efficiency.

The disclosure provides a fused polycyclic compound capable of increasing the luminous efficiency of an organic electroluminescence device.

An embodiment provides a fused polycyclic compound represented by Formula 1.

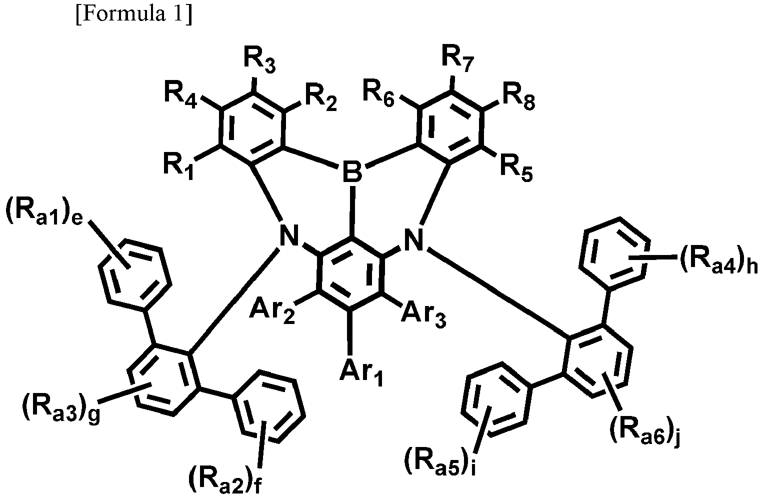

In Formula 1, Ar₁ to Ar₃ may each independently be a hydrogen atom, a deuterium atom, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms; R₁ to R₈ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms; Rₐ₁ to Rₐ₆ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring; e, f, h, and i may each independently be an integer from 0 to 5; and g and j may each independently be an integer from 0 to 3, and at least one of R₁ to R₈ may be a group represented by Formula 2.

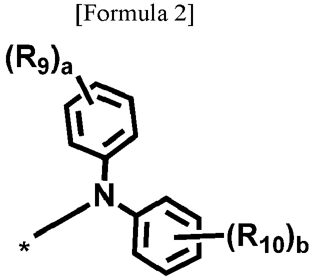

In Formula 2, R₉ and R₁₀ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring; and a and b may each independently be an integer from 0 to 5.

In an embodiment, the fused polycyclic compound may have a photoluminescence quantum yield (PLQY) equal to or greater than about 80%.

In an embodiment, the fused polycyclic compound represented by Formula 1 may be represented by any one of Formulas 3-1 to 3-3.

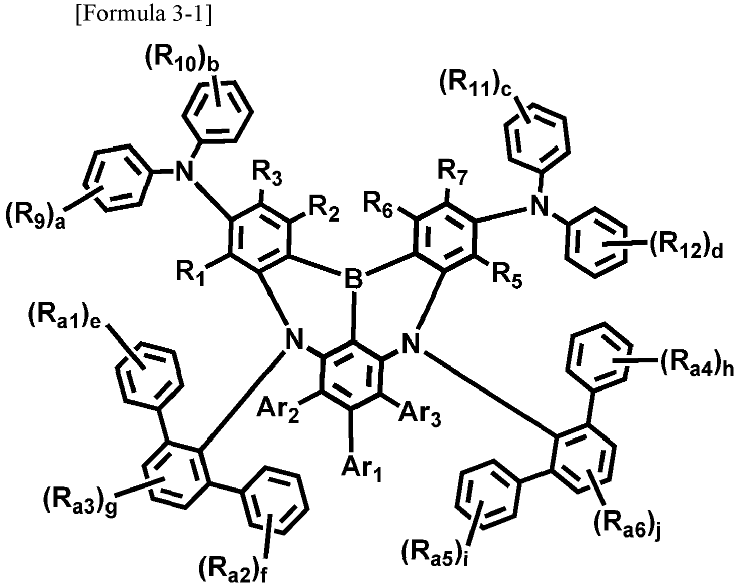

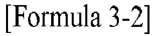

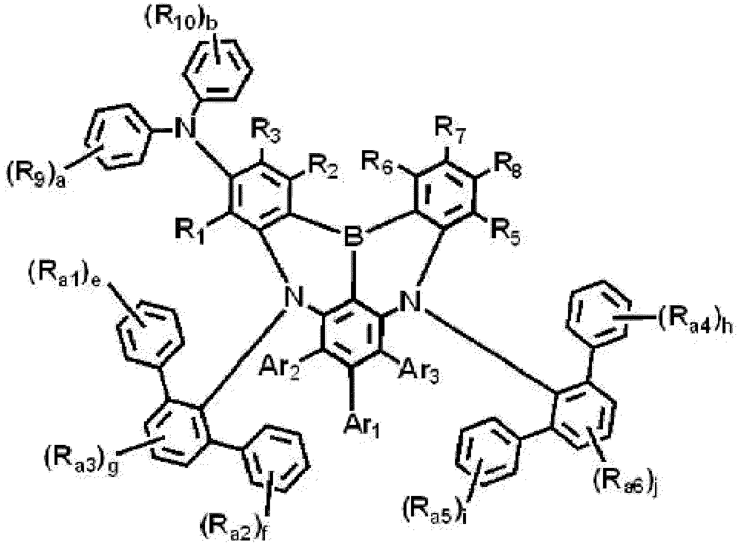

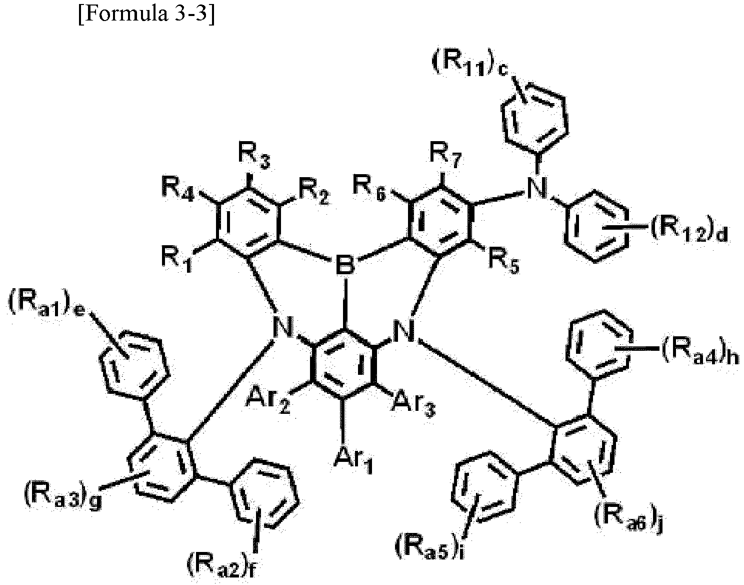

In Formulas 3-1 to 3-3, R₁₁ and R₁₂ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring; c and d may each independently be an integer from 0 to 5; and Ar₁ to Ar₃, R₁ to R₁₀, Rₐ₁ to Rₐ₆ a, b, and e to j are the same as defined in Formulas 1 and 2.

In an embodiment, Ar₁ to Ar₃ may each independently be a hydrogen atom or a deuterium atom.

In an embodiment, Ar₁ may be a substituted or unsubstituted aryl group having 6 to 60 ring-forming carbon atoms, or a substituted or unsubstituted heteroaryl group having 2 to 60 ring-forming carbon atoms, and Ar₂ and Ar₃ may each independently be a hydrogen atom or a deuterium atom.

In an embodiment, Ar₁ may be a substituted or unsubstituted alkyl group having 1 to 20 carbon atoms, and Ar₂ and Ar₃ may each independently be a hydrogen atom or a deuterium atom.

In an embodiment, Ar₁ may be a substituted or unsubstituted silyl group having 1 to 20 carbon atoms, and Ar₂ and Ar₃ may each independently be a hydrogen atom or a deuterium atom.

In an embodiment, the fused polycyclic compound represented by Formula 3-1 may be represented by Formula 5.

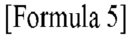

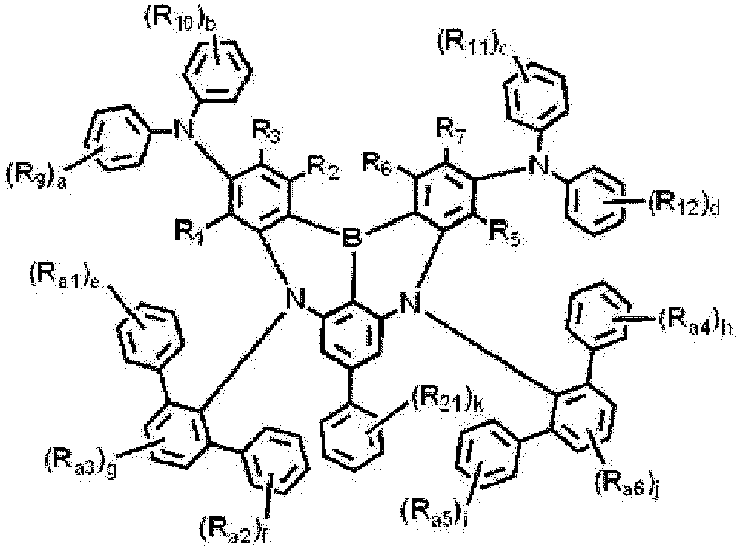

In Formula 5, R₂₁ may be a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring; k may be an integer from 0 to 5; and R₁ to R₃, R₅ to R₇, R₉ to R₁₂, Rₐ₁ to Rₐ₆, and a to j are the same as defined in Formula 3-1.

In an embodiment, the fused polycyclic compound represented by Formula 3-2 may be represented by Formula 6-1 or Formula 6-2.

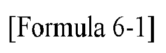

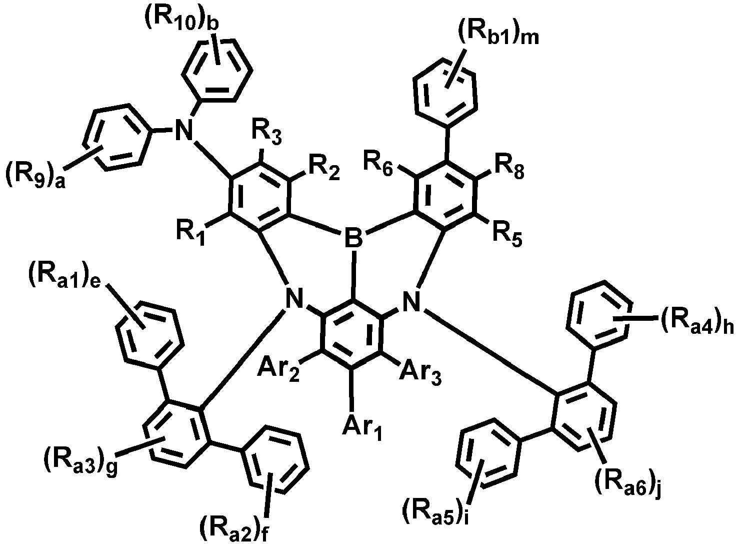

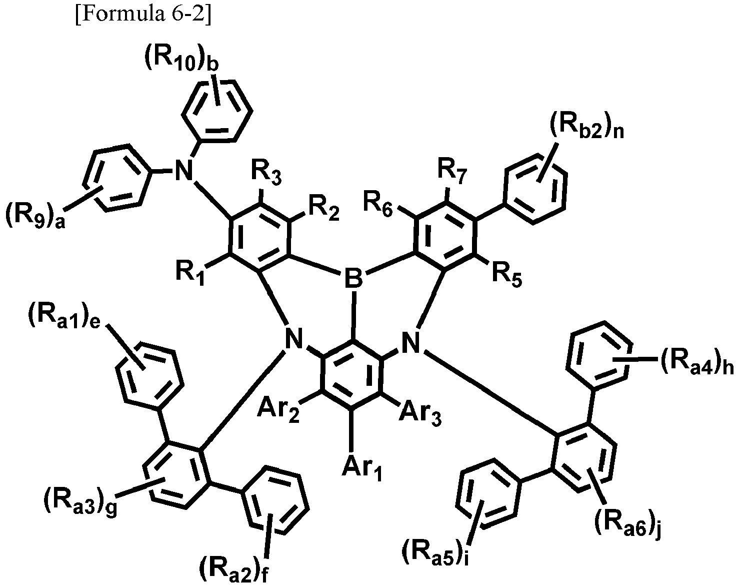

In Formulas 6-1 and 6-2, R_{b1} and R_{b2} may each independently be a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring; m and n may each independently be an integer from 0 to 5, and Ar₁ to Ar₃, R₁ to R₃, R₅ to R₁₀, Rₐ₁ to Rₐ₆, a, b, and e to j are the same as defined in Formula 3-2.

In an embodiment, the fused polycyclic compound may include at least one selected from Compound Group 1, which is explained below.

In an embodiment, a hole transporting first host and the electron transporting second host may each independently be represented by Formula E.

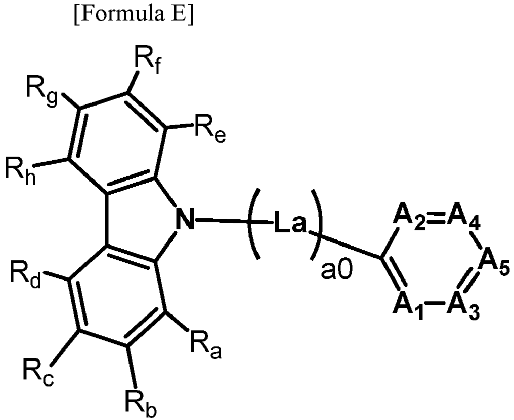

In Formula E, a0 may be an integer from 0 to 10; La may be a direct linkage, a substituted or unsubstituted arylene group having 6 to 30 ring-forming carbon atoms, or a substituted or unsubstituted heteroarylene group having 2 to 30 ring-forming carbon atoms; A₁ to A₅ may each independently be N or C(Rᵢ), and Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring.

In an embodiment, a hole transporting first host represented by Formula E may include at least one selected from Compound Group HT, which is explained below.

In an embodiment, an electron transporting second host represented by Formula E may include at least one selected from Compound Group ET, which is explained below.

In an embodiment, an emission layer may further include a sensitizer including an organometallic complex.

In an embodiment, the organometallic complex may be represented by Formula M-b.

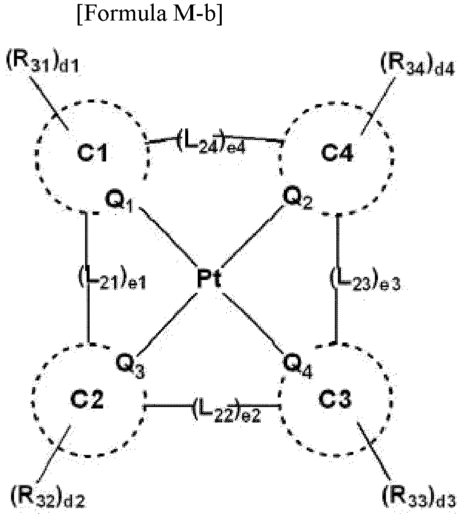

In Formula M-b, Q₁ to Q₄ may each independently be C or N; C1 to C4 may each independently be a substituted or unsubstituted hydrocarbon ring having 5 to 30 ring-forming carbon atoms, or a substituted or unsubstituted heterocycle having 2 to 30 ring-forming carbon atoms; L₂₁ to L₂₄ may each independently be a direct linkage, 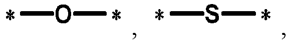 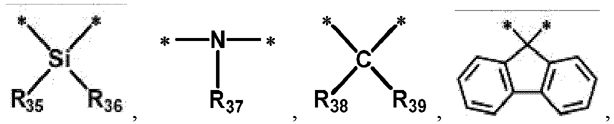 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms; e1 to e4 may each independently be 0 or 1; R₃₁ to R₃₉ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring; and d1 to d4 may each independently be an integer from 0 to 4.

In an embodiment, the organometallic complex represented by Formula M-b may include at least one selected from Compound Group PS, which is explained below.

An embodiment provides an organic electroluminescence device which may include a first electrode, a second electrode facing the first electrode, and an emission layer disposed between the first electrode and the second electrode and including a host and a light emitting dopant, wherein the light emitting dopant may include a fused polycyclic compound represented by Formula 1, and the host may be represented by Formula E-1.

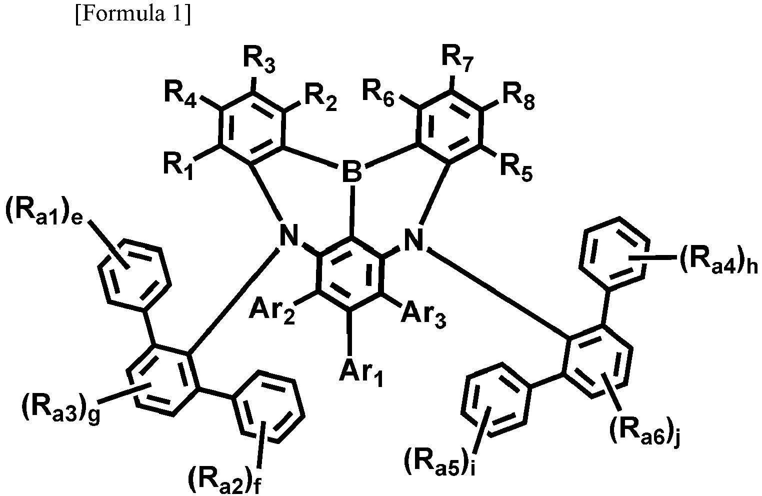

In Formula 1, Ar₁ to Ar₃ may each independently be a hydrogen atom, a deuterium atom, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms; R₁ to R₈ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms; Rₐ₁ to Rₐ₆ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring; e, f, h, and i may each independently be an integer from 0 to 5; g and j may each independently be an integer from 0 to 3; and at least one of R₁ to R₈ may be a group represented by Formula 2.

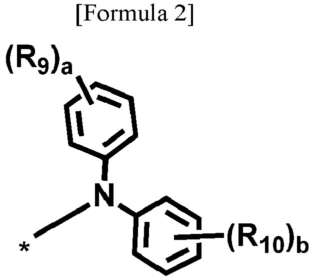

In Formula 2, R₉ and R₁₀ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring; and a and b may each independently be an integer from 0 to 5.

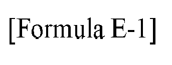

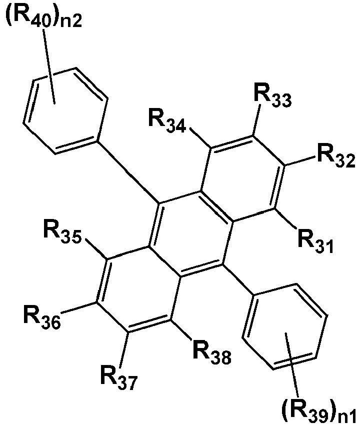

In Formula E-1, n1 and n2 may each independently be an integer from 0 to 5; and R₃₁ to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring.

In an embodiment, the emission layer may emit blue light.

In an embodiment, the emission layer may include a first sub-emission layer and a second sub-emission layer, which are stacked in a thickness direction, and at least one of the first sub-emission layer or the second sub-emission layer may include the host and the light emitting dopant.

### BRIEF DESCRIPTION OF THE DRAWINGS

The accompanying drawings are included to provide a further understanding of the embodiments, and are incorporated in and constitute a part of this specification. The drawings illustrate embodiments of the disclosure and principles thereof. The above and other aspects and features of the disclosure will become more apparent by describing in detail embodiments thereof with reference to the attached drawings, in which:
FIG. 1 is a plan view of a display apparatus according to an embodiment;
FIG. 2 is a schematic cross-sectional view of a display apparatus according to an embodiment;
FIG. 3 is a schematic cross-sectional view illustrating an organic electroluminescence device according to an embodiment;
FIG. 4 is a schematic cross-sectional view illustrating an organic electroluminescence device according to an embodiment;
FIG. 5 is a schematic cross-sectional view illustrating an organic electroluminescence device according to an embodiment;
FIG. 6 is a schematic cross-sectional view illustrating an organic electroluminescence device according to an embodiment;
FIG. 7 is a schematic cross-sectional view of a display apparatus according to an embodiment;
FIG. 8 is a schematic cross-sectional view of a display apparatus according to an embodiment;
FIG. 9A shows a molecular orbital view of a fused polycyclic compound according to an embodiment;
FIG. 9B shows a molecular orbital view of a fused polycyclic compound according to an embodiment;
FIG. 10A shows a three-dimensional structure view of a fused polycyclic compound according to an embodiment;
FIG. 10B shows a three-dimensional structure view of a fused polycyclic compound according to an embodiment; and
FIG. 10C shows a three-dimensional structure view of a fused polycyclic compound according to an embodiment.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like numbers refer to like elements throughout.

In the specification, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the specification, when an element is "directly on," "directly connected to," or "directly coupled to" another element, there are no intervening elements present. For example, "directly on" may mean that two layers or two elements are disposed without an additional element such as an adhesion element therebetween.

As used herein, the expressions used in the singular such as "a," "an," and "the," are intended to include the plural forms as well, unless the context clearly indicates otherwise.

As used herein, the term "and/or" includes any and all combinations of one or more of the associated listed items. For example, "A and/or B" may be understood to mean "A, B, or A and B." The terms "and" and "or" may be used in the conjunctive or disjunctive sense and may be understood to be equivalent to "and/or".

The term "at least one of" is intended to include the meaning of "at least one selected from the group of" for the purpose of its meaning and interpretation. For example, "at least one of A and B" may be understood to mean "A, B, or A and B." When preceding a list of elements, the term, "at least one of," modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (i.e., the limitations of the measurement system). For example, "about" may mean within one or more standard deviations, or within ±20%, ±10%, or ±5% of the stated value.

It should be understood that the terms "comprises," "comprising," "includes," "including," "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

Hereinafter, an organic electroluminescence device according to an embodiment will be described with reference to the accompanying drawings.

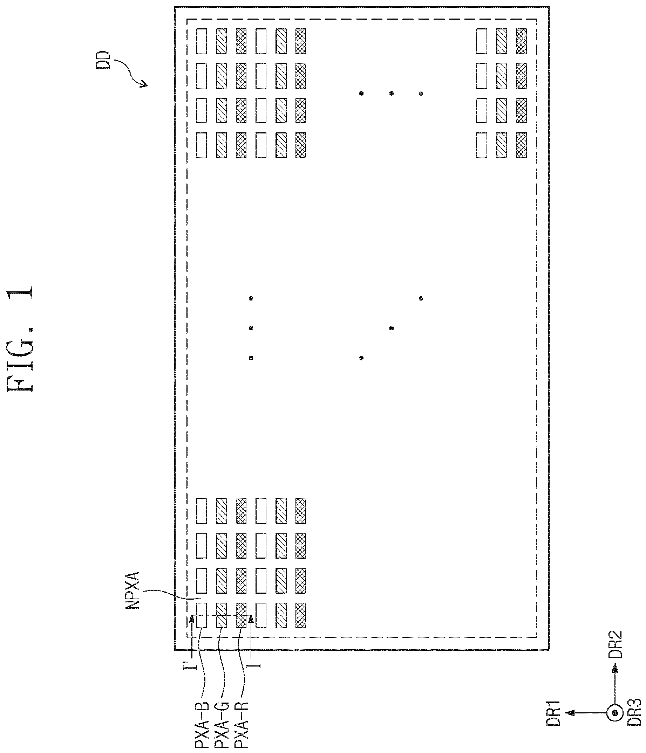

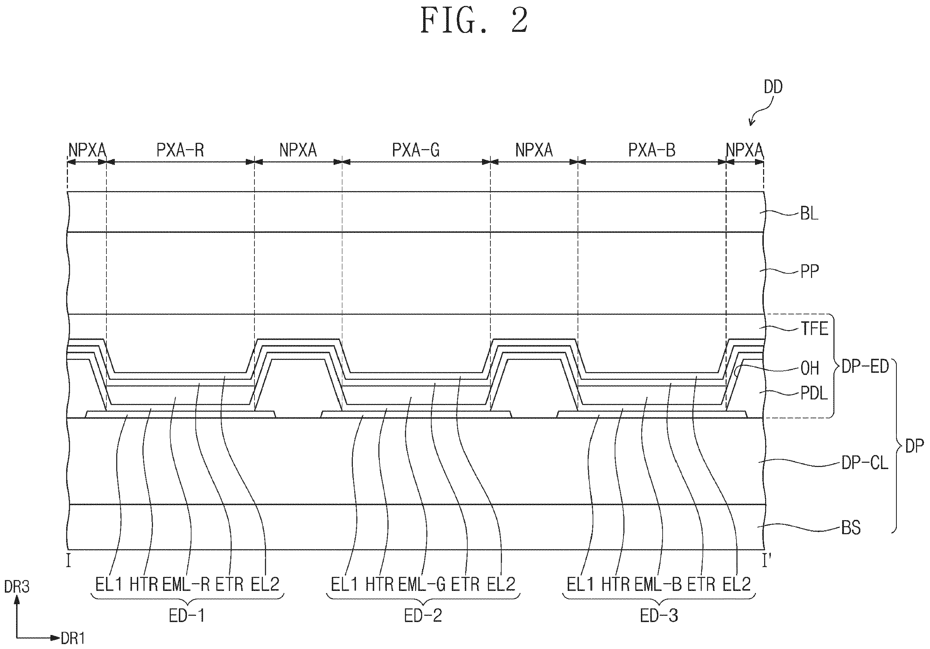

FIG. 1 is a plan view showing an embodiment of a display apparatus DD. FIG. 2 is a schematic cross-sectional view of a display apparatus DD according to an embodiment. FIG. 2 is a schematic cross-sectional view showing a portion corresponding to line I-I' of FIG. 1.

The display apparatus DD may include a display panel DP and an optical layer PP disposed on the display panel DP. The display panel DP may include organic electroluminescence devices ED-1, ED-2, and ED-3. The display apparatus DD may include multiples of each of the organic electroluminescence devices ED-1, ED-2, and ED-3. The optical layer PP may be disposed on the display panel DP to control light reflected at the display panel DP from an external light. The optical layer PP may include, for example, a polarizing layer or a color filter layer. Although not shown in the drawings, in an embodiment, the optical layer PP may be omitted from the display apparatus DD.

A base substrate BL may be disposed on the optical layer PP. The base substrate BL may provide a base surface on which the optical layer PP is disposed. The base substrate BL may be a glass substrate, a metal substrate, a plastic substrate, etc. However, embodiments are not limited thereto, and the base substrate BL may include an inorganic layer, an organic layer, or a composite material layer. Although not shown in the drawings, in an embodiment, the base substrate BL may be omitted.

The display apparatus DD according to an embodiment may further include a filling layer (not shown). The filling layer (not shown) may be disposed between a display element layer DP-ED and the base substrate BL. The filling layer (not shown) may be an organic material layer. The filling layer (not shown) may include at least one of an acrylic resin, a silicone-based resin, or an epoxy-based resin.

The display panel DP may include a base layer BS, a circuit layer DP-CL provided on the base layer BS, and a display element layer DP-ED. The display element layer DP-ED may include pixel defining films PDL, organic electroluminescence devices ED-1, ED-2, and ED-3 disposed between the pixel defining films PDL, and an encapsulation layer TFE disposed on the organic electroluminescence devices ED-1, ED-2, and ED-3.

The base layer BS may provide a base surface on which the display element layer DP-ED is disposed. The base layer BS may be a glass substrate, a metal substrate, a plastic substrate, etc. However, embodiments are not limited thereto, and the base layer BS may include an inorganic layer, an organic layer, or a composite material layer.

In an embodiment, the circuit layer DP-CL may be disposed on the base layer BS, and the circuit layer DP-CL may include transistors (not shown). The transistors (not shown) may each include a control electrode, an input electrode, and an output electrode. For example, the circuit layer DP-CL may include a switching transistor and a driving transistor for driving the organic electroluminescence devices ED-1, ED-2, and ED-3 of the display element layer DP-ED.

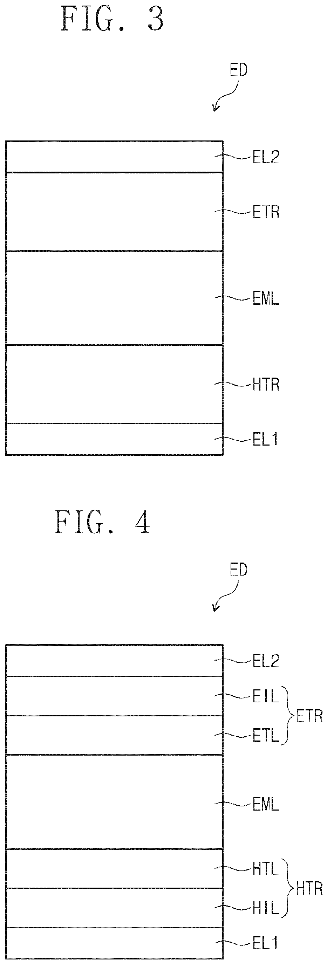

The organic electroluminescence devices ED-1, ED-2, and ED-3 may each have a structure of an organic electroluminescence device ED of an embodiment according to FIGS. 3 to 6, which will be described later. The organic electroluminescence devices ED-1, ED-2, and ED-3 may each include a first electrode EL1, a hole transport region HTR, emission layers EML-R, EML-G, and EML-B, an electron transport region ETR, and a second electrode EL2.

FIG. 2 illustrates an embodiment in which the emission layers EMI,-R, EMI,-G, and EML-B of the organic electroluminescence devices ED-1, ED-2, and ED-3 are disposed in openings OH defined in the pixel defining films PDL, and the hole transport region HTR, the electron transport region ETR, and the second electrode EL2 are each provided as a common layer for all of the organic electroluminescence devices ED-1, ED-2, and ED-3. However, embodiments are not limited thereto, and although not shown in FIG. 2, in an embodiment, the hole transport region HTR and the electron transport region ETR may each be patterned and provided inside the openings OH defined in the pixel defining films PDL. For example, in an embodiment, the hole transport region HTR, the emission layers EMI,-R, EMI,-G, and EML-B, and the electron transport region ETR, etc. of the organic electroluminescence devices ED-1, ED-2, and ED-3 may each be patterned and provided through an inkjet printing method.

The encapsulation layer TFE may cover the organic electroluminescence devices ED-1, ED-2, and ED-3. The encapsulation layer TFE may seal the display element layer DP-ED. The encapsulation layer TFE may be a thin film encapsulation layer. The encapsulation layer TFE may be a single layer or a stack of multiple layers. The encapsulation layer TFE may include at least one insulating layer. The encapsulation layer TFE according to an embodiment may include at least one inorganic film (hereinafter, an encapsulation inorganic film). The encapsulation layer TFE according to an embodiment may include at least one organic film (hereinafter, an encapsulation organic film) and at least one encapsulation inorganic film.

The encapsulation inorganic film may protect the display element layer DP-ED from moisture and/or oxygen and the encapsulation organic film may protect the display element layer DP-ED from foreign substances such as dust particles. The encapsulation inorganic film may include silicon nitride, silicon oxy nitride, silicon oxide, titanium oxide, aluminum oxide, etc., but is not limited thereto. The encapsulation organic film may include an acrylic compound, an epoxy-based compound, etc. The encapsulation organic film may include a photopolymerizable organic material, without limitation.

The encapsulation layer TFE may be disposed on the second electrode EL2, and may be disposed to fill the openings OH.

Referring to FIGS. 1 and 2, the display apparatus DD may include non-light emitting regions NPXA and light emitting regions PXA-R, PXA-G, and PXA-B. The light emitting regions PXA-R, PXA-G, and PXA-B may each be a region emitting light generated from each of the organic electroluminescence devices ED-1, ED-2, and ED-3. The light emitting regions PXA-R, PXA-G, and PXA-B may be spaced apart from each other in a plan view.

Each of the light emitting regions PXA-R, PXA-G, and PXA-B may be a region separated by the pixel defining films PDL. The non-light emitting regions NPXA may be regions between neighboring light emitting regions PXA-R, PXA-G, and PXA-B, and may correspond to the pixel defining films PDL. For example, in an embodiment, each of the light emitting regions PXA-R, PXA-G, and PXA-B may correspond to a pixel. The pixel defining films PDL may separate the organic electroluminescence devices ED-1, ED-2, and ED-3. The emission layers EMI,-R, EMI,-G, and EMI,-B of the organic electroluminescence devices ED-1, ED-2, and ED-3 may be disposed in the openings OH defined in the pixel defining films PDL and separated from each other.

The light emitting regions PXA-R, PXA-G, and PXA-B may be divided into groups according to the color of light generated from the organic electroluminescence devices ED-1, ED-2, and ED-3. In the display apparatus DD of an embodiment shown in FIGS. 1 and 2, three light emitting regions PXA-R, PXA-G, and PXA-B which emit red light, green light, and blue light, are illustrated. For example, the display apparatus DD of an embodiment may include a red light emitting region PXA-R, a green light emitting region PXA-G, and a blue light emitting region PXA-B, which are distinct from one another.

In the display apparatus DD according to an embodiment, the organic electroluminescence devices ED-1, ED-2, and ED-3 may emit light having different wavelength ranges. For example, in an embodiment, the display apparatus DD may include a first organic electroluminescence device ED-1 emitting red light, a second organic electroluminescence device ED-2 emitting green light, and a third organic electroluminescence device ED-3 emitting blue light. For example, the red light emitting region PXA-R, the green light emitting region PXA-G, and the blue light emitting region PXA-B of the display apparatus DD may respectively correspond to the first organic electroluminescence device ED-1, the second organic electroluminescence device ED-2, and the third organic electroluminescence device ED-3.

However, embodiments are not limited thereto, and the first to third organic electroluminescence devices ED-1, ED-2, and ED-3 may emit light in a same wavelength range or at least one thereof may emit light in a different wavelength range. For example, the first to third organic electroluminescence devices ED-1, ED-2, and ED-3 may all emit blue light.

The light emitting regions PXA-R, PXA-G, and PXA-B in the display apparatus DD according to an embodiment may be arranged in a stripe configuration. Referring to FIG. 1, the red light emitting regions PXA-R, the green light emitting regions PXA-G, and the blue light emitting regions PXA-B may be arranged along a second directional axis DR2. In another embodiment, the red light emitting region PXA-R, the green light emitting region PXA-G, and the blue light emitting region PXA-B may be alternately arranged in turn along a first directional axis DR1.

FIGS. 1 and 2 illustrate that the light emitting regions PXA-R, PXA-G, and PXA-B are all similar in size, but embodiments are not limited thereto. The light emitting regions PXA-R, PXA-G, and PXA-B may be different in size from each other according to a wavelength range of emitted light. The areas of the light emitting regions PXA-R, PXA-G, and PXA-B may be areas in a plan view that are defined by the first directional axis DR1 and the second directional axis DR2.

The arrangement of the light emitting regions PXA-R, PXA-G, and PXA-B is not limited to the one shown in FIG. 1, and the order in which the red light emitting region PXA-R, the green light emitting region PXA-G, and the blue light emitting region PXA-B are arranged may be provided in various combinations according to display quality characteristics which are required for the display apparatus DD. For example, the light emitting regions PXA-R, PXA-G, and PXA-B may be arranged in a PENTILE^{™} configuration or in a diamond configuration.

In an embodiment, an area of each of the light emitting regions PXA-R, PXA-G, and PXA-B may be different in size from one another. For example, in an embodiment, an area of the green light emitting region PXA-G may be smaller than an area of the blue light emitting region PXA-B, but embodiments are not limited thereto.

Hereinafter, FIGS. 3 to 6 are each a schematic cross-sectional view illustrating an organic electroluminescence device according to an embodiment. In the organic electroluminescence device ED of an embodiment, the first electrode EL1 and the second electrode EL2 are disposed to face each other, and organic layers may be disposed between the first electrode EL1 and the second electrode EL2. The organic layers may include a hole transport region HTR, an emission layer EML, and an electron transport region ETR. For example, the organic electroluminescence device ED according to an embodiment may include a first electrode EL1, a hole transport region HTR, an emission layer EML, an electron transport region ETR, and a second electrode EL2, which are stacked in that order.

The organic electroluminescence device ED according to an embodiment may include a fused polycyclic compound of an embodiment, which will be described later, in at least one organic layer among the organic layers disposed between the first electrode EL1 and the second electrode EL2. For example, the organic electroluminescence device ED according to an embodiment may include a fused polycyclic compound of an embodiment, which will be described later, in the emission layer EML disposed between the first electrode EL1 and the second electrode EL2. However, embodiments are not limited thereto, and the organic electroluminescence device ED according to an embodiment may include a fused polycyclic compound according to an embodiment, which will be described later, not only in the emission layer EML but also in at least one organic layer included in the hole transport region HTR and electron transport region ETR, which are among the organic layers disposed between the first electrode EL1 and the second electrode EL2, or in a capping layer CPL disposed on the second electrode EL2.

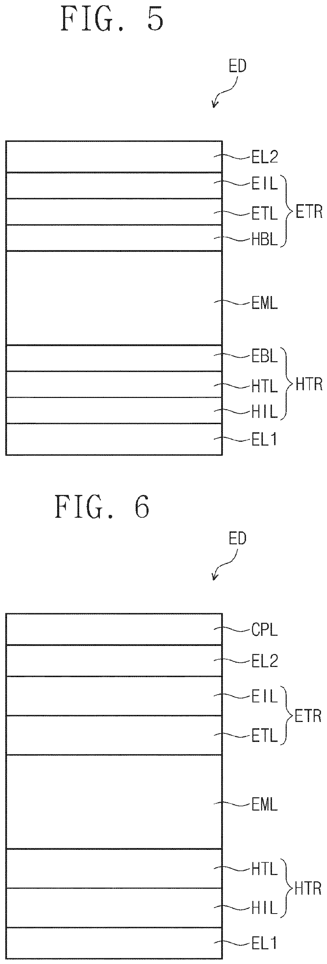

In comparison to FIG. 3, FIG. 4 illustrates a schematic cross-sectional view of an organic electroluminescence device ED of an embodiment in which the hole transport region HTR includes a hole injection layer HIL and a hole transport layer HTL, and the electron transport region ETR includes an electron injection layer EIL and an electron transport layer ETL. In comparison to FIG. 3, FIG. 5 illustrates a schematic cross-sectional view of an organic electroluminescence device ED of an embodiment in which the hole transport region HTR includes a hole injection layer HIL, a hole transport layer HTL, and an electron blocking layer EBL, and the electron transport region ETR includes an electron injection layer EIL, an electron transport layer ETL, and a hole blocking layer HBL. In comparison to FIG. 4, FIG.6 illustrates a schematic cross-sectional view of an organic electroluminescence device ED of an embodiment including a capping layer CPL disposed on the second electrode EL2.

Hereinafter, in the description of the organic electroluminescence device ED of an embodiment, the fused polycyclic compound according to an embodiment, which will be described later, is included in the emission layer EML, but the embodiment is not limited thereto, and the fused polycyclic compound according to an embodiment, which will be described later, may be included in the hole transport region HTR, the electron transport region ETR, or the capping layer CPL.

The first electrode EL1 has conductivity. The first electrode EL1 may be formed of a metal material, a metal alloy, or a conductive compound. The first electrode EL1 may be an anode or a cathode. However, embodiments are not limited thereto. For example, the first electrode EL1 may be a pixel electrode. The first electrode EL1 may be a transmissive electrode, a transflective electrode, or a reflective electrode. When the first electrode EL1 is a transmissive electrode, the first electrode EL1 may include a transparent metal oxide such as indium tin oxide (ITO), indium zinc oxide (IZO), zinc oxide (ZnO), or indium tin zinc oxide (ITZO). When the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca, LiF/Al, Mo, Ti, W, a compound thereof, or a mixture thereof (e.g., a mixture of Ag and Mg). In another embodiment, the first electrode EL1 may have a multilayer structure including a reflective film or a transflective film formed of the above-described materials, and a transparent conductive film formed of indium tin oxide (ITO), indium zinc oxide (IZO), zinc oxide (ZnO), indium tin zinc oxide (ITZO), etc. For example, the first electrode EL1 may have a three-layer structure of ITO/Ag/ITO. However, embodiments are not limited thereto, and the first electrode EL1 may include the above-described metal materials, a combination of two or more metal materials selected from the above-described metal materials, or oxides of the above-described metal materials. The first electrode EL1 may have a thickness in a range of about 700 Å to about 10,000 Å. For example, the first electrode EL1 may have a thickness in a range of about 1,000 Å to about 3,000 Å.

The hole transport region HTR is provided on the first electrode EL1. The hole transport region HTR may include at least one of a hole injection layer HIL, a hole transport layer HTL, a buffer layer (not shown), a light emitting auxiliary layer (not shown), and an electron blocking layer EBL. The hole transport region HTR may have, for example, a thickness in a range of about 50 Å to about 15,000 Å.

The hole transport region HTR may be a layer formed of a single material, a layer formed of different materials, or a multilayer structure having layers formed of different materials.

For example, the hole transport region HTR may have a single-layer structure formed of a hole injection layer HIL or a hole transport layer HTL, or a single-layer structure formed of a hole injection material and a hole transport material. For example, the hole transport region HTR may have a single-layer structure formed of different materials, or a structure in which a hole injection layer HIL/hole transport layer HTL, a hole injection layer HIL/hole transport layer HTL/buffer layer (not shown), a hole injection layer HIL/buffer layer (not shown), a hole transport layer HTL/buffer layer (not shown), or a hole injection layer HIL/hole transport layer HTL/electron blocking layer EBL are stacked in its respective stated order from the first electrode EL1, but embodiments are not limited thereto.

The hole transport region HTR may be formed using various methods such as a vacuum deposition method, a spin coating method, a cast method, a Langmuir-Blodgett (LB) method, an inkjet printing method, a laser printing method, and a laser induced thermal imaging (LITI) method.

The hole transport region HTR may include a compound represented by Formula H-1.

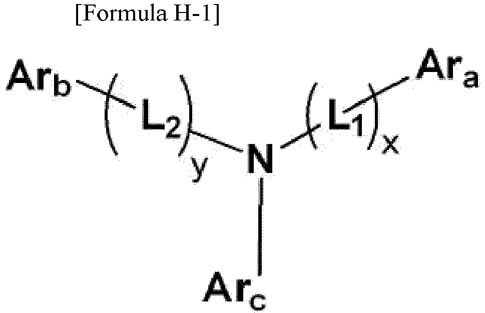

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. In Formula H-1, x and y may each independently be an integer from 0 to 10. When x or y is 2 or greater, multiple L₁ groups and multiple L₂ groups may each independently be a substituted or unsubstituted arylene group having 6 to 30 ring-forming carbon atoms, or a substituted or unsubstituted heteroarylene group having 2 to 30 ring-forming carbon atoms.

In Formula H-1, Arₐ to Ar_{c} may each independently be a substituted or unsubstituted aryl group having 6 to 30 ring-forming carbon atoms, or a substituted or unsubstituted heteroaryl group having 2 to 30 ring-forming carbon atoms.

In an embodiment, a compound represented by Formula H-1 may be a monoamine compound. However, embodiments are not limited thereto, and the compound represented by Formula H-1 may be a diamine compound in which at least one of Arₐ to Ar_{c} includes an amine group as a substituent.

In an embodiment, L₁ and L₂ may each independently be a direct linkage or a substituted or unsubstituted phenylene group.

In an embodiment, at least one of Arₐ to Ar_{c} may be a substituted or unsubstituted fluorenyl group, a substituted or unsubstituted carbazole group, or a substituted or unsubstituted dibenzofuranyl group.

In an embodiment, in Formula H-1, Ar_{c} may be a substituted or unsubstituted aryl group having 6 to 30 ring-forming carbon atoms.

In an embodiment, the compound represented by Formula H-1 may be a carbazole-based compound in which at least one of Arₐ and Ar_{b} may include a substituted or unsubstituted carbazole group. In an embodiment, the compound represented by Formula H-1 may be a fluorene-based compound in which at least one of Arₐ and Ar_{b} may include a substituted or unsubstituted fluorene group.

The compound represented by Formula H-1 may be any one selected from Compound Group H. However, the compounds listed in Compound Group H are only presented as examples, and the compound represented by Formula H-1 is not limited to the those listed in Compound Group H.

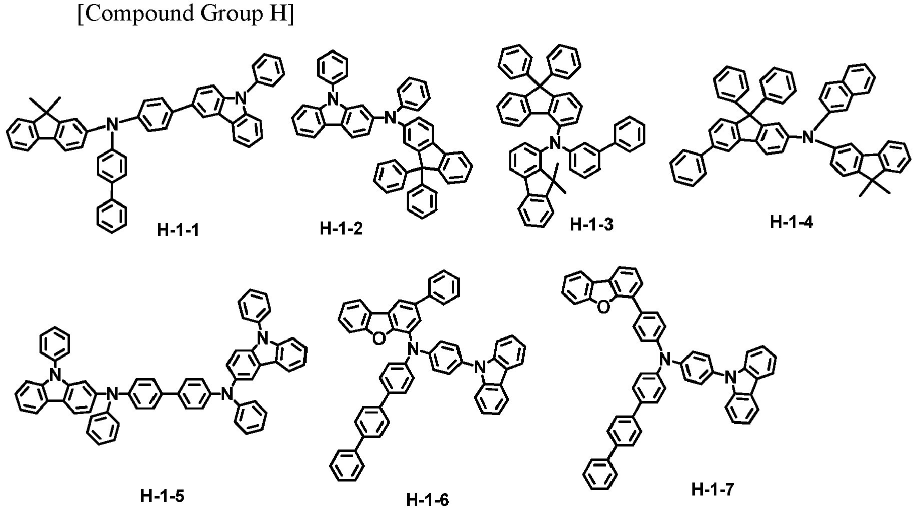

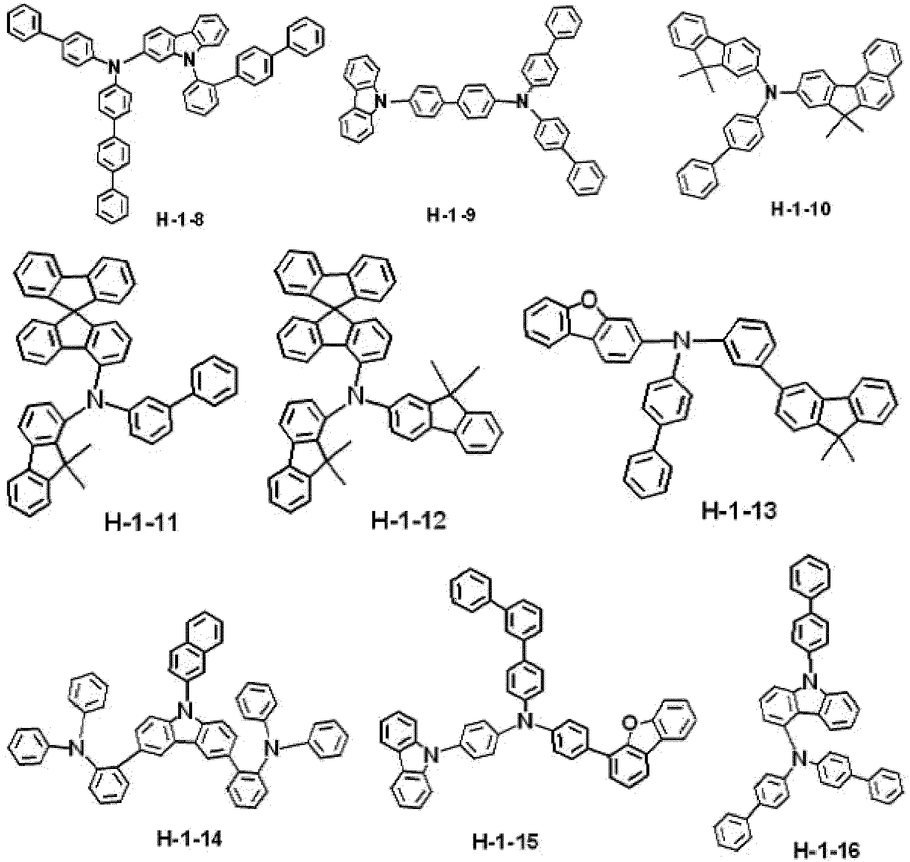

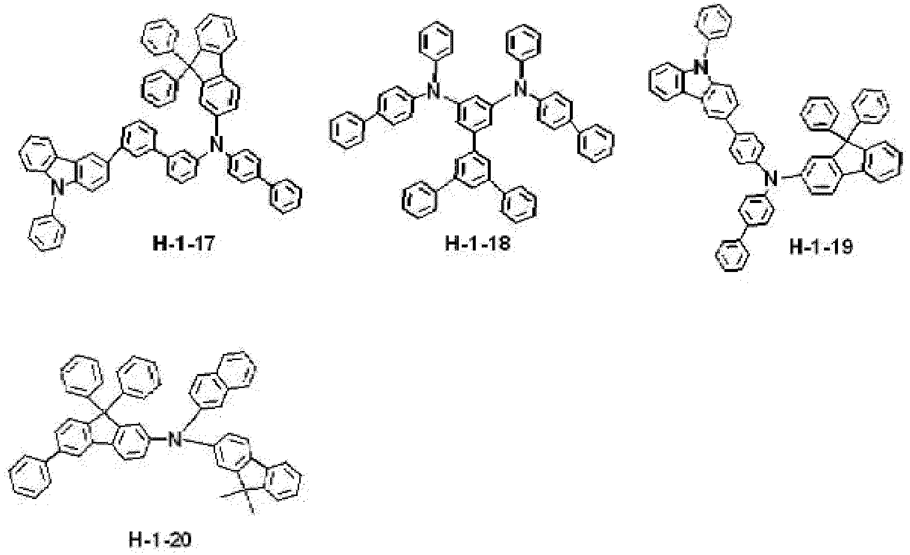

The hole transport region HTR may include a phthalocyanine compound such as copper phthalocyanine, N,N'-diphenyl-N,N'-bis-[4-(phenyl-m-tolyl-amino)-phenyl]-biphenyl-4,4'-diamine (DNTPD), 4,4',4"-[tris(3-methylphenyl)phenylamino]triphenylamine] (m-MTDATA), 4,4',4"-tris(N,N-diphenylamino)triphenylamine (TDATA), 4,4',4"-tris {N,-(2-naphthyl) -N-phenylamino)-triphenylamine (2-TNATA), poly(3,4-ethylenedioxythiophene)/poly(4-styrenesulfonate) (PEDOT/PS S), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-1-yl)-N,N'-diphenyl-benzidine (NPD), triphenylamine-containing polyetherketone (TPAPEK), 4-isopropyl-4'-methyldiphenyliodonium tetrakis(pentafluorophenyl)borate, dipyrazino[2,3-f: 2',3'-h]quinoxaline-2,3,6,7,10,11-hexacarbonitrile (HAT-CN), etc.

The hole transport region HTR may include carbazole-based derivatives such as N-phenyl carbazole and polyvinyl carbazole, fluorene-based derivatives, N,N'-bis(3-methylphenyl)-N,N'-diphenyl-[1,1-biphenyl]-4,4'-diamine (TPD), triphenylamine-based derivatives such as 4,4',4"-tris(N-carbazolyl)triphenylamine (TCTA), N,N'-di(1-naphtalene-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), etc.

The hole transport region HTR may include 9-(4-tert-Butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol- 9-yl)benzene (mDCP), etc.

The hole transport region HTR may include the compounds of the hole transport region described above in at least one of the hole injection layer HIL, the hole transport layer HTL, or the electron blocking layer EBL.

The hole transport region HTR may have a thickness in a range of about 100 Å to about 10,000 Å. For example, the hole transport region HTR may have a thickness in a range of about 100 Å to about 5,000 Å. When the hole transport region HTR includes a hole injection layer HIL, the hole injection layer HIL may have a thickness in a range of, for example, about 30 Å to about 1,000 Å. When the hole transport region HTR includes a hole transport layer HTL, the hole transport layer HTL may have a thickness in a range of about 30 Å to about 1,000 Å. When the hole transport region HTR includes an electron blocking layer EBL, the electron blocking layer EBL may have a thickness in a range of, for example, about 10 Å to about 1,000 Å. When the thicknesses of the hole transport region HTR, the hole injection layer HIL, the hole transport layer HTL, and the electron blocking layer EBL satisfy the above-described ranges, satisfactory hole transport properties may be obtained without a substantial increase in driving voltage.

The hole transport region HTR may further include, in addition to the above-described materials, a charge generation material to increase conductivity. The charge generation material may be uniformly or non-uniformly dispersed in the hole transport region HTR. The charge generation material may be, for example, a p-dopant. The p-dopant may include at least one of halogenated metal compounds, quinone derivatives, metal oxides, or cyano group-containing compounds, but is not limited thereto. For example, the p-dopant may include halogenated metal compounds such as CuI and RbI, quinone derivatives such as tetracyanoquinodimethane (TCNQ) and 2,3,5,6-tetrafluoro-7,7,8,8-tetracyanoquinodimethane (F4-TCNQ), metal oxides such as tungsten oxides and molybdenum oxides, cyano group-containing compounds such as dipyrazino[2,3-f: 2',3'-h] quinoxaline-2,3,6,7,10,11-hexacarbonitrile (HATCN) and 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), etc., but is not limited thereto.

As described above, the hole transport region HTR may further include at least one of a buffer layer (not shown) or an electron blocking layer EBL in addition to the hole injection layer HIL and the hole transport layer HTL. The buffer layer (not shown) may compensate for a resonance distance according to a wavelength of light emitted from an emission layer EML, and may thus increase luminous efficiency. Materials which may be included in the hole transport region HTR may be used as materials included in the buffer layer (not shown). The electron blocking layer EBL may prevent electrons from being injected from the electron transport region ETR to the hole transport region HTR.

The emission layer EML is provided on the hole transport region HTR. The emission layer EML may have a thickness in a range of about 100 Å to about 1,000 Å. For example, the emission layer EML may have a thickness in a range of about 100 Å to about 300 Å. The emission layer EML may be a layer formed of a single material, a layer formed of different materials, or a multilayer structure having layers formed of different materials.

The organic electroluminescence device ED according to an embodiment may include a fused polycyclic compound of an embodiment in the emission layer EML.

In the description, the term "substituted or unsubstituted" may mean a group or moiety that is substituted or unsubstituted with at least one substituent selected from the group consisting of a deuterium atom, a halogen atom, a cyano group, a nitro group, an amine group, a silyl group, an oxy group, a thio group, a sulfinyl group, a sulfonyl group, a carbonyl group, a boryl group, a phosphine oxide group, a phosphine sulfide group, an alkyl group, an alkenyl group, an alkynyl group, an alkoxy group, a hydrocarbon ring group, an aryl group, and a heterocyclic group. Each of the substituents listed above may itself be substituted or unsubstituted. For example, a biphenyl group may be interpreted as an aryl group or may be interpreted as a phenyl group substituted with a phenyl group.

In the description, the term "bonded to an adjacent group to form a ring" may mean a group that is bonded to an adjacent group to form a substituted or unsubstituted hydrocarbon ring, or a substituted or unsubstituted heterocycle. The hydrocarbon ring may be an aliphatic hydrocarbon ring or an aromatic hydrocarbon ring. The heterocycle may be an aliphatic heterocycle or an aromatic heterocycle. A ring that is formed by a group being bonded to an adjacent group may be monocyclic or polycyclic. A ring that is formed by groups being bonded to each other may itself be connected to another ring to form a spiro structure.

In the description, the term "adjacent group" may mean a substituent substituted for an atom which is directly connected to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as mutually "adjacent groups" and two ethyl groups in 1,1-diethylcyclopentane may be interpreted as mutually "adjacent groups".

In the description, examples of a halogen atom may include a fluorine atom, a chlorine atom, a bromine atom, or an iodine atom.

In the description, an alkyl group may be a linear, a branched, or a cyclic type. The number of carbon atoms in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, a s-butyl group, a t-butyl group, an i-butyl group, a 2-ethylbutyl group, a 3,3-a dimethylbutyl group, an n-pentyl group, an i-pentyl group, a neopentyl group, a t-pentyl group, a cyclopentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, a cyclohexyl group, a 4-methylcyclohexyl group, a 4-t-butylcyclohexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, a cyclooctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldodecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, a triphenylmethyl group, a 2-phenylisopropyl group, a tetralinyl group, etc., but are not limited thereto.

In the description, an alkenyl group may be a hydrocarbon group including at least one carbon-carbon double bond in the middle or end of an alkyl group having 2 or more carbon atoms. The alkenyl group may be linear or branched. The number of carbon atoms in the alkenyl group is not particularly limited, but may be 2 to 30, 2 to 20, or 2 to 10. Examples of the alkenyl group may include a vinyl group, a 1-butenyl group, a 1-pentenyl group, a 1,3-butadienyl group, a styrenyl group, a styryl vinyl group, etc., but are not limited thereto.

In the description, an alkynyl group may be a hydrocarbon group including at least one carbon-carbon triple bond in the middle or end of an alkyl group having 2 or more carbon atoms. The alkynyl group may be linear or branched. The number of carbon atoms in the alkynyl group is not particularly limited, but may be 2 to 30, 2 to 20, or 2 to 10. Examples of the alkynyl group may include an ethynyl group, a propynyl group, etc., but are not limited thereto.

In the description, a hydrocarbon ring may be a functional group or substituent derived from an aliphatic hydrocarbon ring or from an aromatic hydrocarbon ring. The number of ring-forming carbon atoms in the hydrocarbon ring may be 5 to 60, 5 to 30, or 5 to 20.

In the description, an aryl group may be a functional group or substituent derived from an aromatic hydrocarbon ring. The aryl group may be a monocyclic aryl group or a polycyclic aryl group. The number of ring-forming carbon atoms in the aryl group may be 6 to 60, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, etc., but are not limited thereto.

In the description, a fluorenyl group may be substituted, and two substituents may be bonded to each other to form a spiro structure. Examples of substituted fluorenyl groups are as follows. However, embodiments are not limited thereto.

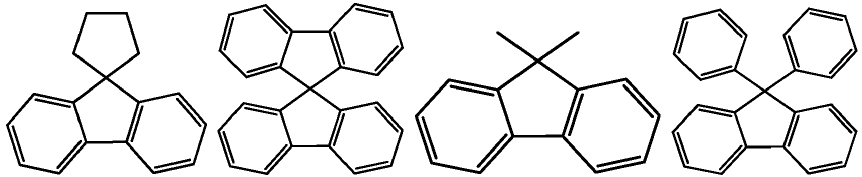

In the description, a heterocyclic group may be a functional group or substituent derived from a ring containing at least one of B, O, N, P, Si, Se, Te, or S as a heteroatom. The heterocyclic group may be an aliphatic heterocyclic group or an aromatic heterocyclic group. The aromatic heterocyclic group may be a heteroaryl group. The aliphatic heterocyclic group and the aromatic heterocyclic group may each independently be monocyclic or polycyclic.

In the description, the heterocyclic group may contain at least one of B, O, N, P, Si, Se, Te, or S as a heteroatom. When the heterocyclic group contains two or more heteroatoms, the two or more heteroatoms may be the same as or different from each other. The heterocyclic group may be a monocyclic heterocyclic group or a polycyclic heterocyclic group, and the heterocyclic group may be a heteroaryl group. The number of ring-forming carbon atoms in the heterocyclic group may be 2 to 30, 2 to 20, or 2 to 10.

In the description, the aliphatic heterocyclic group may contain at least one of B, O, N, P, Si, Se, Te, or S as a heteroatom. The number of ring-forming carbon atoms in the aliphatic heterocyclic group may be 2 to 60, 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, etc., but are not limited thereto.

In the description, a heteroaryl group may include at least one of B, O, N, P, Si, Se, Te, or S as a heteroatom. When the heteroaryl group contains two or more heteroatoms, the two or more heteroatoms may be the same as or different from each other. The heteroaryl group may be a monocyclic heteroaryl group or a polycyclic heteroaryl group. The number of ring-forming carbon atoms in the heteroaryl group may be 2 to 60, 2 to 30, 2 to 20, or 2 to 10. Examples of the heteroaryl group may include a thiophene group, a furan group, a pyrrole group, an imidazole group, a triazole group, a pyridine group, a bipyridine group, a pyrimidine group, a pyrazine group, a triazine group, an acridyl group, a pyridazine group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzoimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, etc., but are not limited thereto.

In the description, the above description of the aryl group may be applied to an arylene group, except that the arylene group is a divalent group. The above description of the heteroaryl group may be applied to a heteroarylene group, except that the heteroarylene group is a divalent group.

In the description, a silyl group may be an alkyl silyl group or an aryl silyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., but are not limited thereto.

In the description, a boryl group may be an alkyl boryl group or an aryl boryl group. Examples of the boryl group may include a dimethylboryl group, a diethylboryl group, a t-butylmethylboryl group, a diphenylboryl group, a phenylboryl group, etc., but are not limited thereto.

In the description, the number of carbon atoms in an amine group is not particularly limited, but may be 1 to 30. The amine group may be -NH₂, an alkyl amine group, an aryl amine group, or a heteroaryl amine group. Examples of the amine group may include a methylamine group, a dimethylamine group, a phenylamine group, a diphenylamine group, a naphthylamine group, a 9-methyl-anthracenylamine group, a triphenylamine group, etc., but are not limited thereto.

In the description, examples of an alkyl group may include an alkoxy group, an alkylthio group, an alkyl sulfoxy group, an alkylaryl group, an alkyl amine group, an alkyl boryl group, and an alkyl silyl group.

In the description, examples of an aryl group may include an aryloxy group, an arylthio group, an aryl sulfoxy group, an aryl amine group, an aryl boryl group, and an aryl silyl group.

In the description, the oxy group may mean the above-defined alkyl group or aryl group which is combined with an oxygen atom. The oxy group may include an alkoxy group and an aryl oxy group. The alkoxy group may be a linear, branched or cyclic chain. The carbon number of the alkoxy group is not specifically limited but may be, for example, 1 to 30, 1 to 20, or 1 to 10. Examples of the oxy group may include methoxy, ethoxy, n-propoxy, isopropoxy, butoxy, pentyloxy, hexyloxy, octyloxy, nonyloxy, decyloxy, benzyloxy, etc. However, an embodiment of the inventive concept is not limited thereto.

In the description, the thio group may mean the above-defined alkyl group or aryl group which is combined with a sulfur atom. The thio group may include an alkyl thio group and an aryl thio group. The carbon number of the thio group is not specifically limited but may be, for example, 1 to 30, 1 to 20, or 1 to 10. Examples of the thio group include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, etc., without limitation.

In the description, the sulfinyl group may mean the above-defined alkyl group or aryl group which is combined with an -S(=O)-. The number of carbon atoms of the sulfinyl group is not particularly limited, but may be 1 to 30, 1 to 20, or 1 to 10. The sulfinyl group may include an alkyl sulfinyl group and an aryl sulfinyl group. For example, the sulfinyl group may have the structure below, but is not limited thereto.

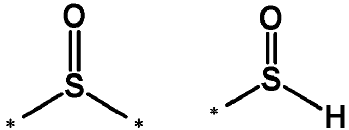

In the description, the sulfonyl group may mean the above-defined alkyl group or aryl group which is combined with an -S(=O)₂-. The number of carbon atoms of the sulfonyl group is not particularly limited, but may be 1 to 30, 1 to 20, or 1 to 10. The sulfonyl group may include an alkyl sulfonyl group and an aryl sulfonyl group. For example, the sulfonyl group may have the structure below, but is not limited thereto.

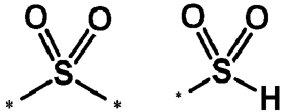

In the description, the carbon number of a carbonyl group is not specifically limited, but the carbon number may be 1 to 40, 1 to 30, or 1 to 20. For example, the carbonyl group may have the structures below, but is not limited thereto.

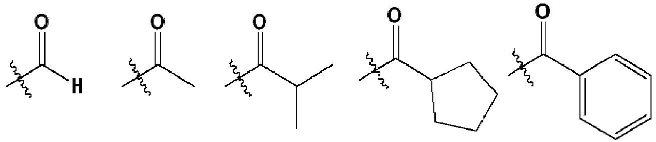

In the description, the phosphine oxide group may mean the above-defined alkyl group or aryl group which is combined with an -P(=O)-. The number of carbon atoms of the phosphine oxide group is not particularly limited, but may be 1 to 30, 1 to 20, or 1 to 10. The phosphine oxide group may include an alkyl phosphine oxide group and an aryl phosphine oxide group. For example, the phosphine oxide group may have the structure below, but is not limited thereto.

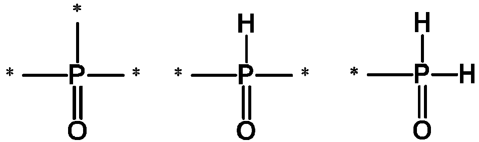

In the description, the phosphine sulfide group may mean the above-defined alkyl group or aryl group which is combined with an -P(=S)-. The number of carbon atoms of the phosphine sulfide group is not particularly limited, but may be 1 to 30, 1 to 20, or 1 to 10. The phosphine sulfide group may include an alkyl phosphine sulfide group and an aryl phosphine sulfide group. For example, the phosphine sulfide group may have the structure below, but is not limited thereto.

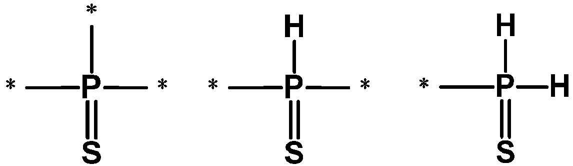

In the description, -* represents a bonding position to a neighboring atom.

The fused polycyclic compound of an embodiment may be represented by Formula 1.

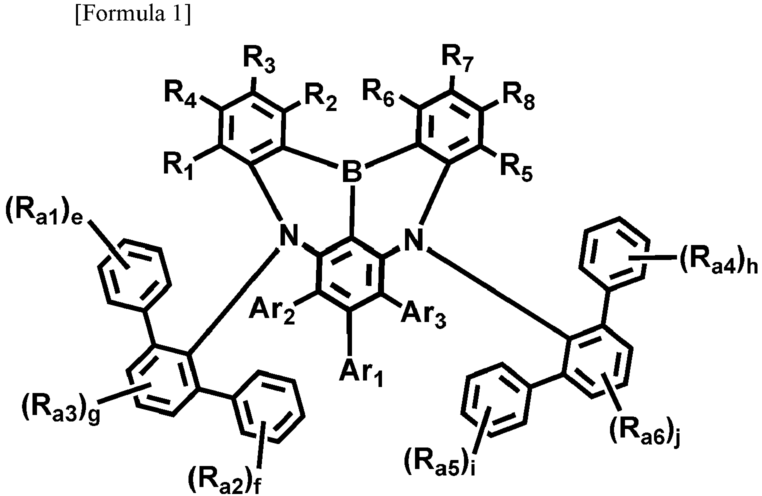

In Formula 1, Ar₁ to Ar₃ may each independently be a hydrogen atom, a deuterium atom, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula 1, R₁ to R₈ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula 1, Rₐ₁ to Rₐ₆ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring.

In Formula 1, e, f, h, and i may each independently be an integer from 0 to 5. When e is 2 or greater, multiple Rₐ₁ groups may be the same as or different from each other. When f is 2 or greater, multiple Rₐ₂ groups may be the same as or different from each other. When h is 2 or greater, multiple Rₐ₄ groups may be the same as or different from each other. When i is 2 or greater, multiple Rₐ₅ groups may be the same as or different from each other.

In Formula 1, g and j may each independently be an integer from 0 to 3. When g is 2 or greater, multiple Rₐ₃ groups may be the same as or different from each other, and when j is 2 or greater, multiple Rₐ₆ groups may be the same as or different from each other.

In Formula 1, at least one of R₁ to R₈ may be a group represented by Formula 2.

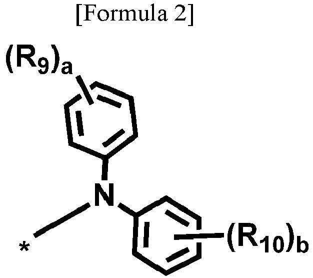

In Formula 2, R₉ and R₁₀ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring.

In Formula 2, a and b may each independently be an integer from 0 to 5. When a is 2 or greater, multiple R₉ groups may be the same as or different from each other, and when b is 2 or greater, multiple R₁₀ groups may be the same as or different from each other.

In an embodiment, any one of R₁ to R₈ of Formula 1 may be a group represented by Formula 2, or any one of R₁ and R₄ of Formula 1 and any one of R₅ to R₈ of Formula 1 may each independently be a group represented by Formula 2.

In an embodiment, the fused polycyclic compound represented by Formula 1 may have a photoluminescence quantum yield (PLQY) equal to or greater than about 80%.

In an embodiment, the fused polycyclic compound represented by Formula 1 may be represented by any one of Formulas 3-1 to 3-3.

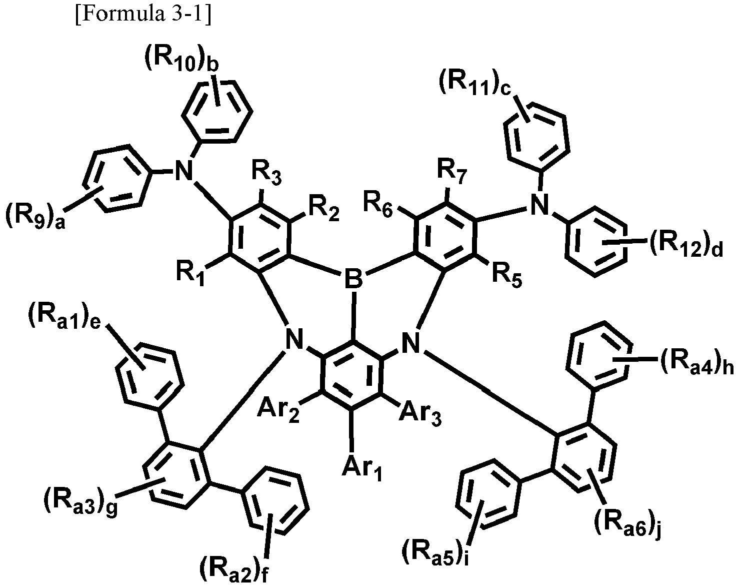

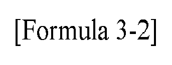

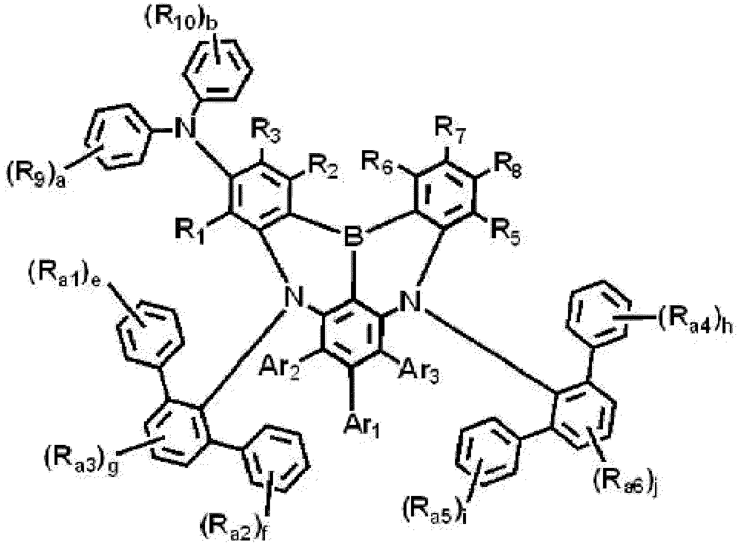

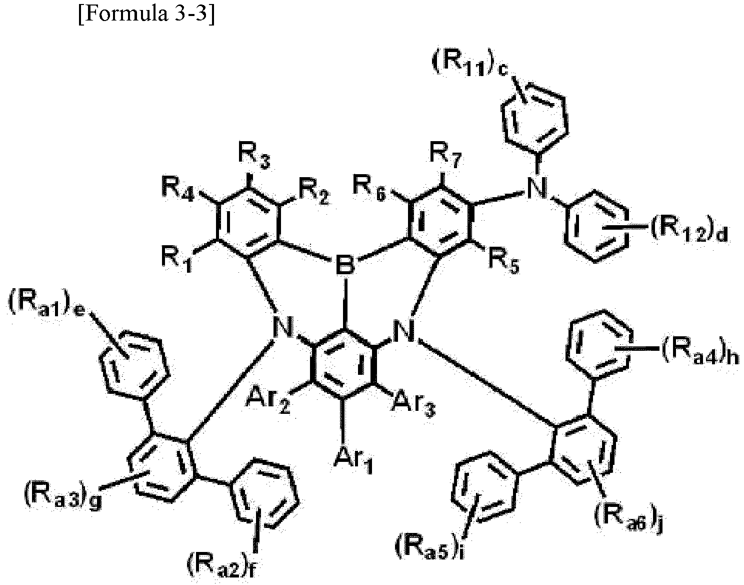

In Formulas 3-1 to 3-3, R₁₁ and R₁₂ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring.

In Formulas 3-1 to 3-3, c and d may each independently be an integer from 0 to 5. When c is 2 or greater, multiple R₁₁ groups may be the same as or different from each other, and when d is 2 or greater, multiple R₁₂ groups may be the same as or different from each other.

In Formulas 3-1 to 3-3, Ar₁ to Ar₃, R₁ to R₁₀, Rₐ₁ to Rₐ₆, a, b, and e to j are the same as defined in Formulas 1 and 2.

In an embodiment, the fused polycyclic compound represented by Formula 1 may be represented by Formula 4.

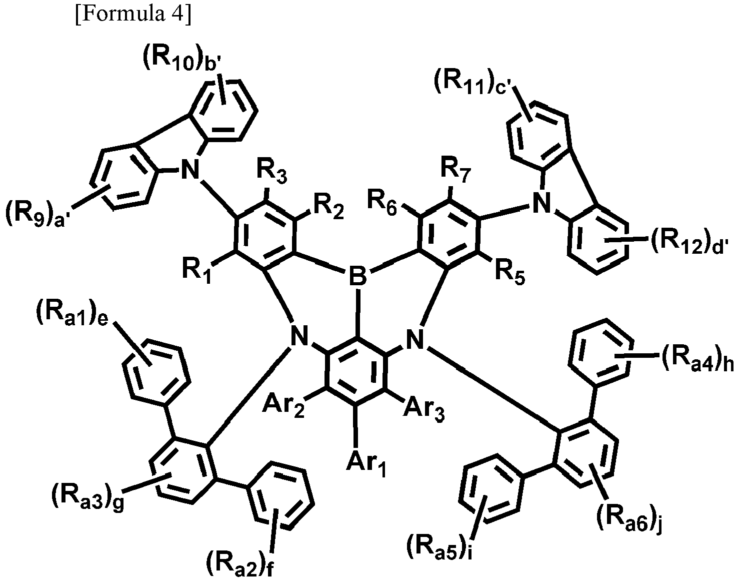

In Formula 4, R₁₁ and R₁₂ may each independently be a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring.

In Formula 4, a' to d' may each independently be an integer from 0 to 4. When a' is 2 or greater, multiple R₉ groups may be the same as or different from each other, and when b' is 2 or greater, multiple R₁₀ groups may be the same as or different from each other. When c' is 2 or greater, multiple Rn groups may be the same as or different from each other, and when d' is 2 or greater, multiple R₁₂ groups may be the same as or different from each other.

In Formula 4, Ar₁ to Ar₃, R₁ to R₃, R₅ to R₇, R₉, R₁₀, Rₐ₁ to Rₐ₆, and e to j are the same as defined in Formulas 1 and 2.

In the fused polycyclic compound of an embodiment, Ar₁ to Ar₃ may each independently be a hydrogen atom or a deuterium atom.

In the fused polycyclic compound of an embodiment, Ar₁ may be a substituted or unsubstituted aryl group having 6 to 60 ring-forming carbon atoms, or a substituted or unsubstituted heteroaryl group having 2 to 60 ring-forming carbon atoms, and Ar₂ and Ar₃ may each independently be a hydrogen atom or a deuterium atom.

In the fused polycyclic compound of an embodiment, Ar₁ may be a substituted or unsubstituted alkyl group having 1 to 20 carbon atoms, and Ar₂ and Ar₃ may each independently be a hydrogen atom or a deuterium atom.

In the fused polycyclic compound of an embodiment, Ar₁ may be a substituted or unsubstituted silyl group having 1 to 20 carbon atoms, and Ar₂ and Ar₃ may each independently be a hydrogen atom or a deuterium atom.

In an embodiment, the fused polycyclic compound represented by Formula 3-1 may be represented by Formula 5.

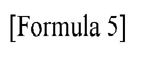

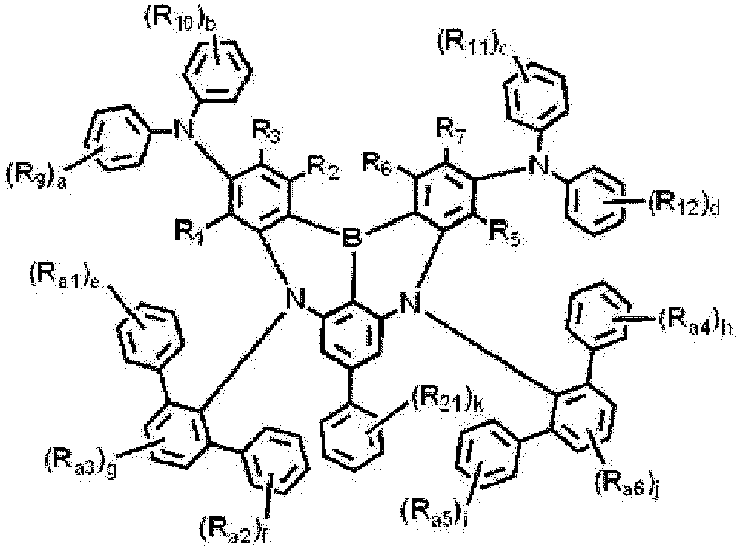

In Formula 5, R₂₁ may be a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring,

In Formula 5, k may be an integer from 0 to 5.When k is 2 or greater, multiple R₂₁ groups may be the same as or different from each other.

In Formula 5, R₁ to R₃, R₅ to R₇, R₉ to R₁₂, Rₐ₁ to Rₐ₆, and a to j are the same as defined in Formula 3-1.

In an embodiment, the fused polycyclic compound represented by Formula 3-2 may be represented by Formula 6-1 or Formula 6-2.

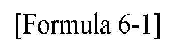

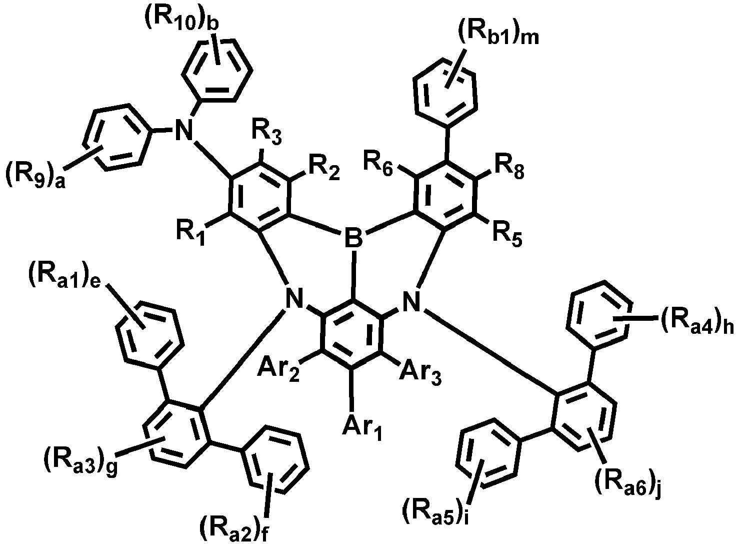

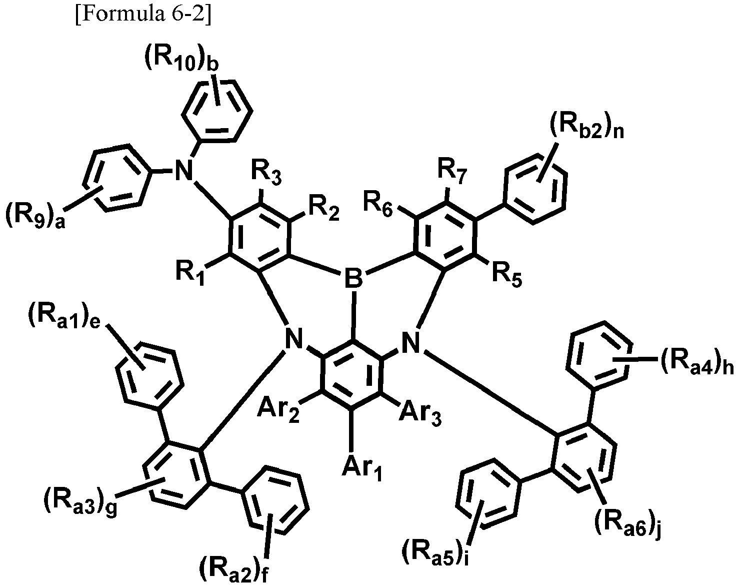

In Formulas 6-1 and 6-2, R_{b1} and R_{b2} may each independently be a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or may be bonded to an adjacent group to form a ring.

In Formulas 6-1 and 6-2, m and n may each independently be an integer from 0 to 5. When m is 2 or greater, multiple R_{b1} groups may be the same as or different from each other, and when n is 2 or greater, multiple R_{b2} groups may be the same as or different from each other.

In Formulas 6-1 and 6-2, Ar₁ to Ar₃, R₁ to R₃, R₅ to R₁₀, Rₐ₁ to Rₐ₆, a, b, and e to j are the same as defined in Formula 3-2.

The fused polycyclic compound of an embodiment may be any one selected from Compound Group 1. The emission layer EML of the organic electroluminescence device ED according to an embodiment may include at least one selected from Compound Group 1.

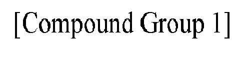

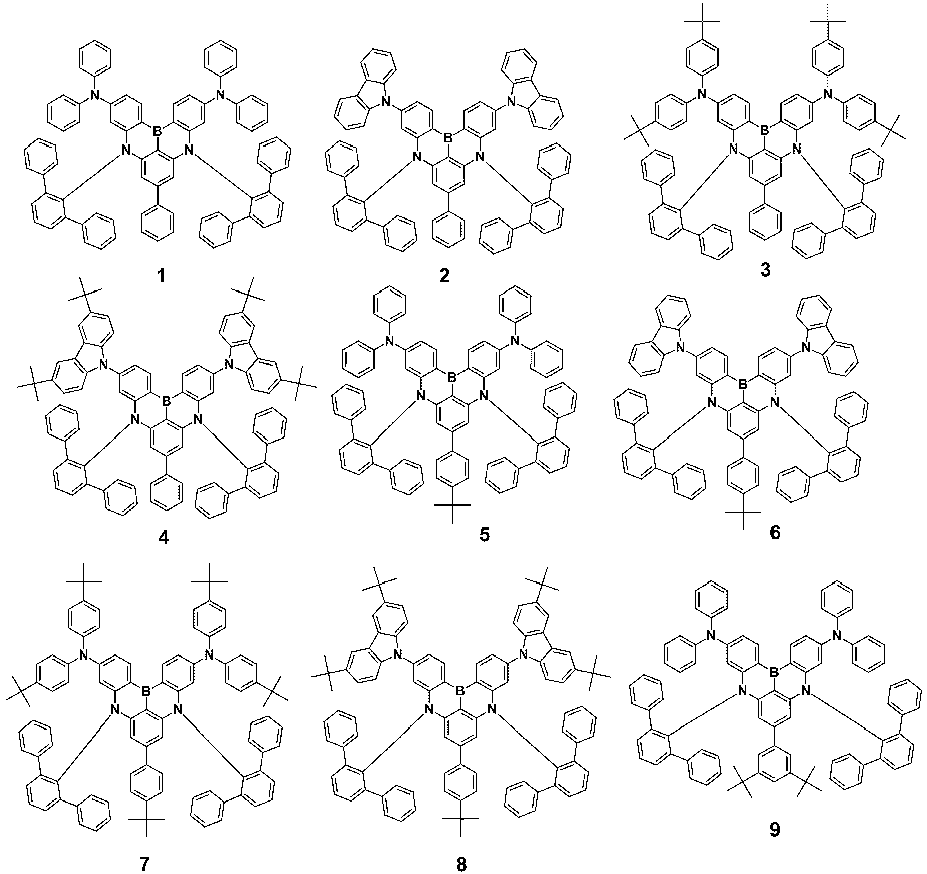

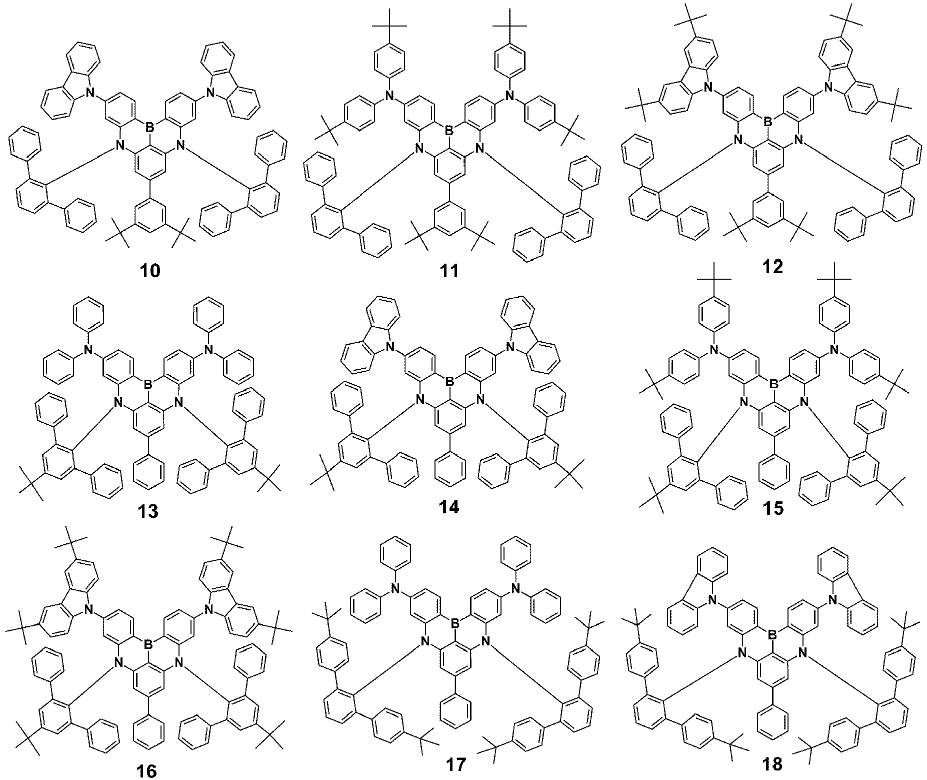

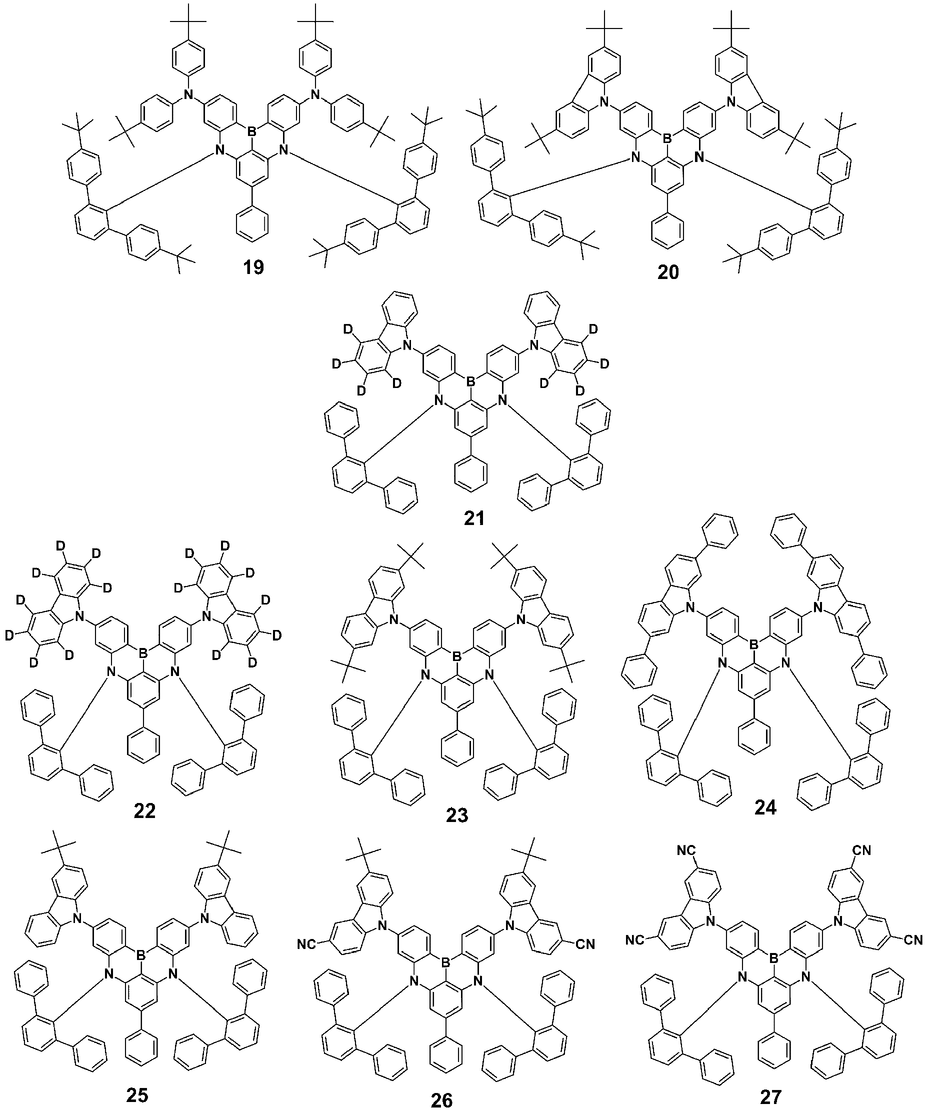

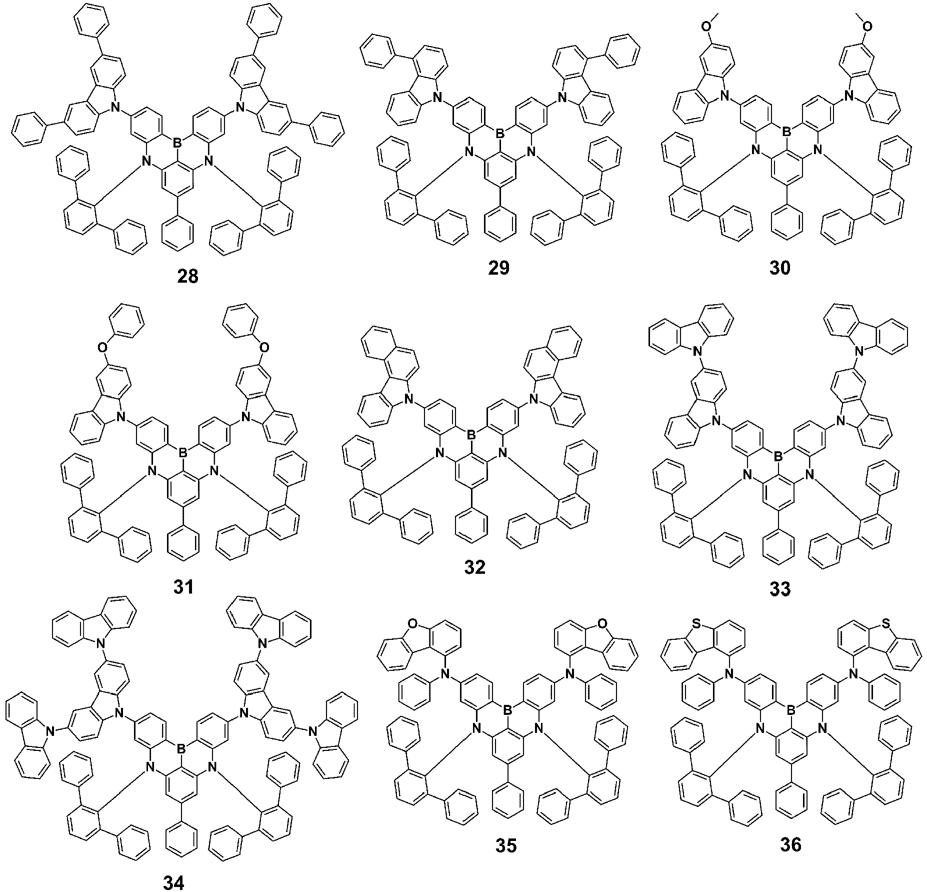

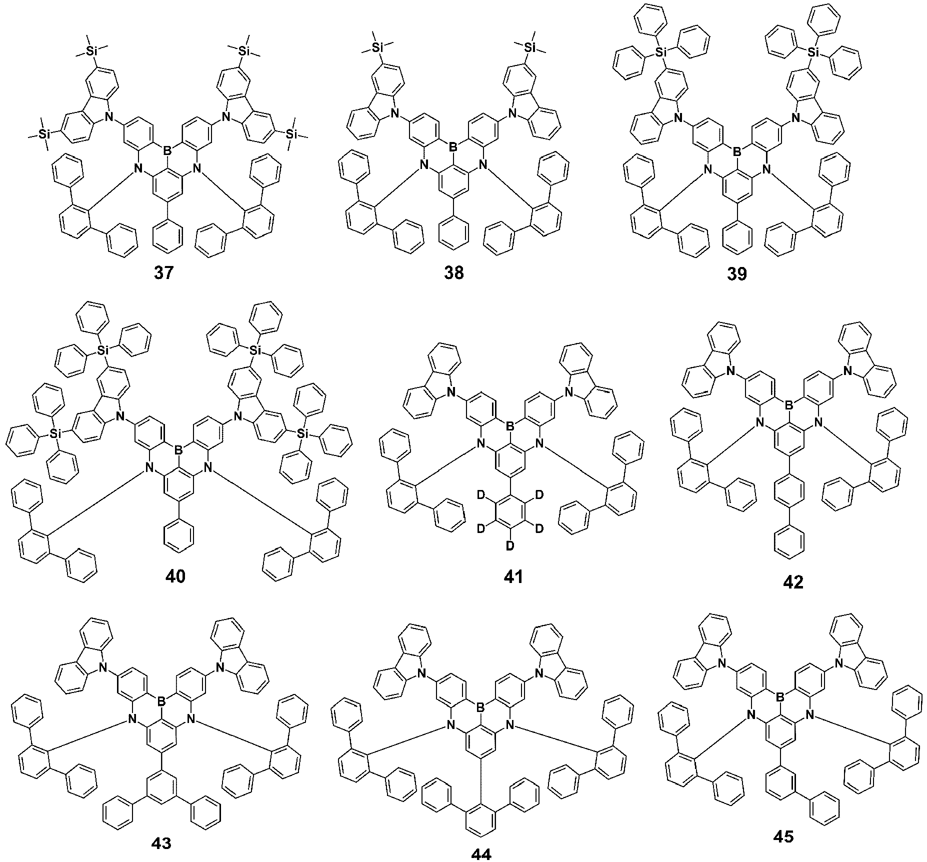

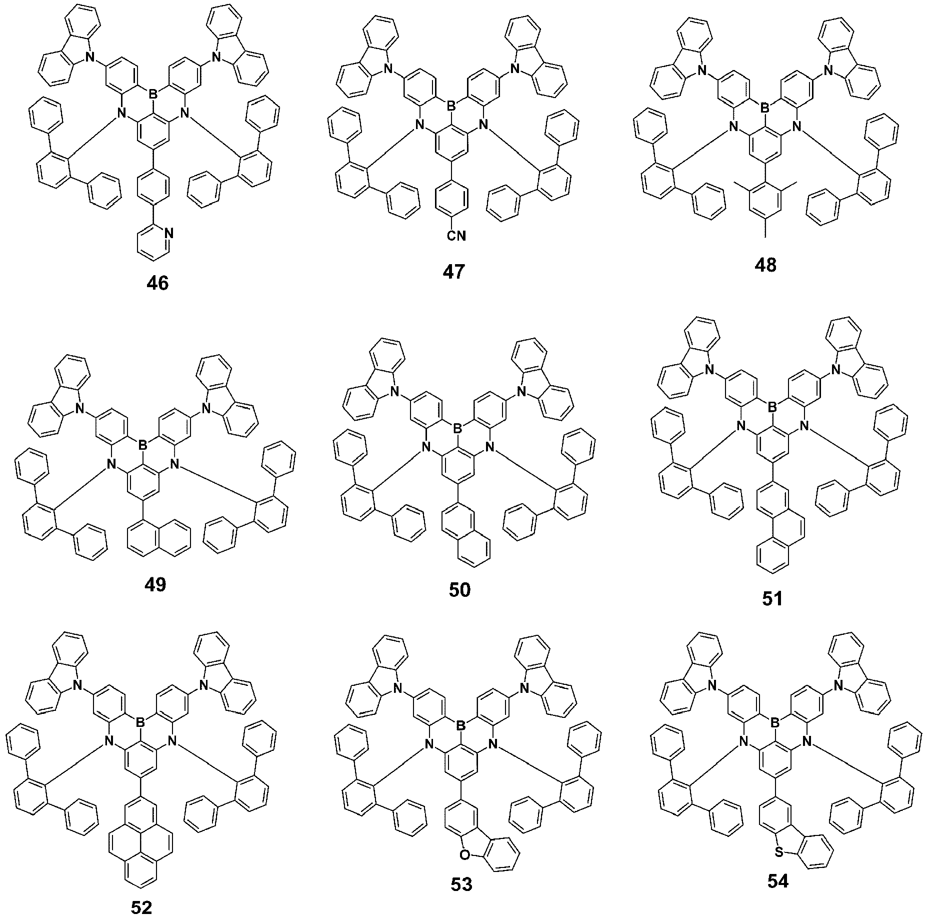

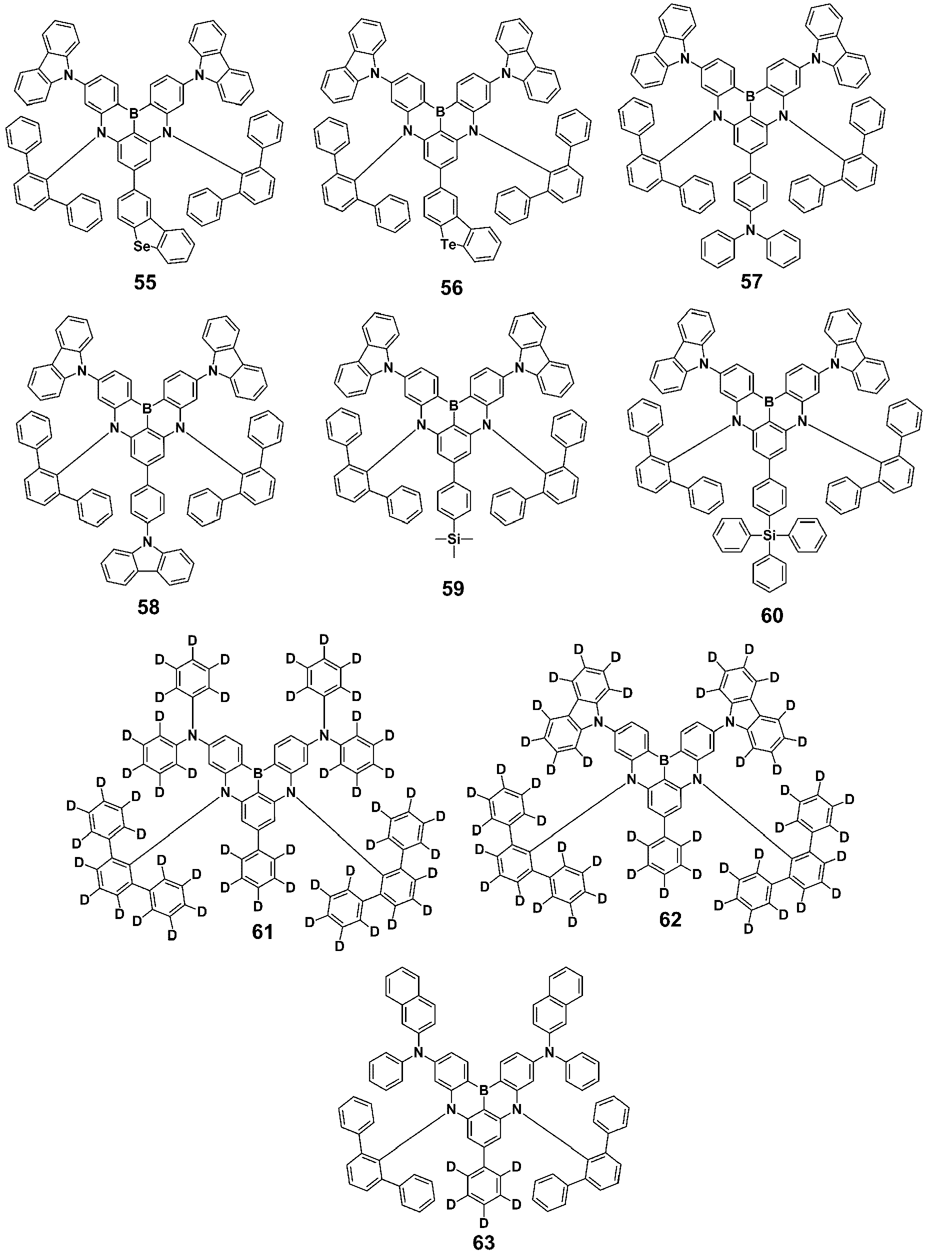

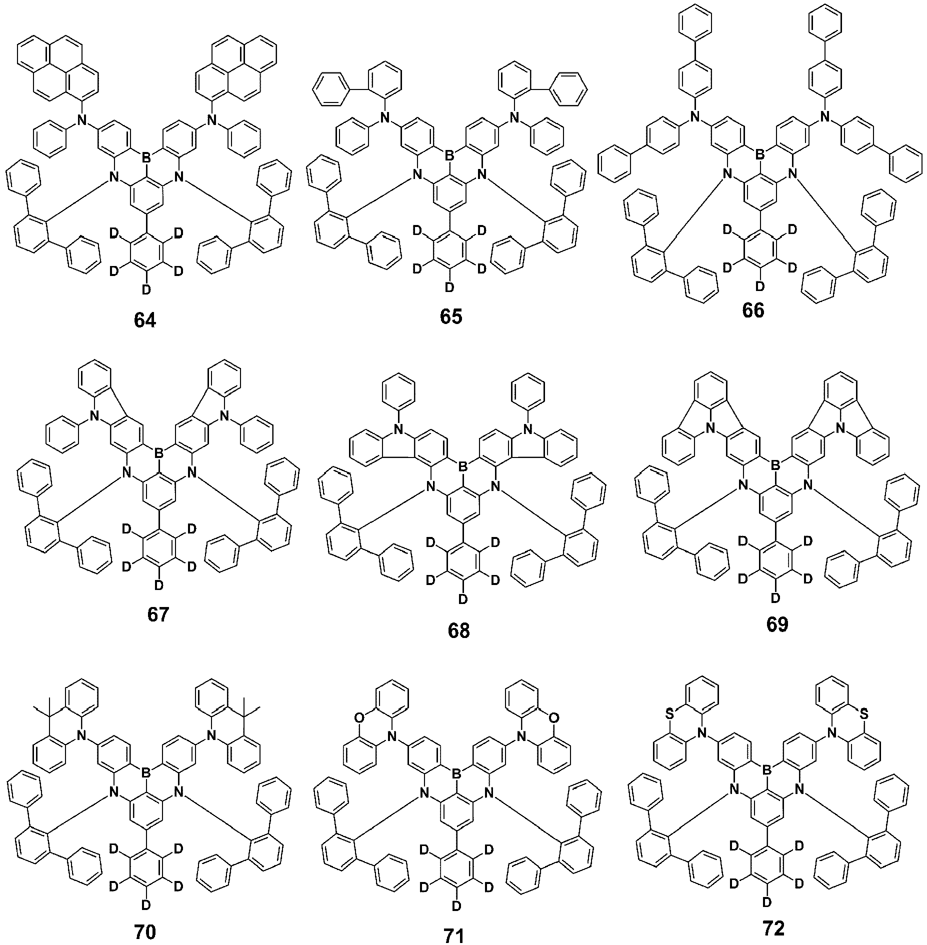

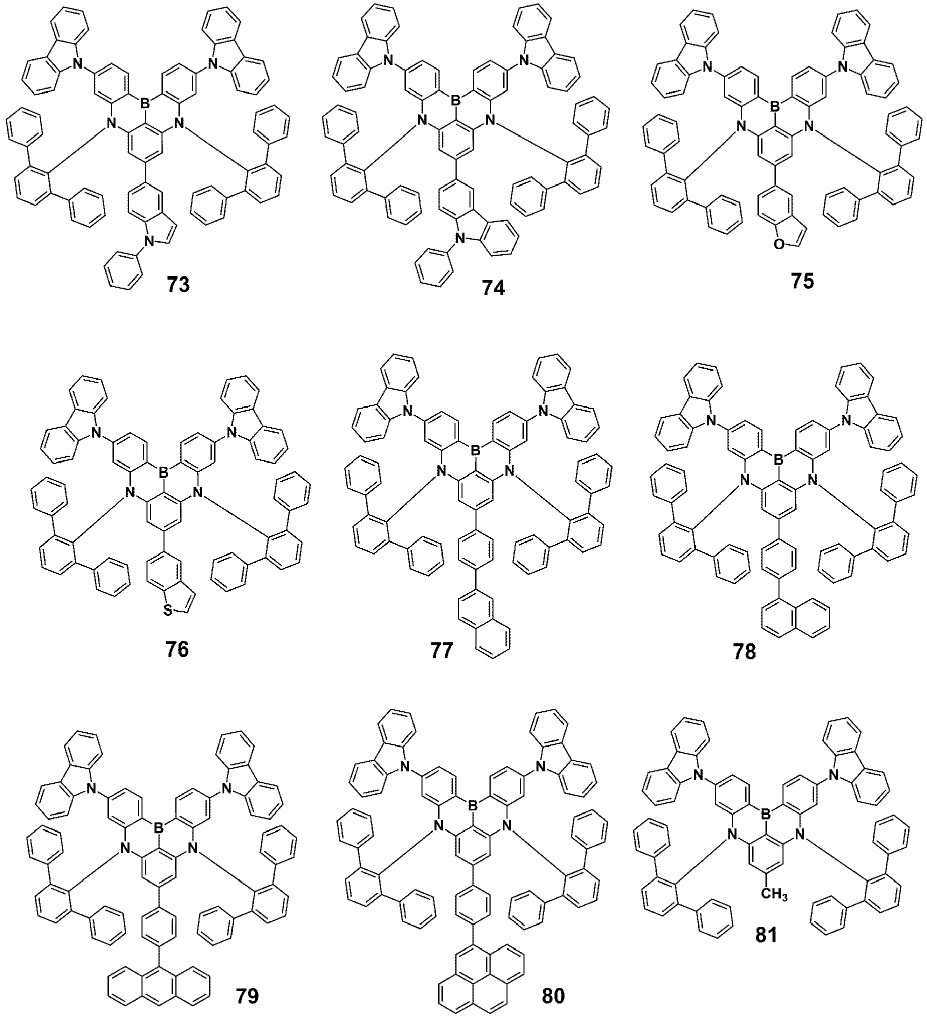

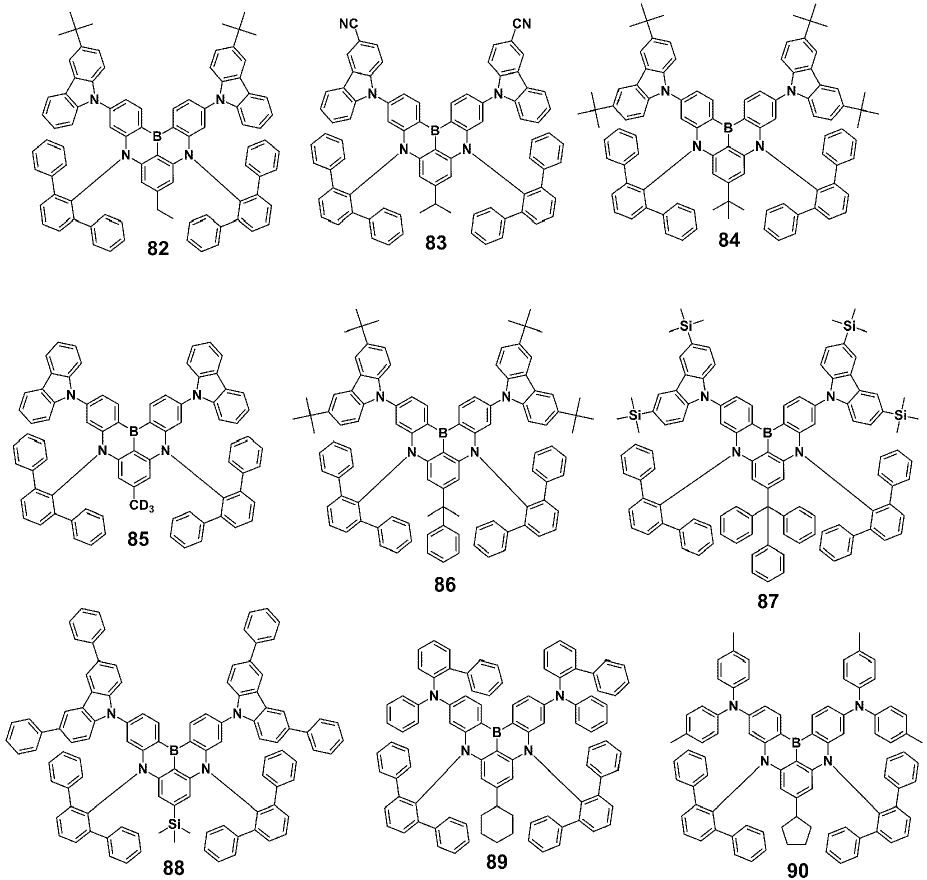

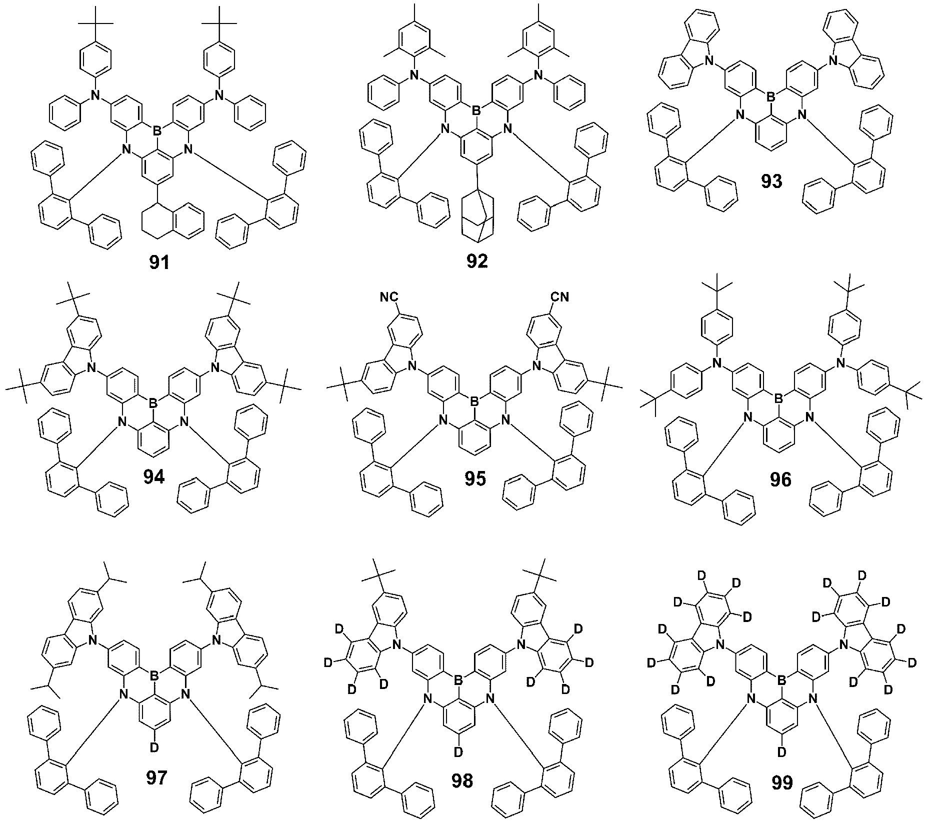

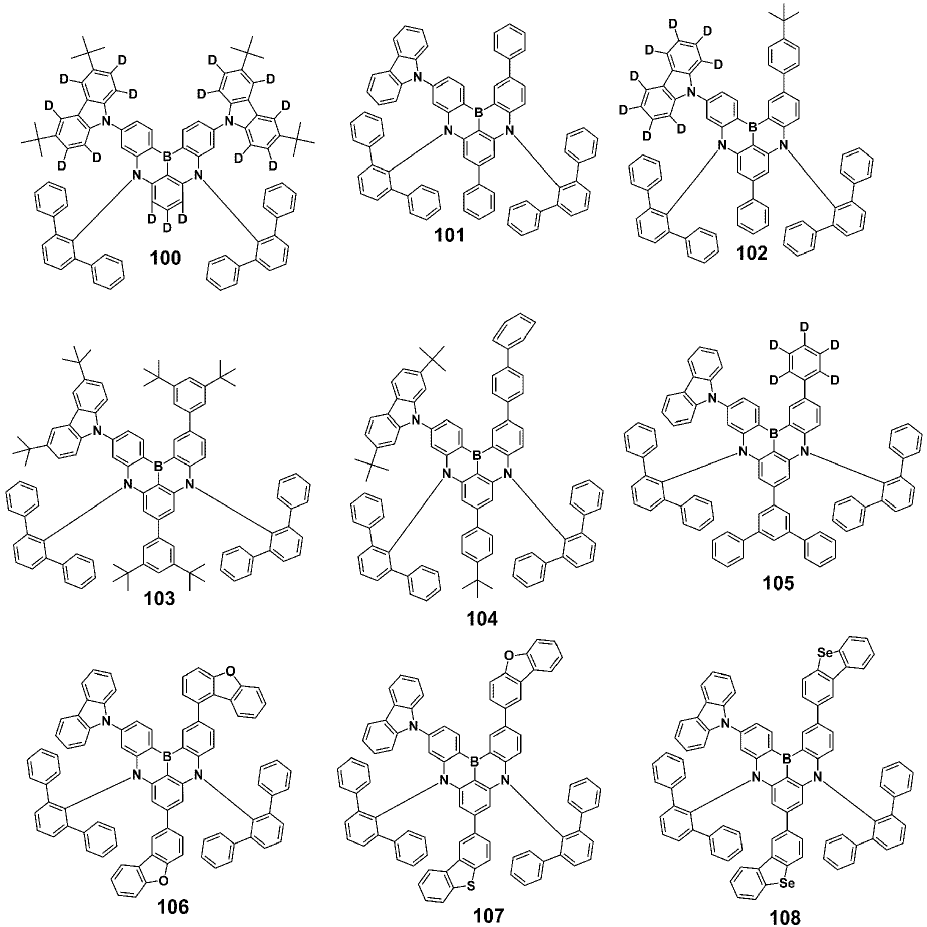

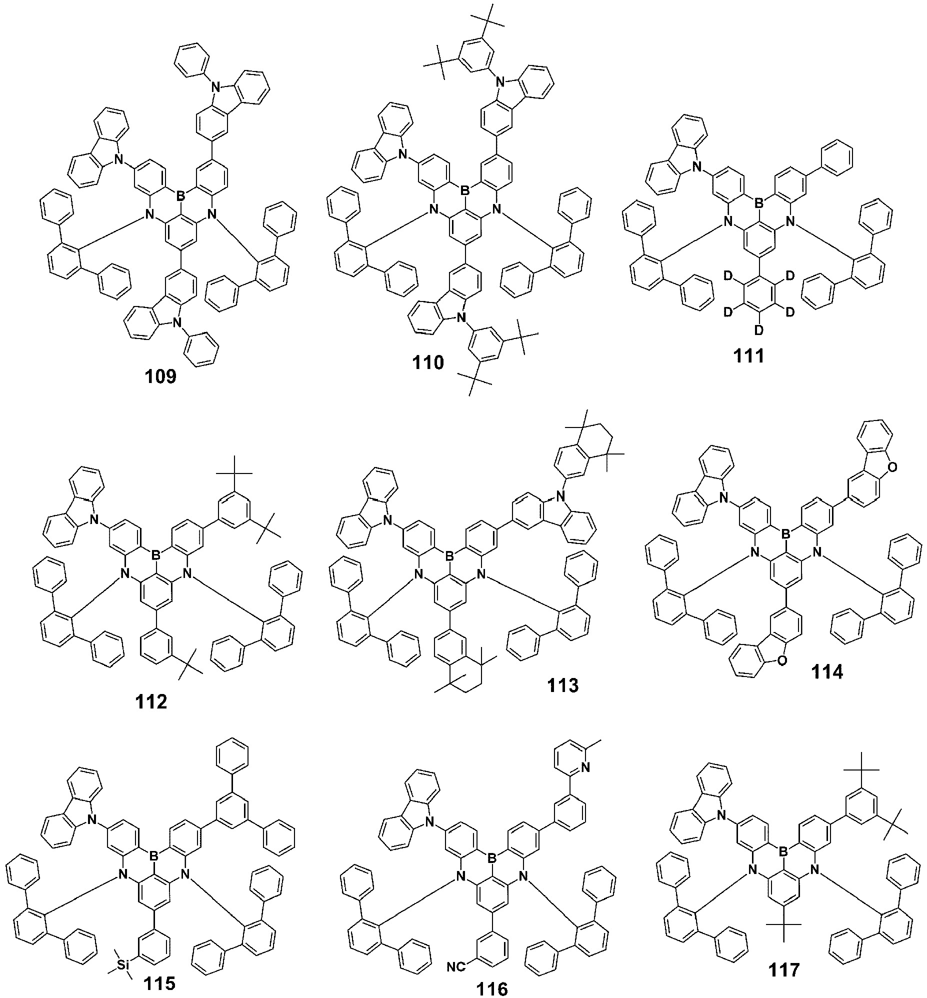

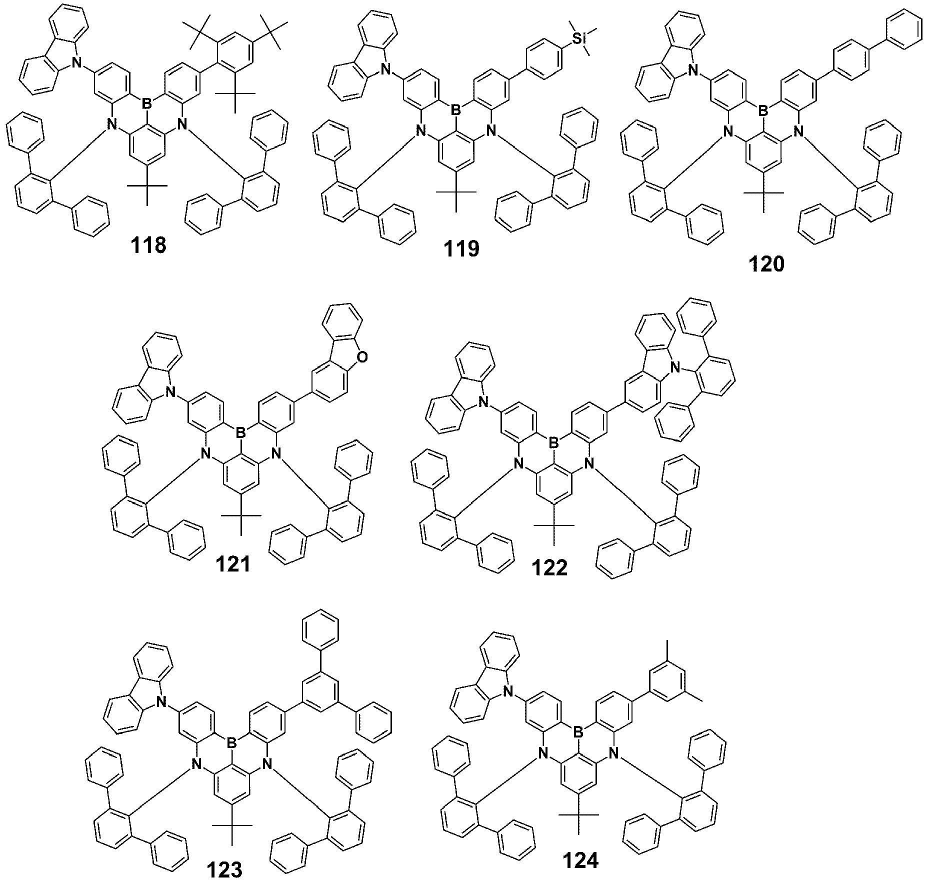

The fused polycyclic compound of an embodiment represented by Formula 1 may be a thermally activated delayed fluorescence emitting material. The fused polycyclic compound of an embodiment represented by Formula 1 may be used as a light emitting dopant material. For example, the fused polycyclic compound of an embodiment represented by Formula 1 may be a thermally activated delayed fluorescence dopant having a difference ΔE_{ST} between a lowest triplet excitation energy level (T1 level) and a lowest singlet excitation energy level (S1 level) equal to or less than about 0.2 eV. However, embodiments are not limited thereto, and the fused polycyclic compound of an embodiment represented by Formula 1 may be a phosphorescent light emitting material. The fused polycyclic compound of an embodiment represented by Formula 1 may be a phosphorescent dopant.

The fused polycyclic compound of an embodiment represented by Formula 1 may be a material that emits blue light. The blue light may refer to, for example, light in a wavelength range of about 430 nm to about 490 nm. For example, the fused polycyclic compound of an embodiment represented by Formula 1 may be a blue thermally activated delayed fluorescence (TADF) dopant. However, embodiments are not limited thereto, and when the fused polycyclic compound of an embodiment is used as a light emitting material, the fused polycyclic compound may be used as a dopant material emitting light in various wavelength ranges, such as a red light emitting dopant or a green light emitting dopant. In another embodiment, the fused polycyclic compound of an embodiment represented by Formula 1 may be a host or a fluorescent dopant.

The fused polycyclic compound as provided herein may be used in the organic electroluminescence device ED according to an embodiment to increase the efficiency and lifespan of the organic electroluminescence device. For example, the fused polycyclic compound as provided herein may be used in the emission layer EML of the organic electroluminescence device ED according to an embodiment to increase the luminous efficiency and lifespan of the organic electroluminescence device.

In the organic electroluminescence device ED according to an embodiment, the emission layer EML further includes a first host and a second host. In an embodiment, the first host and the second host may be different from each other. In an embodiment, the first host may be a hole transporting host, and the second host may be an electron transporting host.

In an embodiment, the hole transporting first host and the electron transporting second host may each independently be represented by Formula E.

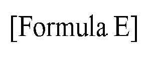

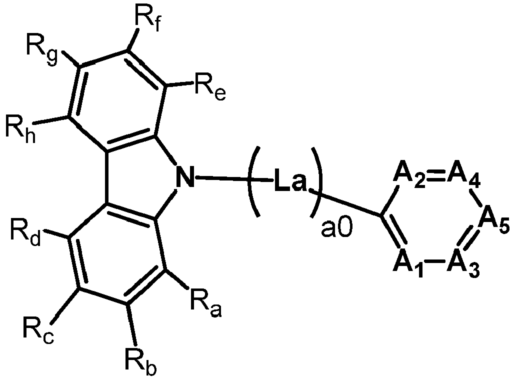

In Formula E, a0 may be an integer from 0 to 10; and La may be a direct linkage, a substituted or unsubstituted arylene group having 6 to 30 ring-forming carbon atoms, or a substituted or unsubstituted heteroarylene group having 2 to 30 ring-forming carbon atoms. When a0 is 2 or greater, multiple La groups may each independently be a substituted or unsubstituted arylene group having 6 to 30 ring-forming carbon atoms, or a substituted or unsubstituted heteroarylene group having 2 to 30 ring-forming carbon atoms.

In Formula E, A₁ to As may each independently be N or C(Rᵢ). In Formula E, Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. Rₐ to Rᵢ may be bonded to an adjacent group to form a hydrocarbon ring or a heterocycle containing N, O, S, etc. as a ring-forming atom.

In Formula E, two or three of A₁ to As may be N, and the remainder of A₁ to As may be C(Rᵢ).

The organic electroluminescence device ED according to an embodiment may include, as the hole transporting first host, at least one selected from Compound Group HT in the emission layer EML.

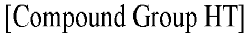

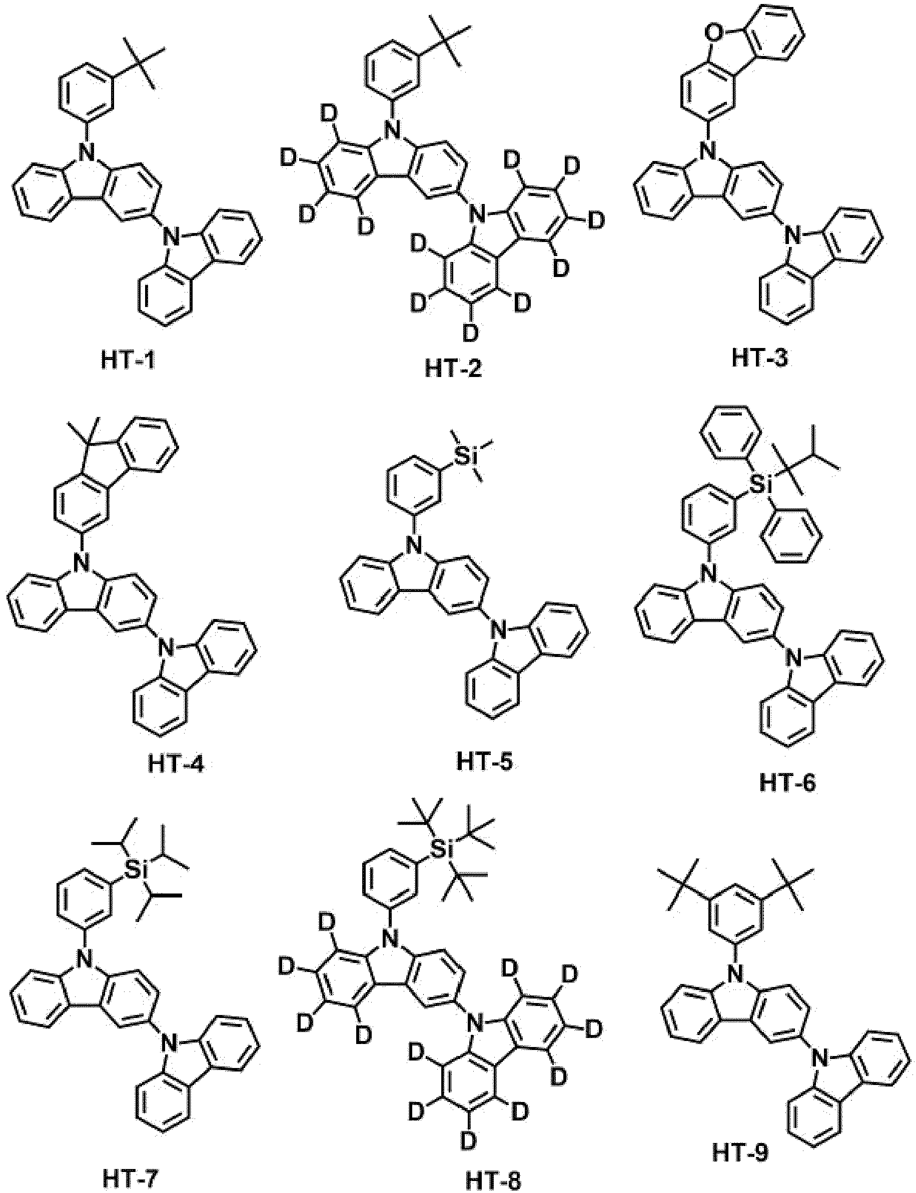

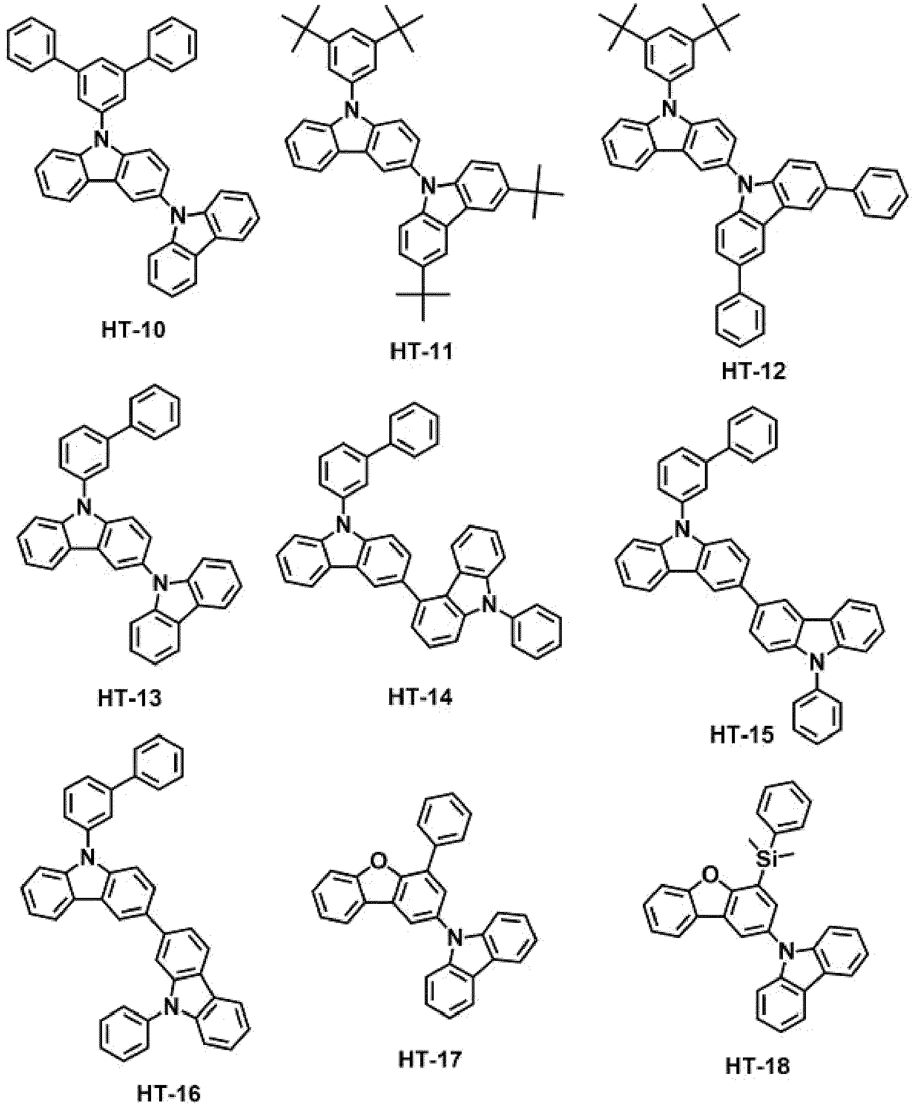

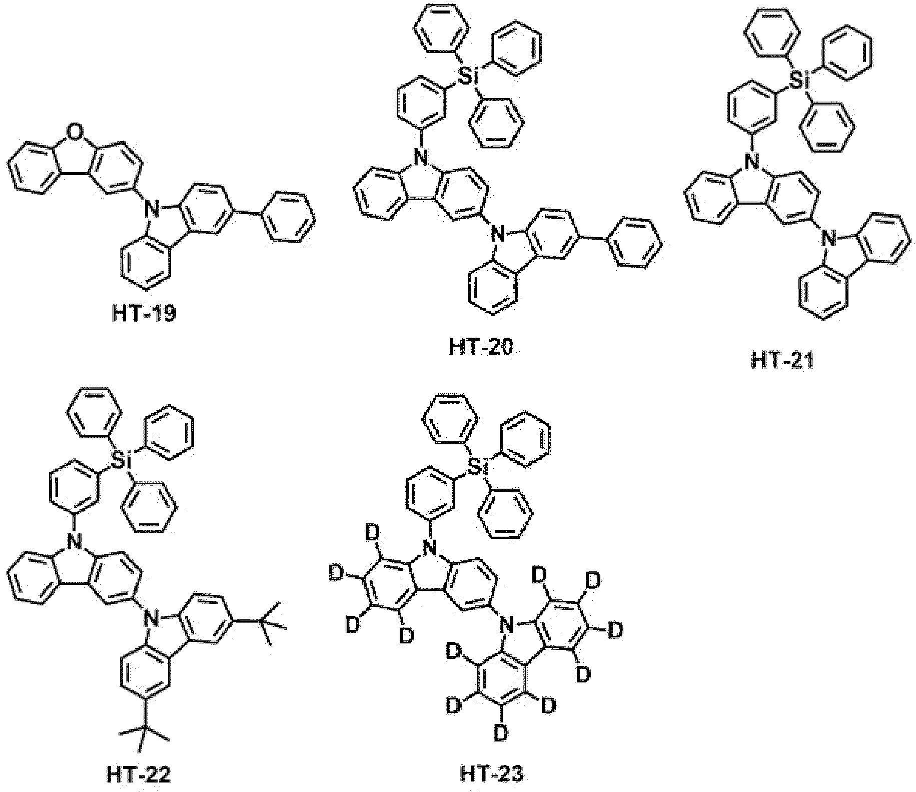

The organic electroluminescence device ED according to an embodiment may include, as the electron transporting second host, at least one selected from Compound Group ET in the emission layer EML.

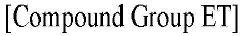

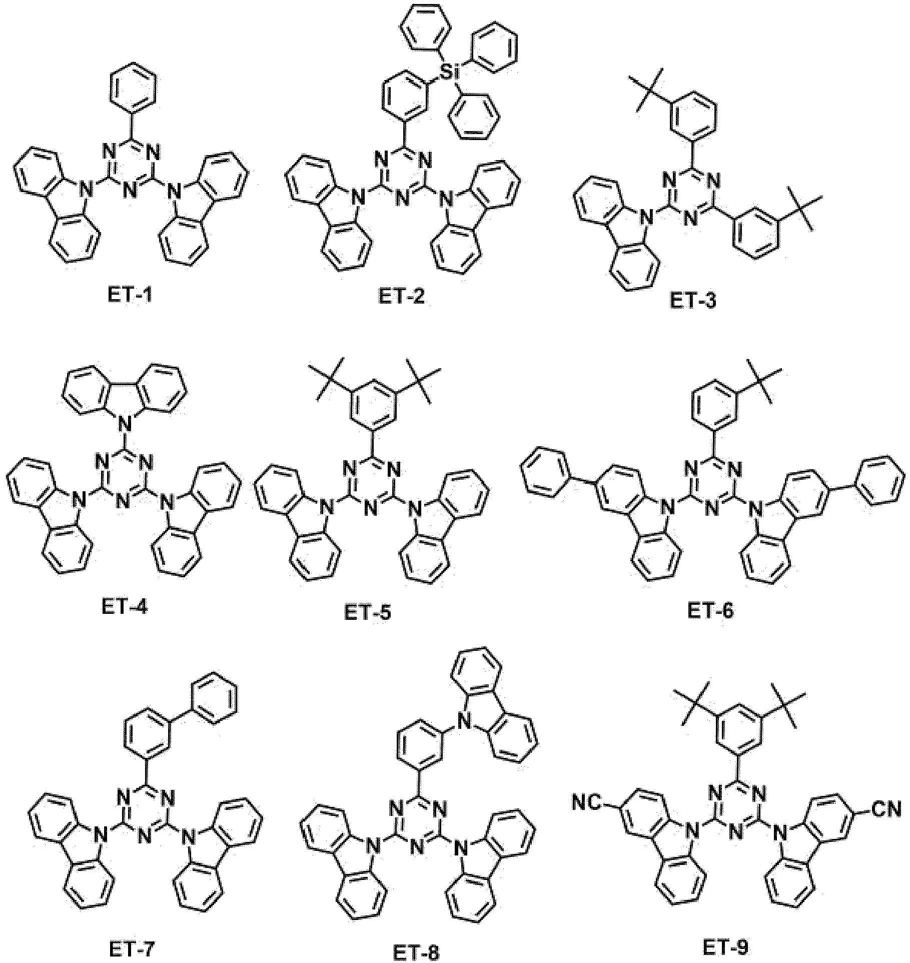

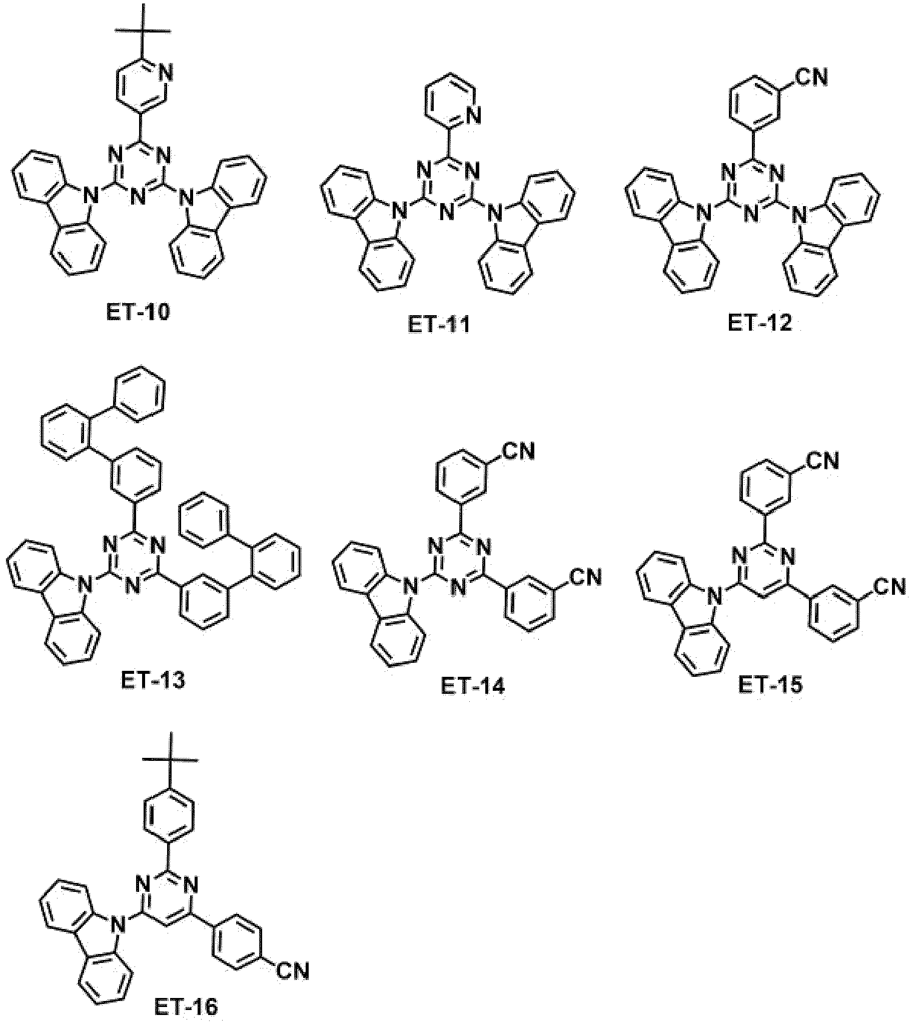

In the organic electroluminescence device ED of an embodiment, the emission layer EML may further include a sensitizer. In an embodiment, the sensitizer may include an organometallic complex. The sensitizer included in the emission layer EML may serve as an auxiliary dopant, and may be a phosphorescent sensitizer. In the organic electroluminescence device ED according to an embodiment, the sensitizer included in the emission layer EML may transfer energy to the light emitting dopant to increase the rate at which the light emitting dopant emits fluorescence.

The organometallic complex according to an embodiment may be represented by Formula M-b.

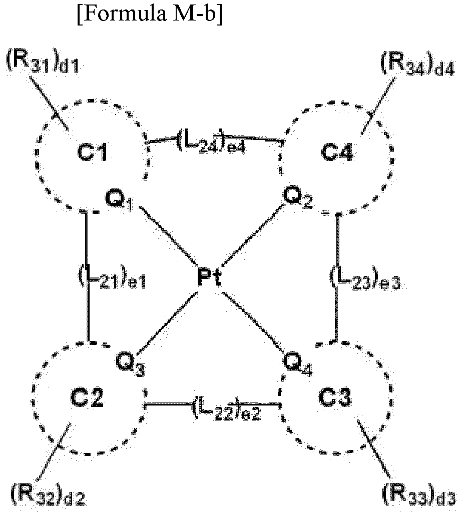

In Formula M-b, Q₁ to Q₄ may each independently be C or N; and C1 to C4 may each independently be a substituted or unsubstituted hydrocarbon ring having 5 to 30 ring-forming carbon atoms, or a substituted or unsubstituted heterocycle having 2 to 30 ring-forming carbon atoms. In Formula M-b, L₂₁ to L₂₄ may each independently be a direct linkage, 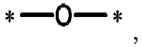 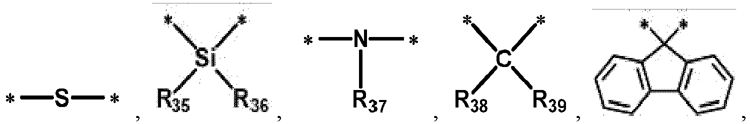 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms; and e1 to e4 may each independently be 0 or 1. In Formula M-b, R₃₁ to R₃₉ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring; and d1 to d4 may each independently be an integer from 0 to 4.

In an embodiment, the organometallic complex represented by Formula M-b may include at least one selected from Compound Group PS.

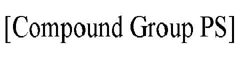

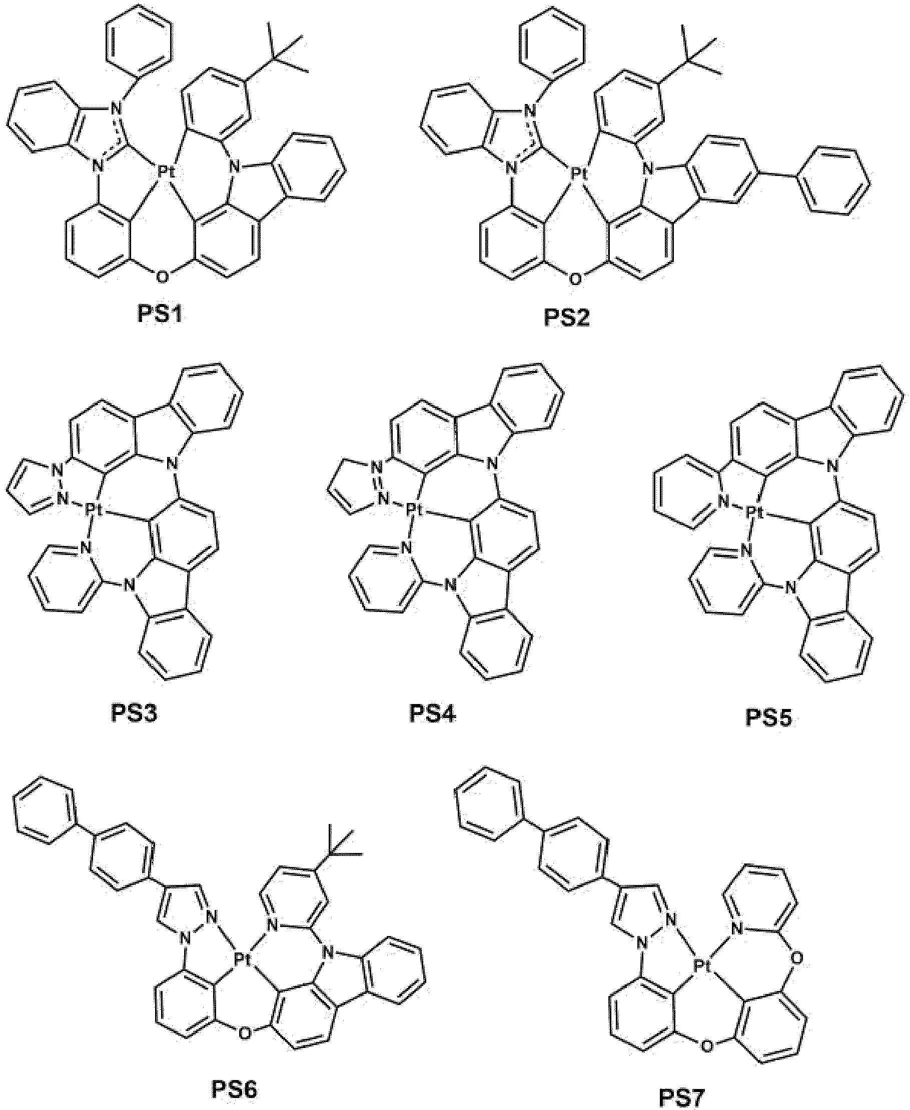

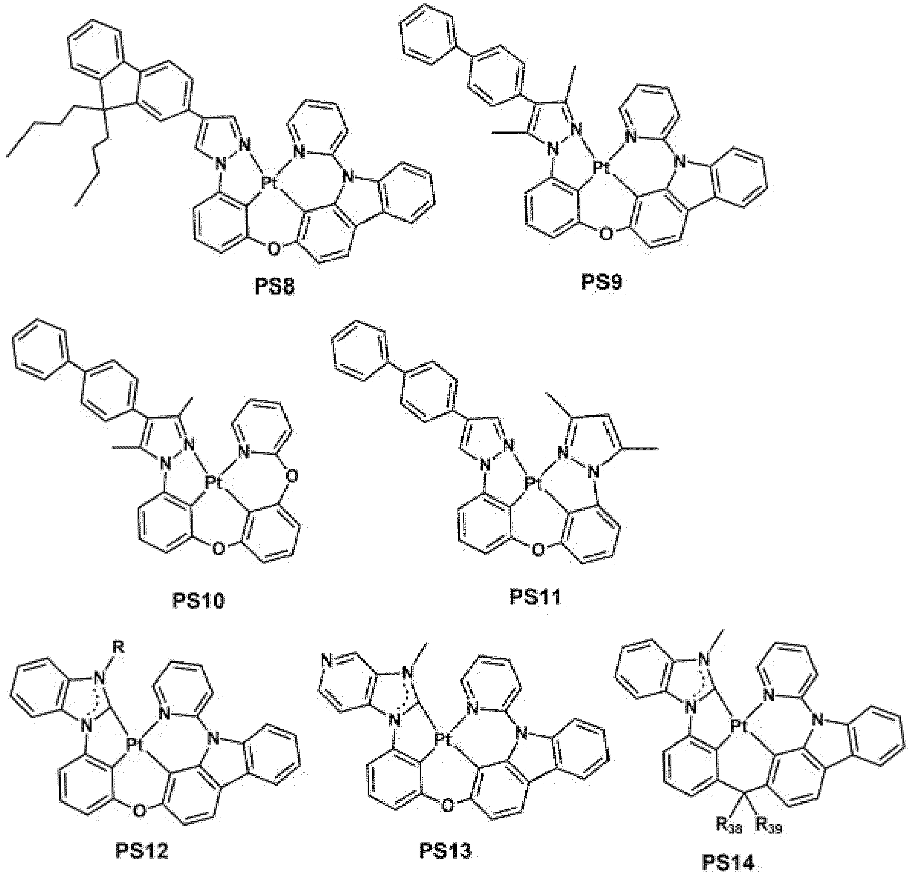

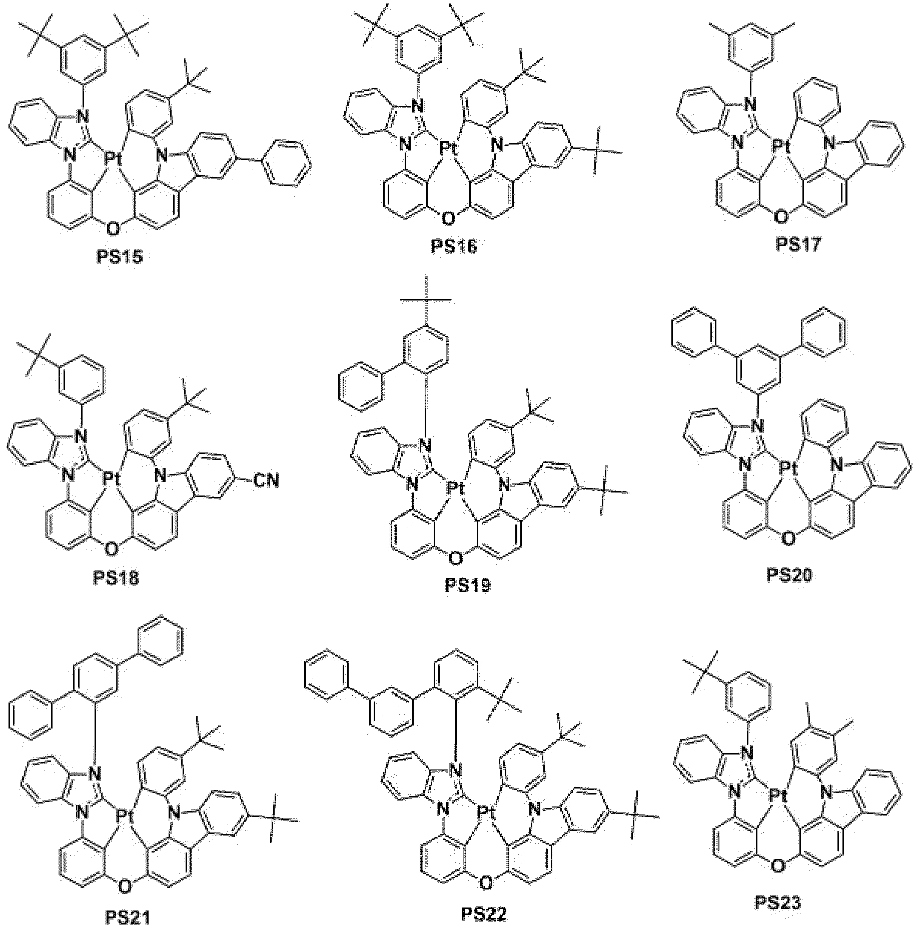

In Compound Group PS, R, R₃₈, and R₃₉ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

The organic electroluminescence device ED according to an embodiment may include multiple emission layers. The emission layers may be sequentially stacked and provided, and as an example, the organic electroluminescence device ED including multiple emission layers may emit white light. The organic electroluminescence device including multiple emission layers may be an organic electroluminescence device having a tandem structure. When the organic electroluminescence device ED includes multiple emission layers, at least one emission layer EML may include the fused polycyclic compound according to an embodiment as described above.

In the organic electroluminescence device ED of an embodiment, the emission layer EML may include an anthracene derivative, a pyrene derivative, a fluoranthene derivative, a chrysene derivative, a dihydrobenzanthracene derivative, or a triphenylene derivative. For example, the emission layer EML may include an anthracene derivative or a pyrene derivative.

The emission layer EML may further include a host and a dopant, and the emission layer EML may include a compound represented by Formula E-1. The compound represented by Formula E-1 may be used as a fluorescent host material.

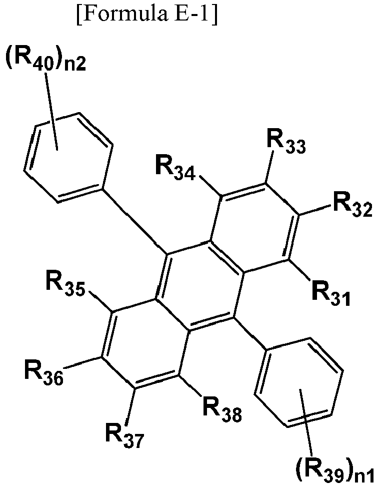

In Formula E-1, R₃₁ to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. For example, R₃₁ to R₄₀ may be bonded to an adjacent group to form a saturated hydrocarbon ring, an unsaturated hydrocarbon ring, a saturated heterocycle, or an unsaturated heterocycle.

In Formula E-1, n1 and n2 may each independently be an integer from 0 to 5.

The compound represented by Formula E-1 may be any one selected from Compounds E1 to E20.

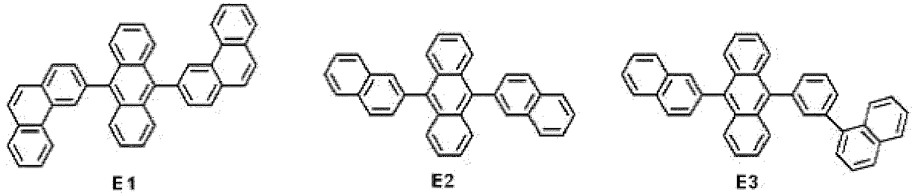

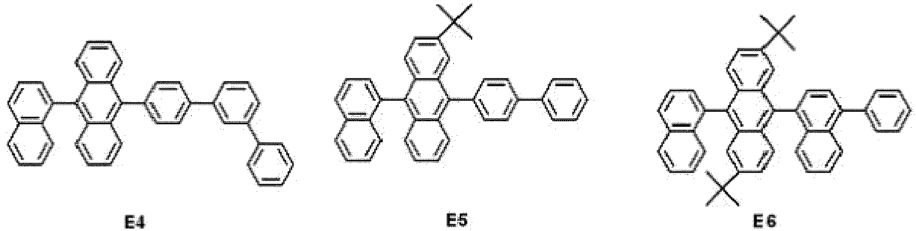

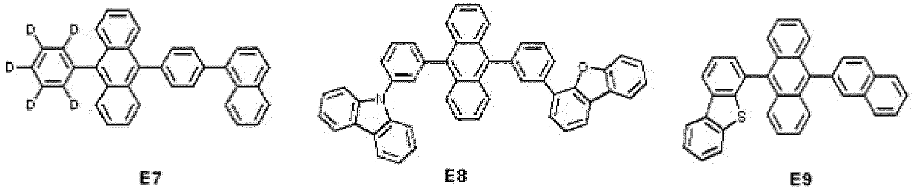

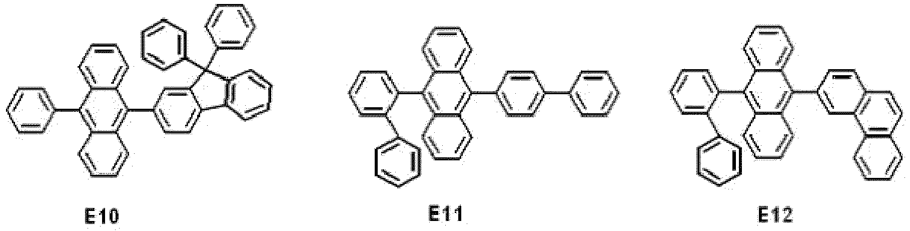

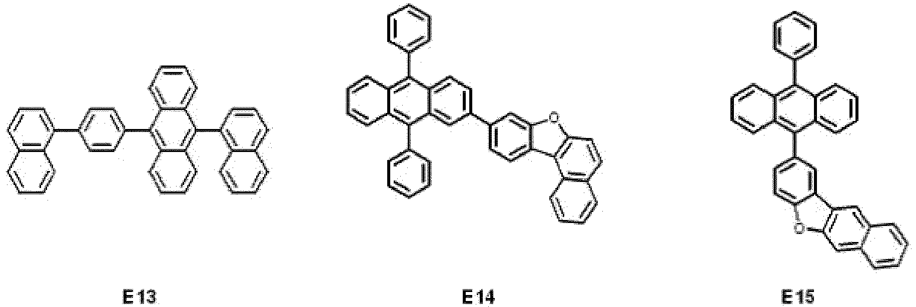

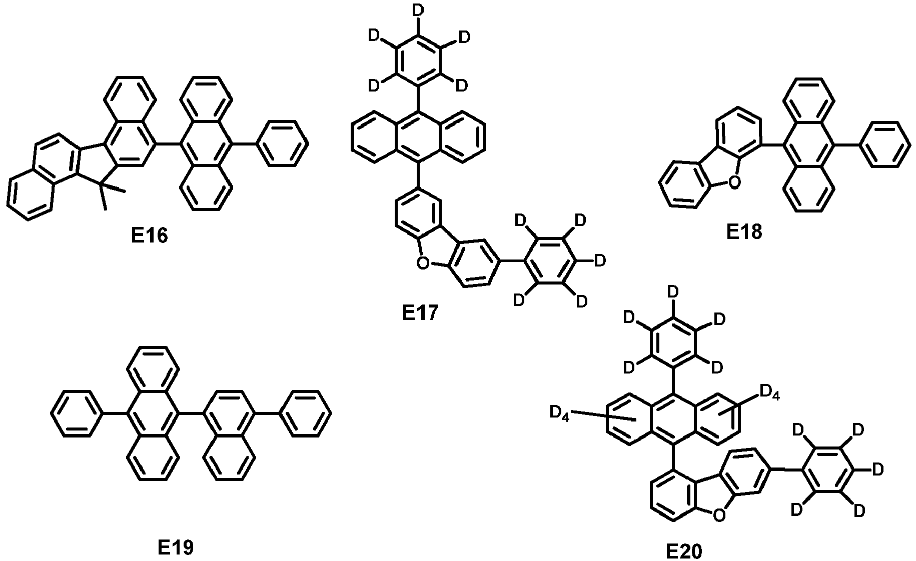

In an embodiment, the emission layer EML may further include a compound represented by Formula E-2b. The compound represented by Formula E-2b may be used as a fluorescent host material.

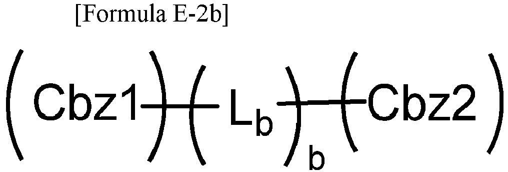

In Formula E-2b, Cbz1 and Cbz2 may each independently be a substituted or unsubstituted aryl group having 6 to 60 ring-forming carbon atoms or a substituted or unsubstituted heteroaryl group having 2 to 60 ring-forming carbon atoms. For example, Cbz1 and Cbz2 may each independently be an unsubstituted carbazole group or a carbazole group substituted with an aryl group having 6 to 30 ring-forming carbon atoms. In Formula E-2b, L_{b} may be a direct linkage, a substituted or unsubstituted arylene group having 6 to 30 ring-forming carbon atoms, or a substituted or unsubstituted heteroarylene group having 2 to 30 ring-forming carbon atoms. In Formula E-2b, b may be an integer from 0 to 10, and when b is 2 or greater, multiple L_{b} groups may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2b may be any one selected from Compound Group E-2. However, the compounds listed in Compound Group E-2 are only presented as examples, and the compound represented by Formula E-2b is not limited to those listed in Compound Group E-2.

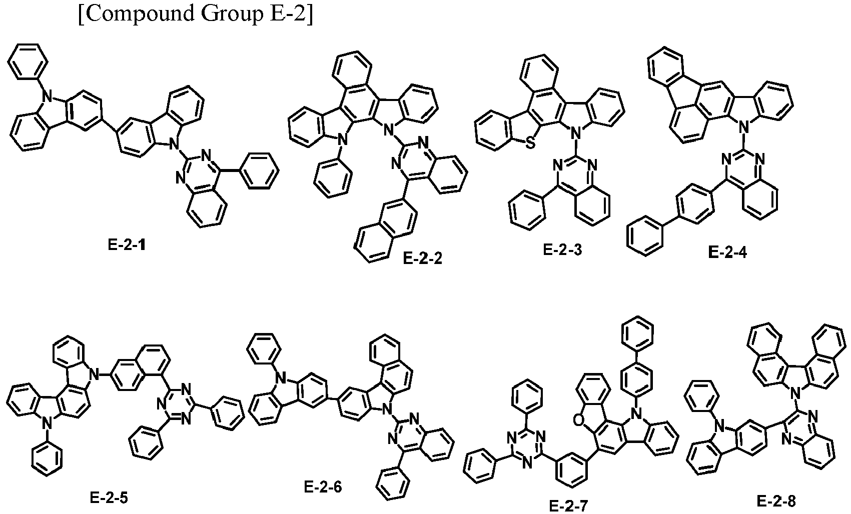

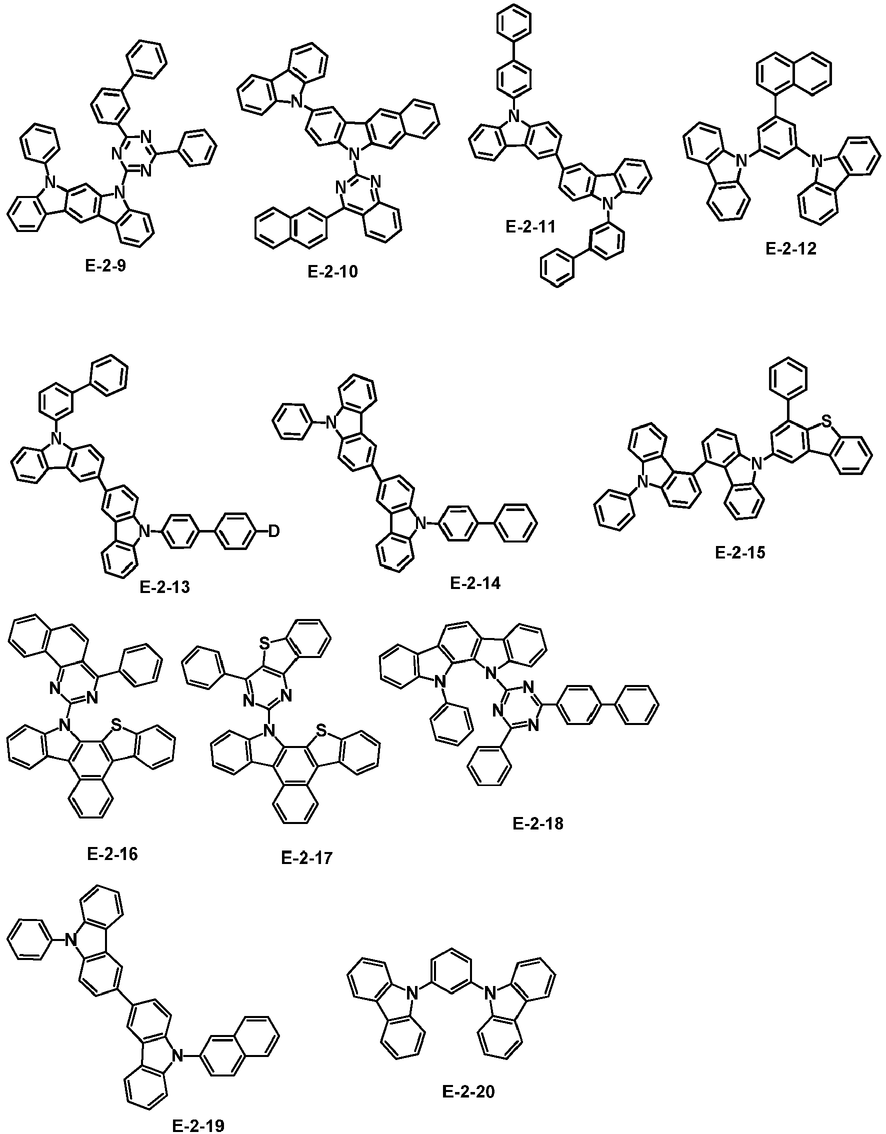

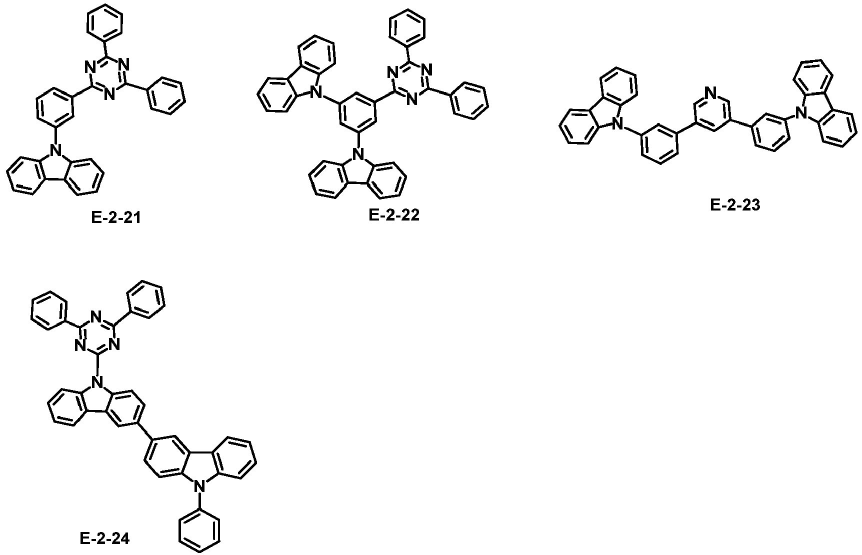

The emission layer EML may further include a material of the related art as a host material. For example, the emission layer EML may include, as a host material, at least one of bis[2-(diphenylphosphino)phenyl]ether oxide (DPEPO), 4,4'-bis(N-carbazolyl)-1,1'-biphenyl (CBP), 1,3-bis(carbazolyl-9-yl)benzene (mCP), 2,8-bis(diphenylphosphoryl)dibenzofuran (PPF), 4,4',4"-tris(carbazol-9-yl)- triphenylamine (TCTA), and 1,3,5-tris(1-phenyl-1H-benzo[d]imidazol-2-yl) benzene (TPBi). However, embodiments are not limited thereto, and for example, tris(8-hydroxyquinolino)aluminum (Alq₃), 9,10-di(naphthalene-2-yl)anthracene (ADN), 3-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetrasiloxane (DPSiO₄), etc. may be used as a host material.

The emission layer EML may include a compound represented by Formula M-a. The compound represented by Formula M-a may be used as a phosphorescent dopant material.

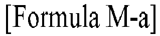

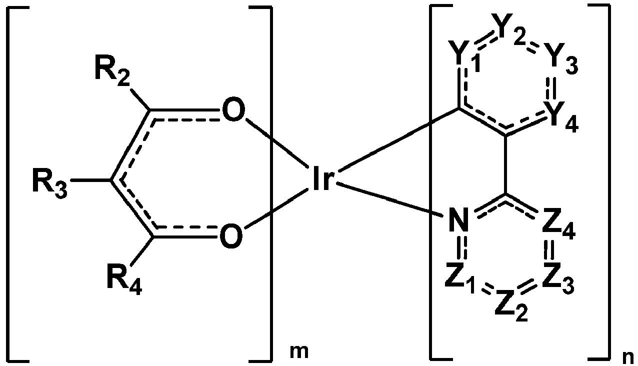

In Formula M-a, Y₁ to Y₄ and Z₁ to Z₄ may each independently be C(R₁) or N, and R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. In Formula M-a, m may be 0 or 1, and n may be 2 or 3. In Formula M-a, when m is 0, n may be 3, and when m is 1, n may be 2.

The compound represented by Formula M-a may be used as a phosphorescent dopant.

The compound represented by Formula M-a may be any one selected from Compounds M-a1 to M-a25. However, Compounds M-a1 to M-a25 are only examples, and the compound represented by Formula M-a is not limited to Compounds M-a1 to M-a25.

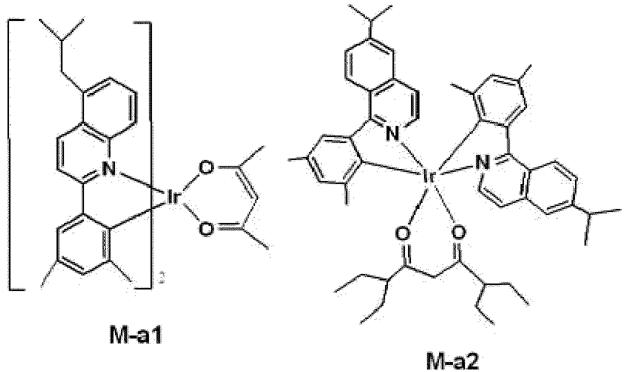

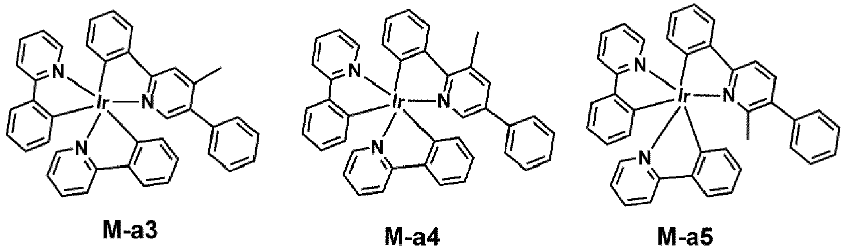

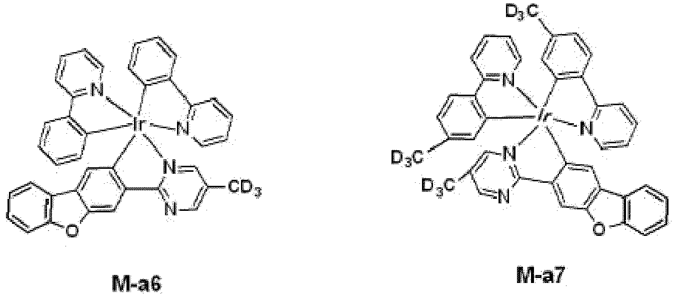

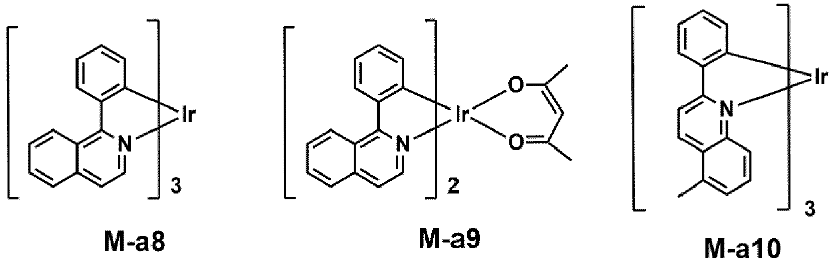

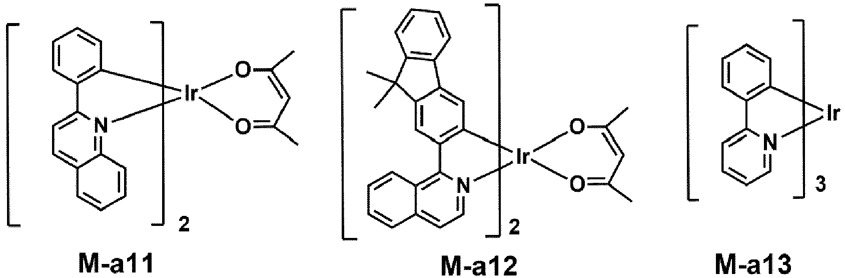

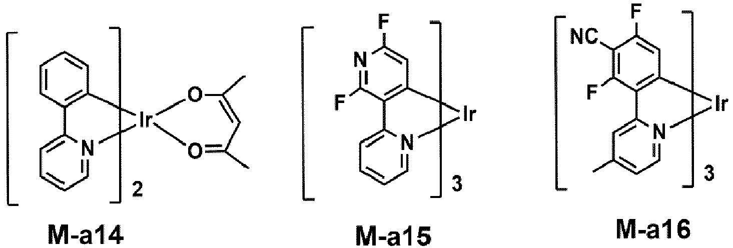

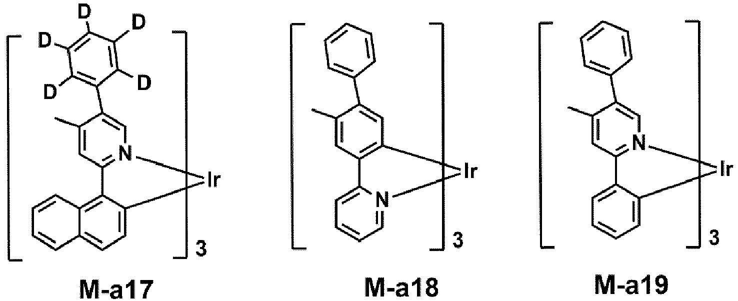

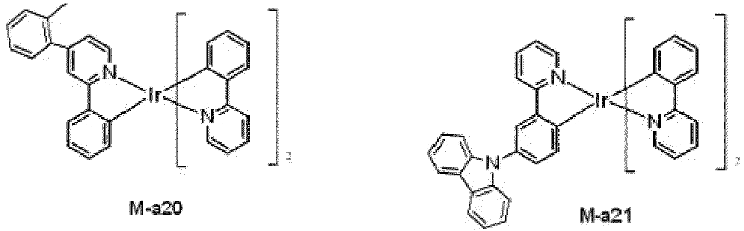

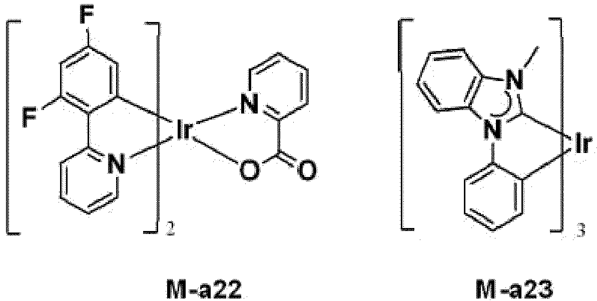

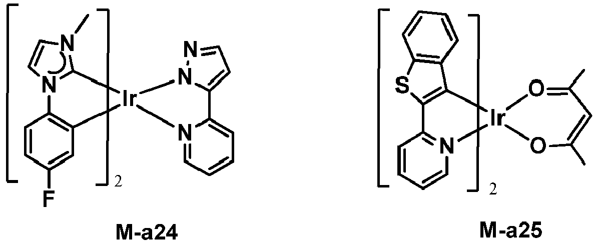

Compounds M-a1 and M-a2 may be used as red dopant materials and Compounds M-a3 to M-a7 may be used as green dopant materials.

The emission layer EML may include a compound represented by any one of Formulas F-a or F-b. The compounds represented by Formulas F-a or F-b may be used as a fluorescent dopant material.

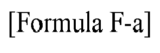

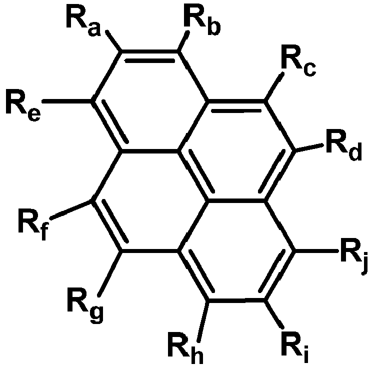

In Formula F-a, two of Rₐ to Rⱼ may each independently be substituted with a group represented by *-NAr₁Ar₂. The remainder of Rₐ to Rⱼ which are not substituted with the group represented by *-NAr₁Ar₂ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In the group represented by *-NAr₁Ar₂, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. For example, at least one of Ar₁ or Ar₂ may each independently be a heteroaryl group containing O or S as a ring-forming atom.

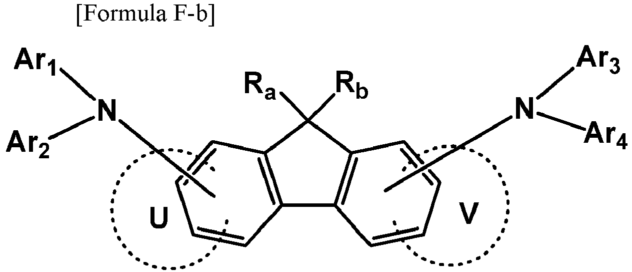

In Formula F-b, Rₐ and R_{b} may each independently be a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form a ring. In Formula F-b, An to Ar₄ may each independently be a substituted or unsubstituted aryl group having 6 to 30 ring-forming carbon atoms, or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms, or a substituted or unsubstituted heterocycle having 2 to 30 ring-forming carbon atoms.

In Formula F-b, the number of rings represented by U and V may each independently be 0 or 1. For example, in Formula F-b, when the number of U or V is 1, a fused ring may be present at a portion indicated by U or V, and when the number of U or V is 0, a fused ring may not be present at a portion indicated by U or V. When the number of U is 0 and the number of V is 1, or when the number of U is 1 and the number of V is 0, a fused ring having a fluorene core of Formula F-b may be a cyclic compound having four rings. When the number of both U and V is 0, a fused ring having the fluorene core of Formula F-b may be a cyclic compound having three rings. When the number of both U and V is 1, a fused ring having a fluorene core of Formula F-b may be a cyclic compound having five rings.

In the organic electroluminescence device ED of an embodiment shown in FIGS. 3 to 6, an electron transport region ETR is provided on the emission layer EML. The electron transport region ETR may include at least one of a hole blocking layer HBL, an electron transport layer ETL, and an electron injection layer EIL, but embodiments are not limited thereto.

The electron transport region ETR may be a layer formed of a single material, a layer formed of different materials, or a multilayer structure having layers formed of different materials.

For example, the electron transport region ETR may have a single layer structure of an electron injection layer EIL or an electron transport layer ETL, or may have a single layer structure formed of an electron injection material and an electron transport material. In other embodiments, the electron transport region ETR may have a single layer structure formed of different materials, or may have a structure in which an electron transport layer ETL/electron injection layer EIL, or a hole blocking layer HBL/electron transport layer ETL/electron injection layer EIL are stacked in its respective stated order from the emission layer EML, but embodiments are not limited thereto. The electron transport region ETR may have a thickness, for example, in a range of about 1,000 Å to about 1,500 Å.

The electron transport region ETR may be formed using various methods such as a vacuum deposition method, a spin coating method, a cast method, a Langmuir-Blodgett (LB) method, an inkjet printing method, a laser printing method, a laser induced thermal imaging (LITI) method, etc.

When the electron transport region ETR includes an electron transport layer ETL, the electron transport region ETR may include an anthracene-based compound. However, embodiments are not limited thereto, and the electron transport region may include, for example, tris(8-hydroxyquinolinato)aluminum (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazolyl-1-ylphenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), berylliumbis(benzoquinolin-10-olate (Bebq₂), 9,10-di(naphthalene-2-yl)anthracene (ADN), 1,3-bis[3,5-di(pyridin-3-yl)phenyl]benzene (BmPyPhB), diphenyl[4-(triphenylsilyl)phenyl]phosphine oxide (TSPO1), or a mixture thereof.

For example, the electron transport region ETR may include a compound represented by Formula ET-1.

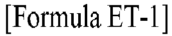

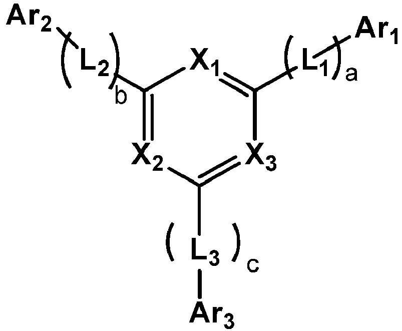

In Formula ET-1, at least one of X₁ to X₃ may be N and the remainder of X₁ to X₃ may be C(Rₐ). Rₐ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In Formula ET-1, Ar₁ to Ar₃ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-1, a to c may each independently be an integer from 0 to 10. In Formula ET-1, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. When a to c are 2 or greater, L₁ to L₃ may each independently be a substituted or unsubstituted arylene group having 6 to 30 ring-forming carbon atoms, or a substituted or unsubstituted heteroarylene group having 2 to 30 ring-forming carbon atoms.

The electron transport region ETR may include at least one of Compounds ET1 to ET36.

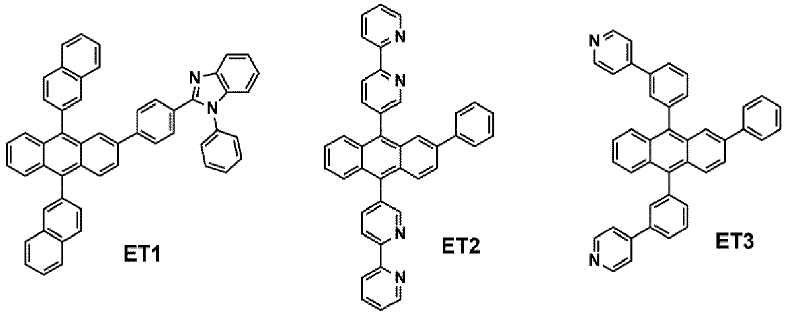

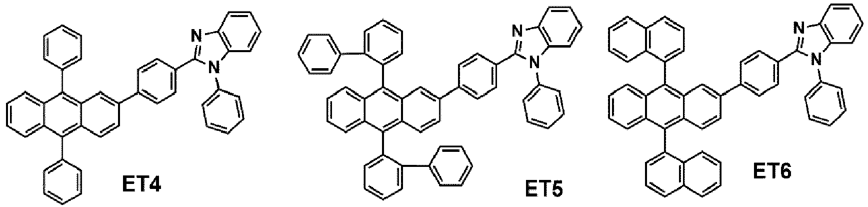

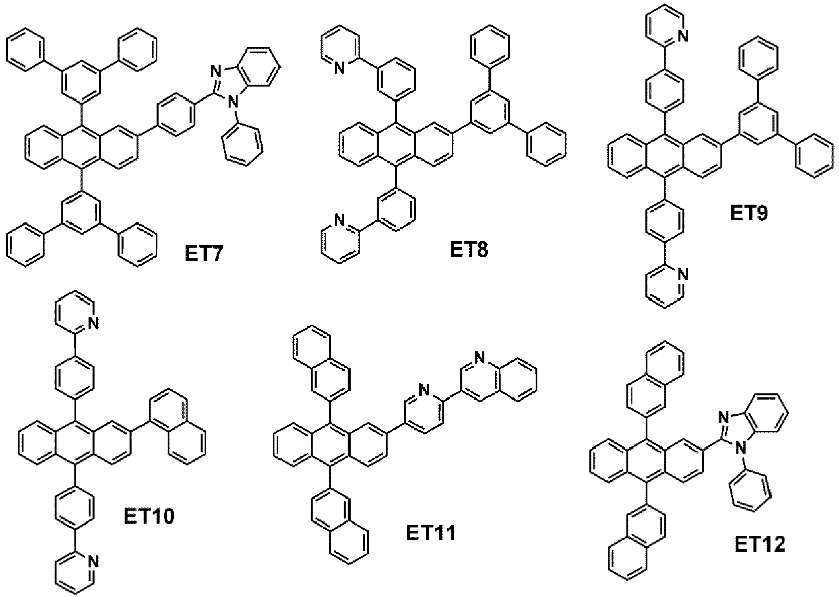

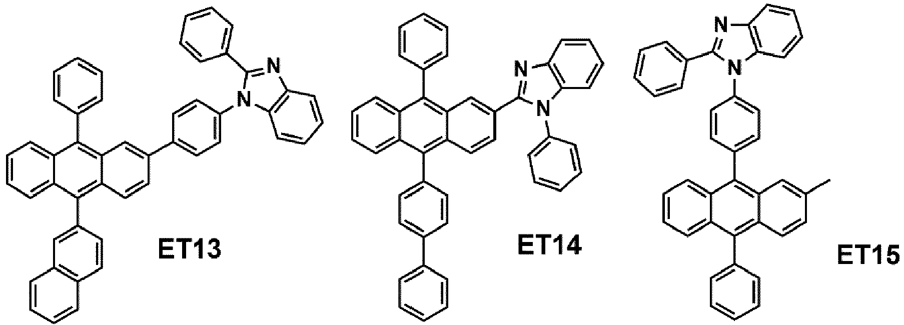

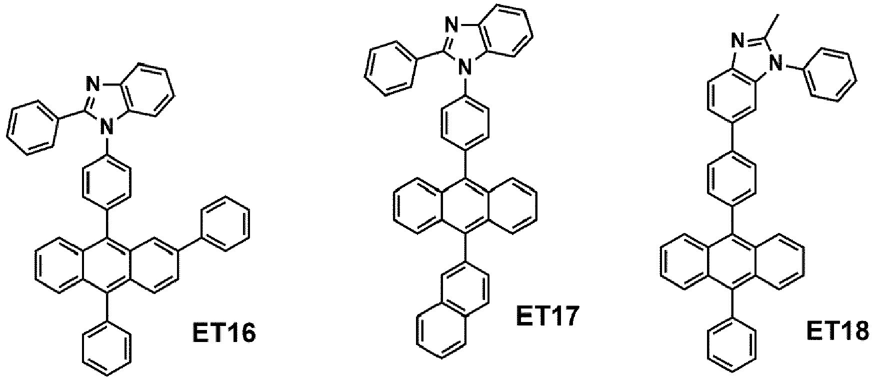

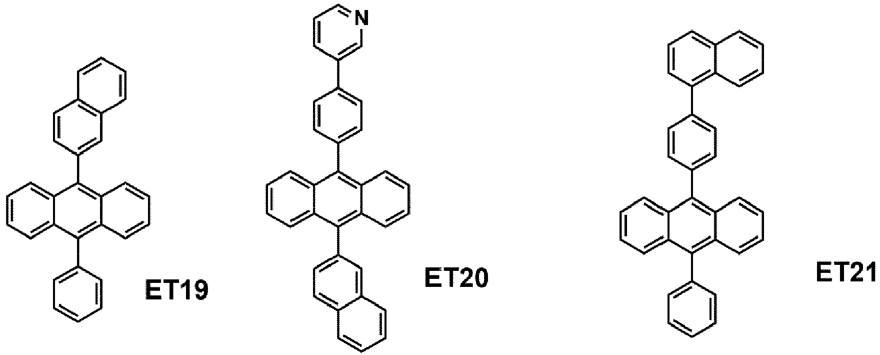

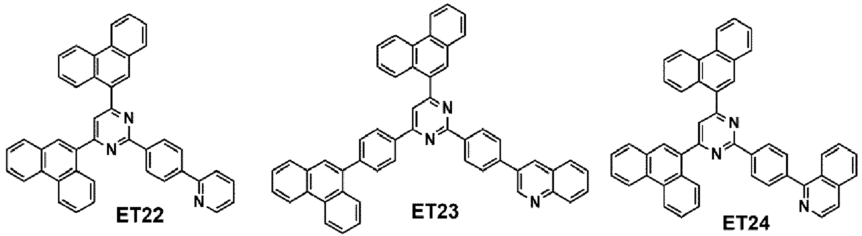

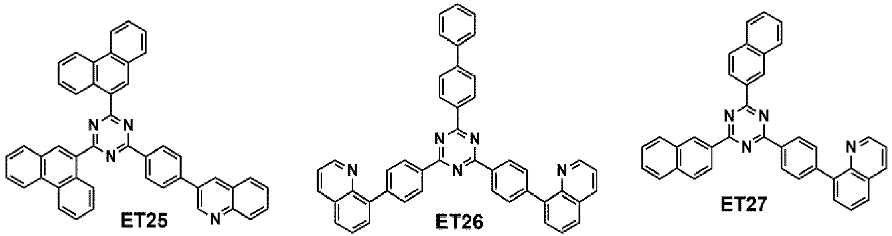

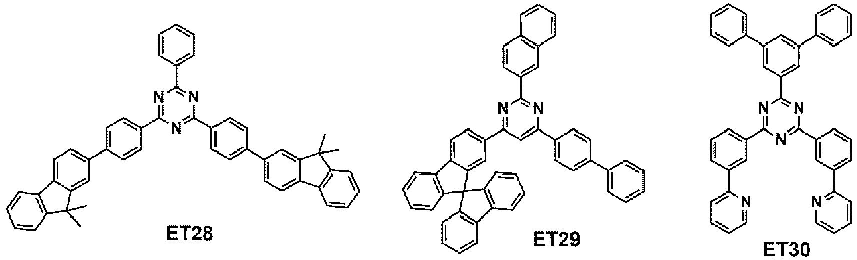

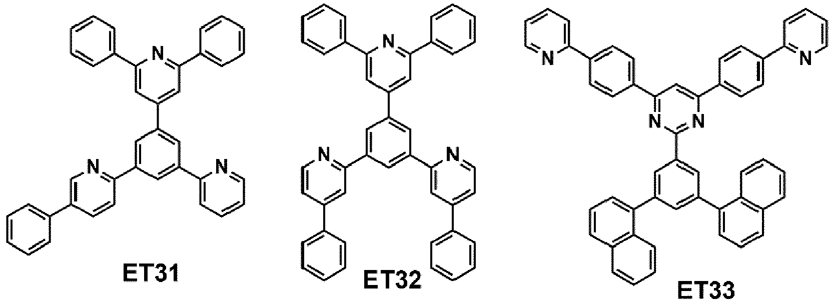

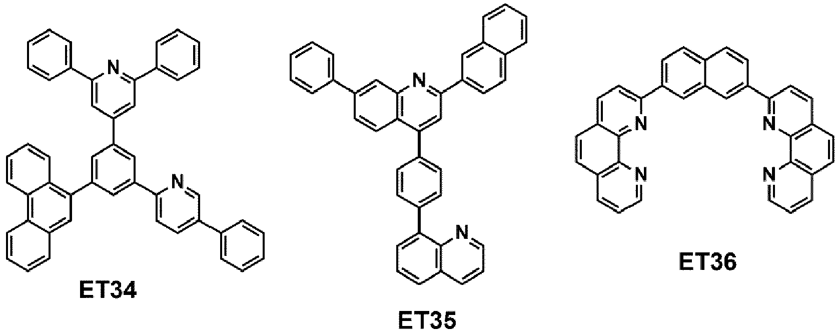

The electron transport region ETR may include halogenated metals such as LiF, NaCl, CsF, RbCl, RbI, Cul, or KI, lanthanide metals such as Yb, or co-deposition materials of a halogenated metal and a lanthanide metal. For example, the electron transport region ETR may include KI:Yb, RbI:Yb, LiF:Yb, etc. as a co-deposition material. The electron transport region ETR may include a metal oxide such as Li₂O and BaO, or 8-hydroxyl-lithium quinolate (Liq), etc., but embodiments are not limited thereto. The electron transport region ETR may also be formed of a mixture material of an electron transport material and an insulating organo-metal salt. The organo-metal salt may be a material having an energy band gap equal to or greater than about 4 eV. For example, the organo-metal salt may include metal acetates, metal benzoates, metal acetoacetates, metal acetylacetonates, or metal stearates.

The electron transport region ETR may further include, for example, at least one of 2,9-dimethyl-4,7-diphenyl-1,10-phenanthroline (BCP) or 4,7-diphenyl-1,10-phenanthroline (Bphen) in addition to the materials described above, but embodiments are not limited thereto.

The electron transport region ETR may include the compounds of the electron transport region described above in at least one of the electron injection layer EIL, the electron transport layer ETL, or the hole blocking layer HBL.

When the electron transport region ETR includes an electron transport layer ETL, the electron transport layer ETL may have a thickness in a range of about 100 Å to about 1,000 Å. For example, the electron transport layer ETL may have a thickness in a range of about 150 Å to about 500 Å. When the thickness of the electron transport layer ETL satisfies the above-described range, satisfactory electron transport properties may be obtained without a substantial increase in driving voltage. When the electron transport region ETR includes an electron injection layer EIL, the electron injection layer EIL may have a thickness in a range of about 1 Å to about 100 Å. For example, the electron injection layer EIL may have a thickness in a range of about 3 Å to about 90 Å. When the thickness of the electron injection layer EIL satisfies the above-described ranges, satisfactory electron injection properties may be obtained without a substantial increase in driving voltage.

The second electrode EL2 is provided on the electron transport region ETR. The second electrode EL2 may be a common electrode. The second electrode EL2 may be a cathode or an anode, but embodiments are not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is a transmissive electrode, the second electrode EL2 may be formed of a transparent metal oxide, for example, indium tin oxide (ITO), indium zinc oxide (IZO), zinc oxide (ZnO), indium tin zinc oxide (ITZO), etc.

When the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, a compound thereof, or a mixture thereof (e.g., AgMg, AgYb, or MgYb). In another embodiment, the first electrode EL1 may have a multilayer structure including a reflective film or a transflective film formed of the above-described materials, and a transparent conductive film formed of indium tin oxide (ITO), indium zinc oxide (IZO), zinc oxide (ZnO), indium tin zinc oxide (ITZO), etc.

Although not shown in the drawings, the second electrode EL2 may be electrically connected to an auxiliary electrode. When the second electrode EL2 is electrically connected to the auxiliary electrode, the resistance of the second electrode EL2 may decrease.

In an embodiment, the organic electroluminescence device ED may further include a capping layer CPL disposed on the second electrode EL2. The capping layer CPL may be a multilayer or a single layer.

In an embodiment, the capping layer CPL may include an organic layer or an inorganic layer. For example, when the capping layer CPL includes an inorganic material, the inorganic material may include an alkali metal compound such as LiF, an alkaline earth metal compound such as MgF₂, SiON, SiNx, SiOy, etc.

For example, when the capping layer CPL includes an organic material, the organic material may include α-NPD, NPB, TPD, m-MTDATA, Alq₃ CuPc, N4,N4,N4',N4'-tetra(biphenyl-4-yl) biphenyl-4,4'-diamine (TPD15), 4,4',4"-tris(carbazol sol-9-yl)triphenylamine (TCTA), etc., or may include epoxy resins or acrylates such as methacrylates. However, embodiments are not limited thereto, and the capping layer CPL may include at least one of Compounds P1 to P5.

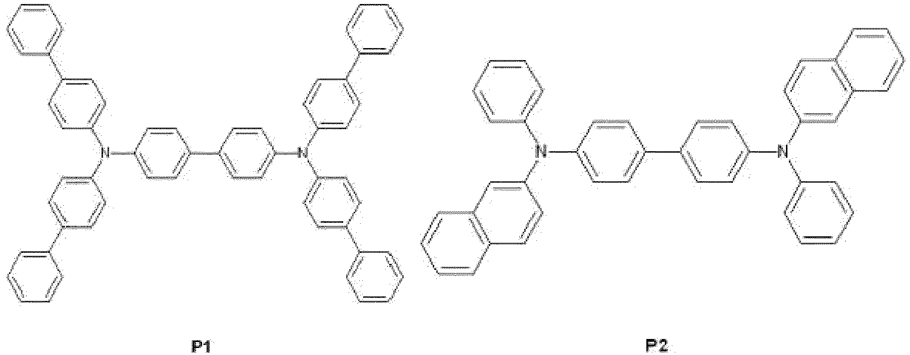

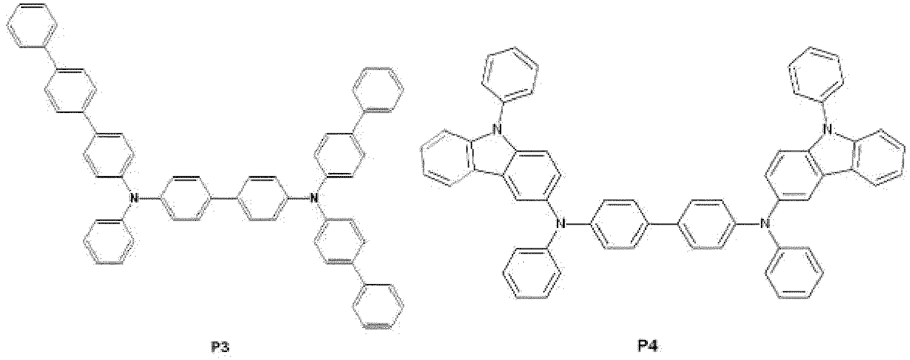

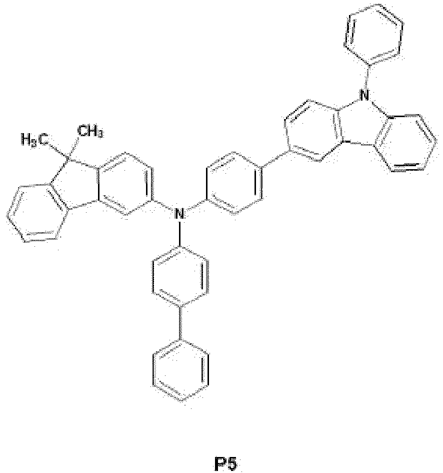

The capping layer CPL may have a refractive index equal to or greater than about 1.6. For example, the capping layer CPL may have a refractive index equal to or greater than about 1.6 with respect to a wavelength range of about 550 nm to about 660 nm.

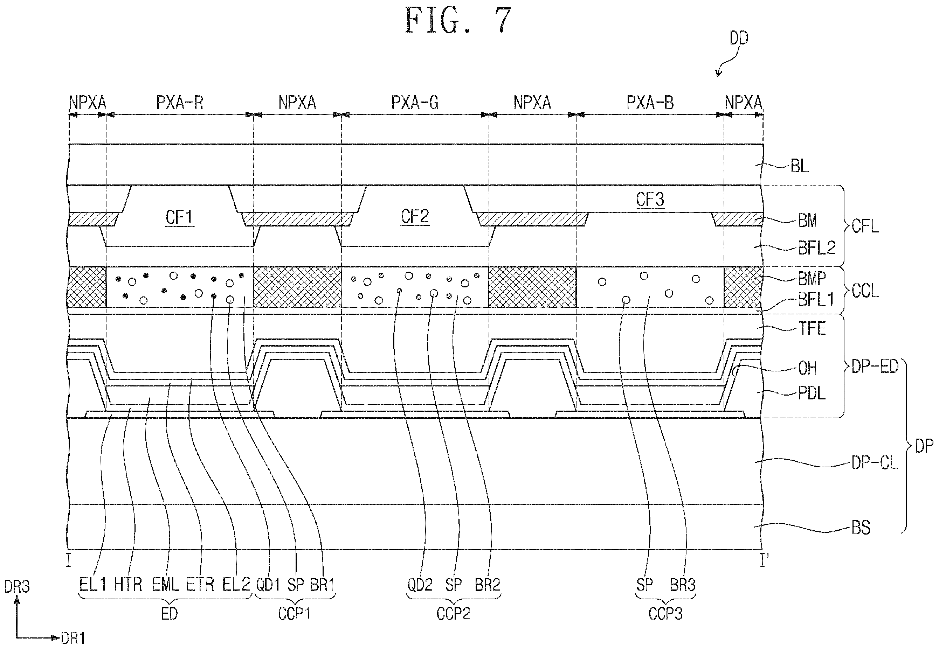

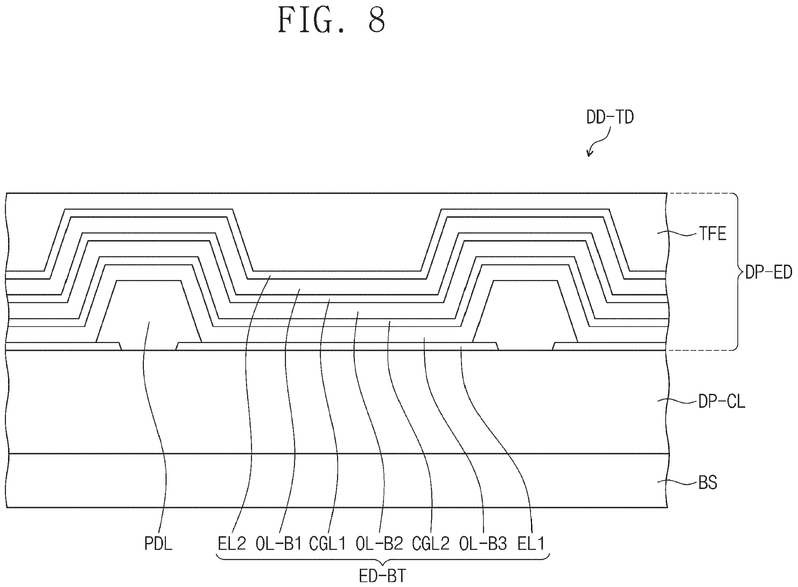

FIGS. 7 and 8 are each a schematic cross-sectional view of a display apparatus according to an embodiment. Hereinafter, in the description of the display apparatus according to an embodiment with reference to FIGS. 7 and 8, content which overlaps with the explanation of FIGS. 1 to 6 will not be described again, and the differences will be described.

Referring to FIG. 7, a display apparatus DD according to an embodiment may include a display panel DP having a display element layer DP-ED, a light control layer CCL disposed on the display panel DP, and a color filter layer CFL.

In an embodiment illustrated in FIG. 7, the display panel DP may include a base layer BS, a circuit layer DP-CL provided on the base layer BS, and a display element layer DP-ED, and the display element layer DP-ED may include an organic electroluminescence device ED.

The organic electroluminescence device ED may include a first electrode EL1, a hole transport region HTR disposed on the first electrode EL1, an emission layer EML disposed on the hole transport region HTR, an electron transport region ETR disposed on the emission layer EML, and a second electrode EL2 disposed on the electron transport region ETR. A structure of the organic electroluminescence device ED illustrated in FIG. 7 may be the same as a structure of the organic electroluminescence device of FIGS. 3 to 6 as described above.

Referring to FIG. 7, the emission layer EML may be disposed in the openings OH defined in the pixel defining films PDL. For example, the emission layer EML which is separated by the pixel defining films PDL and provided corresponding to each of the light emitting regions PXA-R, PXA-G, and PXA-B may emit light in a same wavelength range. In the display apparatus DD of an embodiment, the emission layer EML may emit blue light. Although not shown in the drawings, in an embodiment, the emission layer EML may be provided as a common layer throughout the light emitting regions PXA-R, PXA-G, and PXA-B.

The light control layer CCL may be disposed on the display panel DP. The light control layer CCL may include a photoconverter. The photoconverter may be a quantum dot or a phosphor. The photoconverter may convert the wavelength of a provided light, and may emit the resulting light. For example, the light control layer CCL may be a layer containing quantum dots or phosphors.

The quantum dot may be a Group II-VI compound, a Group III-VI compounds, a Group I-III-VI compound, a Group III-V compound, a Group IV-VI compound, a Group IV element, a Group IV compound, or a combination thereof.

The Group II-VI compound may be selected from: a binary compound selected from the group consisting of CdSe, CdTe, CdS, ZnS, ZnSe, ZnTe, ZnO, HgS, HgSe, HgTe, MgSe, MgS, and a mixture thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof; or any combination thereof.

The Group III-VI compound may include: a binary compound such as In₂S₃ and In₂Se₃; a ternary compound such as InGaS₃ and InGaSe₃; or any combination thereof.

The Group I-III-VI compound may include: a ternary compound selected from the group consisting of AgInS, AgInS₂, CuInS, CuInS₂, AgGaS₂, CuGaS₂ CuGaO₂, AgGaO₂, AgAlO₂, or any mixture thereof; a quaternary compound such as AgInGaS₂ and CuInGaS₂; or any combination thereof.

The Group III-V compound may be selected from: a binary compound selected from the group consisting of GaN, GaP, GaAs, GaSb, AlN, AlP, AlAs, AlSb, InN, InP, InAs, InSb, and a mixture thereof; a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof; a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof; or any combination thereof. The Group III-V compound may further include a Group II metal. For example, InZnP, etc. may be selected as a Group III-II-V compound.

The Group IV-VI compound may be selected from: a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; a quaternary compound selected from the group consisting of SnPbSSe, SnPbSeTe, SnPbSTe, and a mixture thereof; or any combination thereof. The Group IV element may be selected from the group consisting of Si, Ge, and a mixture thereof. The Group IV compound may be a binary compound selected from the group consisting of SiC, SiGe, and a mixture thereof.

A binary compound, a ternary compound, or a quaternary compound may be present in particles at a uniform concentration distribution, or may be present in particles at a partially different concentration distribution. In an embodiment, the quantum dot may have a core/shell structure in which a quantum dot surrounds another quantum dot. A quantum dot having a core/shell structure may have a concentration gradient at an interface between the core and the shell in which the concentration of an element that is present in the shell decreases towards the center.

In embodiments, a quantum dot may have a core/shell structure including a core having nano-crystals, and a shell surrounding the core, which are described above. The shell of the quantum dot may function as a protection layer that prevents chemical deformation of the core so as to maintain semiconductor properties, and/or may function as a charging layer that imparts electrophoretic properties to the quantum dot. The shell may be a single layer or multiple layers. Examples of the shell of the quantum dot may include a metal oxide, a non-metal oxide, a semiconductor compound, or a combination thereof.

For example, the metal oxide or the non-metal oxide may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, or a ternary compound such as MgAl₂O₄, CoFe₂O₄, NiFe₂O₄, and CoMn₂O₄, but embodiments are not limited thereto.

The semiconductor compound may be, for example, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, etc., but embodiments are not limited thereto.

A quantum dot may have a full width of half maximum (FWHM) of a light emission wavelength spectrum equal to or less than about 45 nm. For example, the quantum dot may have a FWHM of a light emission wavelength spectrum equal to or less than about 40 nm. For example, the quantum dot may have a FWHM of a light emission wavelength spectrum equal to or less than about 30 nm. Color purity or color reproducibility may be enhanced in the above ranges. Light emitted through such a quantum dot may be emitted in all directions, so that a wide viewing angle may be improved.

The form of a quantum dot is not particularly limited as long as it is a form used in the related art. For example, a quantum dot may have a spherical shape, a pyramidal shape, a multi-arm shape, or a cubic shape, or the quantum dot may be in the form of nanoparticles, nanotubes, nanowires, nanofibers, nanoplatelets, etc.

The quantum dot may control the color of emitted light according to a particle size thereof, and thus the quantum dot may have various colors of emitted light such as blue, red, green, etc.

The light control layer CCL may include light control units CCP1, CCP2, and CCP3. The light control units CCP1, CCP2, and CCP3 may be spaced apart from each other.

Referring to FIG. 7, a division pattern BMP may be disposed between the light control units CCP1, CCP2, and CCP3 spaced apart from each other, but embodiments are not limited thereto. In FIG. 7, the division pattern BMP is shown so that it does not overlap the light control units CCP1, CCP2, and CCP3, but the edges of the light control units CCP1, CCP2, and CCP3 may overlap at least a portion of the division pattern BMP.

The light control layer CCL may include a first light control unit CCP1 including a first quantum dot QD1 for converting first color light provided from the organic electroluminescence device ED into second color light, a second light control unit CCP2 including a second quantum dot QD2 for converting the first color light provided from the organic electroluminescence device ED into third color light, and a third light control unit CCP3 transmitting the first color light provided from the organic electroluminescence device ED.

In an embodiment, the first light control unit CCP1 may provide red light, which is the second color light, and the second light control unit CCP2 may provide green light, which is the third color light. The third light control unit CCP3 may transmit and provide blue light, which is the first color light provided from the organic electroluminescence device ED. For example, the first quantum dot QD1 may be a red quantum dot and the second quantum dot QD2 may be a green quantum dot. The same descriptions as provided above with respect to quantum dots may be applied to the quantum dots QD1 and QD2.

The light control layer CCL may further include scatterers SP. The first light control unit CCP1 may include the first quantum dot QD1 and the scatterers SP, the second light control unit CCP2 may include the second quantum dot QD2 and the scatterers SP, and the third light control unit CCP3 may not include a quantum dot but may include the scatterers SP.

The scatterers SP may be inorganic particles. For example, the scatterers SP may include at least one of TiO₂, ZnO, Al₂O₃, SiO₂, or hollow silica. The scatterers SP may include any one of TiO₂, ZnO, Al₂O₃, SiO₂, or hollow silica, or may be a mixture of two or more materials selected from TiO₂, ZnO, Al₂O₃, SiO₂, and hollow silica.

The first light control unit CCP1, the second light control unit CCP2, and the third light control unit CCP3 may each include base resins BR1, BR2, and BR3 for dispersing the quantum dots QD1 and QD2 and the scatterers SP. In an embodiment, the first light control unit CCP1 may include the first quantum dot QD1 and the scatterers SP dispersed in the first base resin BR1, the second light control unit CCP2 may include the second quantum dot QD2 and the scatterers SP dispersed in the second base resin BR2, and the third light control unit CCP3 may include the scatterers SP dispersed in the third base resin BR3. The base resins BR1, BR2, and BR3 may each be a medium in which the quantum dots QD1 and QD2 and the scatterers SP are dispersed, and may be formed of various resin compositions, which may be generally referred to as a binder. For example, the base resins BR1, BR2, and BR3 may each independently be an acrylic resin, a urethane-based resin, a silicone-based resin, an epoxy-based resin, etc. The base resins BR1, BR2, and BR3 may each be a transparent resin. In an embodiment, the first base resin BR1, the second base resin BR2, and the third base resin BR3 may each be the same as or different from each other.

The light control layer CCL may include a barrier layer BFL1. The barrier layer BFL1 may prevent moisture and/or oxygen (hereinafter referred to as "moisture/oxygen") from being introduced. The barrier layer BFL1 may be disposed on the light control units CCP1, CCP2, and CCP3 to prevent the light control units CCP1, CCP2, and CCP3 from being exposed to moisture/oxygen. The barrier layer BFL1 may cover the light control units CCP1, CCP2, and CCP3. A barrier layer BFL2 may be provided between the light control units CCP1, CCP2, and CCP3 and the color filter layer CFL.

The barrier layers BFL1 and BFL2 may each include at least one inorganic layer. For example, the barrier layers BFL1 and BFL2 may each be formed of an inorganic material. For example, the barrier layers BFL1 and BFL2 may each independently include silicon nitride, aluminum nitride, zirconium nitride, titanium nitride, hafnium nitride, tantalum nitride, silicon oxide, aluminum oxide, titanium oxide, tin oxide, cerium oxide, silicon oxynitride, or a metal thin film in which light transmittance is secured, etc. The barrier layers BFL1 and BFL2 may each further include an organic film. The barrier layers BFL1 and BFL2 may be formed of a single layer or of multiple layers.

In the display apparatus DD of an embodiment, the color filter layer CFL may be disposed on the light control layer CCL. In an embodiment, the color filter layer CFL may be directly disposed on the light control layer CCL. For example, the barrier layer BFL2 may be omitted.

The color filter layer CFL may include a light blocking unit BM and filters CF1, CF2, and CF3. For example, the color filter layer CFL may include a first filter CF1 transmitting second color light, a second filter CF2 transmitting third color light, and a third filter CF3 transmitting first color light. For example, the first filter CF1 may be a red filter, the second filter CF2 may be a green filter, and the third filter CF3 may be a blue filter. The filters CF1, CF2, and CF3 may each include a polymer photosensitive resin, a pigment, or a dye. The first filter CF1 may include a red pigment or a red dye, the second filter CF2 may include a green pigment or a green dye, and the third filter CF3 may include a blue pigment or a blue dye. However, embodiments are not limited thereto, and the third filter CF3 may not include a pigment or a dye. The third filter CF3 may include a polymer photosensitive resin, and may not include a pigment or a dye. The third filter CF3 may be transparent. The third filter CF3 may be formed of a transparent photosensitive resin.

In an embodiment, the first filter CF1 and the second filter CF2 may each be yellow filters. The first filter CF1 and the second filter CF2 may not be separated from each other and may be provided as a single body.

The light blocking unit BM may be a black matrix. The light blocking unit BM may include an organic light blocking material or an inorganic light blocking material, each including a black pigment or a black dye. The light blocking unit BM may prevent light leakage, and may distinguish boundaries between the adjacent filters CF1, CF2, and CF3. In an embodiment, the light blocking unit BM may be formed of a blue filter.

The first to third filters CF1, CF2, and CF3 may be disposed corresponding to the red light emitting region PXA-R, green light emitting region PXA-G, and blue light emitting region PXA-B, respectively.

The base substrate BL may be disposed on the color filter layer CFL. The base substrate BL may provide a base surface on which the color filter layer CFL and the light control layer CCL are disposed. The base substrate BL may be a glass substrate, a metal substrate, a plastic substrate, etc. However, embodiments are not limited thereto, and the base substrate BL may include an inorganic layer, an organic layer, or a composite material layer. Although not shown in the drawings, in an embodiment, the base substrate BL may be omitted.

FIG. 8 is a schematic cross-sectional view showing a portion of a display apparatus according to an embodiment. FIG. 8 shows a schematic cross-sectional view of a portion corresponding to the display panel DP of FIG. 7. In a display apparatus DD-TD of an embodiment, an organic electroluminescence device ED-BT may include light emitting structures OL-B1, OL-B2, and OL-B3. The organic electroluminescence device ED-BT may include the first electrode EL1 and the second electrode EL2 facing each other, and the light emitting structures OL-B1, OL-B2, and OL-B3 provided by being stacked in a thickness direction between the first electrode EL1 and the second electrode EL2. The light emitting structures OL-B1, OL-B2, and OL-B3 may each include the emission layer EML (FIG. 7), a hole transport region HTR and an electron transport region ETR disposed with the emission layer EML (FIG. 7) therebetween. At least one of the emission layers of each of the light emitting structures OL-B1, OL-B2, and OL-B3 may include a host and a light emitting dopant represented by Formula 1. In each of the emission layers of the light emitting structures OL-B1, OL-B2, and OL-B3, there may be more than one host.

At least one of an emission layer (hereinafter, referred to as a first sub-emission layer) included in any one of the light emitting structures OL-B1, OL-B2, and OL-B3, or an emission layer (hereinafter, referred to as a second sub-emission layer) included in another light emitting structure may include a host and a fused polycyclic compound. For example, at least one of the first sub-emission layer and the second sub-emission layer may include the host and the fused polycyclic compound according to an embodiment.

For example, the organic electroluminescence device ED-BT included in the display apparatus DD-TD according to an embodiment may be an organic electroluminescence device having a tandem structure including multiple emission layers.

In an embodiment illustrated in FIG. 8, light emitted from each of the light emitting structures OL-B1, OL-B2, and OL-B3 may all be blue light. However, embodiments are not limited thereto, and wavelength ranges of light emitted from each of the light emitting structures OL-B1, OL-B2, and OL-B3 may be different from each other. For example, the organic electroluminescence device ED-BT including the light emitting structures OL-B1, OL-B2, and OL-B3 emitting light in different wavelength ranges may emit white light.

Charge generation layers CGL1 and CGL2 may be disposed between neighboring light emitting structures OL-B1, OL-B2, and OL-B3. The charge generation layers CGL1 and CGL2 may each independently include a p-type charge generation layer and/or an n-type charge generation layer.

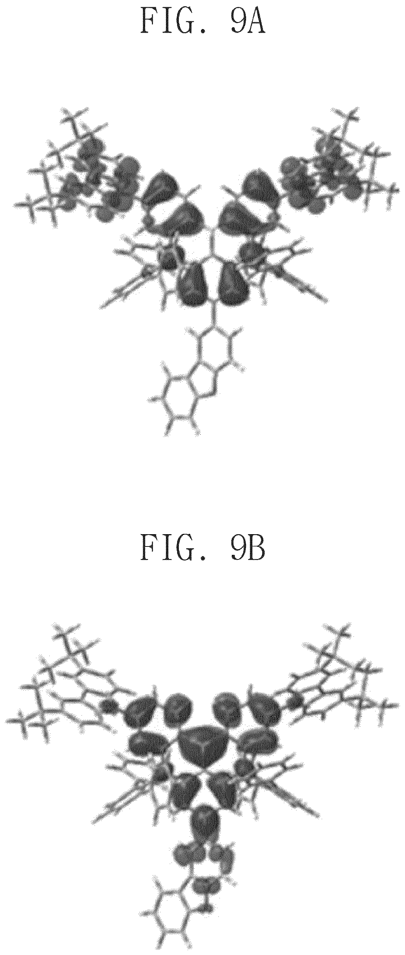

FIGS. 9A and 9B each show a molecular orbital view of fused polycyclic compounds according to an embodiment. FIG. 9A shows Highest Occupied Molecular Orbital (HOMO) of Compound 53, and FIG. 9B shows Lowest Occupied Molecular Orbital (LUMO) of Compound 53.

Referring to FIGS. 9A and 9B, it can be seen that molecular orbitals do not overlap each other and are independently present, and even in the presence of a substituent having a three-dimensional structure (e.g., a ortho-terphenyl group), multiple resonance is maintained in a pentacyclic fused ring. The pentacyclic fused ring included in the fused polycyclic compound may include two nitrogen atoms and one boron atom as ring-forming atoms.

It can be seen that molecular orbitals (i.e., orbitals) are not occupied in the ortho-terphenyl group. The ortho-terphenyl group prevents intermolecular interactions (e.g., electron and/or hole transfer, dexter energy transfer) of the fused polycyclic compound, and does not serve to deliver excitons, and accordingly, multiple resonances may be maintained in the pentacyclic fused ring. In the fused polycyclic compound in which the ortho-terphenyl group is bonded to nitrogen atoms on either side of the pentacyclic fused ring, deterioration may be prevented. The fact that the ortho-terphenyl group is bonded to nitrogen atoms on either side may prevent excitons from being accumulated in the pentacyclic fused ring, or may prevent deterioration due to a polaron. Accordingly, the organic electroluminescence device including the fused polycyclic compound may have increased lifespan.

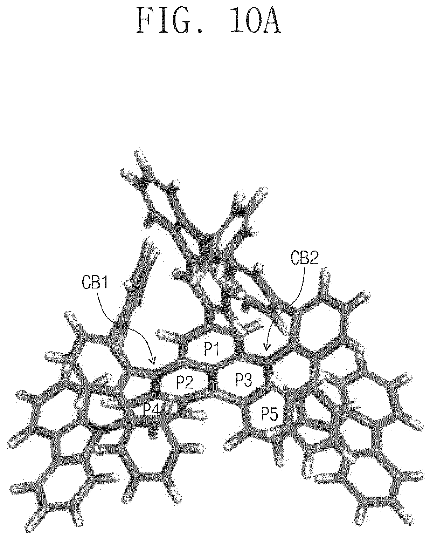

FIGS. 10A to 10C each show a three-dimensional structure view of a fused polycyclic compound according to an embodiment. The three-dimensional structure shown in FIGS. 10A to 10C is the structure of Compound 1.

Referring to FIG. 10A, P1 to P5 are shown as a pentacyclic fused ring included in a fused polycyclic compound according to an embodiment. In FIG. 10A, CB1 and CB2 each indicate a bonding position between a nitrogen atom and a substituent bonded to the nitrogen atom. For example, CB1 and CB2 each indicate a bonding position between a nitrogen atom and a ortho-terphenyl group in Compound 1.

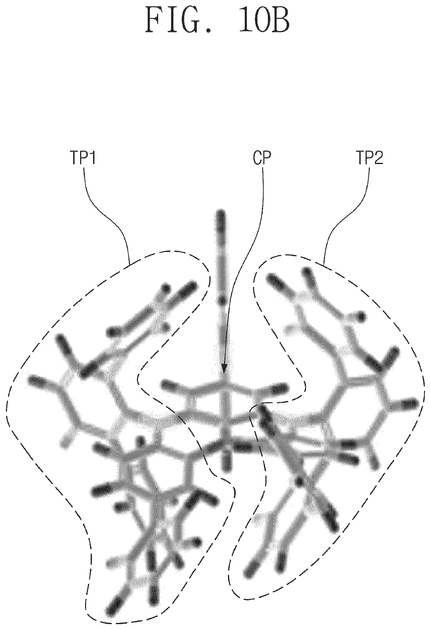

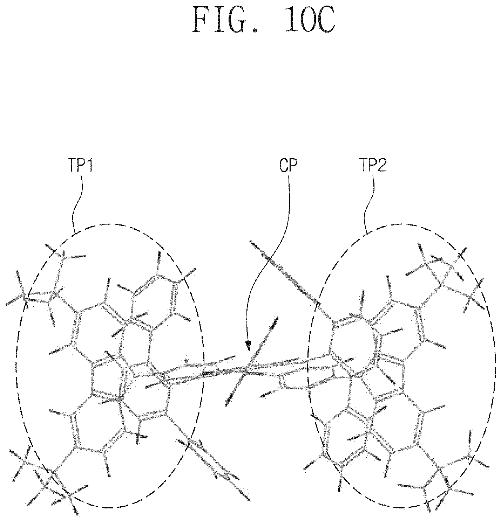

In FIGS. 10B and 10C, CP indicates a pentacyclic fused ring included in Compound 1. In FIGS. 10B and 10C, TP1 and TP2 are each a ortho-terphenyl group bonded to a pentacyclic fused ring.

Referring to FIGS. 10A to 10C, it can be seen that the pentacyclic fused ring included in Compound 1 has a structure surrounded by a ortho-terphenyl group. Compound 1 includes a structure in which a ortho-terphenyl group is perpendicular to a plane including a pentacyclic fused ring, and thus may be spaced apart from a host by a maximum distance when used as a dopant of an organic electroluminescence device. For example, when the fused polycyclic compound of an embodiment including a substituent such as a ortho-terphenyl group is used as a dopant for an organic electroluminescence device, intermolecular interaction with the host may be prevented. Due to the fact that the ortho-terphenyl group is bonded to the nitrogen atoms on either side of the pentacyclic fused ring, and thus prevents intermolecular interaction, the organic electroluminescence device including the fused polycyclic compound of an embodiment may exhibit increased lifespan.

When the ortho-terphenyl group is not included in the pentacyclic fused ring, dexter energy transfer may occur due to intermolecular interaction. The dexter energy transfer is caused through a region where the ortho-terphenyl group is not bonded to the pentacyclic fused ring, resulting in deterioration of the fused ring.

The fused polycyclic compound according to an embodiment may have a structure in which a substituent bonded to a nitrogen atom included in the pentacyclic fused ring surrounds the pentacyclic fused ring. Accordingly, in the fused polycyclic compound of an embodiment, intermolecular interaction may be prevented, and thus dexter energy transfer may not occur.

Hereinafter, with reference to the Examples and the Comparative Examples, a fused polycyclic compound according to an embodiment and an organic electroluminescence device according to an embodiment will be described. The Examples shown below are only provided as illustrations for understanding the disclosure, and the scope thereof is not limited thereto.

### [Examples]

### 1. Synthesis of fused polycyclic compounds

A process of synthesizing fused polycyclic compounds according to an embodiment will be described in detail by describing a process of synthesizing Compounds 1, 4, 26, 37, 53, 62, 64, 69, 79, 84, 95, 103, and 114 as an example. A process of synthesizing fused polycyclic compounds, which will be described hereinafter, is provided as an example, and thus a process of synthesizing fused polycyclic compounds according to an embodiment is not limited to the Examples below.

### (1) Synthesis of Compound 1

Fused polycyclic compound 1 according to an embodiment may be synthesized by, for example, a reaction below.

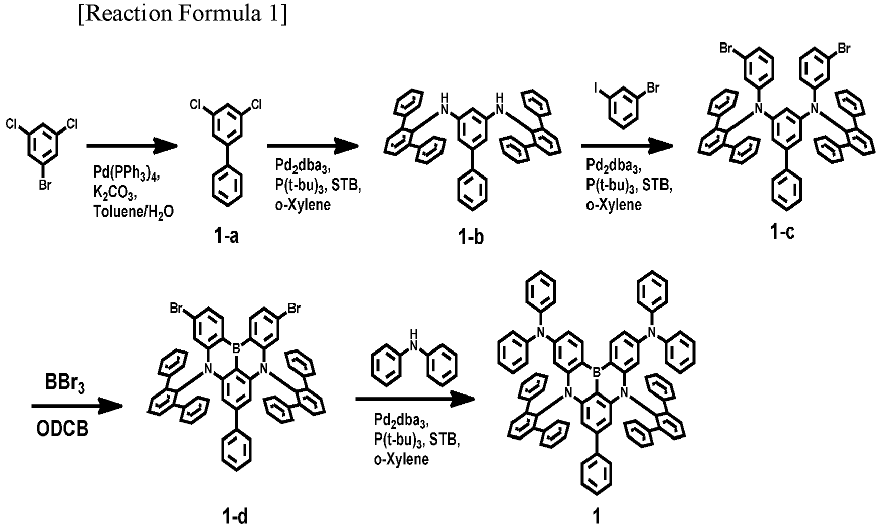

### 1) Synthesis of Intermediate 1-a

In an argon atmosphere, in a 2 L flask, 1-bromo-3,5-dichlorobenzene (10 g, 44 mmol), phenylboronic acid (6.5 g, 35 mmol), Pd(PPh₃)₄ (1.5 g, 1.3 mmol), potassium carbonate (18 g, 132 mmol) were dissolved in 300 mL of toluene and 60 mL of water, and the mixture was reflux-stirred at 110 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 1-a (colorless liquid, 7.8 g, 75%). It was confirmed that the obtained colorless liquid was Intermediate 1-a through ESI-LCMS and ¹H-NMR.
ESI-LCMS: [M+H]⁺: C₁₂H₈Cl₂. 222.0012.
¹H-NMR (400 MHz, CDCl₃): 7.85 (s, 2H), 7.72 (d, 2H), 7.71 (s, 1H), 7.45 (m, 3H).

### 2) Synthesis of Intermediate 1-b

In an argon atmosphere, in a 2 L flask, Intermediate Compound 1-a (7.5 g, 33 mmol), [1,1':3',1"-terphenyl]-2'-amine (17 g, 69 mmol), Pd₂dba₃ (1.5 g, 1.6 mmol), tris-tert-butyl phosphine (1.5 mL, 3.2 mmol) and sodium tert-butoxide (9.5 g, 99 mmol) were dissolved in 300 mL of o-xylene, and the mixture was stirred at 140 0°C for 6 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 1-b (colorless liquid, 14 g, 68%). It was confirmed that the obtained colorless liquid was Intermediate 1-b through ESI-LCMS.

ESI-LCMS: [M+H]⁺: C₄₈H₃₆N₂. 640.2821.

### (3) Synthesis of Intermediate 1-c

In an argon atmosphere, in a 2 L flask, Intermediate Compound 1-b (14 g, 21 mmol), 1-bromo-3-iodobenzene (31 g, 109 mmol), Pd₂dba₃ (1.0 g, 1.1 mmol), tris-tert-butyl phosphine (1.0 mL, 1.1 mmol) and sodium tert-butoxide (6.0 g, 63 mmol) were dissolved in 200 mL of oxylene, and the mixture was stirred at 160 °C for 26 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 1-c (white solid, 10 g, 51%). It was confirmed that the obtained white solid was Intermediate 1-c through ESI-LCMS.

ESI-LCMS: [M+H]⁺: C₆₀H₄₂N₂Br₂. 948.1417.

### 4) Synthesis of Intermediate 1-d

In an argon atmosphere, Intermediate Compound 1-c (10 g, 10.5 mmol) was placed in a 2 L flask and dissolved in 500 mL of o-dichlorobenzene. BBr₃ (1.5 equiv.) was slowly dropped to 0 °C using an ice-water container, and at a temperature raised to 140°C, the resulting product was stirred for 12 hours. After cooling, an organic layer was separated through extraction with CH₂Cl₂ and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 1-d (yellow solid, 1 g, 10%). It was confirmed that the obtained yellow solid was Intermediate 1-d through ESI-LCMS.

ESI-LCMS: [M+H]⁺: C₆₀H₃₉N₂BBr₂. 956.1612.

### 5) Synthesis of Compound 1

In an argon atmosphere, in a 1 L flask, Intermediate Compound 1-d (1 g, 1 mmol), diphenylamine (0.34 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 1 (yellow solid, 0.7 g, 65%). It was confirmed that the obtained yellow solid was Compound 1 through ESI-LCMS and ¹H-NMR.
ESI-LCMS: [M+H]⁺: C₈₄H₅₉N₄B. 1134.4812.
¹H-NMR (400 MHz, CDCl₃): 8.84 (d, 2H), 8.20 (d, 4H), 7.41 (m, 17H), 7.24 (m, 8H), 7.12 (m, 20H), 6.93 (s, 2H), 6.84 (d, 2H), 6.71 (s, 2H).

### (2) Synthesis of Compound 4

Fused polycyclic compound 4 according to an embodiment may be synthesized by, for example, a reaction below.

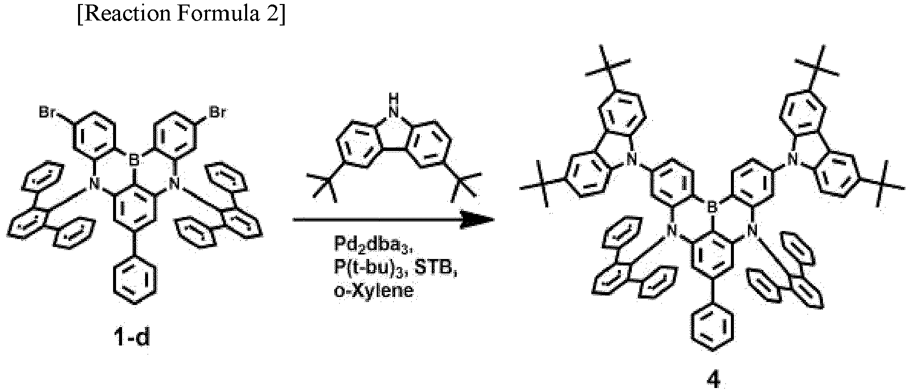

In an argon atmosphere, in a 1 L flask, Intermediate Compound 1-d (1 g, 1 mmol), 3,6-di-tert-butyl carbazole (0.56 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 4 (yellow solid, 1 g, 68%). It was confirmed that the obtained yellow solid was Compound 4 through ESI-LCMS and ¹H-NMR.
ESI-LCMS: [M+H]⁺: C₁₀₀H₈₇N₄B. 1354.6971.
¹H-NMR (400 MHz, CDCl₃): 8.84 (d, 2H), 8.75 (s, 4H), 8.23 (d, 4H), 7.86 (d, 4H), 7.75 (d, 2H), 7.39 (m, 19H), 7.23 (s, 2H), 7.11 (d, 4H), 6.95 (s, 2H), 1.43 (s, 36H).

### (3) Synthesis of Compound 26

Fused polycyclic compound 26 according to an embodiment may be synthesized by, for example, a reaction below.

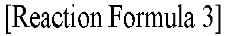

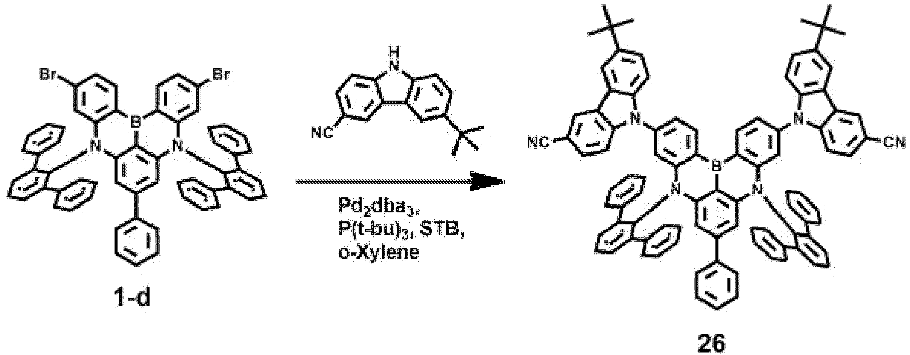

In an argon atmosphere, in a 1 L flask, Intermediate compound 1-d (1 g, 1 mmol), 3-cyano-6-tert-butyl carbazole (0.5 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 26 (yellow solid, 1 g, 68%). It was confirmed that the obtained yellow solid was Compound 26 through ESI-LCMS and ¹H-NMR.
ESI-LCMS: [M+H]⁺: C₉₄H₆₉N₆B. 1292.5715.
¹H-NMR (400 MHz, CDCl₃): 8.95 (d, 2H), 8.88 (s, 2H), 8.21 (d, 4H), 8.12 (d, 2H), 7.81 (s, 2H), 7.75 (d, 2H), 7.62 (d, 2H), 7.50 (m, 17H), 7.43 (s, 2H), 7.35 (m, 8H), 6.93 (m, 2H), 1.45 (s, 18H).

### (4) Synthesis of Compound 37

Fused polycyclic compound 37 according to an embodiment may be synthesized by, for example, a reaction below.

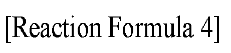

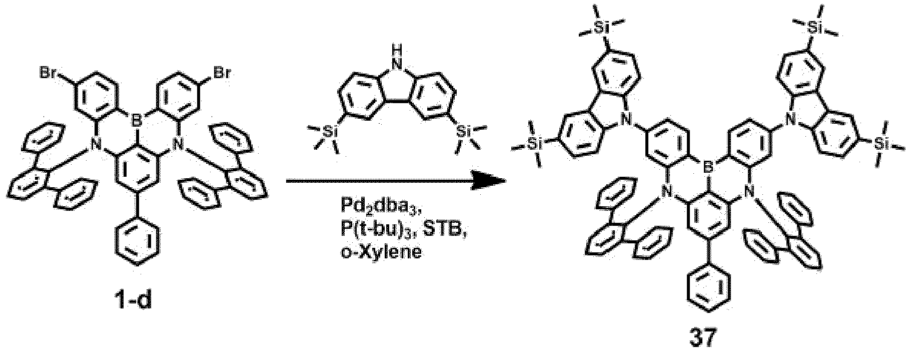

In an argon atmosphere, in a 1 L flask, Intermediate compound 1-d (1 g, 1 mmol), 3,6-di-trimethylsilyl carbazole (0.6 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 37 (yellow solid, 1.1 g, 76%). It was confirmed that the obtained yellow solid was Compound 37 through ESI-LCMS and ¹H-NMR.
ESI-LCMS: [M+H]⁺: C₉₆H₈₇N₄BSi₄. 1419.6112.
¹H-NMR (400 MHz, CDCl₃): 8.68 (d, 2H), 8.20 (d, 4H), 7.92 (d, 4H), 7.77 (s, 4H), 7.56 (d, 4H), 7.44 (m, 19H), 7.30 (d, 4H), 7.23 (s, 2H), 7.43 (s, 2H), 7.08 (m, 8H), 6.95 (d, 2H), 0.45 (s, 36H).

### (5) Synthesis of Compound 53

Fused polycyclic compound 53 according to an embodiment may be synthesized by, for example, a reaction below.

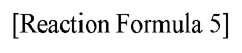

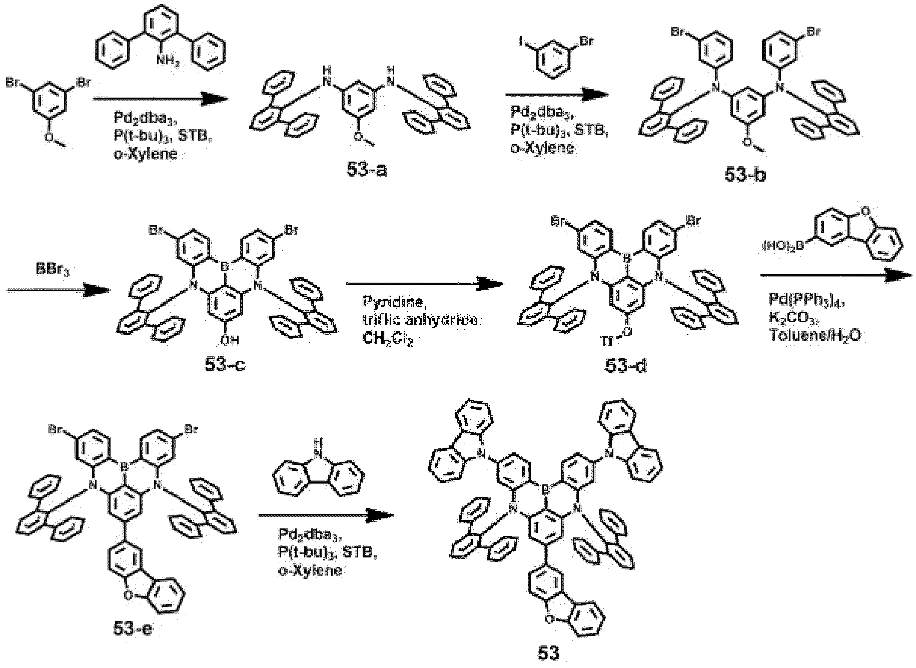

### 1) Synthesis of Intermediate 53-a

In an argon atmosphere, in a 2 L flask, 1,3-dibromo-5-methoxybenzene (50 g, 188 mmol), [1,1':3',1"-terphenyl]-2'-amine (97 g, 395 mmol), Pd₂dba₃ (8.6 g, 9.4 mmol), tris-tert-butyl phosphine (8.6 mL, 19.2 mmol) and sodium tert-butoxide (54 g, 564 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 53-a (white solid, 85 g, 76%). It was confirmed that the obtained white solid was Intermediate 53-a through ESI-LCMS.

ESI-LCMS: [M+H]⁺: C₄₃H₃₄N₂O. 594.2787.

### 2) Synthesis of Intermediate 53-b

In an argon atmosphere, in a 2 L flask, Intermediate 53-a (85 g, 142 mmol), 1-bromo-3-iodobenzene (200 g, 710 mmol), Pd₂dba₃ (13 g, 14.2 mmol), tris-tert-butyl phosphine (13 mL, 28.4 mmol), and sodium tert-butoxide (41 g, 426 mmol) were dissolved in 1 L of o-xylene, and the mixture was reflux-stirred at 160 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 53-b (white solid, 68 g, 53%). It was confirmed that the obtained white solid was Intermediate 53-b through ESI-LCMS.

ESI-LCMS: [M+H]⁺: C₅₅H₄₀N₂OBr₂. 904.1512.

### 3) Synthesis of Compound 53-c

In an argon atmosphere, in a 2 L flask, Intermediate 53-b (85 g, 142 mmol) was dissolved in 1 L of o-dichlorobenzene, and cooled to 0 °C using a water-ice container. BBr₃ (5 equiv.) was slowly added dropwise, and at a temperature raised to room temperature, the resulting product was stirred for 3 hours. After confirming that Intermediate 53-b was completely consumed using TLC, the temperature was raised to 140 °C and the obtained was stirred for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 53-c (yellow solid, 16 g, 12%). It was confirmed that the obtained yellow solid was Intermediate 53-c through ESI-LCMS.

ESI-LCMS: [M+H]⁺: C₅₄H₃₅N₂OBBr₂. 896.1107.

### 4) Synthesis of Intermediate 53-d

In an argon atmosphere, in a 2 L flask, Intermediate 53-c (16 g, 18 mmol) was dissolved in 200 mL of CH₂Cl₂, pyridine (1.2 equiv.) was added dropwise thereto, and the mixture was cooled to 0 °C using a water-ice container. Triflic anhydride (1.5 equiv.) was slowly added dropwise, and at a temperature raised to room temperature, the resulting product was stirred for 3 hours. An organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 53-d (yellow solid, 15 g, 81%). It was confirmed that the obtained yellow solid was Intermediate 53-d through ESI-LCMS.

ESI-LCMS: [M+H]⁺: C₅₅H₃₄N₂O₃BSF₃Br₂. 1028.0711.

### 5) Synthesis of Intermediate 53-e

In an argon atmosphere, in a 2 L flask , Intermediate 53-d (15 g, 15 mmol), dibenzo[b,d]furan-2-ylboronic acid (5 g, 23 mmol), potassium carbonate (6.2 g, 45 mmol), Pd(PPh₃)₄ (0.52 g, 0.45 mmol) were dissolved in 200 mL of toluene and 50 mL of water, and the mixture was reflux-stirred at 110 °C for 12 hours. An organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 53-e (yellow solid, 11 g, 76%). It was confirmed that the obtained yellow solid was Intermediate 53-e through ESI-LCMS.

ESI-LCMS: [M+H]⁺: C₆₆H₄₁N₂OBBr₂. 1046.1727.

### 6) Synthesis of Compound 53

In an argon atmosphere, in a 1 L flask, Intermediate 53-e (1 g, 1 mmol), carbazole (0.33 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 53 (yellow solid, 0.75 g, 62%). It was confirmed that the obtained yellow solid was Compound 53 through ESI-LCMS and ¹H-NMR.
ESI-LCMS: [M+H]⁺: C₉₀H₅₇N₄BO. 1220.4612.
¹H-NMR (400 MHz, CDCl₃): 8.92 (d, 2H), 8.55 (d, 4H), 7.94 (d, 4H), 7.81 (m, 4H), 7.56 (t, 4H), 7.43 (m, 14H), 7.32 (m, 8H), 7.20 (s, 2H), 6.93 (s, 2H).

### (6) Synthesis of Compound 62

Fused polycyclic compound 62 according to an embodiment may be synthesized by, for example, a reaction below.

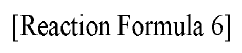

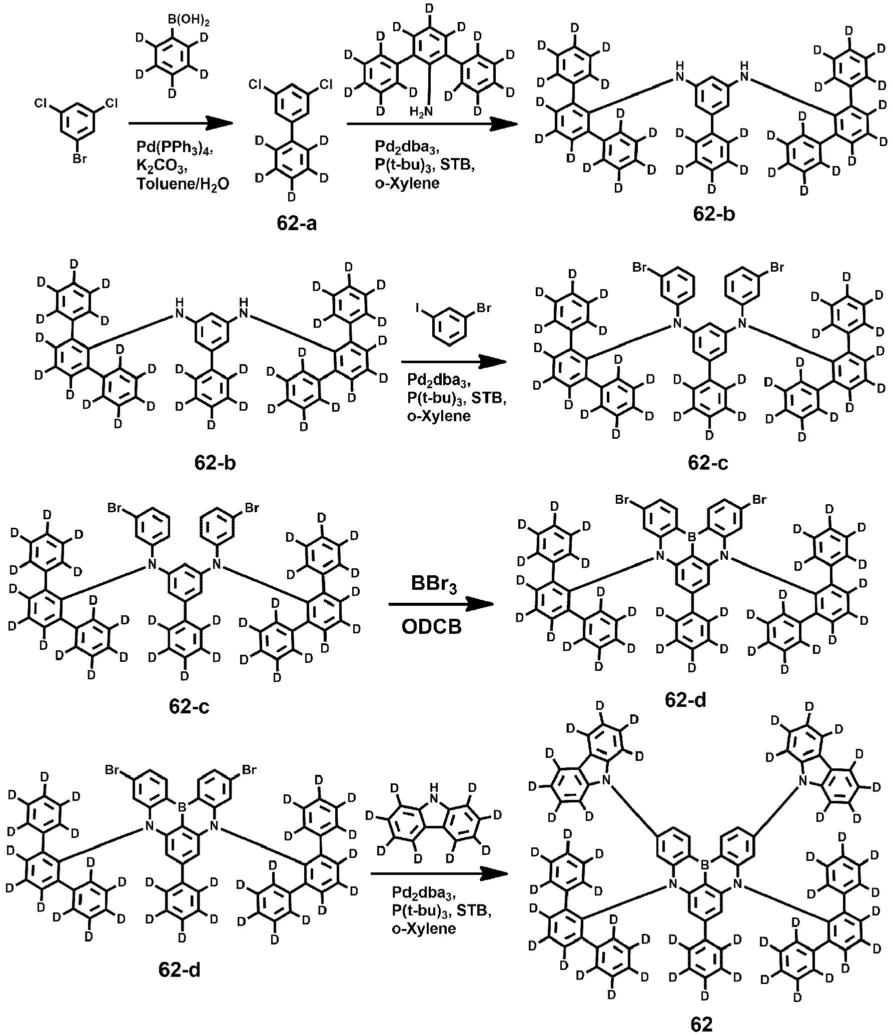

### 1) Synthesis of Intermediate 62-a

In an argon atmosphere, in a 2 L flask, 1,3-dichloro-5-bromobenzene (20 g, 88 mmol), d-5-phenyl-boronic acid (17 g, 132 mmol), Pd(PPh₃)₄ (3.1 g, 2.6 mmol), potassium carbonate (36 g, 264 mmol) were dissolved in 600 mL of toluene and 150 mL of water, and the mixture was reflux-stirred at 110 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 62-a (colorless liquid, 13 g, 65%). It was confirmed that the obtained colorless liquid was Compound 62-a through ESI-LCMS.

ESI-LCMS: [M+H]⁺: C₁₂H₃Cl₂D₅. 227.0312.

### 2) Synthesis of Intermediate 62-b

In an argon atmosphere, in a 2 L flask, Intermediate 62-a (13 g, 57 mmol), [1,1':3',1"-terphenyl]-d13-2'-amine (31 g, 119 mmol), Pd₂dba₃ (2.6 g, 2.9 mmol), tris-tert-butyl phosphine (2.6 mL, 5.8 mmol), and sodium tert-butoxide (16 g, 171 mmol) were dissolved in 500 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 62-b (white solid, 30 g, 78%). It was confirmed that the obtained white solid was Intermediate 62-b through ESI-LCMS.

ESI-LCMS: [M+H]⁺: C₄₈H₅N₂D₃₁. 671.4812.

### 3) Synthesis of Intermediate 62-c

In an argon atmosphere, in a 2 L flask, Intermediate 62-b (30 g, 44 mmol), 1-bromo-3-iodobenzene (63 g, 223 mmol), Pd₂dba₃ (4.0 g, 4.4 mmol), tris-tert-butyl phosphine (4.0 mL, 8.8 mmol), and sodium tert-butoxide (13 g, 132 mmol) were dissolved in 500 mL of o-xylene, and the mixture was reflux-stirred at 160 °C for 24 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 62-c (white solid, 22 g, 51%). It was confirmed that the obtained white solid was Intermediate 62-c through ESI-LCMS.

ESI-LCMS: [M+H]⁺: C₆₀H₁₁N₂D₃₁Br₂. 979.3701.

### 4) Synthesis of Intermediate 62-d

In an argon atmosphere, Intermediate 62-c (20 g, 20 mmol) was placed in a 2 L flask and dissolved in 500 mL of o-dichlorobenzene. BBr₃ (1.5 equiv.) was slowly dropped to 0 °C using an ice-water container, and at a temperature raised to 140 °C, the resulting product was stirred for 12 hours. After cooling, an organic layer was separated through extraction with CH₂Cl₂ and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 62-d (yellow solid, 1.5 g, 8%). It was confirmed that the obtained yellow solid was Intermediate 62-d through ESI-LCMS.

ESI-LCMS: [M+H]⁺: C₆₀H₈N₂BBr₂D₃₁. 987.3517.

### 5) Synthesis of Compound 62

In an argon atmosphere, in a 1 L flask, Intermediate 62-d (1 g, 1 mmol), 9H-carbazole-1,2,3,4,5,6,7,8-d8 (0.35 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 62 (yellow solid, 0.73 g, 62%). It was confirmed that the obtained yellow solid was Compound 62 through ESI-LCMS and ¹H-NMR.
ESI-LCMS: [M+H]⁺: C₈₄H₈N₄BD₄₇. 1177.7575.
¹H-NMR (400 MHz, CDCl₃): 8.84 (d, 2H), 8.20 (d, 4H), 7.41 (m, 17H), 7.24 (m, 8H), 7.12 (m, 20H), 6.93 (s, 2H), 6.84 (d, 2H), 6.71 (s, 2H).

### (7) Synthesis of Compound 64

Fused polycyclic compound 64 according to an embodiment may be synthesized by, for example, a reaction below.

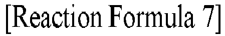

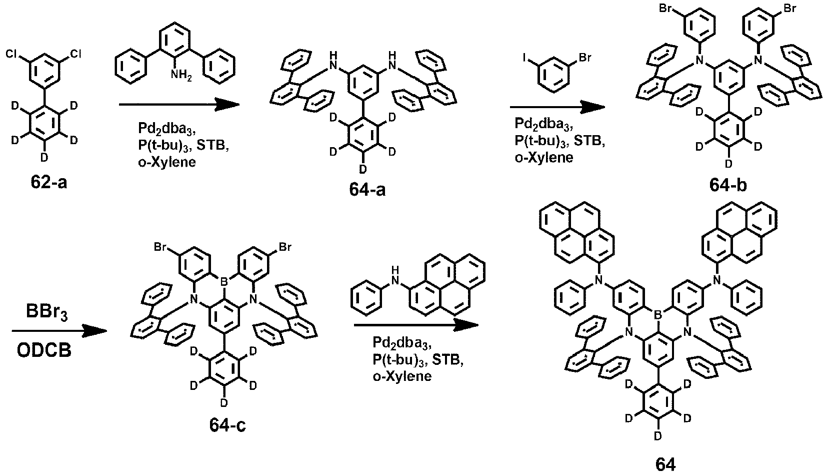

### 1) Synthesis of Intermediate 64-a

In an argon atmosphere, in a 2 L flask, Intermediate 62-a (10 g, 88 mmol), [1,1':3',1"-terphenyl]-2'-amine (45 g, 184 mmol), Pd₂dba₃ (4.0 g, 4.4 mmol), tris-tert-butyl phosphine (4.0 mL, 8.8 mmol), and sodium tert-butoxide (26 g, 264 mmol) were dissolved in 1 L of o-xylene, and the mixture was stirred at 140 °C for 6 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 64-a (white solid, 37.5 g, 66%). It was confirmed that the obtained white solid was Intermediate 64-a through ESI-LCMS.

ESI-LCMS: [M+H]⁺: C₄₈H₃₁N₂D₅. 645.3212.

### 2) Synthesis of Intermediate 64-b

In an argon atmosphere, in a 2 L flask, Intermediate 64-a (35 g, 54 mmol), 1-bromo-3-iodobenzene (77 g, 270 mmol), Pd₂dba₃ (5.0 g, 5.4 mmol), tris-tert-butyl phosphine (5.0 mL, 10.8 mmol), and sodium tert-butoxide (16 g, 162 mmol) were dissolved in 500 mL of o-xylene, and the mixture was reflux-stirred at 160 °C for 24 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 64-b (white solid, 24.7 g, 48%). It was confirmed that the obtained white solid was Intermediate 64-b through ESI-LCMS.

ESI-LCMS: [M+H]⁺: C₆₀H₃₇N₂D₅Br₂. 953.1991.

### 3) Synthesis of Intermediate 64-c

In an argon atmosphere, Intermediate 64-b (24 g, 25 mmol) was placed in a 2 L flask and dissolved in 500 mL of o-dichlorobenzene. BBr₃ (1.5 equiv.) was slowly dropped to 0 °C using an ice-water container, and at a temperature raised to 140 °C, the resulting product was stirred for 12 hours. After cooling, an organic layer was separated through extraction with CH₂Cl₂ and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 64-c (yellow solid, 1.6 g, 7%). It was confirmed that the obtained yellow solid was Intermediate 64-c through ESI-LCMS.

ESI-LCMS: [M+H]⁺: C₆₀H₃₄N₂BBr₂D₅. 961.1887.

### 4) Synthesis of Compound 64

In an argon atmosphere, in a 1 L flask, Intermediate 64-c (1 g, 1 mmol), N-phenylpyren-1-amine (0.59 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 64 (yellow solid, 1.06 g, 77%). It was confirmed that the obtained yellow solid was Compound 64 through ESI-LCMS and ¹H-NMR.
ESI-LCMS: [M+H]⁺: C₁₀₄H₆₂N₄BD₅. 1387.5858.
¹H-NMR (400 MHz, CDCl₃): 9.12 (d, 2H), 8.31 (d, 2H), 8.20 (d, 4H), 8.10 (m, 10H), 7.92 (d, 2H), 7.60 (d, 4H), 7.34 (m, 14H), 7.24 (t, 4H), 7.00 (m, 16H), 6.83 (d, 2H), 6.68 (s, 2H).

### (8) Synthesis of Compound 69

Fused polycyclic compound 69 according to an embodiment may be synthesized by, for example, a reaction below.

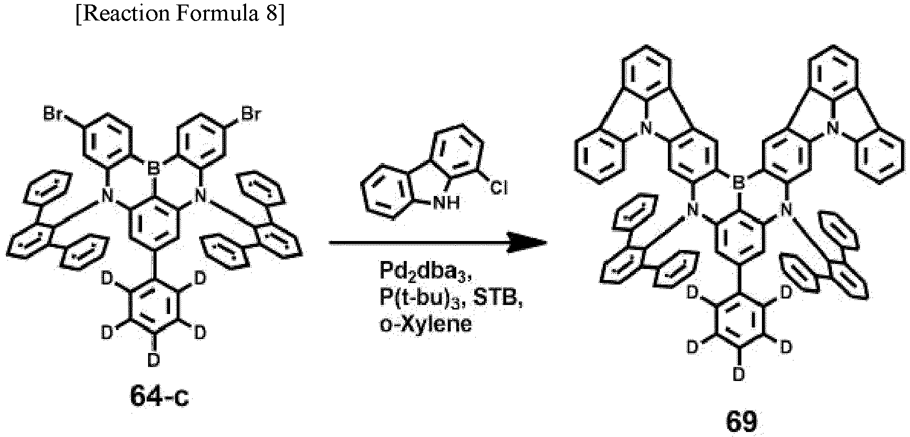

In an argon atmosphere, in a 1 L flask, Intermediate 64-c (1 g, 1 mmol), 1-chloro-9H-carbazole (0.4 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 69 (yellow solid, 1.01 g, 79%). It was confirmed that the obtained yellow solid was Compound 69 through ESI-LCMS and ¹H-NMR.
ESI-LCMS: [M+H]⁺: C₈₄H₄₆N₄BD₅. 1131.4517.
¹H-NMR (400 MHz, CDCl₃): 9.22 (d, 2H), 8.29 (d, 2H), 8.19 (d, 4H), 7.95 (d, 4H), 7.58 (d, 2H), 7.43 (m, 16H), 7.20 (m, 4H), 7.05 (m, 8H), 6.93 (s, 2H).

### (9) Synthesis of Compound 79

Fused polycyclic compound 79 according to an embodiment may be synthesized by, for example, a reaction below.

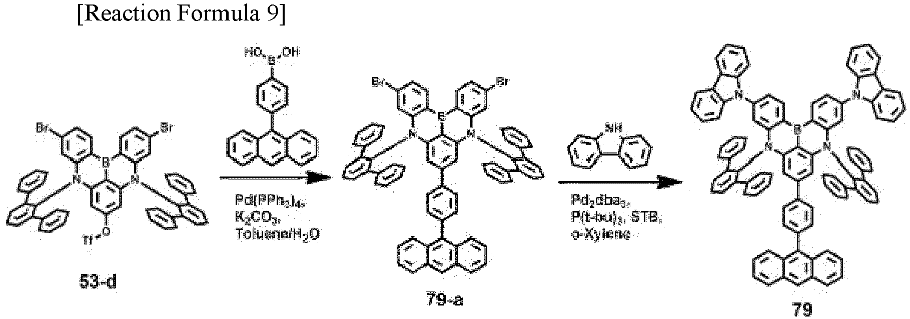

### 1) Synthesis of Intermediate 79-a

In an argon atmosphere, in a 2 L flask, Intermediate 53-d (10 g, 9.7 mmol), (4-(anthracen-9-yl)phenyl)boronic acid (4.3 g, 14.5 mmol), Pd(PPh₃)₄ (0.3 g, 0.3 mmol), potassium carbonate (40 g, 291 mmol) were dissolved in 800 mL of toluene and 200 mL of water, and the mixture was reflux-stirred at 110 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 79-a (white solid, 8 g, 73%). It was confirmed that the obtained white solid was Intermediate 79-a through ESI-LCMS.

ESI-LCMS: [M+H]⁺: C₇₄H₄₇Br₂N₂B. 1132.1722.

### 2) Synthesis of Compound 79

In an argon atmosphere, in a 1 L flask, Intermediate 79-a (1.14 g, 1 mmol), carbazole (0.34 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 79 (yellow solid, 0.86 g, 83%). It was confirmed that the obtained yellow solid was Compound 79 through ESI-LCMS and ¹H-NMR.
ESI-LCMS: [M+H]⁺: C₉₈H₆₃N₄B. 1306.5007.
¹H-NMR (400 MHz, CDCl₃): 8.87 (d, 2H), 8.55 (d, 2H), 8.39 (s, 1H), 8.21 (d, 6H), 8.03 (d, 2H), 7.94 (d, 4H), 7.53 (t, 4H), 7.42 (d, 2H), 7.35 (m, 18H), 7.24 (m, 4H), 7.09 (m, 12H), 7.01 (s, 2H).

### (10) Synthesis of Compound 84

Fused polycyclic Compound 84 according to an embodiment may be synthesized by, for example, a reaction below.

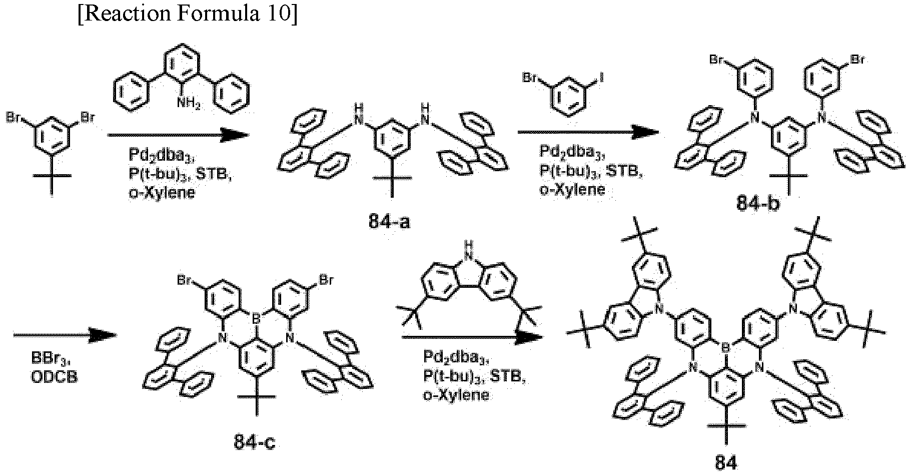

### 1) Synthesis of Intermediate 84-a

In an argon atmosphere, in a 1 L flask, 1,3-dibromo-5-(tert-butyl)benzene (10 g, 34 mmol), [1,1':3',1"-terphenyl]-2'-amine (17 g, 68 mmol), Pd₂dba₃ (1.55 g, 1.7 mmol), tris-tert-butyl phosphine (1.6 mL, 3.4 mmol), and sodium tert-butoxide (9.5 g, 102 mmol) were dissolved in 400 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 84-a (white solid, 16 g, 77%). It was confirmed that the obtained white solid was Intermediate 84-a through ESI-LCMS.

ESI-LCMS: [M+H]⁺: C₄₆H₄₀N₂. 620.3232.

### 2) Synthesis of Intermediate 84-b

In an argon atmosphere, in a 1 L flask, Intermediate 84-a (16 g, 25 mmol), 1-Iodo-3-bromobenzene (35 g, 125 mmol), Pd₂dba₃ (2.2 g, 2.5 mmol), tris-tert-butyl phosphine (2.3 mL, 5.0 mmol), and sodium tert-butoxide (9.5 g, 102 mmol) were dissolved in 250 mL of o-xylene, and the mixture was stirred at 160 °C for 24 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 84-b (white solid, 10 g, 46%). It was confirmed that the obtained white solid was Intermediate 84-b through ESI-LCMS.

ESI-LCMS: [M+H]⁺: C₅₈H₄₆N2Br₂. 928.1997.

### 3) Synthesis of Intermediate 84-c

In an argon atmosphere, Intermediate 84-b (10 g, 10.7 mmol) was placed in a 1 L flask and dissolved in 200 mL of o-dichlorobenzene. The mixed solution was cooled to 0 °C, and BBr₃ (5 equiv.) was slowly added dropwise thereto, and at a temperature raised to 180 °C, the resulting product was stirred for 24 hours. After cooling, triethylamine was added to complete the reaction, and a solvent was removed at reduced pressure. CH₂Cl₂ and hexane were used as developing solvents to purify and separate the resulting product through column chromatography using silica gel, thereby obtaining Intermediate 84-c (yellow solid, 1.1 g, 11%). It was confirmed that the obtained yellow solid was Intermediate 84-c through ESI-LCMS.

ESI-LCMS: [M+H]⁺: C₅₈H₄₃N₂BBr₂. 936.1889.

### 4) Synthesis of Compound 84

In an argon atmosphere, in a 1 L flask, Intermediate 84-c (1 g, 1 mmol), 3,6-di-tert-butyl carbazole (0.66 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 84 (yellow solid, 1.1 g, 78%). It was confirmed that the obtained yellow solid was Compound 84 through ESI-LCMS and ¹H-NMR.
ESI-LCMS: [M+H]⁺: C₉₈H₉₁N₄B. 1334.7473.
¹H-NMR (400 MHz, CDCl₃): 8.92 (d, 2H), 8.36 (s, 4H), 8.20 (d, 4H), 7.69 (d, 8H), 7.43 (m, 12H), 7.12 (m, 10H), 1.43 (s, 36H), 1.32 (s, 9H).

### (11) Synthesis of Compound 95

Fused polycyclic Compound 95 according to an embodiment may be synthesized by, for example, a reaction below.

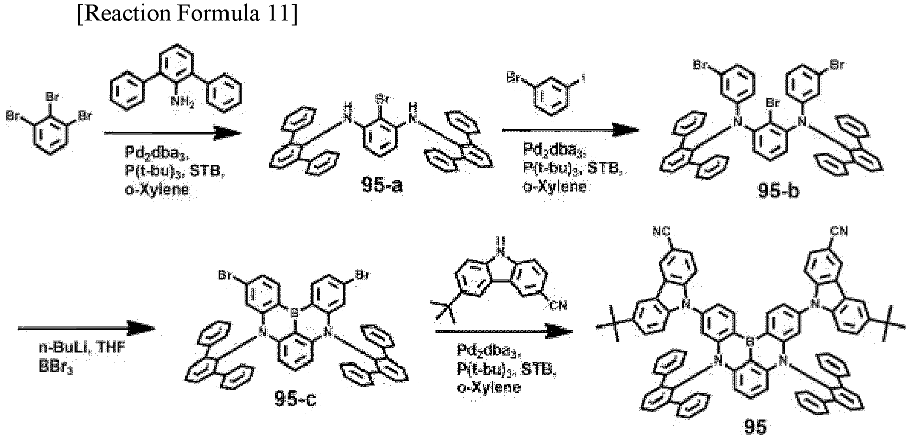

### 1) Synthesis of Intermediate 95-a

In an argon atmosphere, in a 1 L flask, 1,2,3-tribromobenzene (10 g, 32 mmol), [1,1':3',1"-terphenyl]-2'-amine (17 g, 68 mmol), Pd₂dba₃ (1.55 g, 1.7 mmol), tris-tert-butyl phosphine (1.6 mL, 3.4 mmol), and sodium tert-butoxide (9.5 g, 102 mmol) were dissolved in 400 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 95-a (white solid, 16.3 g, 82%). It was confirmed that the obtained white solid was Intermediate 95-a through ESI-LCMS.

ESI-LCMS: [M+H]⁺: C₄₂H₃₁N₂Br. 642.1721.

### 2) Synthesis of Intermediate 95-b

In an argon atmosphere, in a 1 L flask, Intermediate 95-a (16 g, 25 mmol), 1-Iodo-3-chlorobenzene (35 g, 125 mmol), Pd₂dba₃ (2.2 g, 2.5 mmol), tris-tert-butyl phosphine (2.3 mL, 5.0 mmol), and sodium tert-butoxide (9.5 g, 102 mmol) were dissolved in 250 mL of o-xylene, and the mixture was stirred at 160 °C for 24 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 95-b (white solid, 12 g, 51%). It was confirmed that the obtained white solid was Intermediate 95-b through ESI-LCMS.

ESI-LCMS: [M+H]⁺: C₅₄H₃₇N₂Br₃. 951.0991.

### 3) Synthesis of Intermediate 95-c

In an argon atmosphere, Intermediate 95-b (12 g, 12.5 mmol) was placed in a 1 L flask and dissolved in 250 mL of THF. The mixed solution was cooled to -78 °C and n-BuLi. (1.2 equiv.) was slowly added dropwise. At a temperature raised to room temperature, the resulting product was stirred for 3 hours, and again cooled to -40 °C, and BBr₃ (5 equiv.) was slowly added dropwise. After slowly raising the temperature to room temperature, the obtained was stirred for 30 minutes, diisopropylethylamine was added thereto, the temperature was raised to 80 °C, and the mixture was stirred for 24 hours. After cooling, a solvent was removed at reduced pressure, and CH₂Cl₂ and hexane were used as developing solvents to purify and separate the resulting product through column chromatography using silica gel, thereby obtaining Intermediate 95-c (yellow solid, 0.99 g, 10%). It was confirmed that the obtained yellow solid was Intermediate 95-c through ESI-LCMS.

ESI-LCMS: [M+H]⁺: C₅₄H₃₅N₂BBr₂. 881.1239.

### 4) Synthesis of Compound 95

In an argon atmosphere, in a 1 L flask, Intermediate 95-c (0.9 g, 1 mmol), 6-(tert-butyl)-9H-carbazole-3-carbonitrile (0.5 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 95 (yellow solid, 0.79 g, 65%). It was confirmed that the obtained yellow solid was Compound 95 through ESI-LCMS and ¹H-NMR.
ESI-LCMS: [M+H]⁺: C₈₈H₆₅N₆B. 1217.5434.
¹H-NMR (400 MHz, CDCl₃): 9.43 (d, 2H), 8.95 (s, 2H), 8.31 (d, 4H), 7.86 (d, 8H), 7.43 (m, 19H), 7.11 (m, 10H), 6.83 (d, 2H), 1.43 (s, 18H).

### (12) Synthesis of Compound 103

Fused polycyclic compound 103 according to an embodiment may be synthesized by, for example, a reaction below.

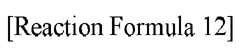

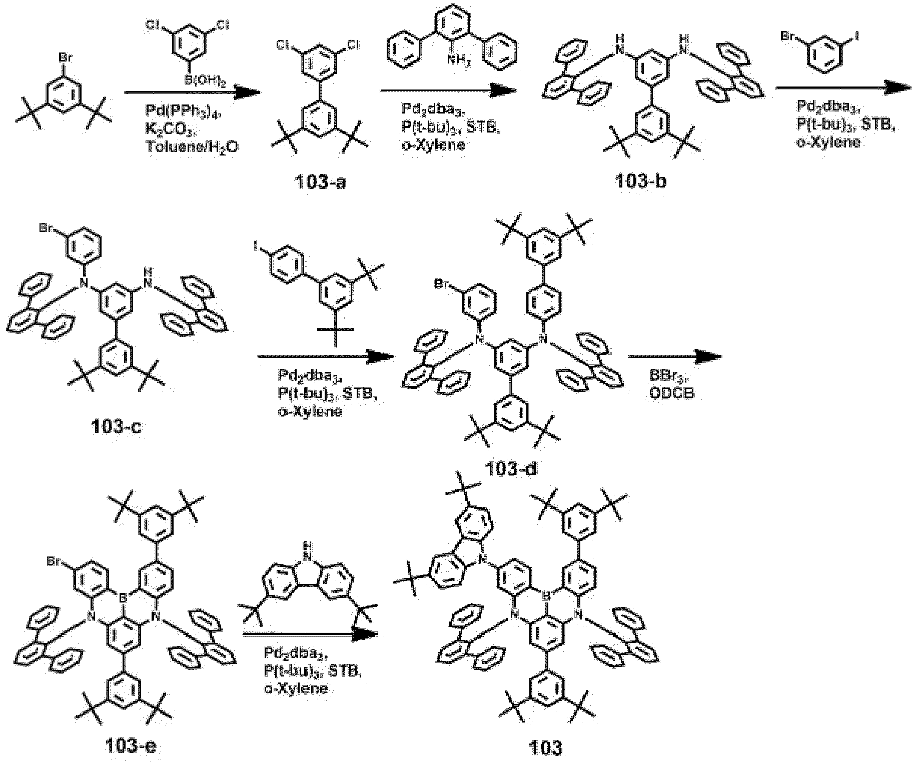

### 1) Synthesis of Intermediate 103-a

In an argon atmosphere, in a 1 L flask, 3,5-di-tert-butyl-1-bromobenzene (10 g, 37 mmol), 3,5-dichloro-1-boronic acid (14 g, 74 mmol), Pd(PPh₃)₄ (1.3 g, 1.1 mmol), potassium carbonate (15 g, 111 mmol) were dissolved in 400 mL of toluene and 150 mL of water, and the mixture was reflux-stirred at 110 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 103-a (white solid, 7.8 g, 63%). It was confirmed that the obtained white solid was Intermediate 103-a through ESI-LCMS.

ESI-LCMS: [M+H]⁺: C₂₀H₂₄Cl₂. 334.1231.

### 2) Synthesis of Intermediate 103-b

In an argon atmosphere, in a 1 L flask, Intermediate 103-a (7.5 g, 22 mmol), [1,1':3',1"-terphenyl]-2'-amine (12 g, 44 mmol), Pd₂dba₃ (1.55 g, 1.7 mmol), tris-tert-butyl phosphine (1.6 mL, 3.4 mmol), and sodium tert-butoxide (9.5 g, 102 mmol) were dissolved in 400 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 103-b (white solid, 13.5 g, 83%). It was confirmed that the obtained white solid was Intermediate 103-b through ESI-LCMS.

ESI-LCMS: [M+H]⁺: C₅₆H₅₂N₂. 752.4119.

### 3) Synthesis of Intermediate 103-c

In an argon atmosphere, in a 1 L flask, Intermediate 103-b (13 g, 17 mmol), 1-Iodo-3-chlorobenzene (5 g, 17 mmol), Pd₂dba₃ (0.77 g, 0.9 mmol), tris-tert-butyl phosphine (0.8 mL, 1.8 mmol), and sodium tert-butoxide (5 g, 51 mmol) were dissolved in 200 mL of o-xylene, and the mixture was stirred at 160 °C for 24 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 103-c (white solid, 8.6 g, 56%). It was confirmed that the obtained white solid was Intermediate 103-c through ESI-LCMS.

ESI-LCMS: [M+H]⁺: C₆₂H₅₅N₂Br. 906.3535.

### 4) Synthesis of Intermediate 103-d

In an argon atmosphere, in a 1 L flask, Intermediate 103-c (8 g, 8.8 mmol), 3,5-di-tert-butyl-4'-iodo-1,1'-biphenyl (4 g, 10 mmol), Pd₂dba₃ (0.45 g, 0.5 mmol), tris-tert-butyl phosphine (0.5 mL, 1 mmol), and sodium tert-butoxide (2.9 g, 30 mmol) were dissolved in 200 mL of o-xylene, and the mixture was stirred at 160 °C for 24 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 103-d (white solid, 8.6 g, 56%). It was confirmed that the obtained white solid was Intermediate 103-d through ESI-LCMS.

ESI-LCMS: [M+H]⁺: C₈₂H₇₉N₂Br. 1170.5434.

### 5) Synthesis of Intermediate 103-e

In an argon atmosphere, Intermediate 103-d (8 g, 7 mmol) was placed in a 1 L flask and dissolved in 160 mL of o-dichlorobenzene. The mixed solution was cooled to 0 °C, and BBr₃ (5 equiv.) was slowly added dropwise thereto, and at a temperature raised to 180 °C, the resulting product was stirred for 24 hours. After cooling, triethylamine was added to complete the reaction, and a solvent was removed at reduced pressure. CH₂Cl₂ and hexane were used as developing solvents to purify and separate the resulting product through column chromatography using silica gel, thereby obtaining Intermediate 103-e (yellow solid, 0.96 g, 12%). It was confirmed that the obtained yellow solid was Intermediate 103-e through ESI-LCMS.

ESI-LCMS: [M+H]⁺: C₈₂H₇₆N₂BBr₂. 1178.5331.

### 6) Synthesis of Compound 103

In an argon atmosphere, in a 1 L flask, Intermediate 103-e (1.2 g, 1 mmol), 3,6-di-tert-butyl carbazole (0.66 g, 2 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 103 (yellow solid, 1 g, 74%). It was confirmed that the obtained yellow solid was Compound 103 through ESI-LCMS and ¹H-NMR.
ESI-LCMS: [M+H]⁺: C₁₀₂H₁₀₀N₃B. 1377.7991.
¹H-NMR (400 MHz, CDCl₃): 9.12 (d, 2H), 8.92 (s, 2H), 8.36 (s, 2H), 8.20 (d, 4H), 7.86 (d, 1H), 7.73 (s, 4H), 7.55 (s, 3H), 7.43 (m, 17H), 7.23 (m, 2H), 7.08 (m, 9H), 6.89 (s, 2H), 1.43 (s, 18H), 1.32 (s, 18H), 1.22 (s, 18H).

### (13) Synthesis of Compound 114

Fused polycyclic Compound 114 according to an embodiment may be synthesized by, for example, a reaction below.

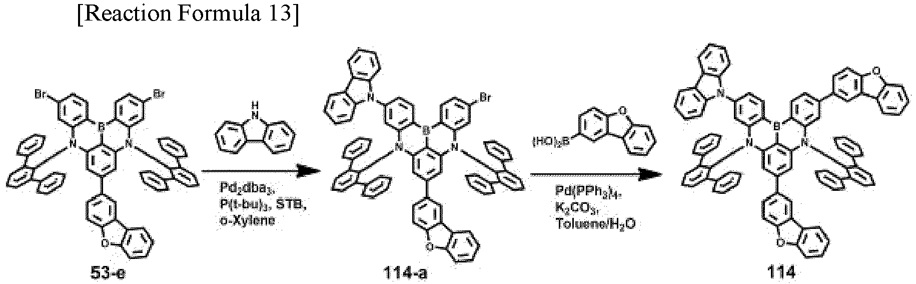

### 1) Synthesis of Intermediate 114-a

In an argon atmosphere, in a 1 L flask, Intermediate 53-e (1 g, 1 mmol), carbazole (0.14 g, 1 mmol), Pd₂dba₃ (0.05 g, 0.05 mmol), tris-tert-butyl phosphine (0.05 mL, 0.1 mmol), and sodium tert-butoxide (0.3 g, 3 mmol) were dissolved in 20 mL of o-xylene, and the mixture was stirred at 140 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Intermediate 114-a (yellow solid, 0.6 g, 62%). It was confirmed that the obtained yellow solid was Intermediate 114-a through ESI-LCMS.

ESI-LCMS: [M+H]⁺: C₇₈H₄₉N₃BOBr. 1133.3221.

### 2) Synthesis of Compound 114

In an argon atmosphere, in a 1 L flask, Intermediate 114-a (0.6 g, 0.5 mmol), Dibenzofuran-2-ylboronic acid (0.22 g, 1 mmol), Pd(PPh₃)₄ (0.02 g, 0.02 mmol), potassium carbonate (0.2 g, 1.5 mmol) were dissolved in 10 mL of toluene and 3 mL of water, and the mixture was reflux-stirred at 110 °C for 12 hours. After cooling, an organic layer was separated through extraction with ethyl acetate and water, dried over MgSO₄, and filtered. The organic layers were collected, and a solvent was removed at reduced pressure, and CH₂Cl₂ and hexane were used as developing solvents to purify and separate the resulting product through column chromatography using silica gel, thereby obtaining Compound 114 (yellow solid, 0.5 g, 81%). It was confirmed that the obtained yellow solid was Compound 114 through ESI-LCMS and ¹H-NMR.
ESI-LCMS: [M+H]⁺: C₉₀H₅₆N₃BO₂. 1221.4537.
¹H-NMR (400 MHz, CDCl₃): 8.84 (d, 2H), 8.55 (d, 4H), 8.21 (m, 4H), 7.88 (m, 8H), 7.53 (m, 14H), 7.42 (m, 22H), 6.81 (s, 2H).

### 2. Evaluation of physical properties of fused polycyclic compounds

Various physical properties were measured for compounds of Examples and Comparative Examples in Table 1. A light emission spectrum of films formed by depositing each compound on a substrate was measured at room temperature. The results are shown in Table 1.

In Table 1, HOMO energy level and LUMO energy level were measured using Smart Manager software of SP2 electrochemical workstation equipment from ZIVE LAB. λ_{Abs} was measured using Labsolution UV-Vis software with a Deuterium/Tungsten-Halogen light source and silicon photodiode mounted on SHIMADZU's UV-1800 UV/Visible Scanning Spectrophotometer equipment. λₑₘᵢ, λ_{film}, and full-width quarter maximum (FWQM) were measured using FluorEssence software with a xenon light source and monochromator mounted on HORIBA's fluoromax+ spectrometer. FWQM was measured in solution state by providing toluene as a solvent. Photoluminescence quantum yield (PLQY) was measured using PLQY measurement software with a xenon light source, monochromator, photonic multichannel analyzer, and integrating sphere mounted on Hamamatsu's Quantaurus-QY Absolute PL quantum yield spectrometer. Lifespan of compounds (τ, lifetimes) were measured using Hamamatsu's Transient fluorescence lifetime spectrometer (with streak camera mounted thereon), PLP-10 Laser diode (M10306, excitation source), and laser control panel program, and were analyzed in an analyze mode using Fitting: u8167 program. Stokes-shift indicates a difference between a maximum wavelength when energy is absorbed and a maximum wavelength when energy is emitted.

### (Example Compounds)

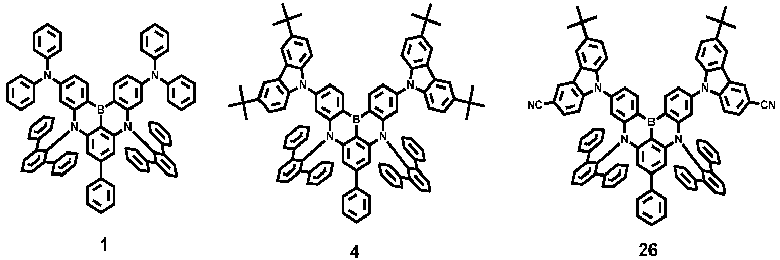

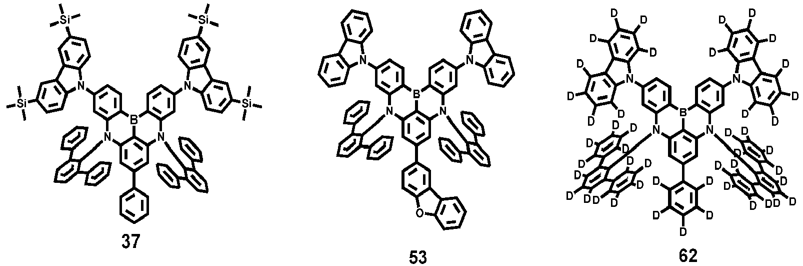

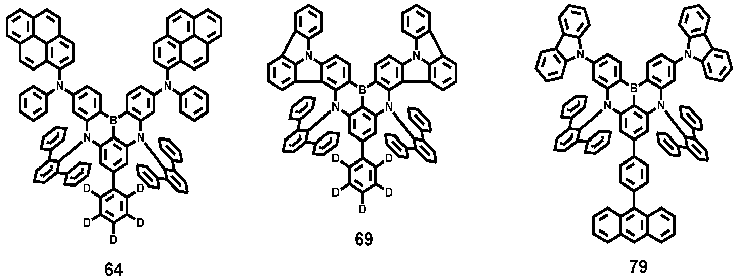

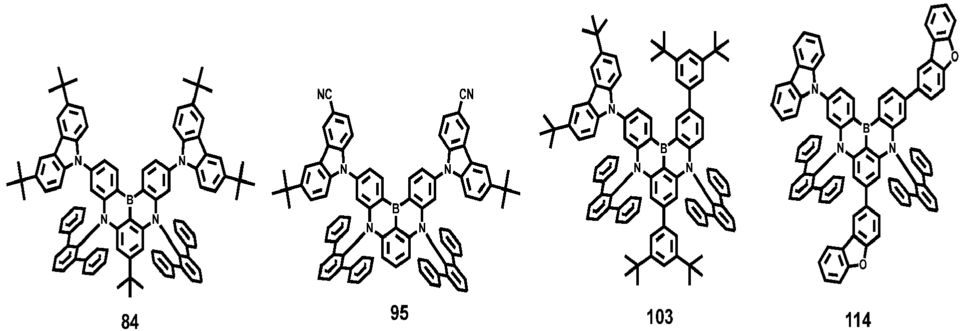

### (Comparative Example Compounds)

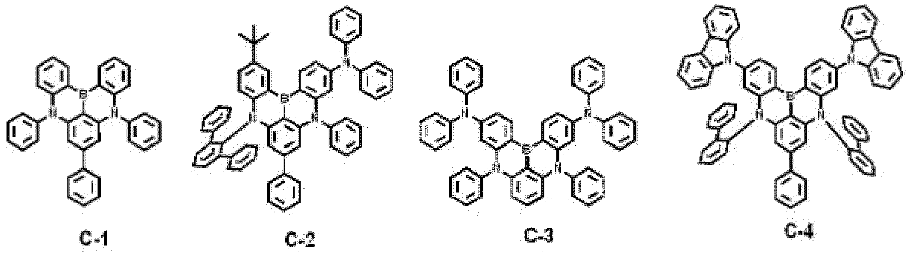

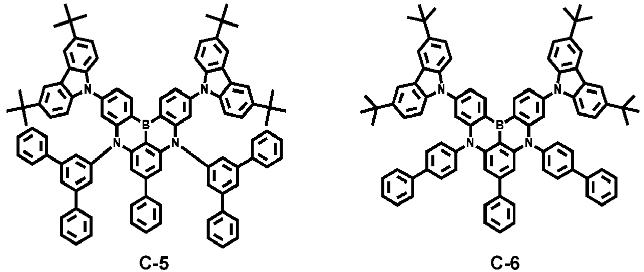

**[Table 1]**

| Compou nd example | HOM O (eV) | LUM O (eV) | S1 (eV) | T1 (eV) | DE_{ST} (eV) | τ (ms) | PLQY (%) | λ_{Abs} (nm) | λₑₘᵢ (nm) | λ_{filmm3} (nm) | Stokes -shift (nm) | FWQ M (sol.) |
|---|---|---|---|---|---|---|---|---|---|---|---|---|
| Compou nd 1 | -5.14 | -2.34 | 2.72 | 2.55 | 0.17 | 85 | 85.2 | 443 | 456 | 458 | 13 | 29 |
| Compou nd 4 | -5.42 | -2.36 | 2.69 | 2.53 | 0.16 | 72 | 83.2 | 449 | 461 | 463 | 12 | 34 |
| Compou nd 26 | -5.50 | -2.44 | 2.67 | 2.52 | 0.15 | 74 | 88.7 | 451 | 464 | 466 | 13 | 34 |
| Compou nd 37 | -5.43 | -2.37 | 2.68 | 2.52 | 0.16 | 77 | 85.8 | 450 | 462 | 464 | 12 | 34 |
| Compou nd 53 | -5.24 | -2.33 | 2.70 | 2.56 | 0.14 | 70 | 94.9 | 448 | 461 | 463 | 13 | 36 |
| Compou nd 62 | -5.47 | -2.41 | 2.68 | 2.53 | 0.15 | 76 | 85 | 449 | 462 | 464 | 13 | 36 |
| Compou nd 64 | -5.12 | -2.32 | 2.71 | 1.96 | 0.75 | - | 80.1 | 446 | 458 | 460 | 12 | 28 |
| Compou nd 69 | -5.28 | -2.31 | 2.70 | 2.49 | 0.21 | 156 | 90.3 | 453 | 465 | 467 | 12 | 29 |
| Compou nd 79 | -5.32 | -2.35 | 2.64 | - | - | - | 88.4 | 449 | 461 | 463 | 12 | 34 |
| Compou nd 84 | -5.34 | -2.27 | 2.71 | 2.61 | 0.10 | 29 | 92.5 | 446 | 457 | 460 | 11 | 35 |
| Compou nd 95 | -5.31 | -2.28 | 2.72 | 2.53 | 0.19 | 53 | 86.7 | 448 | 458 | 460 | 10 | 32 |
| Compou nd 103 | -5.23 | -2.28 | 2.70 | 2.53 | 0.17 | 39 | 86.7 | 448 | 461 | 463 | 12 | 36 |
| Compou nd 114 | -5.47 | -2.41 | 2.68 | 2.54 | 0.14 | 77 | 84.2 | 450 | 463 | 465 | 13 | 35 |
| Compou nd C-1 | -5.05 | -2.33 | 2.70 | 2.50 | 0.20 | 93 | 66.1 | 442 | 458 | 467 | 16 | 42 |
| Compou nd C-2 | -5.12 | -2.32 | 2.71 | 2.53 | 0.18 | 82 | 74.3 | 444 | 458 | 463 | 14 | 39 |
| Compou nd C-3 | -5.26 | -2.33 | 2.69 | 2.53 | 0.16 | 65 | 72.9 | 442 | 456 | 462 | 14 | 32 |
| Compou nd C-4 | -5.33 | -2.41 | 2.71 | 2.55 | 0.16 | 83 | 62.1 | 449 | 463 | 466 | 14 | 36 |

Referring to Table 1, it is seen that compared to the compounds of Comparative Examples Compounds C-1 to C-4, compounds 1, 4, 26, 37, 53, 62, 64, 69, 79, 84, 95, 103, and 114 have satisfactory photoluminescence quantum yield (PLQY). It can be seen that compounds 1, 4, 26, 37, 53, 62, 64, 69, 79, 84, 95, 103, and 114 have a photoluminescence quantum yield (PLQY) equal to or greater than 80%. It can be seen that Compounds 1, 4, 26, 37, 53, 62, 64, 69, 79, 84, 95, 103, and 114 have a difference in wavelength according to Stokes-shift in a range of about 10 nm to about 13 nm. Compounds 1, 4, 26, 37, 53, 62, 64, 69, 79, 84, 95, 103, and 114 are fused polycyclic compounds according to an embodiment.

### 3. Manufacture and Evaluation of an organic electroluminescence device including a fused polycyclic compound

An organic electroluminescence device according to an embodiment including compounds of Examples and Comparative Examples in an emission layer were manufactured using a method below.

### (1) Manufacture of organic electroluminescence device 1

As a first electrode, a glass substrate having an ITO electrode (Corning Inc, 15 Ω/cm², 1200 Å) formed thereon was cut to a size of about 50 mm x 50 mm x 0.7 mm, subjected to ultrasonic cleaning using isopropyl alcohol and pure water for 5 minutes respectively and ultraviolet irradiation for 30 minutes, and exposed to ozone for cleaning to be mounted on a vacuum deposition apparatus.

On the first electrode, a hole injection layer having a thickness of 300 Å was formed through deposition of NPD, and on the hole injection layer, a hole transport layer having a thickness of 200 Å was formed through deposition of H-1-19, and on the hole transport layer, an electron blocking layer having a thickness of 100 Å was formed through deposition of CzSi.

On the electron blocking layer, a host compound in which a first host HT and a second host ET are mixed in a ratio of 1:1 as shown in Table 2 and a compound of an Example or a compound of a Comparative Example were co-deposited at a weight ratio of 97:3 to form an emission layer having a thickness of 200 Å.

On the emission layer, a hole blocking layer having a thickness of 200 Å was formed through deposition of TSPO1. On the hole blocking layer, an electron transport layer having a thickness of 300 Å was formed through deposition of TPBi. On the electron transport layer, an electron injection layer having a thickness of 10 Å was formed through deposition of LiF. On the electron injection layer, a second electrode having a thickness of 3000 Å was formed through deposition of Al. On the electrode, a capping layer having a thickness of 700 Å was formed through deposition of P4 to manufacture an organic electroluminescence device. The compounds used in the manufacture of an organic electroluminescence device are shown below.

Table 2 shows results of evaluation on organic electroluminescence devices for Examples 1 to 9, and Comparative Examples 1 to 4. In the characteristic evaluation results for Examples and Comparative Examples, driving voltage (V) at a current density of 1000cd/m², luminous efficiency (Cd/A), and light emission color each were measured using Keithley MU 236 and a luminance meter PR650, and a time taken for luminance to reach 95% with respect to an initial luminance was measured as lifetime T₉₅, and relative lifetime was calculated with respect to Comparative Example 1, and the results are shown for each.

### (2) Manufacture of organic electroluminescence device 2

An organic electroluminescence device was manufactured as in the manufacture of organic electroluminescence device 1, except that a host compound in which the first host HT and the second host ET are mixed at a ratio of 1:1, a sensitizer PS2, and a compound of Example or a compound of Comparative Example were co-deposited at a weight ratio of 85: 14: 1 to form an emission layer having a thickness of 200 Å on an electron blocking layer as shown in Tables 3 to 5 and 7.

Tables 3 to 5 and 7 show evaluation results of the organic electroluminescence devices for Examples 10 to 21, Example 3-1, Comparative Examples 5 to 16, Comparative Examples 3-1 to Comparative Example 3-4, which were measured in the same manner as in the manufacture of the organic electroluminescence device 1. However, for the lifetime T₉₅ in Table 3, the relative lifetime with respect to Comparative Example 5 was calculated, and the results are shown for each. For the lifetime T₉₅ in Table 4, the relative lifetime with respect to Comparative Example 9 was calculated, and the results are shown for each. For the lifetime T₉₅ in Table 5, the relative lifetime with respect to Comparative Example 13 was calculated, and the results are shown for each.

### (3) Manufacture of organic electroluminescence device 3

An organic electroluminescence device was manufactured as in the manufacture of organic electroluminescence device 1, except that a host compound in which HT-1 and ET-1 are mixed, a sensitizer PS1, and a compound of Example or a compound of Comparative Example were co-deposited at a weight ratio of 85: 14: 1 to form an emission layer having a thickness of 200 Å on an electron blocking layer as shown in Table 6.

Table 6 shows evaluation results of the organic electroluminescence devices for Examples 2-1 to 2-4, and Comparative Examples 2-1 to 2-10, which were measured in the same manner as in the manufacture of the organic electroluminescence device 1. However, for the lifetime T₉₅ in Table 6, the relative lifetime with respect to Comparative Example 2-1 was calculated, and the results are shown for each.

### (4) Manufacture of organic electroluminescence device 4

The organic electroluminescence devices of Examples 4-1 to 4-9 and Comparative Examples 4-1 to 4-6 were manufactured through a method below. As a first electrode, Al having a thickness of 3000 Å was mounted in a vacuum deposition apparatus. On the first electrode, a hole injection layer having a thickness of 300 Å was formed through deposition of NPD, and on the hole injection layer, a hole transport layer having a thickness of 200 Å was formed through deposition of H-1-19, and on the hole transport layer, an electron blocking layer having a thickness of 100 Å was formed through deposition of CzSi.

On the electron blocking layer, a host compound and a dopant compound as shown in Table 8 were co-deposited at a weight ratio of 97:3 to form an emission layer having a thickness of 200 Å. As the host compound, E20, an anthracene-based compound, was used, and as the dopant compound, an Example compound or a Comparative Example compound was used.

On the emission layer, a hole blocking layer having a thickness of 200 Å was formed through deposition of TSPO1. On the hole blocking layer, an electron transport layer having a thickness of 300 Å was formed through deposition of TPBi. On the electron transport layer, an electron injection layer having a thickness of 10 Å was formed through deposition of LiF. A glass substrate having an ITO electrode (Corning, 15 Ω/cm², 1200 Å) formed thereon was cut to a size of about 50 mm x 50 mm x 0.7 mm, subjected to ultrasonic cleaning using isopropyl alcohol and pure water for 5 minutes respectively and ultraviolet irradiation for 30 minutes, and exposed to ozone for cleaning and provided on the electron injection layer. On the electrode, a capping layer having a thickness of 700 Å was formed through deposition of P4 to manufacture an organic electroluminescence device.

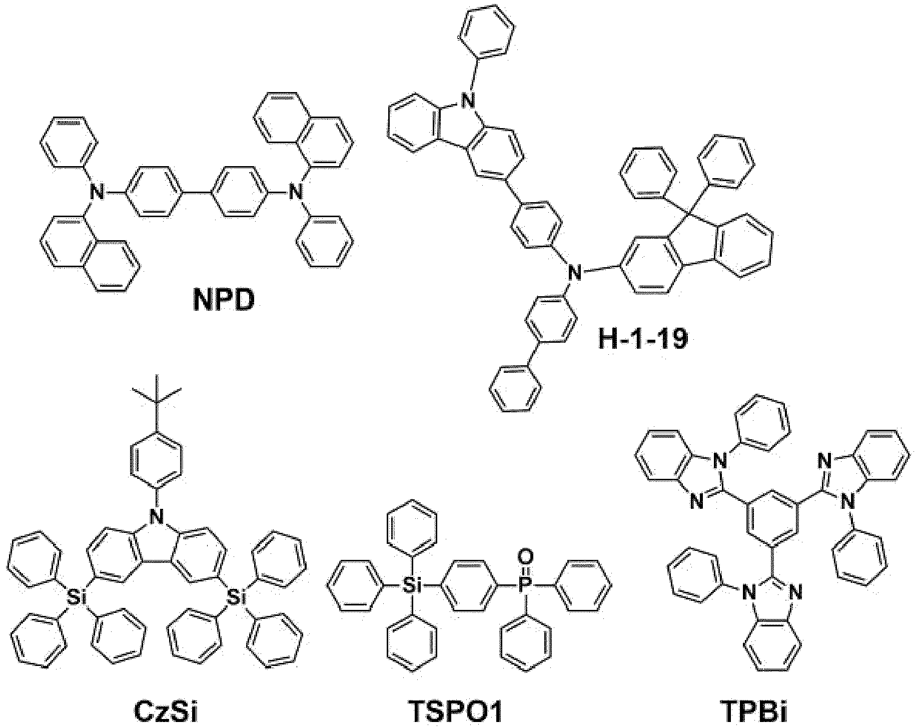

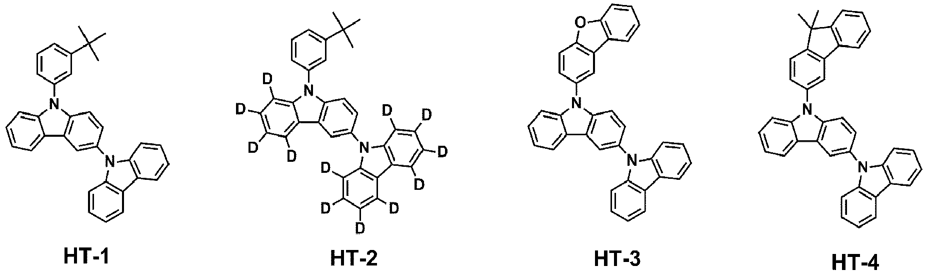

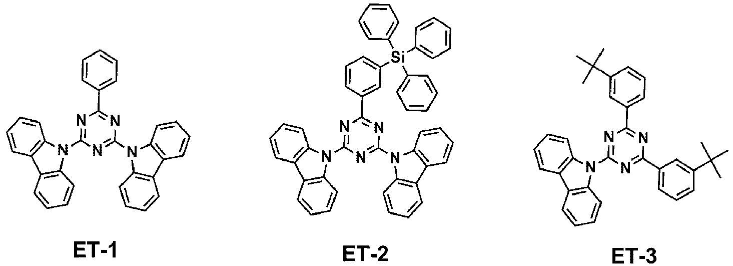

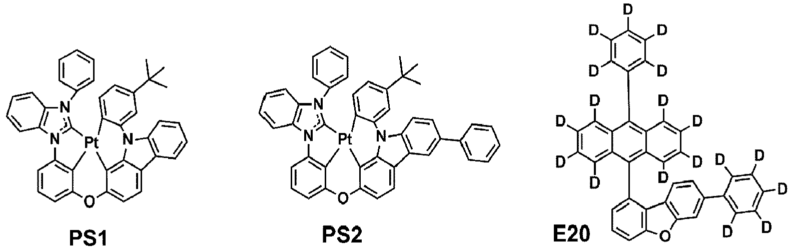

**[Table 2]**

| Example of manufactur ing device | Host (HT/ET) | Dopant | Driving voltage (V) | Efficienc y (cd/A) | Light emission wavelength (nm) | Lifetime ratio (T95) | CIE (x,y) | Q.E |
|---|---|---|---|---|---|---|---|---|
| Example 1 | HT-1/ET-1 | Example Compound 1 | 4.6 | 8.3 | 460 | 3.1 | 0.149, 0.092 | 9.4 |
| Example 2 | HT-1/ET-1 | Example Compound 4 | 4.4 | 9.4 | 463 | 4.2 | 0.138, 0.122 | 11.1 |
| Example 3 | HT-1/ET-1 | Example Compound 26 | 4.8 | 8.3 | 465 | 2.9 | 0.132, 0.131 | 10.3 |
| Example 4 | HT-1/ET-1 | Example Compound 37 | 4.7 | 8.5 | 464 | 3.3 | 0.149, 0.092 | 10.8 |
| Example 5 | HT-1/ET-1 | Example Compound 53 | 4.5 | 8.1 | 461 | 3.2 | 0.149, 0.086 | 10.6 |
| Example 6 | HT-1/ET-1 | Example Compound 62 | 4.6 | 8.3 | 463 | 3.0 | 0.136, 0.119 | 11.0 |
| Example 7 | HT-1/ET-1 | Example Compound 64 | 4.4 | 6.6 | 460 | 7.1 | 0.137, 0.122 | 8.6 |
| Example 8 | HT-1/ET-1 | Example Compound 69 | 4.3 | 7.2 | 460 | 3.3 | 0.149, 0.112 | 9.3 |
| Example 9 | HT-1/ET-1 | Example Compound 79 | 4.4 | 6.8 | 462 | 5.3 | 0.142, 0.121 | 8.1 |
| Comparati ve example 1 | HT-1/ET-1 | Comparative Example Compound C-1 | 5.3 | 9.1 | 458 | 1 | 0.151, 0.088 | 10.9 |
| Comparati ve Example 2 | HT-1/ET-1 | Comparative Example Compound C-2 | 5.2 | 8.8 | 460 | 1.1 | 0.139, 0.109 | 10.7 |
| Comparati ve Example 3 | HT-1/ET-1 | Comparative Example Compound C-3 | 4.8 | 8.2 | 461 | 1.3 | 0.136, 0.101 | 9.9 |
| Comparati ve Example 4 | HT-1/ET-1 | Comparative Example Compound C-4 | 4.9 | 8.3 | 463 | 1.5 | 0.136, 0.117 | 10.6 |

**[Table 3]**

| Example of manufactu ring device | Host (HT/ET ) | Sensitiz er | Dopant | Drivin 9 voltag e (V) | Front surface efficien cy (cd/A) | Light emission wavelen gth (nm) | Full width of quarter maximu m FWQM (nm) | Lifeti me ratio (T95) | CIE (x,y) | Q.E (%) |
|---|---|---|---|---|---|---|---|---|---|---|
| Example 10 | HT-1/ET-1 | PS1 | Example Compound 1 | 4.0 | 21.0 | 462 | 36 | 5.4 | 0.139, 0.047 | 46.9 |
| Example 11 | HT-1/ET-1 | PS1 | Example Compound 4 | 3.9 | 26.1 | 463 | 42 | 6.5 | 0.135, 0.055 | 48.1 |
| Example 12 | HT-1/ET-1 | PS1 | Example Compound 37 | 3.9 | 23.7 | 461 | 41 | 6.8 | 0.134, 0.056 | 45.4 |
| Example 13 | HT-1/ET-1 | PS1 | Example Compound 62 | 3.6 | 24.3 | 462 | 39 | 6.1 | 0.136, 0.052 | 48.0 |
| Comparati ve Example 5 | HT-1/ET-1 | PS1 | Comparativ e Example Compound C-1 | 4.5 | 16.5 | 468 | 52 | 1 | 0.126, 0.071 | 21.4 |
| Comparati ve Example 6 | HT-1/ET-1 | PS1 | Comparativ e Example Compound C-2 | 4.3 | 17.3 | 464 | 45 | 1.6 | 0.133, 0.066 | 33.6 |
| Comparati ve Example 7 | HT-1/ET-1 | PS1 | Comparativ e Example Compound C-3 | 4.2 | 20.4 | 464 | 41 | 1.4 | 0.132, 0.062 | 38.8 |
| Comparati ve Example 8 | HT-1/ET-1 | PS1 | Comparativ e Example Compound C-4 | 4.1 | 18.9 | 465 | 41 | 2.1 | 0.133. 0.061 | 40.1 |

**[Table 4]**

| Example of manufactu ring device | Host (HT/ET ) | Sensiti zer | Dopant | Drivin 9 voltag e (V) | Front surface efficien cy (cd/A) | Light emission wavelen gth (nm) | Full width of quarter maximu m FWQM (nm) | Lifeti me ratio (T95) | CIE (x,y) | Q.E (%) |
|---|---|---|---|---|---|---|---|---|---|---|
| Example 14 | HT-3/ET-2 | PS2 | Example Compound 26 | 4.3 | 25.3 | 463 | 38 | 7.5 | 0.135, 0.065 | 47.7 |
| Example 15 | HT-3/ET-2 | PS2 | Example Compound 53 | 4.2 | 25.7 | 460 | 42 | 6.2 | 0.133, 0.055 | 48.0 |
| Example 16 | HT-3/ET-2 | PS2 | Example Compound 64 | 4.0 | 18.8 | 459 | 42 | 6.4 | 0.131, 0.051 | 34.5 |
| Example 17 | HT-3/ET-2 | PS2 | Example Compound 79 | 3.9 | 16.9 | 463 | 41 | 6.5 | 0.138, 0.058 | 33.0 |
| Comparati ve Example 9 | HT-3/ET-2 | PS2 | Comparativ e Example Compound C-1 | 4.7 | 17.8 | 468 | 52 | 1 | 0.126, 0.071 | 23.4 |
| Comparati ve Example 10 | HT-3/ET-2 | PS2 | Comparativ e Example Compound C-2 | 4.5 | 19.3 | 464 | 45 | 1.8 | 0.133, 0.066 | 33.6 |
| Comparati ve Example 11 | HT-3/ET-2 | PS2 | Comparativ e Example Compound C-3 | 4.5 | 21.4 | 464 | 41 | 1.5 | 0.132, 0.062 | 38.8 |
| Comparati ve Example 12 | HT-3/ET-2 | PS2 | Comparativ e Example Compound C-4 | 4.4 | 22.9 | 465 | 41 | 2.3 | 0.133. 0.061 | 40.1 |

**[Table 5]**

| Example of manufactu ring device | Host (HT/E T) | Sensitiz er | Dopant | Drivi ng voltag e (V) | Front surface efficien cy (cd/A) | Light emission wavelen gth (nm) | Full width of quarter maximum FWQM (nm) | Lifeti me ratio (T95) | CIE (x,y) | Q.E (%) |
|---|---|---|---|---|---|---|---|---|---|---|
| Example 18 | HT-4/ET-3 | PS2 | Example Compound 84 | 4.2 | 27.1 | 460 | 38 | 4.9 | 0.133, 0.050 | 50.0 |
| Example 19 | HT-4/ET-3 | PS2 | Example Compound 95 | 4.3 | 23.2 | 460 | 37 | 4.5 | 0.135, 0.051 | 44.8 |
| Example 20 | HT-4/ET-3 | PS2 | Example Compound 103 | 4.2 | 25.3 | 465 | 41 | 4.5 | 0.128, 0.067 | 47.1 |
| Example 21 | HT-4/ET-3 | PS2 | Example Compound 114 | 4.3 | 26.1 | 463 | 39 | 4.3 | 0.135, 0.056 | 48.5 |
| Comparati ve Example 13 | HT-4/ET-3 | PS2 | Comparativ e Example Compound C-1 | 4.7 | 14.4 | 468 | 48 | 1 | 0.125, 0.072 | 19.8 |
| Comparati ve Example 14 | HT-4/ET-3 | PS2 | Comparativ e Example Compound C-2 | 4.5 | 21.0 | 463 | 45 | 1.1 | 0.134, 0.057 | 33.4 |
| Comparati ve Example 15 | HT-4/ET-3 | PS2 | Comparativ e Example Compound C-3 | 4.5 | 21.3 | 463 | 43 | 1.2 | 0.133, 0.055 | 34.2 |
| Comparati ve Example 16 | HT-4/ET-3 | PS2 | Comparativ e Example Compound C-4 | 4.5 | 24.7 | 465 | 42 | 1.6 | 0.129, 0.061 | 46.8 |

**[Table 6]**

| Example of manufacturi ng device | Host (HT-1/ET-1) | Sensitiz er | Dopant | Drivi ng voltag e (V) | Front surface efficien cy (cd/A) | Light emission wavelen gth (nm) | Full width of quarter maximu m FWQM (nm) | Lifeti me ratio (T95) | CIE (x,y) | Q.E (%) |
|---|---|---|---|---|---|---|---|---|---|---|
| Example 2-1 | 5:5 | PS1 | Example Compound 4 | 3.9 | 26.1 | 463 | 42 | 6.5 | 0.13 5, 0.05 5 | 48.1 |
| Example 2-2 | 4:6 | PS1 | Example Compound 4 | 3.9 | 25.9 | 462 | 42 | 6.4 | 0.13 6, 0.05 5 | 47.5 |
| Example 2-3 | 6:4 | PS1 | Example Compound 4 | 4.1 | 26.0 | 463 | 41 | 7.6 | 0.13 5, 0.05 4 | 47.7 |
| Example 2-4 | 7:3 | PS1 | Example Compound 4 | 4.1 | 26.3 | 463 | 42 | 8.8 | 0.13 5, 0.05 5 | 48.5 |
| Example 2-5 | 3:7 | PS1 | Example Compound 4 | 3.8 | 25.6 | 462 | 41 | 5.7 | 0.13 4, 0.05 3 | 47.3 |
| Comparativ e Examples 2-1 | 5:5 | PS1 | Comparativ e Example Compound C-1 | 4.5 | 16.5 | 468 | 52 | 1 | 0.12 6, 0.07 1 | 21.4 |
| Comparativ e Examples 2-2 | 4:6 | PS1 | Comparativ e Example Compound C-1 | 4.7 | 16.7 | 468 | 51 | 1.05 | 0.12 7, 0.07 1 | 21.6 |
| Comparativ e Examples 2-3 | 6:4 | PS1 | Comparativ e Example Compound C-1 | 4.5 | 15.8 | 468 | 50 | 1.1 | 0.12 6, 0.07 3 | 20.8 |
| Comparativ e Examples 2-4 | 7:3 | PS1 | Comparativ e Example Compound C-1 | 4.4 | 16.2 | 468 | 52 | 1.3 | 0.12 7, 0.07 2 | 21.0 |
| Comparativ e Examples 2-5 | 3:7 | PS1 | Comparativ e Example Compound C-1 | 4.5 | 16.4 | 467 | 52 | 0.95 | 0.12 6, 0.06 9 | 21.1 |
| Comparativ e Examples 2-6 | 5:5 | PS1 | Comparativ e Example Compound C-4 | 4.1 | 18.9 | 465 | 41 | 2.1 | 0.13 3, 0.06 1 | 40.1 |
| Comparativ e Examples 2-7 | 4:6 | PS1 | Comparativ e Example Compound C-4 | 4.2 | 19.1 | 465 | 40 | 2.0 | 0.13 4, 0.06 0 | 40.3 |
| Comparativ e Examples 2-8 | 6:4 | PS1 | Comparativ e Example Compound C-4 | 4.1 | 19.0 | 464 | 41 | 2.4 | 0.13 2, 0.05 9 | 40.0 |
| Comparativ e Examples 2-9 | 7:3 | PS1 | Comparativ e Example Compound C-4 | 4.1 | 18.5 | 465 | 41 | 2.7 | 0.13 3, 0.06 3 | 39.6 |
| Comparativ e Examples 2-10 | 3:7 | PS1 | Comparativ e Example Compound C-4 | 4.0 | 19.3 | 464 | 40 | 2.1 | 0.13 3, 0.06 0 | 40.7 |

**[Table 7]**

| Example of manufactu ring device | Host (HT/ET) | Sensitiz er | Dopant | Drivin 9 voltage (V) | Front surface efficiency (cd/A) | Light emission waveleng th (nm) | Full width of quarter maximu m FWQM (nm) | Lifeti me ratio (T95) | CIE (x,y) | Q.E (%) |
|---|---|---|---|---|---|---|---|---|---|---|
| Example 3-1 | HT-1/ET-1 | PS1 | Example Compound 4 | 3.9 | 26.1 | 463 | 42 | 6.5 | 0.135, 0.055 | 48.1 |
| Comparati ve Examples 3-1 | HT-1/ET-1 | PS1 | Comparativ e Example Compound C-5 | 4.1 | 25.8 | 463 | 46 | 3.5 | 0.136, 0.057 | 44.3 |
| Comparati ve Examples 3-2 | HT-1/ET-1 | PS1 | Comparativ e Example Compound C-6 | 4.2 | 22.0 | 468 | 43 | 2.8 | 0.128, 0.073 | 42.1 |
| Comparati ve Examples 3-3 | HT-1/ET-1 | PS1 | Comparativ e Example Compound C-1 | 4.5 | 16.5 | 468 | 52 | 1 | 0.126, 0.071 | 37.4 |
| Comparati ve | HT-1/ET-1 | PS1 | Comparativ e Example | 4.1 | 18.9 | 465 | 41 | 2.1 | 0.133. 0.061 | 40.1 |
| Examples 3-4 | | | Compound C-4 | | | | | | | |

The "Front surface luminous efficiency" in Tables 2 to 7 means the light efficiency when the majority of light generated in the light emitting layer is directed toward the encapsulation layer. The "Q.E" in Tables 2 to 7 means External Quantum Efficiency. The " CIE(x,y)" in Tables 2 to 7 represents the CIE color coordinates. Referring to the results of Tables 2 to 7, it can be seen that Examples of the organic electroluminescence device using the fused polycyclic compound according to an embodiment as an emission layer material exhibit a lower driving voltage value, and relatively higher luminous efficiency and lifetime than Comparative Examples of the organic electroluminescence device.

Example compounds exhibit TADF characteristics through multi resonance due to an aromatic ring forming a fused ring. The Example compounds include a ortho-terphenyl group bonded to two nitrogen atoms to have a triplet-singlet energy value equal to or less than 0.2 eV, and are capable of quickly converting triplet excitons into singlet excitons through a RISC (Reverse Inter System Crossing) mechanism. The introduction of an arylamine group at the p-position of boron may lead to multiple resonance, shift the emission wavelength of Example compounds to a longer wavelength, and accordingly, greatly improve a molar absorption coefficient to be advantageous for Forster resonance energy transfer (FRET) from a sensitizer. Accordingly, the organic electroluminescence devices of Examples may exhibit luminous efficiency and lifetime which are greater than or equal to the luminous efficiency and lifetime of the organic electroluminescence devices of Comparative Examples.

The fused polycyclic compound according to an embodiment may also be used as a fluorescent dopant. For example, when a polycyclic substituent such as a naphthyl group, anthracenyl group, or pyrenyl group is bonded to a pentacyclic fused ring included in the fused polycyclic compound, triplet excitons may have reduced density. Accordingly, the organic electroluminescence device including the fused polycyclic compound of an embodiment may exhibit a long lifetime.

In the fused polycyclic compound according to an embodiment, with the introduction of an aryl group having a substituent at the ortho position on either side, a molecular shape thereof is made into a sphere type, and thus molecular-molecular interactions may minimally occur, and dexter energy transfer may be prevented. Therefore, the long lifetime of the organic electroluminescence device may be achieved. On the other hand, it can be seen that Comparative Example compounds C-5 and C-6 in which an aryl group having a substituent is introduced at a meta- or para-position where molecular-molecular interactions occur frequently may have a longer light emission wavelength towards sky blue, and the lifetime of the light emitting device is reduced.

Referring to the results of Table 3, it can be seen that, with respect to the organic electroluminescence devices of Example in Table 2, the inclusion of a sensitizer in the emission layer results in a relatively high luminous efficiency.

**[Table 8]**

| Example of manufacturing device | Host | Dopant | Drivi ng voltag e (V) | Rear surface efficienc y (cd/A) | Light emission wavelen gth (Nm) | Full width of quarter maximu m FWQM (Nm) | Lifeti me ratio (T95) | CIE (x,y) | Q.E (%) |
|---|---|---|---|---|---|---|---|---|---|
| Example 4-1 | E20 | Example Compound 1 | 4.4 | 4.1 | 456 | 21 | 145.5 | 0.140, 0.061 | 8.0 |
| Example 4-2 | E20 | Example Compound 4 | 4.0 | 5.6 | 463 | 23 | 197.0 | 0.130, 0.095 | 8.1 |
| Example 4-3 | E20 | Example Compound 26 | 3.9 | 5.9 | 464 | 23 | 155.4 | 0.129, 0.099 | 8.5 |
| Example 4-4 | E20 | Example Compound 37 | 4.1 | 5.4 | 463 | 22 | 183.0 | 0.091, 0.092 | 7.9 |
| Example 4-5 | E20 | Example Compound 53 | 4.0 | 5.8 | 460 | 23 | 195.0 | 0.131, 0.086 | 9.2 |
| Example 4-6 | E20 | Example Compound 62 | 4.0 | 5.5 | 462 | 21 | 177.9 | 0.131, 0.091 | 8.1 |
| Example 4-7 | E20 | Example Compound 64 | 4.1 | 5.4 | 461 | 21 | 355 | 0.135, 0.089 | 7.9 |
| Example 4-8 | E20 | Example Compound 69 | 3.8 | 7.3 | 463 | 22 | 340 | 0.123, 0.120 | 9.1 |
| Example 4-9 | E20 | Example Compound 79 | 4.0 | 6.8 | 465 | 23 | 265 | 0.131, 0.100 | 8.5 |
| Comparative Example 4-1 | E20 | Comparative Example Compound C-1 | 4.7 | 3.6 | 461 | 28 | 10.0 | 0.131, 0.115 | 4.3 |
| Comparative Example 4-2 | E20 | Comparative Example Compound C-2 | 4.7 | 4.2 | 463 | 26 | 16.0 | 0.130, 0.095 | 4.7 |
| Comparative Example 4-3 | E20 | Comparative Example Compound C-3 | 4.3 | 4.5 | 459 | 26 | 22.3 | 0.136, 0.072 | 7.9 |
| Comparative Example 4-4 | E20 | Comparative Example Compound C-4 | 4.1 | 4.7 | 463 | 24 | 37.6 | 0.130, 0.091 | 6.9 |
| Comparative Example 4-5 | E20 | Comparative Example Compound C-5 | 3.8 | 5.4 | 464 | 23 | 41.9 | 0.128, 0.095 | 9.0 |
| Comparative Example 4-6 | E20 | Comparative Example Compound C-6 | 3.9 | 5.3 | 467 | 24 | 31.4 | 0.125, 0.112 | 8.3 |

The "Rear surface luminous" in the Table 8 means the light efficiency when the majority of light generated in the light emitting layer is directed toward the circuit layer. The "Q.E" in the Table 8 means External Quantum Efficiency. The " CIE(x,y)" in the Table 8 represents the CIE color coordinates. Referring to Table 8, it can be seen that the organic electroluminescence devices of Examples 4-1 to 4-9 have satisfactory lifespan compared to the organic electroluminescence devices of Comparative Examples 4-1 to 4-6. It can be seen that the organic electroluminescence devices of Examples 4-1 to 4-9 have satisfactory lifespan compared to the organic electroluminescence device of Comparative Example 4-1. The organic electroluminescence devices of Examples 4-1 to 4-9 have a narrower quarter maximum width than the organic electroluminescence device of Comparative Example 4-1, indicating satisfactory color purity. Each of the organic electroluminescence devices of Examples 4-1 to 4-9 includes Compounds 1, 4, 26, 37, 53, 62, 64, 69, and 79, and Compounds 1, 4, 26, 37, 53, 62, 64, 69, and 79 are fused polycyclic compounds according to an embodiment, and are used as a fluorescent dopant. Accordingly, the organic electroluminescence device including the fused polycyclic compound of an embodiment may exhibit increased lifespan. The organic electroluminescence device including the fused polycyclic compound of an embodiment may exhibit satisfactory color purity. The organic electroluminescence device of an embodiment includes the fused polycyclic compound of an embodiment, and thus may exhibit increased luminous efficiency. The organic electroluminescence device of an embodiment includes the fused polycyclic compound of an embodiment as an emission layer material, and thus may achieve high luminous efficiency in a wavelength range of blue light.

An organic electroluminescence device of an embodiment may exhibit improved device characteristics of a low driving voltage and high efficiency.

A fused polycyclic compound of an embodiment is included in an emission layer of an organic electroluminescence device, and thus may contribute to high efficiency of the organic electroluminescence device.

Embodiments have been disclosed herein, and although terms are employed, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the spirit and scope of the disclosure as set forth in the following claims.

The following clauses are exemplary and are not intended to be considered claims:

### Clauses

1. An organic electroluminescence device comprising:
   a first electrode;
   a second electrode facing the first electrode; and
   an emission layer disposed between the first electrode and the second electrode, wherein
   the emission layer includes:
      a hole transporting first host;
      an electron transporting second host different from the first host; and
      a light emitting dopant, and
   the light emitting dopant includes a fused polycyclic compound represented by Formula 1: 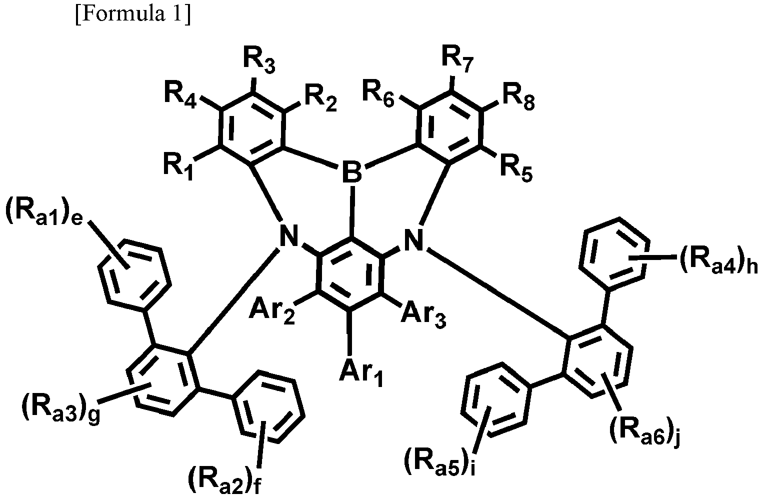
   wherein in Formula 1,
   Ar₁ to Ar₃ are each independently a hydrogen atom, a deuterium atom, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
   R₁ to R₈ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
   Rₐ₁ to Rₐ₆ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
   e, f, h, and i are each independently an integer from 0 to 5,
   g and j are each independently an integer from 0 to 3, and
   at least one of R₁ to R₈ is a group represented by Formula 2: 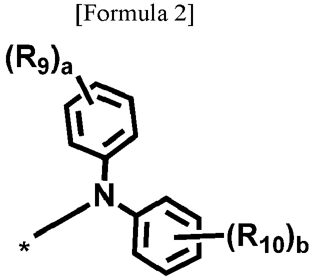
   wherein in Formula 2,
   R₉ and R₁₀ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring, and
   a and b are each independently an integer from 0 to 5.
2. The organic electroluminescence device of clause 1, wherein the fused polycyclic compound has a photoluminescence quantum yield (PLQY) equal to or greater than about 80%.
3. The organic electroluminescence device of clause 1 or clause 2, wherein the fused polycyclic compound represented by Formula 1 is represented by one of Formulas 3-1 to 3-3: 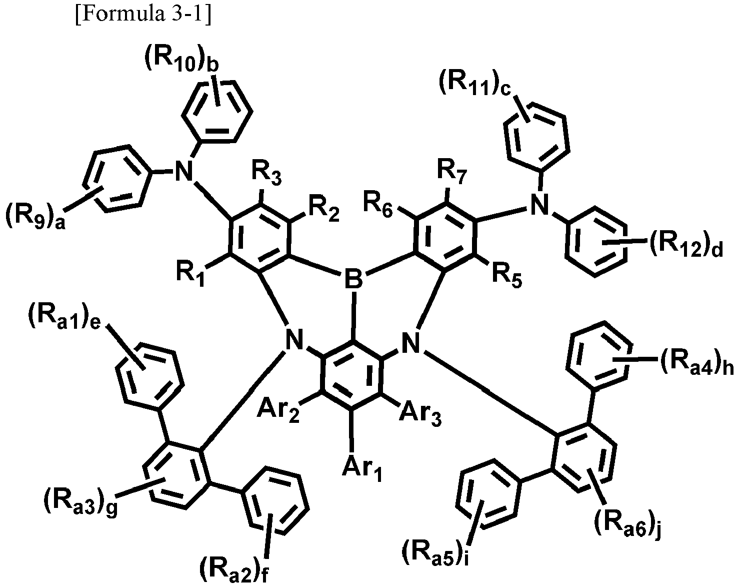 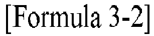 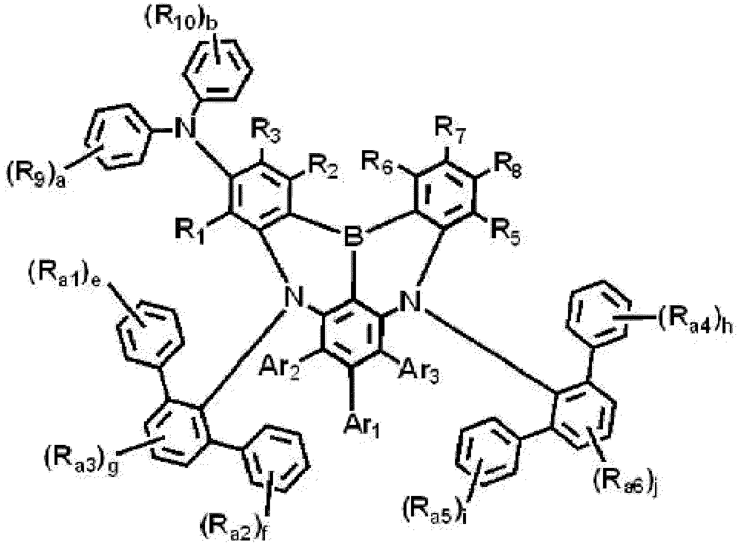 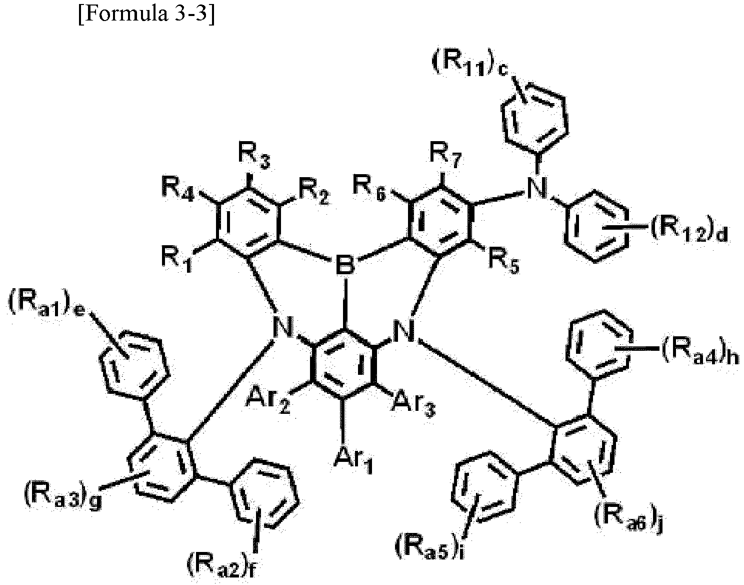
   wherein in Formulas 3-1 to 3-3,
   R₁₁ and R₁₂ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
   c and d are each independently an integer from 0 to 5, and
   Ar₁ to Ar₃, R₁ to R₁₀, Rₐ₁ to Rₐ₆, a, b, and e to j are the same as defined in Formulas 1 and 2.
4. The organic electroluminescence device of clause 3, wherein Ar₁ to Ar₃ are each independently a hydrogen atom or a deuterium atom.
5. The organic electroluminescence device of clause 3, wherein
   Ar₁ is a substituted or unsubstituted aryl group having 6 to 60 ring-forming carbon atoms, or a substituted or unsubstituted heteroaryl group having 2 to 60 ring-forming carbon atoms, and
   Ar₂ and Ar₃ are each independently a hydrogen atom or a deuterium atom.
6. The organic electroluminescence device of clause 3, wherein
   Ar₁ is a substituted or unsubstituted alkyl group having 1 to 20 carbon atoms, and
   Ar₂ and Ar₃ are each independently a hydrogen atom or a deuterium atom.
7. The organic electroluminescence device of clause 3, wherein
   Ar₁ is a substituted or unsubstituted silyl group having 1 to 20 carbon atoms, and
   Ar₂ and Ar₃ are each independently a hydrogen atom or a deuterium atom.
8. The organic electroluminescence device of clause 3, wherein the fused polycyclic compound represented by Formula 3-1 is represented by Formula 5: 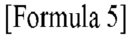 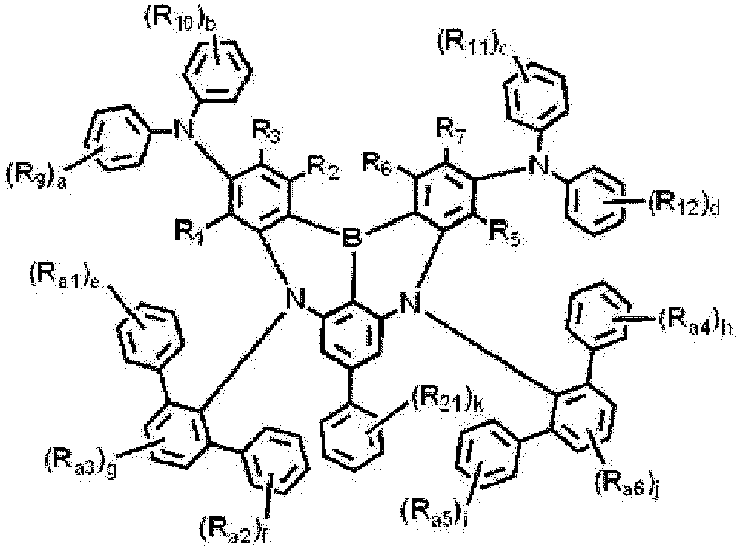
   wherein in Formula 5,
   R₂₁ is a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
   k is an integer from 0 to 5, and
   R₁ to R₃, R₅ to R₇, R₉ to R₁₂, Rₐ₁ to Rₐ₆, and a to j are the same as defined in Formula 3-1.
9. The organic electroluminescence device of clause 3, wherein the fused polycyclic compound represented by Formula 3-2 is represented by Formula 6-1 or Formula 6-2: 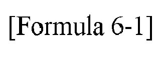 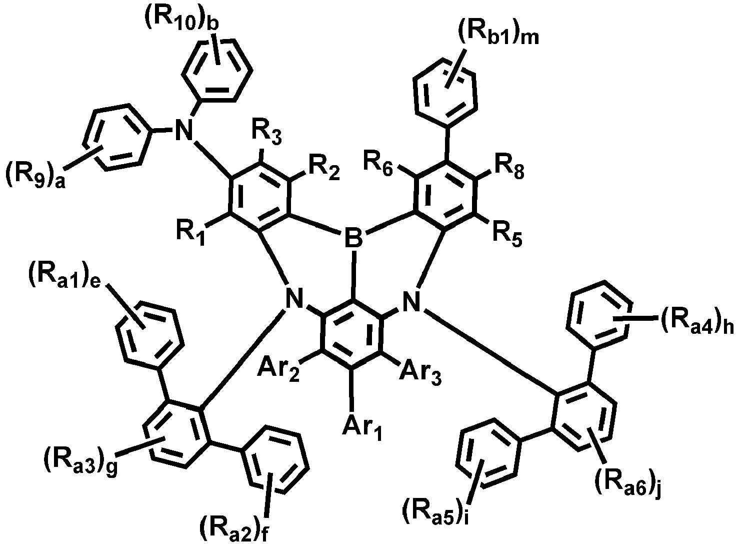 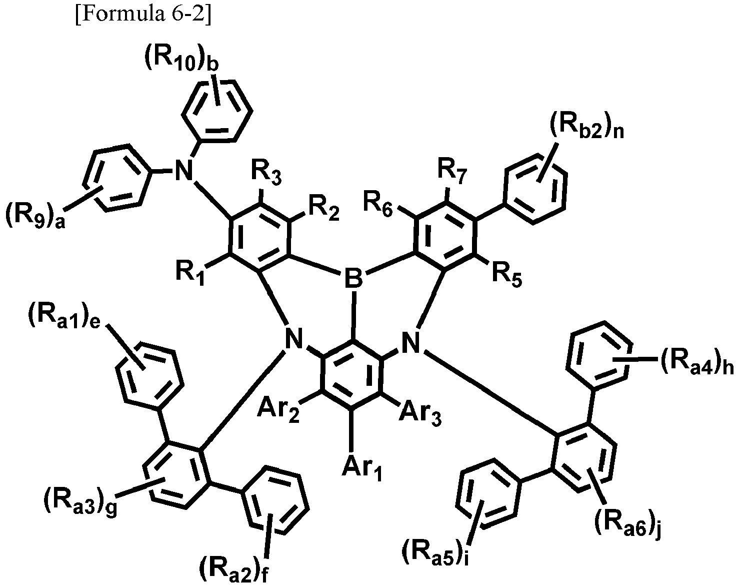
   wherein in Formulas 6-1 and 6-2,
   R_{b1} and R_{b2} are each independently a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
   m and n are each independently an integer from 0 to 5, and
   R₁ to R₃, R₅ to R₇, R₈, R₉, R₁₀, Rₐ₁ to Rₐ₆, a, b, and e to j are the same as defined in Formula 3-1.
10. The organic electroluminescence device of clause 1, wherein the fused polycyclic compound comprises at least one selected from Compound Group 1: 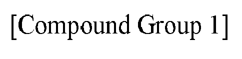 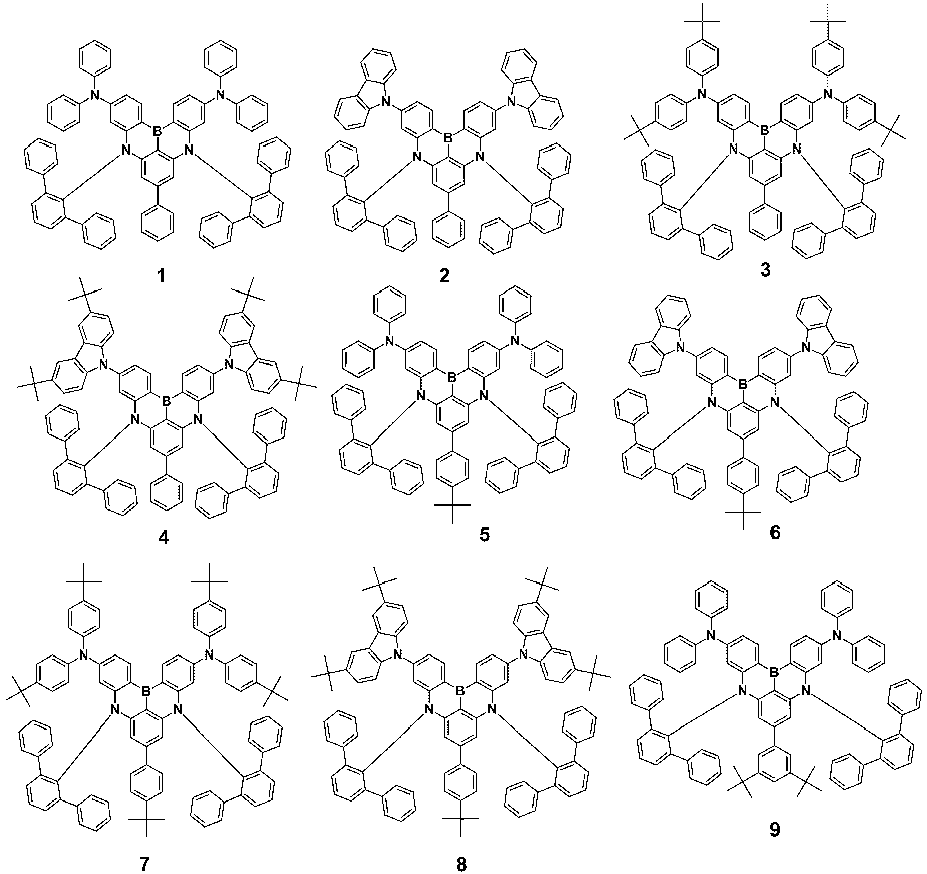 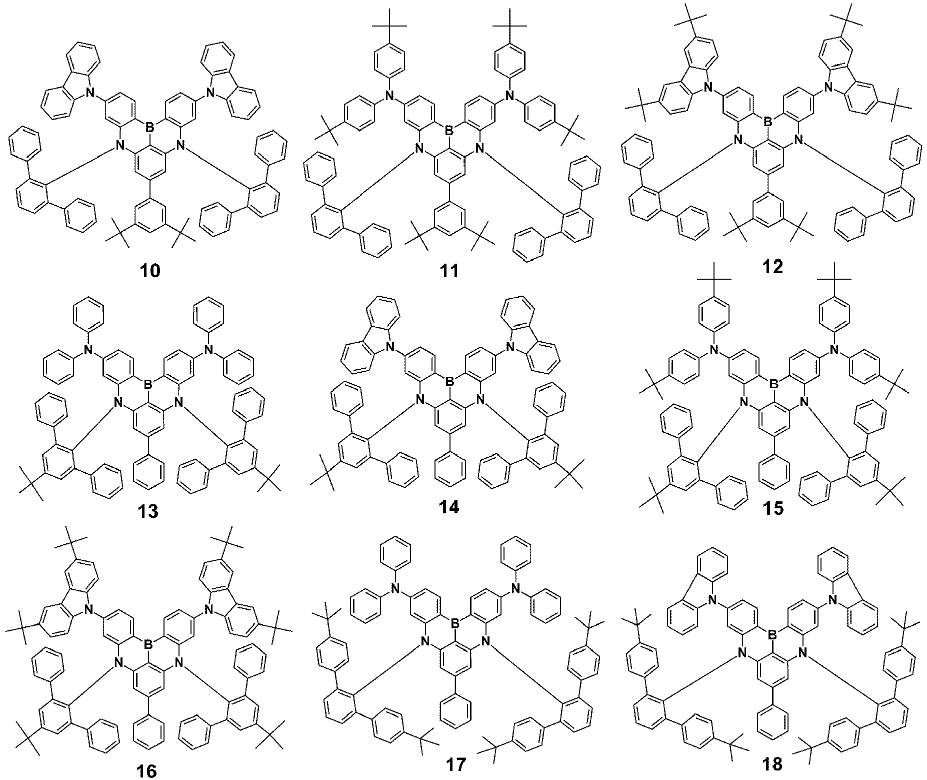 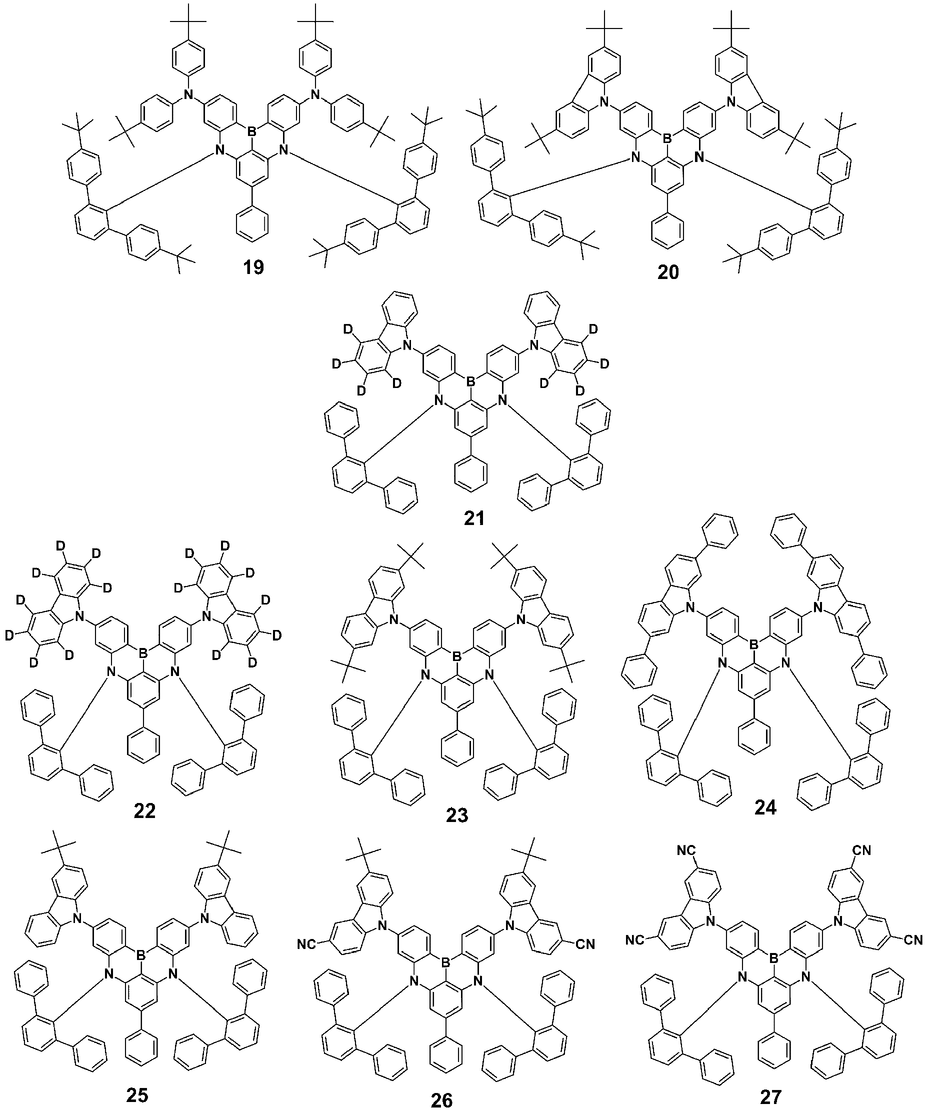 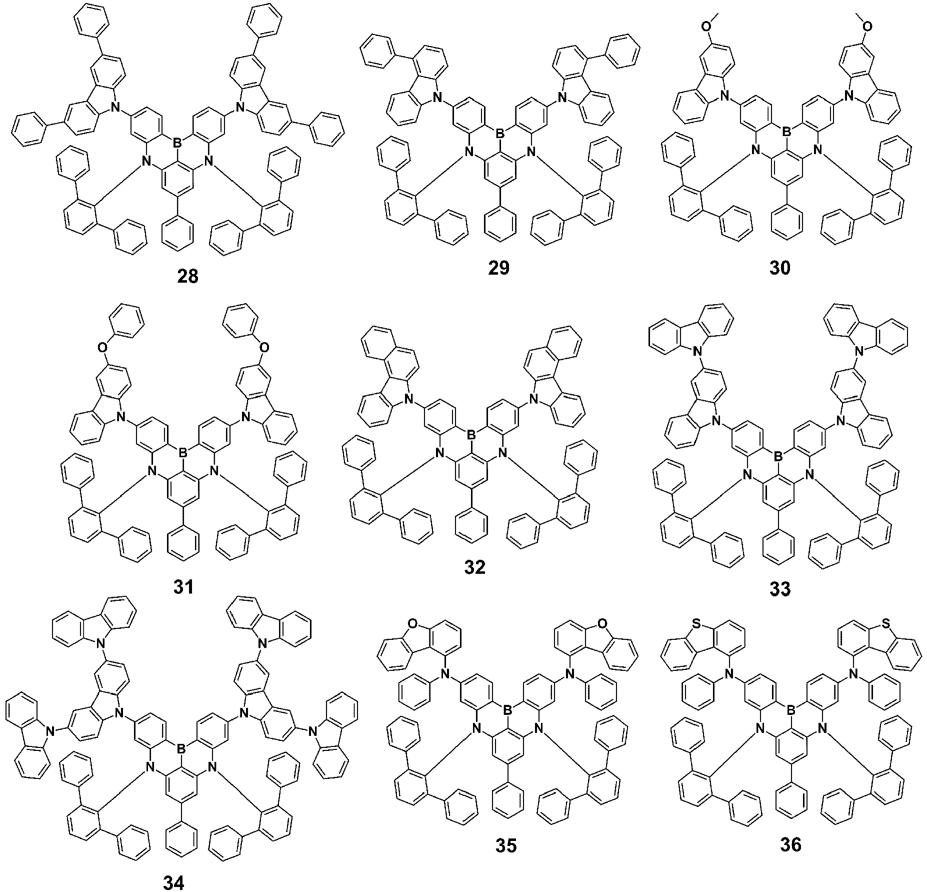 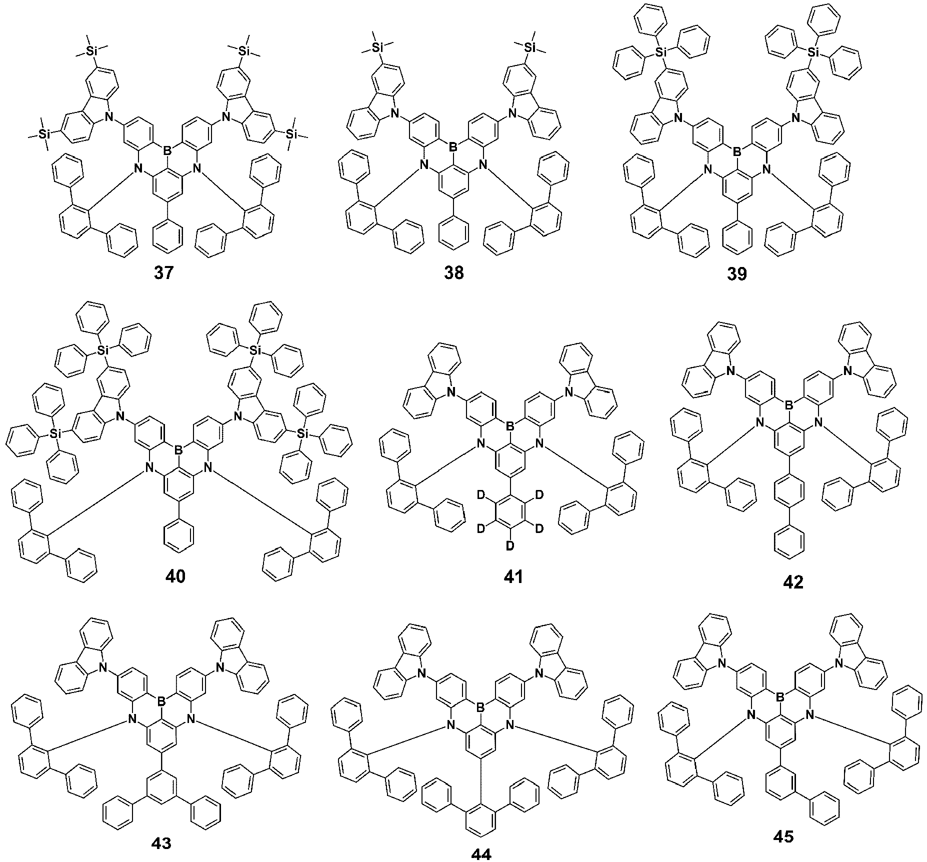 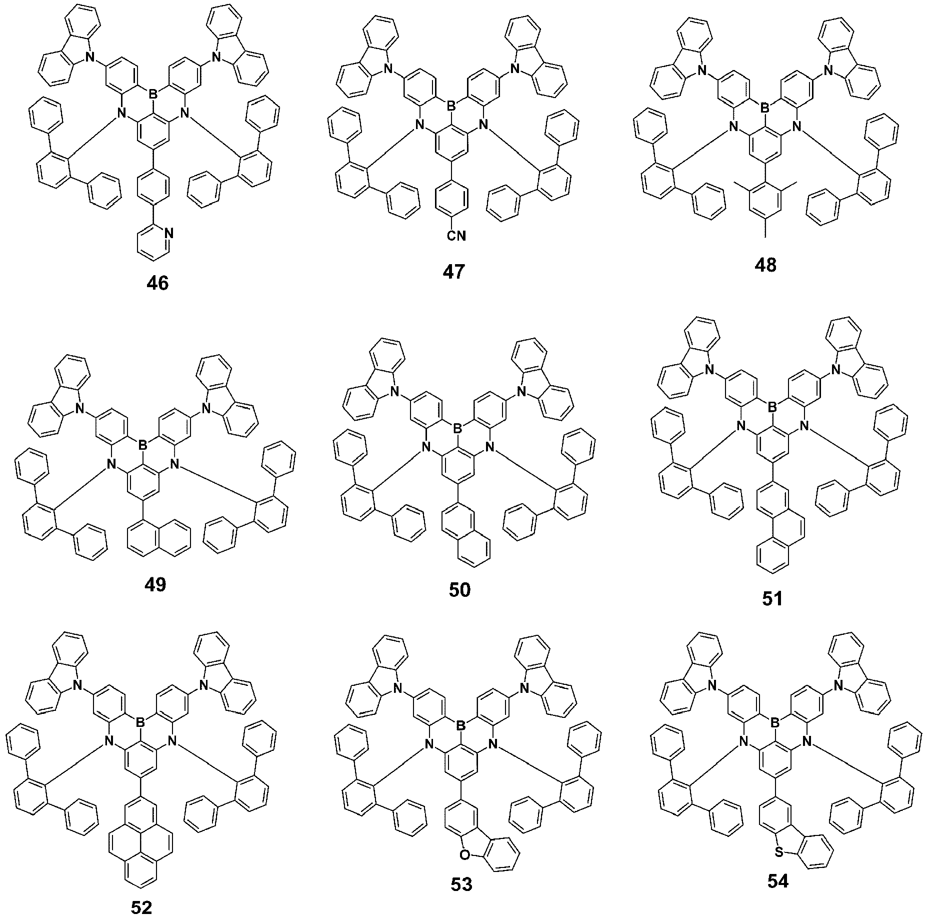 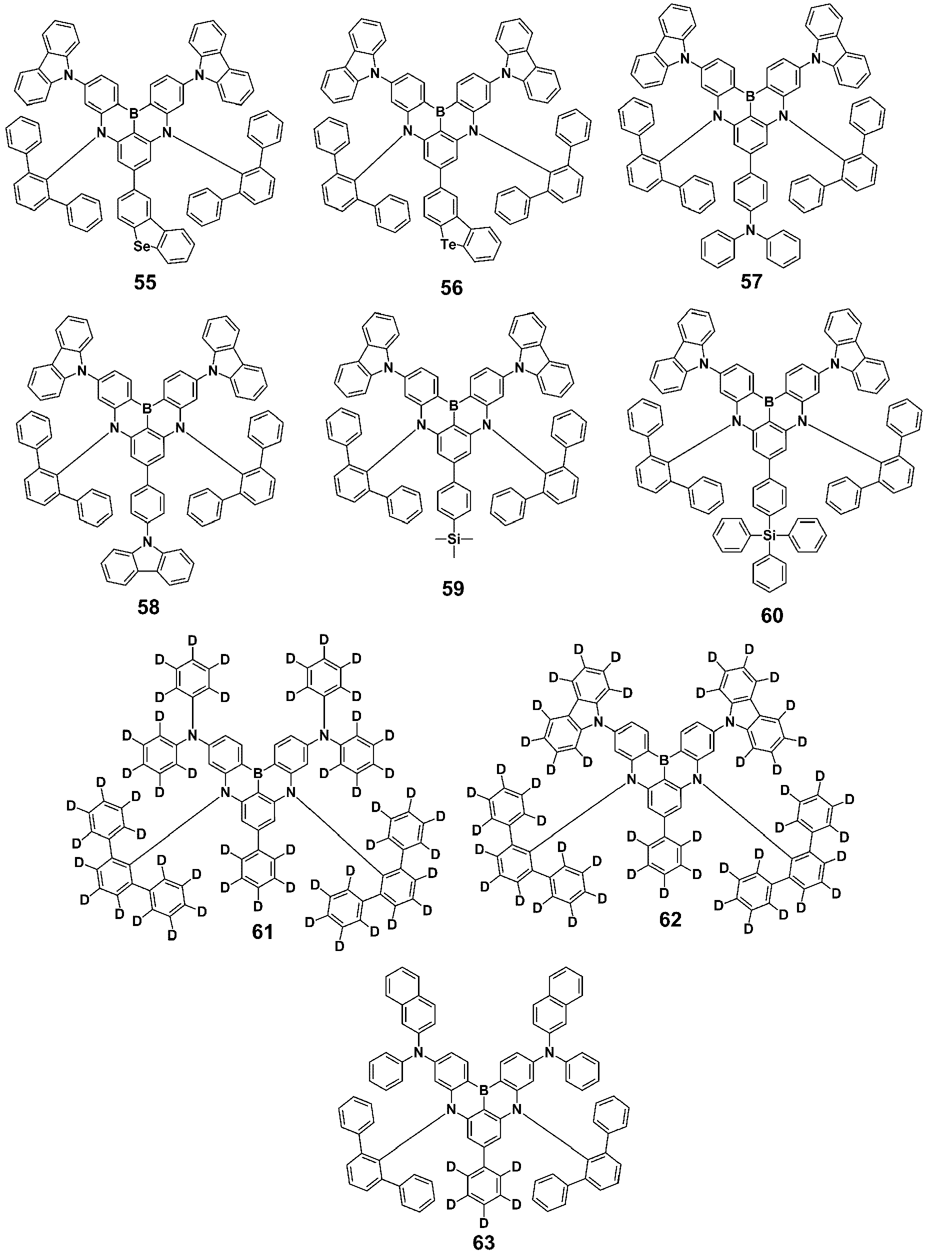 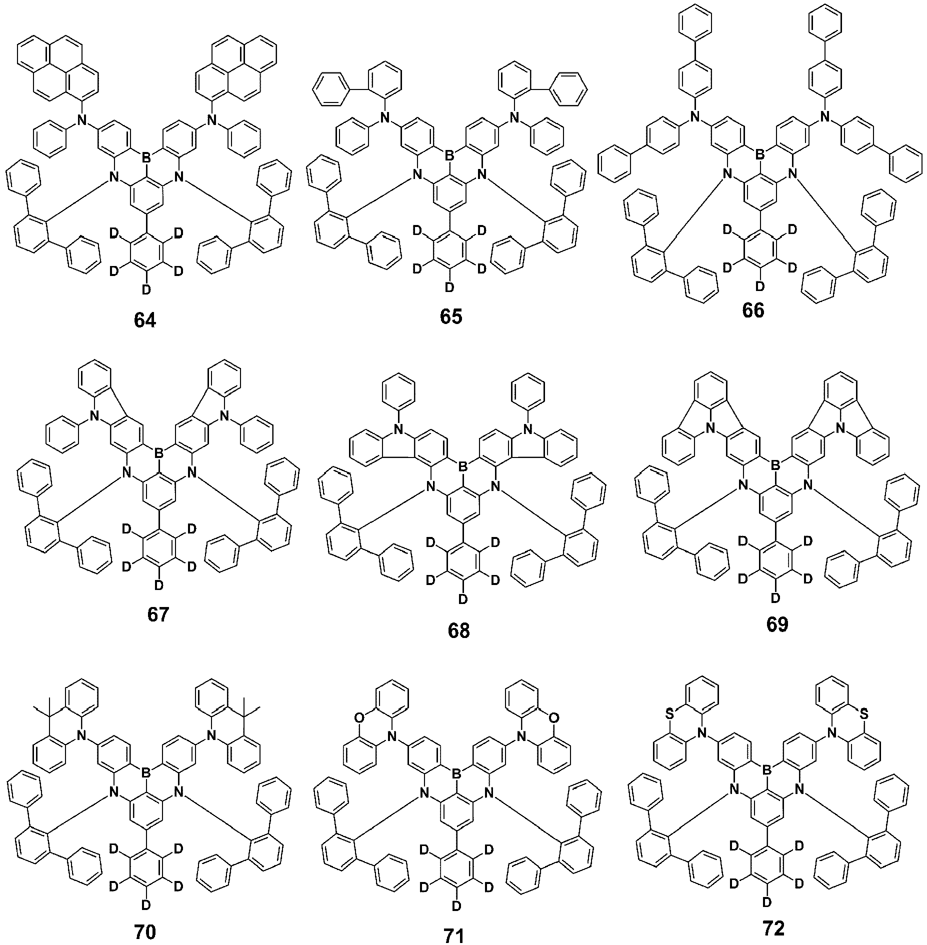 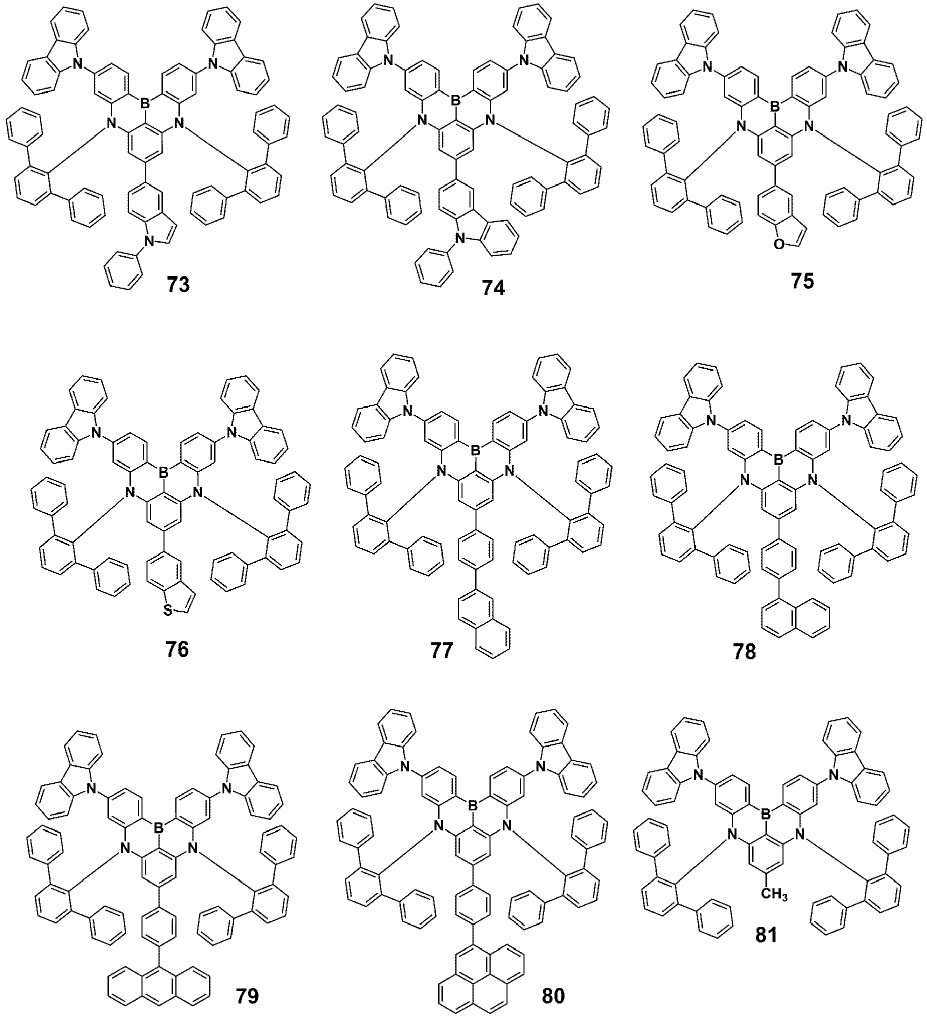 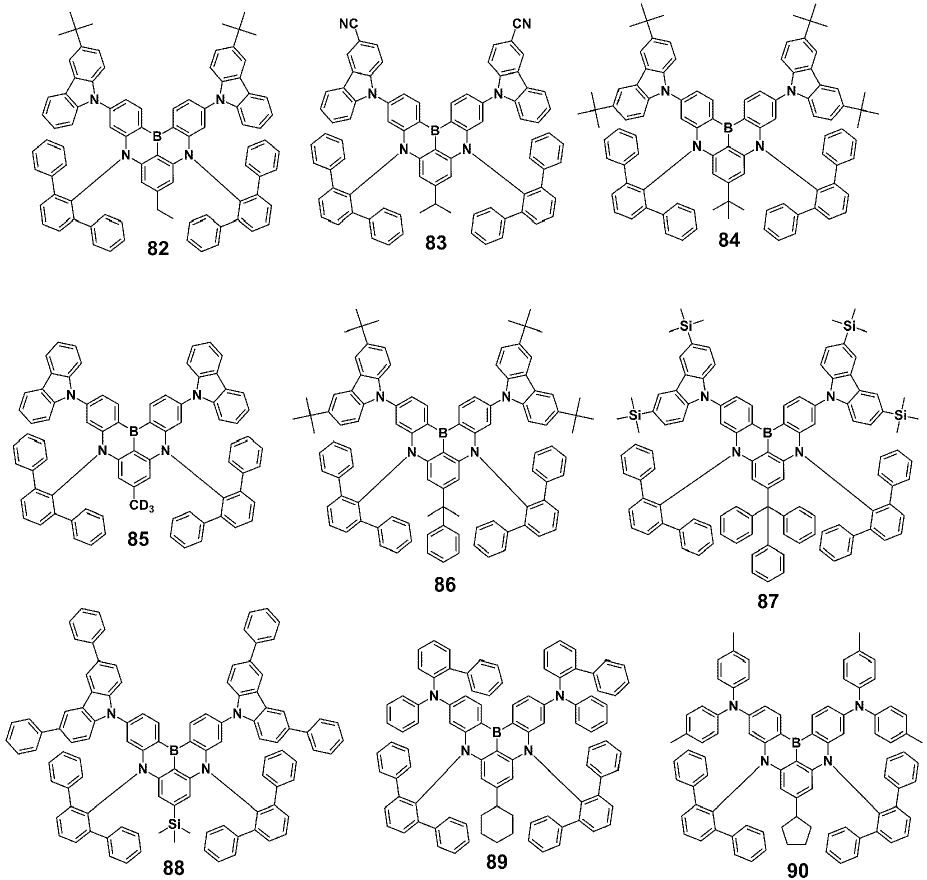 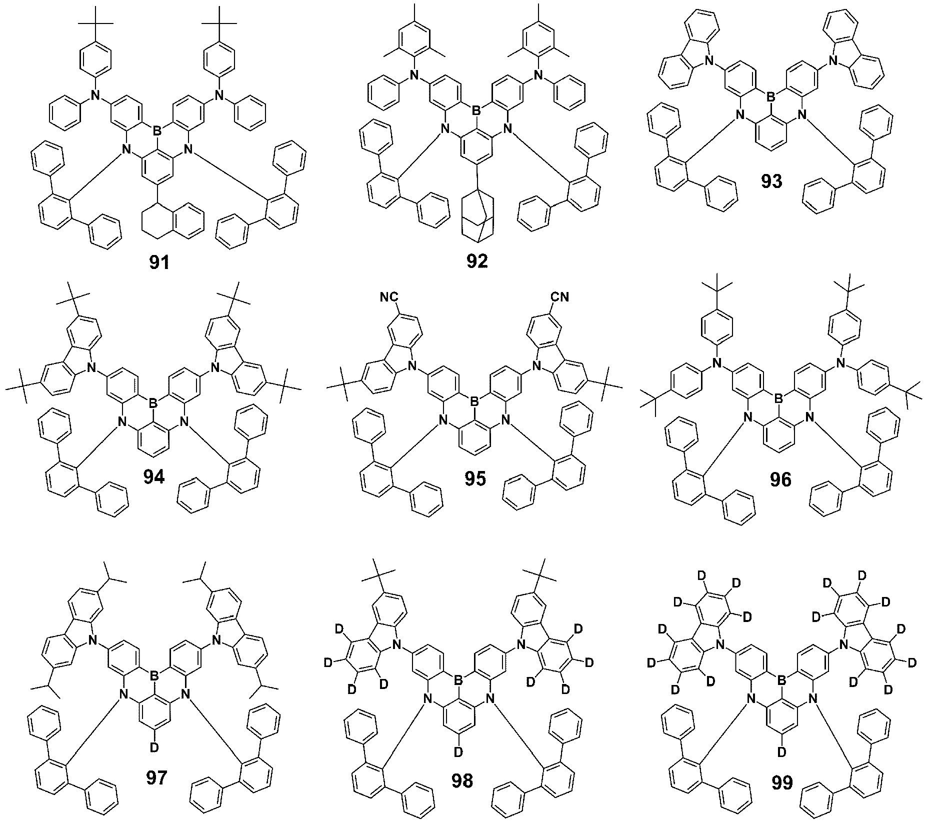 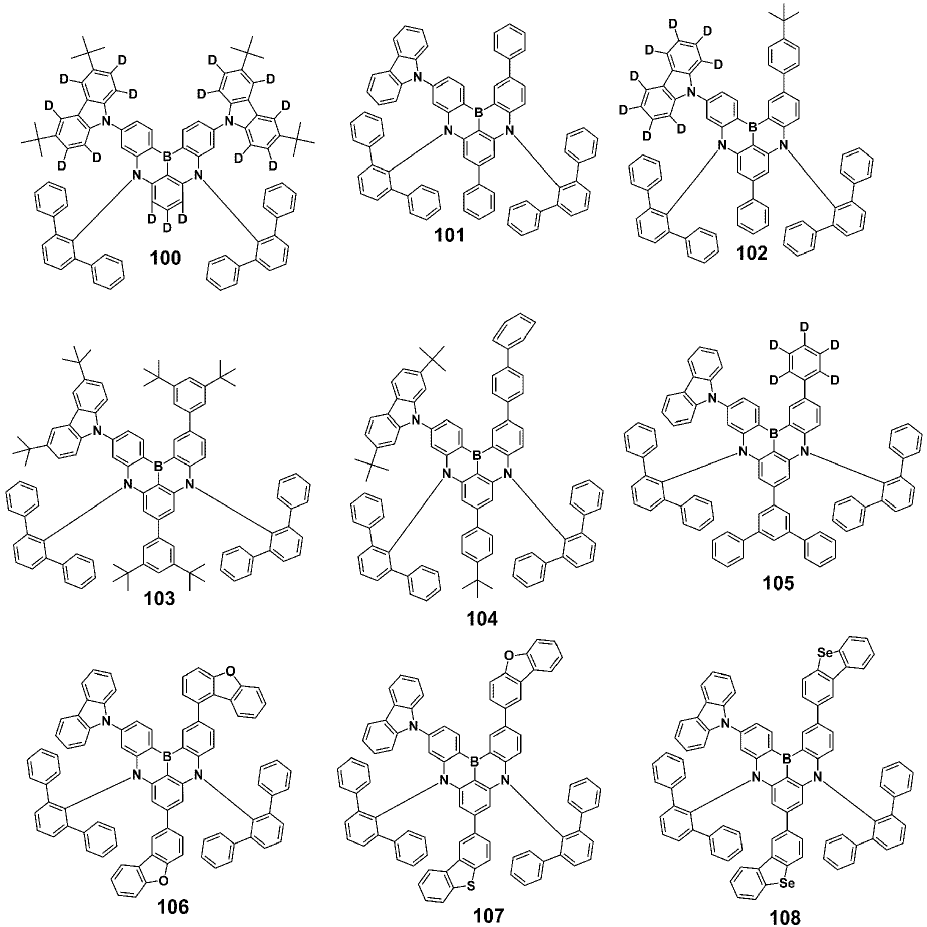 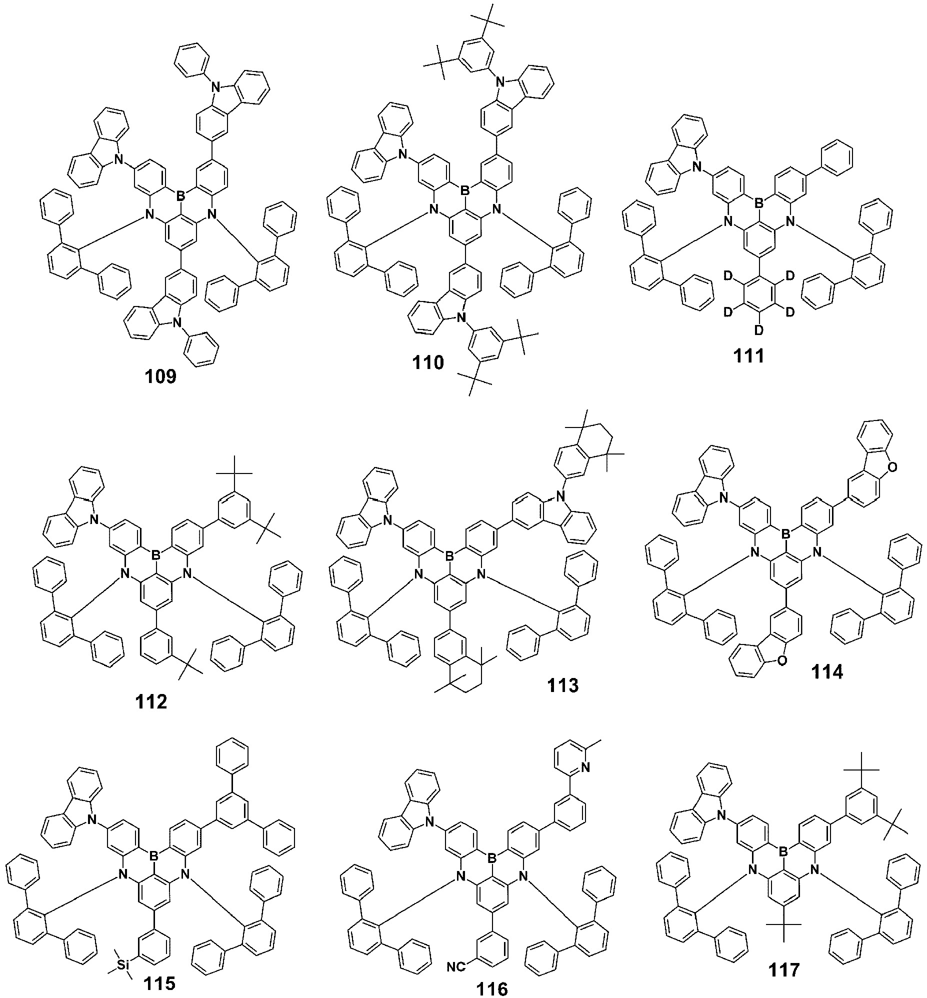 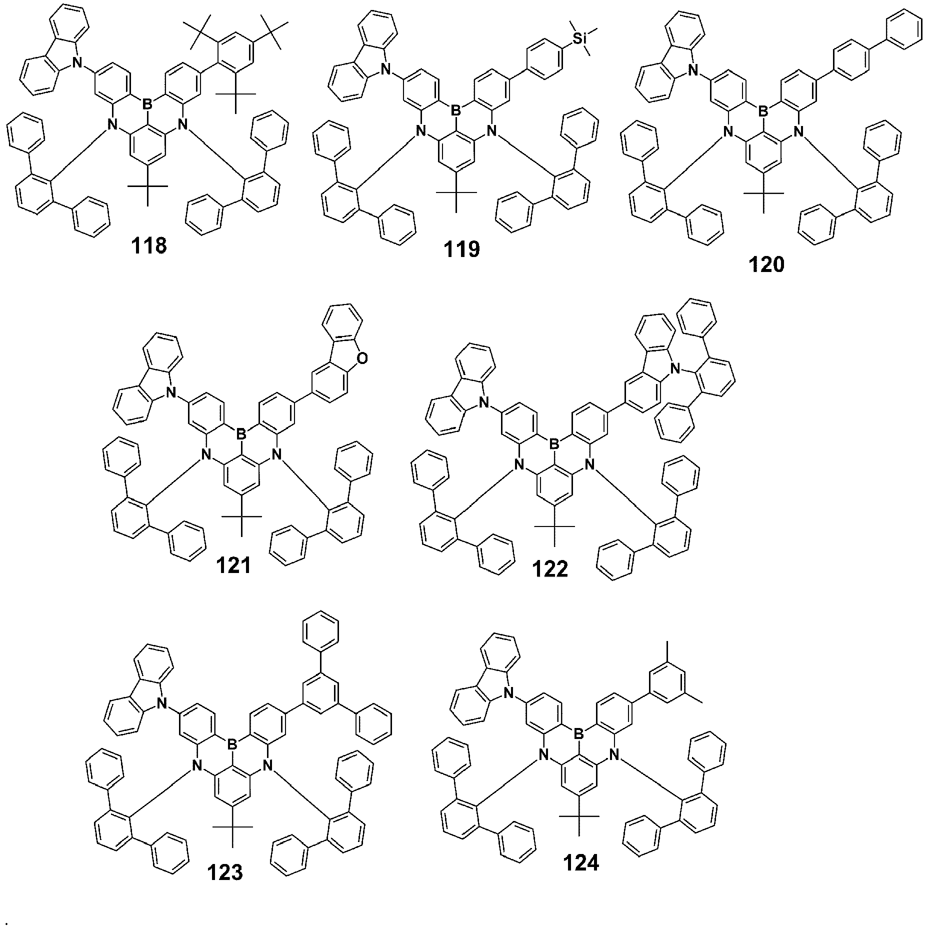
11. The organic electroluminescence device of any one of clauses 1 to 10, wherein the hole transporting first host and the electron transporting second host are each independently represented by Formula E: 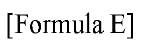 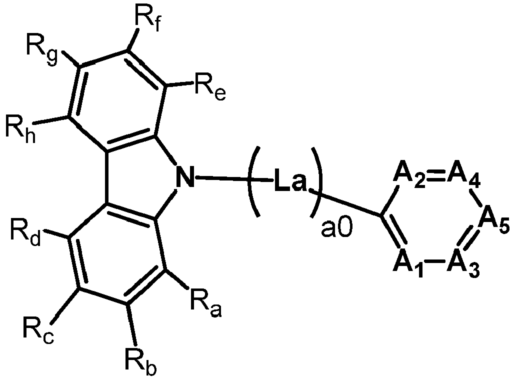
   wherein in Formula E,
   a0 is an integer from 0 to 10,
   La is a direct linkage, a substituted or unsubstituted arylene group having 6 to 30 ring-forming carbon atoms, or a substituted or unsubstituted heteroarylene group having 2 to 30 ring-forming carbon atoms,
   A₁ to A₅ are each independently N or C(Rᵢ), and
   Rₐ to Rᵢ are each independently a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or are bonded to an adjacent group to form a ring.
12. The organic electroluminescence device of clause 11, wherein
   the hole transporting first host represented by Formula E comprises at least one selected from Compound Group HT, and
   wherein the electron transporting second host represented by Formula E comprises at least one selected from Compound Group ET: 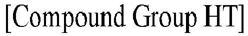 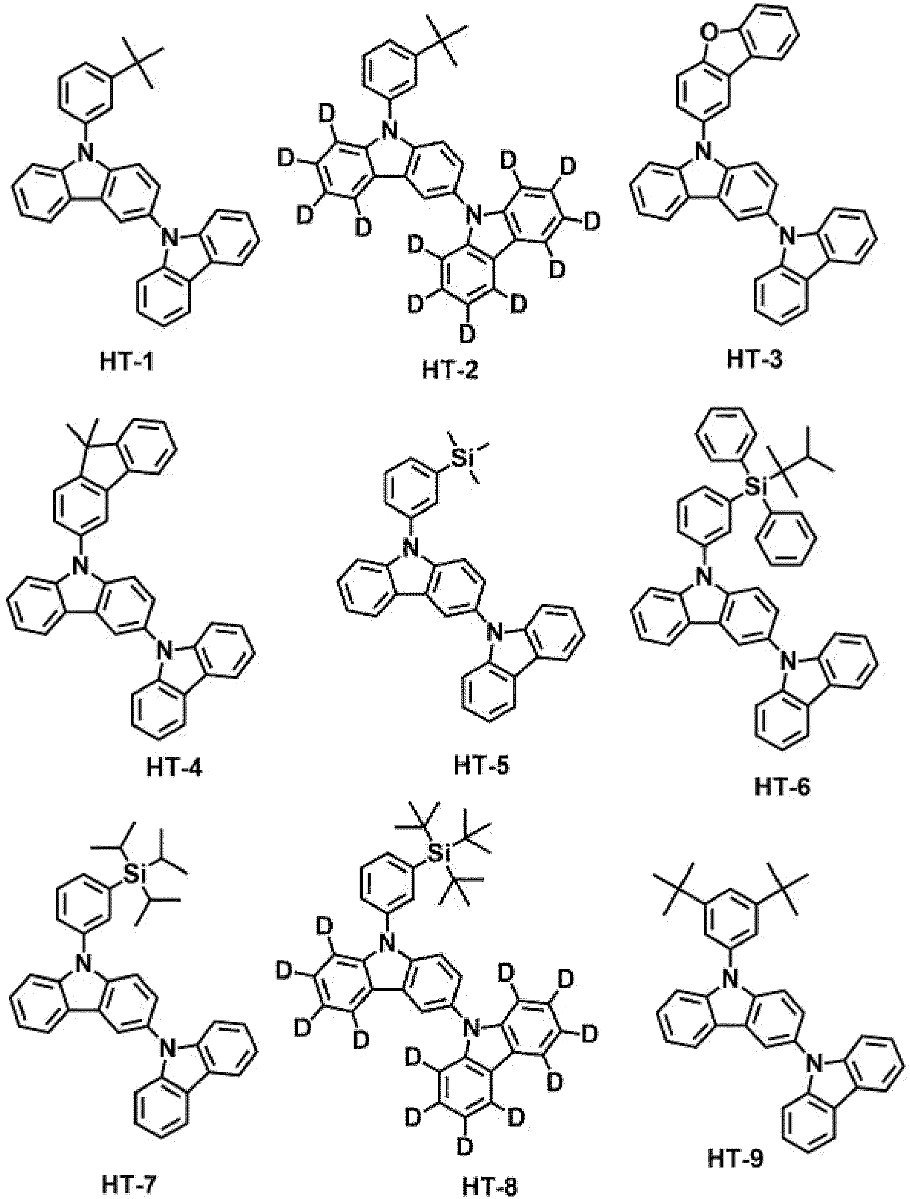 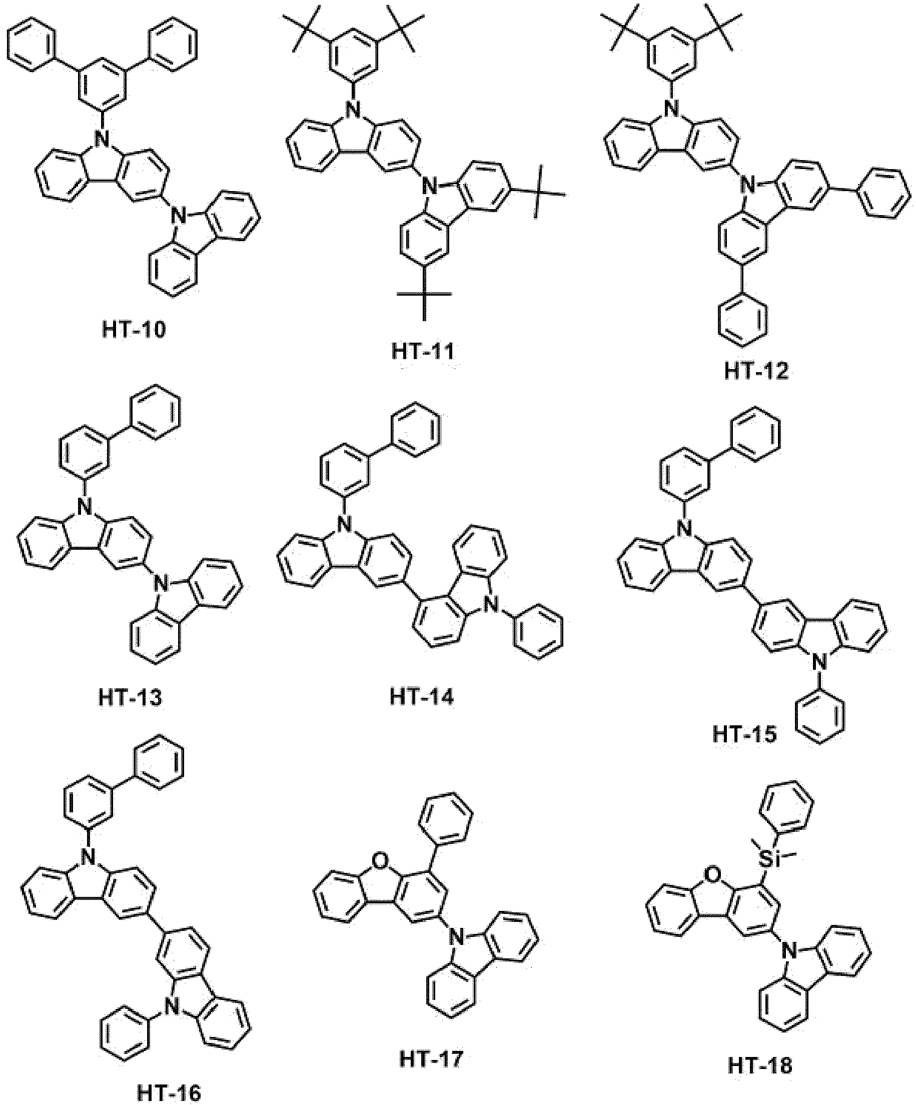 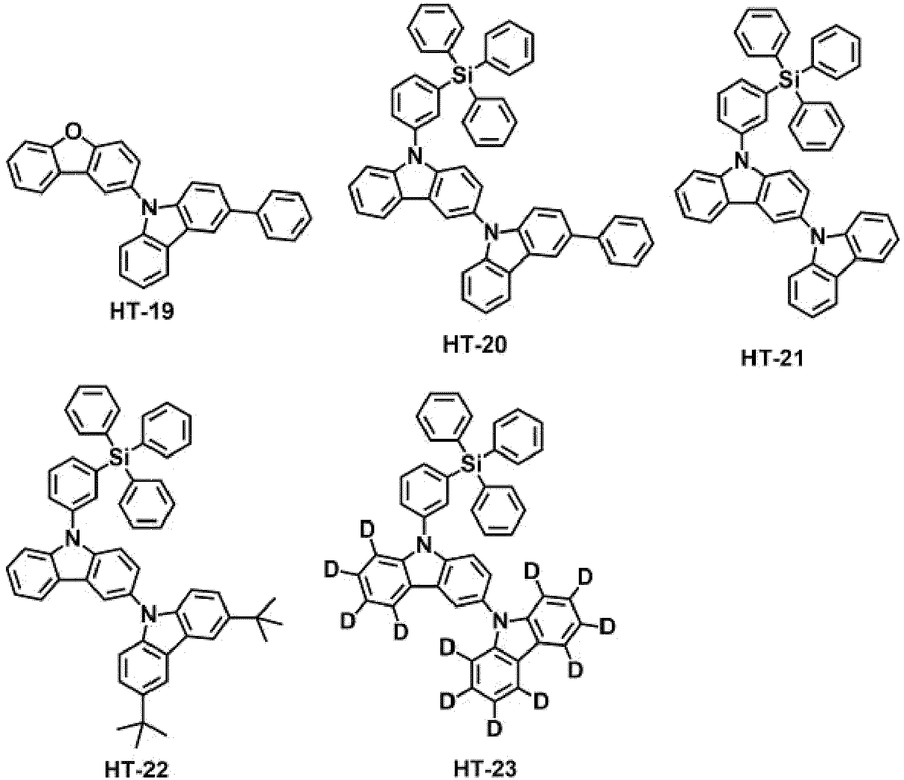 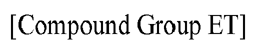 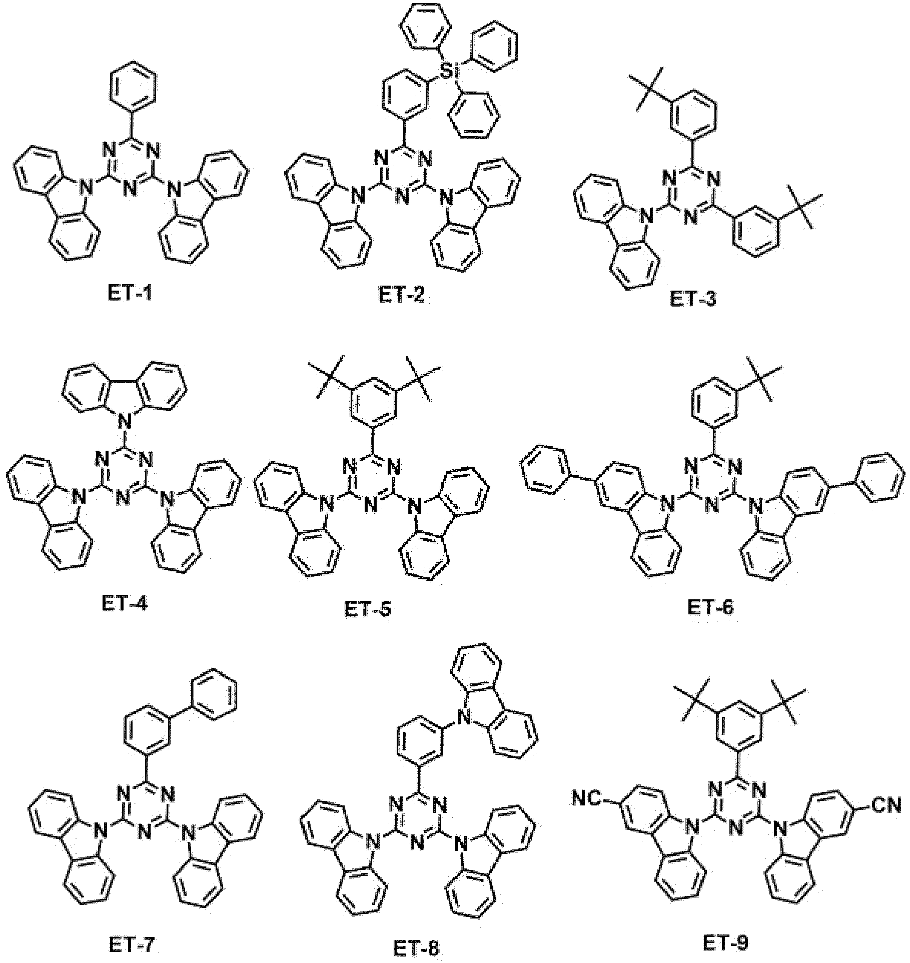 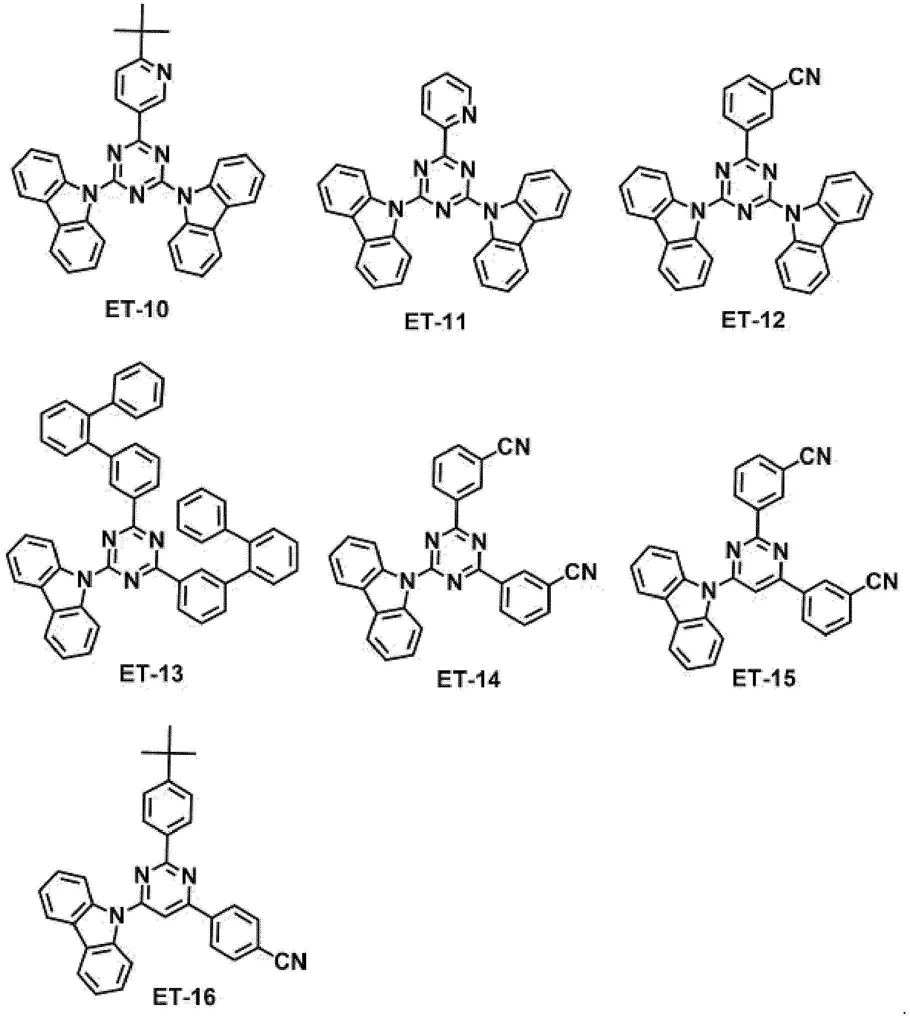
13. The organic electroluminescence device of any one of clauses 1 to 12, wherein the emission layer further comprises a sensitizer including an organometallic complex.
14. The organic electroluminescence device of clause 13, wherein the organometallic complex is represented by Formula M-b: 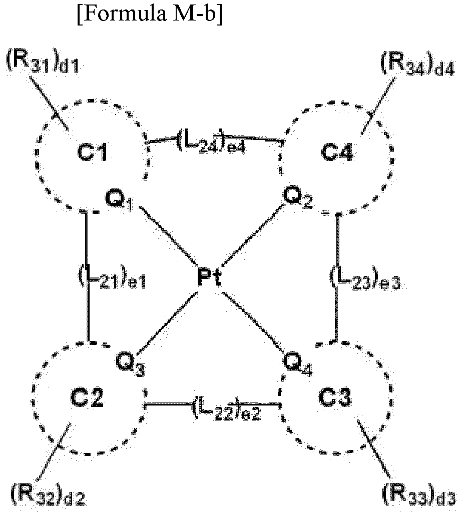
   wherein in Formula M-b,
   Q₁ to Q₄ are each independently C or N,
   C1 to C4 are each independently a substituted or unsubstituted hydrocarbon ring having 5 to 30 ring-forming carbon atoms, or a substituted or unsubstituted heterocycle having 2 to 30 ring-forming carbon atoms,
   L₂₁ to L₂₄ are each independently a direct linkage, 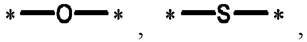 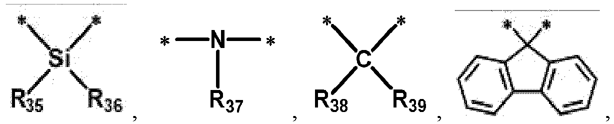 a substituted or unsubstituted divalent alkyl group having 1 to 20 carbon atoms, a substituted or unsubstituted arylene group having 6 to 30 ring-forming carbon atoms, or a substituted or unsubstituted heteroarylene group having 2 to 30 ring-forming carbon atoms,
   e1 to e4 are each independently 0 or 1,
   R₃₁ to R₃₉ are each independently a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or are bonded to an adjacent group to form a ring, and
   d1 to d4 are each independently an integer from 0 to 4, and
   wherein * represents a binding position of a neighboring atom.
15. The organic electroluminescence device of clause 1, wherein
   the emission layer comprises a first sub-emission layer and a second sub-emission layer, which are stacked in a thickness direction, and
   at least one of the first sub-emission layer or the second sub-emission layer includes the light emitting dopant.

## Claims

1. A fused polycyclic compound represented by Formula 1: 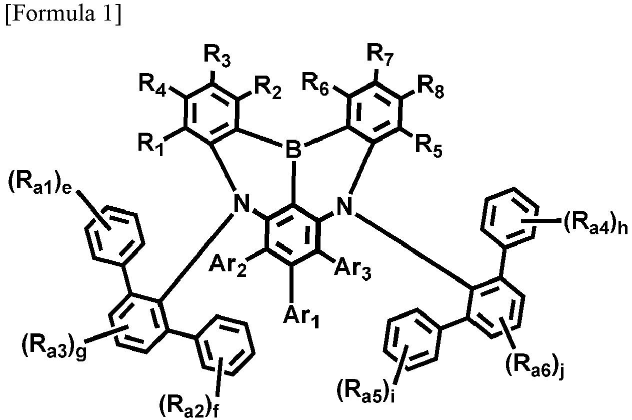
wherein in Formula 1,
Ar₁ to Ar₃ are each independently a hydrogen atom, a deuterium atom, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
R₁ to R₈ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms,
Rₐ₁ to Rₐ₆ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, a substituted or unsubstituted heteroaryl group having 2 to 60 ring-forming carbon atoms, or are bonded to an adjacent group to form a ring,
e, f, h, and i are each independently an integer from 0 to 5,
g and j are each independently an integer from 0 to 3, and
at least one of R₁ to R₈ is a group represented by Formula 2: 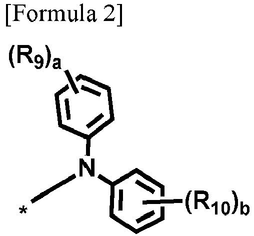
wherein in Formula 2,
R₉ and R₁₀ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring, and
a and b are each independently an integer from 0 to 5.

2. The fused polycyclic compound of claim 1, wherein the fused polycyclic compound represented by Formula 1 is represented by one of Formulas 3-1 to 3-3: 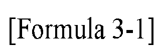 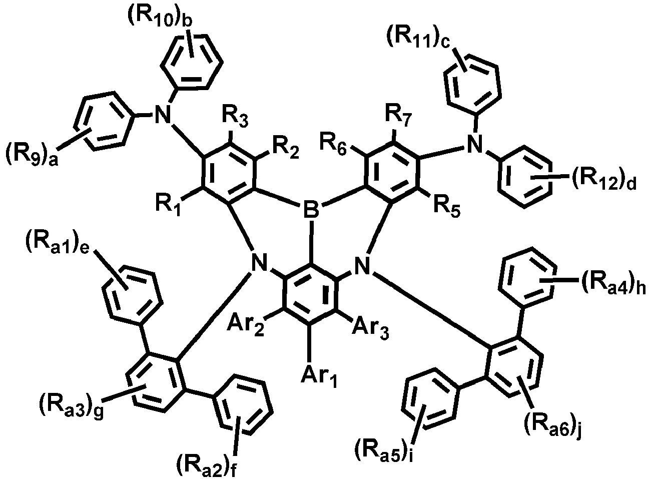 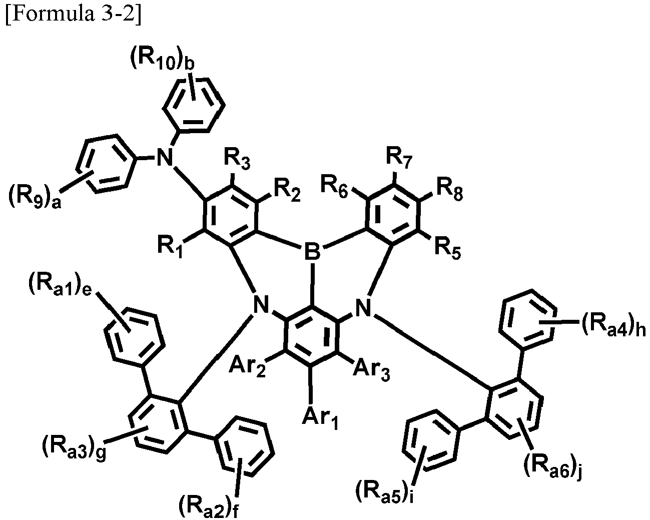 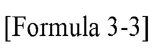 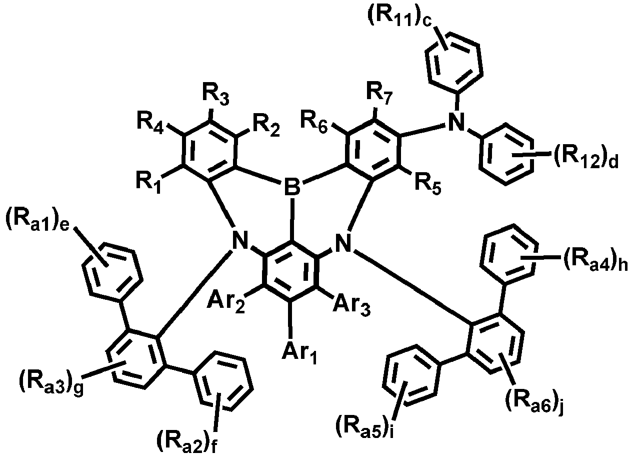
wherein in Formulas 3-1 to 3-3,
R₁₁ and R₁₂ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
c and d are each independently an integer from 0 to 5, and
Ar₁ to Ar₃, R₁ to R₁₀, Rₐ₁ to Rₐ₆, a, b, and e to j are the same as defined in Formulas 1 and 2.

3. The fused polycyclic compound of claim 2, wherein the fused polycyclic compound represented by Formula 3-1 is represented by Formula 5: 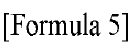 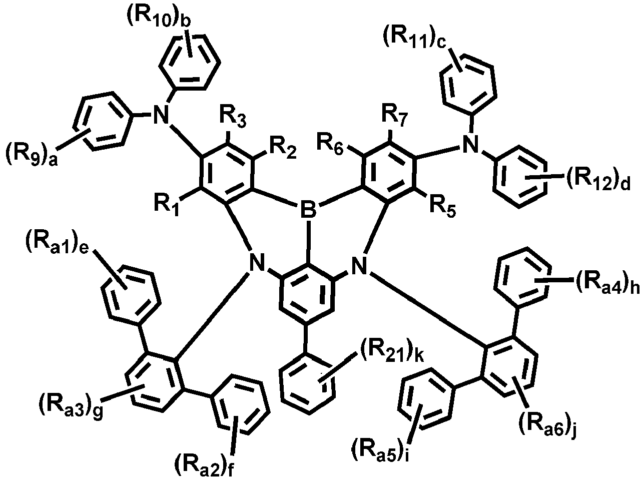
wherein in Formula 5,
R₂₁ is a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
k is an integer from 0 to 5, and
R₁ to R₃, R₅ to R₇, R₉ to R₁₂, Rₐ₁ to Rₐ₆, and a to j are the same as defined in Formula 3-1.

4. The fused polycyclic compound of claim 2, wherein the fused polycyclic compound represented by Formula 3-2 is represented by Formula 6-1 or Formula 6-2: 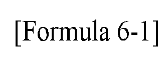 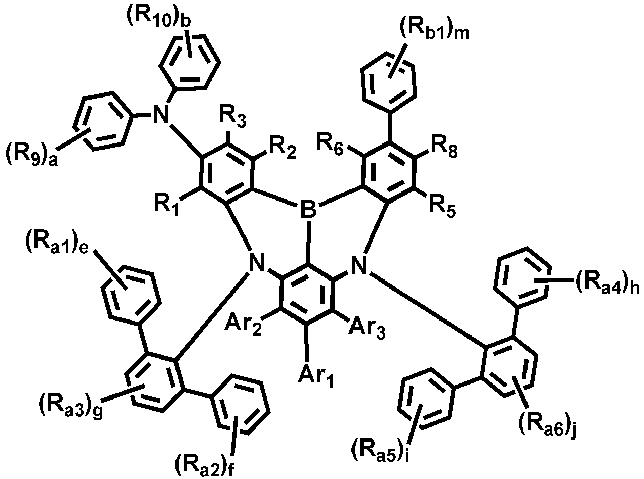 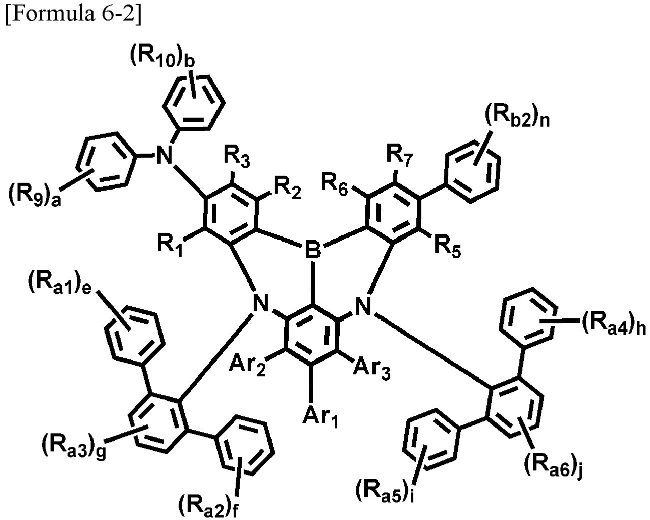
wherein in Formulas 6-1 and 6-2,
R_{b1} and R_{b2} are each independently a hydrogen atom, a deuterium atom, a halogen atom, a substituted or unsubstituted amine group, a substituted or unsubstituted silyl group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
m and n are each independently an integer from 0 to 5, and
Ar₁ to Ar₃, R₁ to R₃, R₅ to R₁₀, Rₐ₁ to Rₐ₆, a, b, and e to j are the same as defined in Formula 3-2.

5. The fused polycyclic compound of claim 1, wherein the fused polycyclic compound represented by Formula 1 is represented by Formula 4: 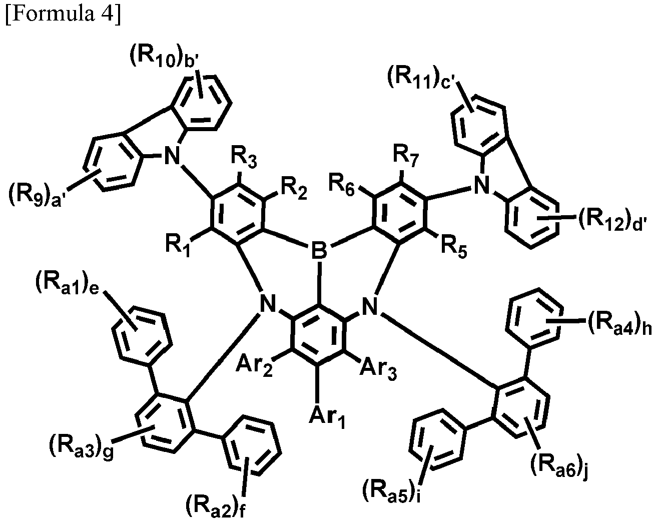
wherein in Formula 4,
R₁₁ and R₁₂ are each independently a hydrogen atom, a deuterium atom, a halogen atom, a cyano group, a substituted or unsubstituted silyl group, a substituted or unsubstituted amine group, a substituted or unsubstituted oxy group, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms, or are bonded to an adjacent group to form a ring,
a' to d' are each independently an integer from 0 to 4, and
Ar₁ to Ar₃, R₁ to R₃, R₅ to R₇, Rₐ₁ to Rₐ₆, e to j, R₉, and R₁₀ are the same as defined in Formulas 1 and 2.

6. The fused polycyclic compound of claim 1, wherein the fused polycyclic compound represented by Formula 1 is selected from Compound Group 1:

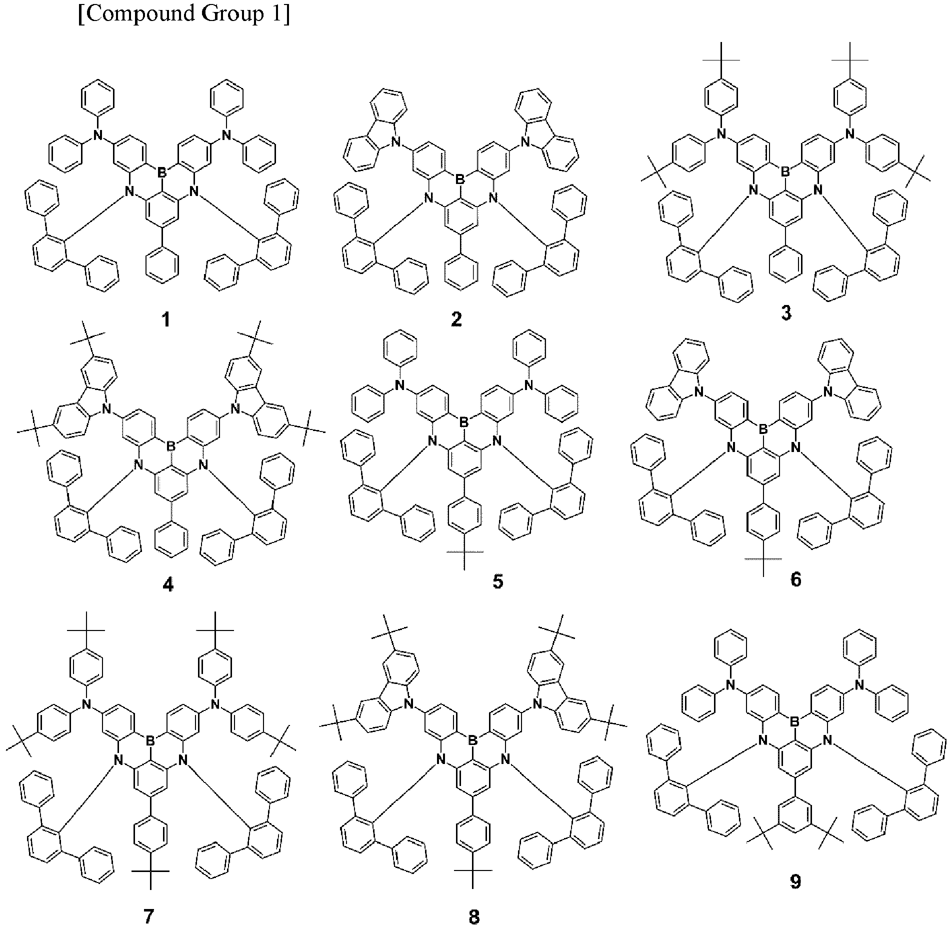

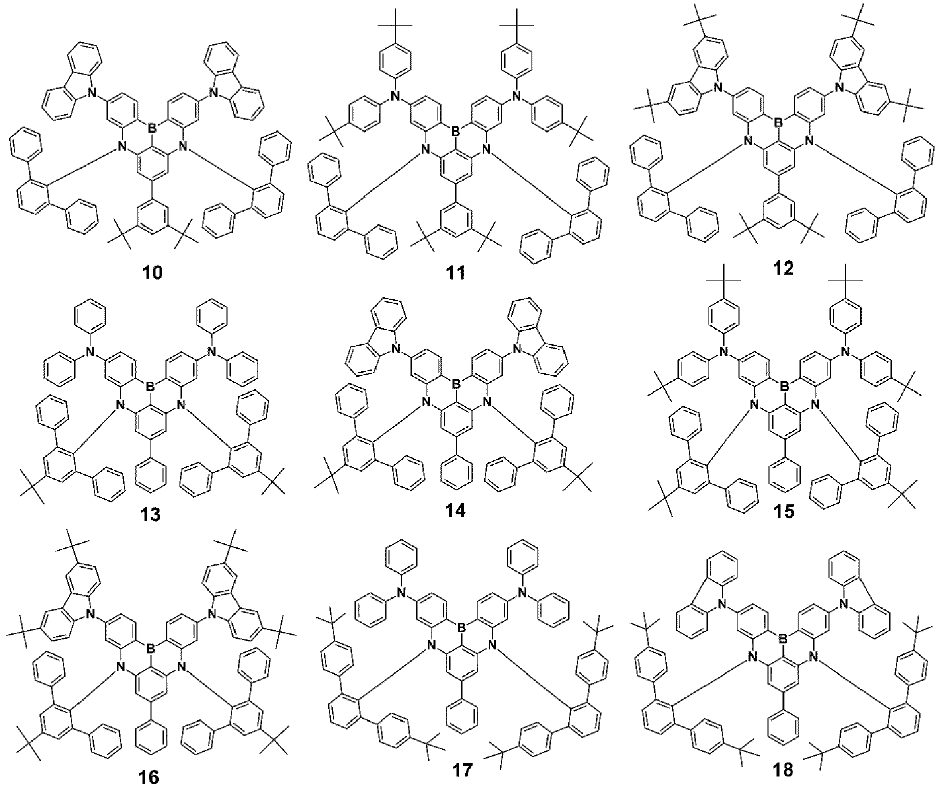

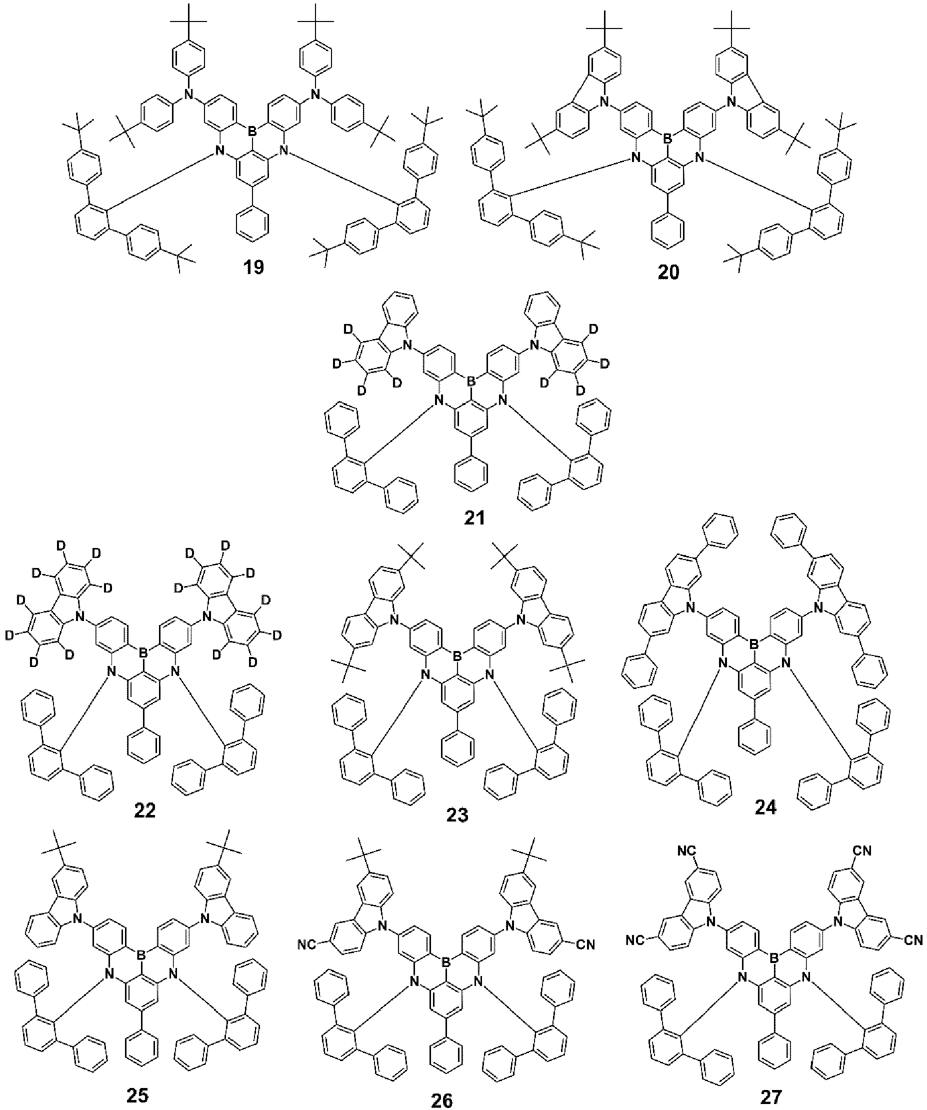

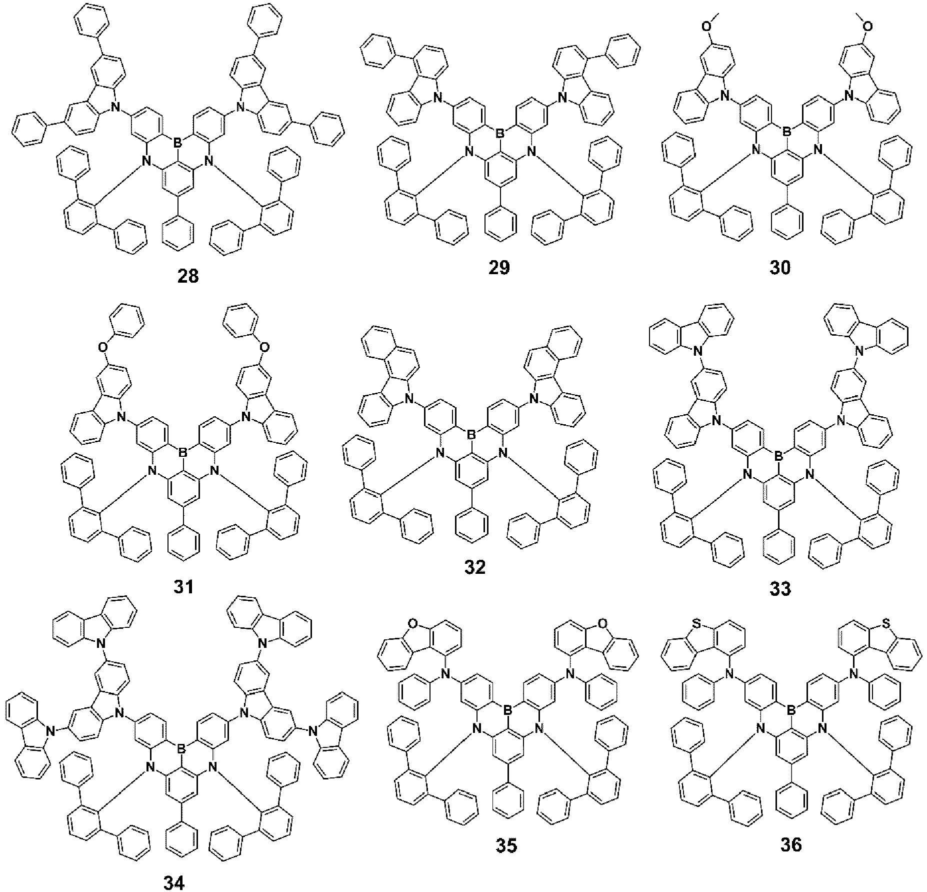

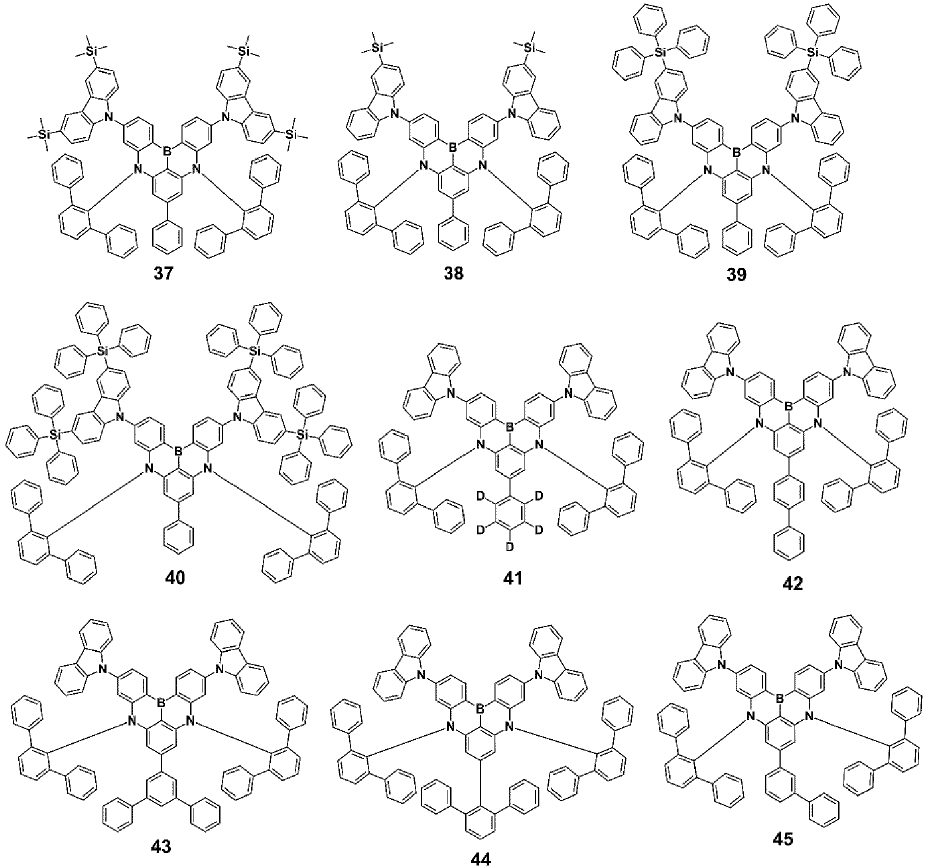

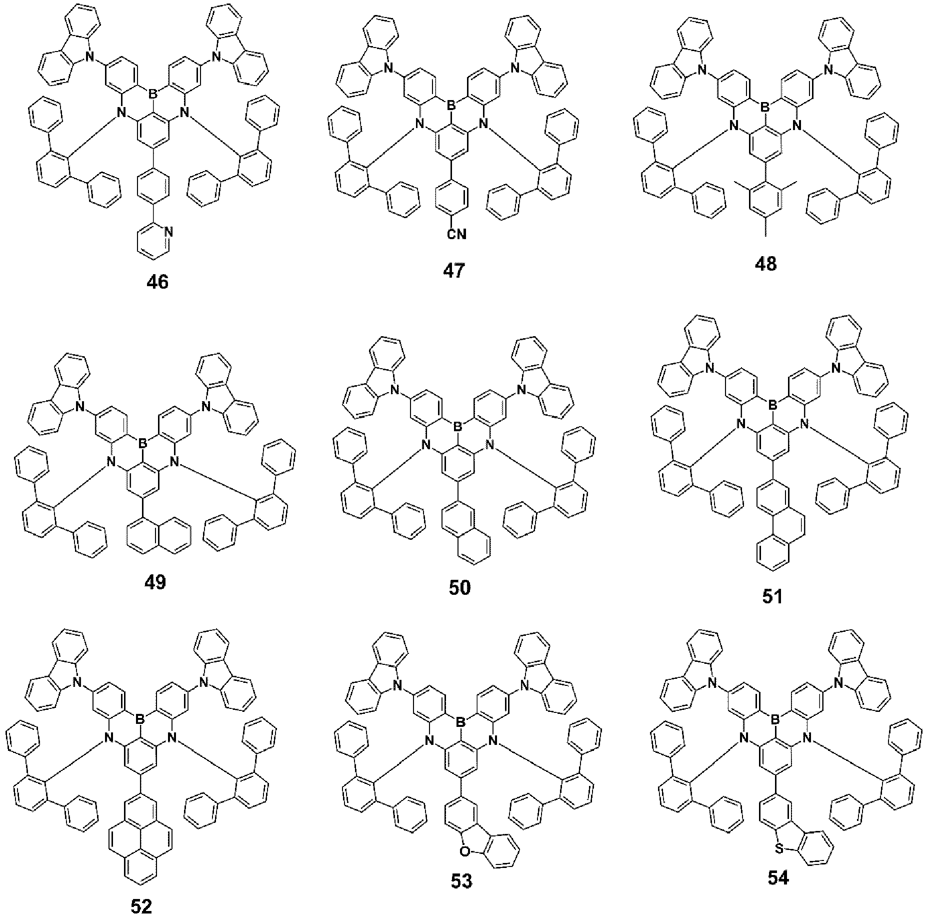

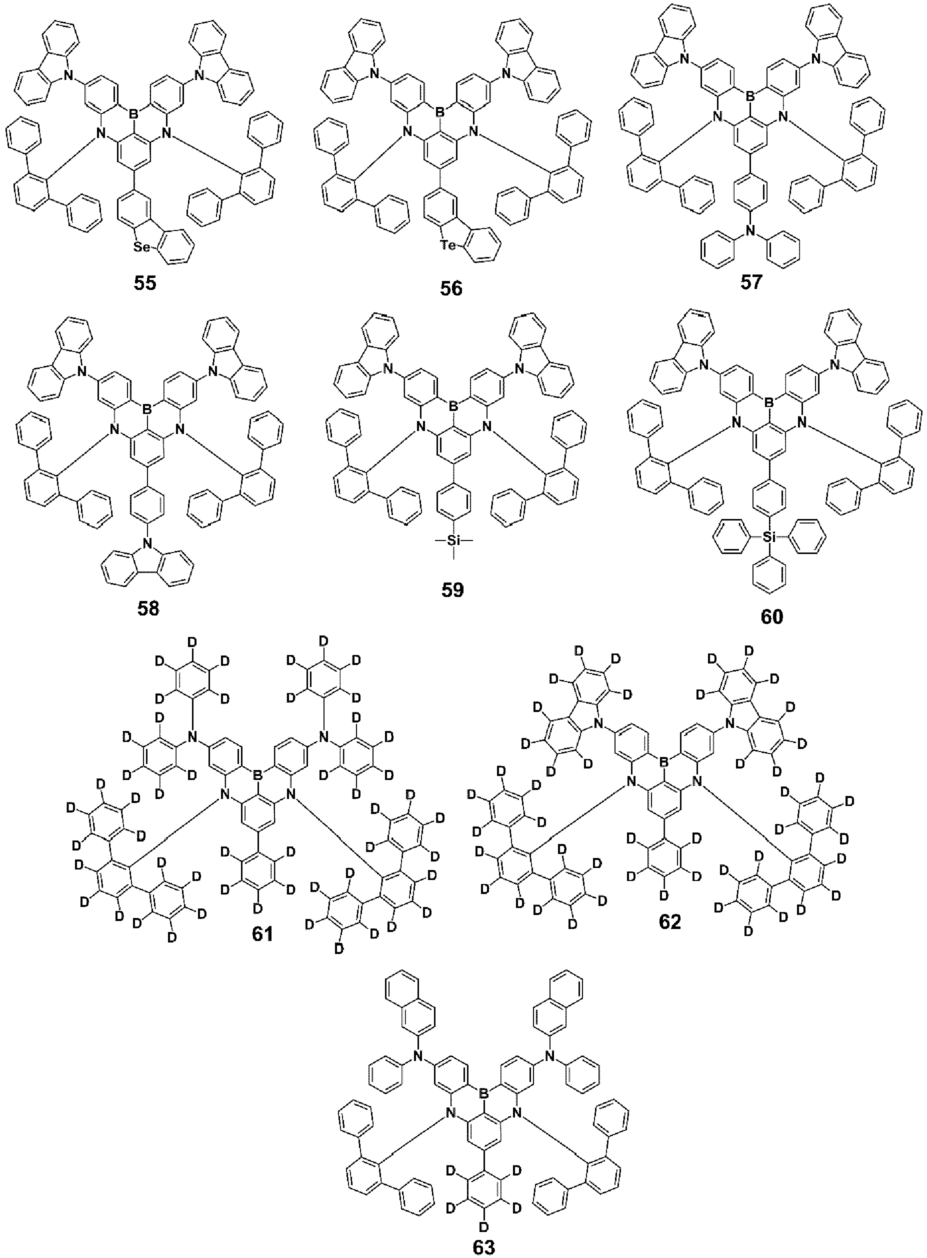

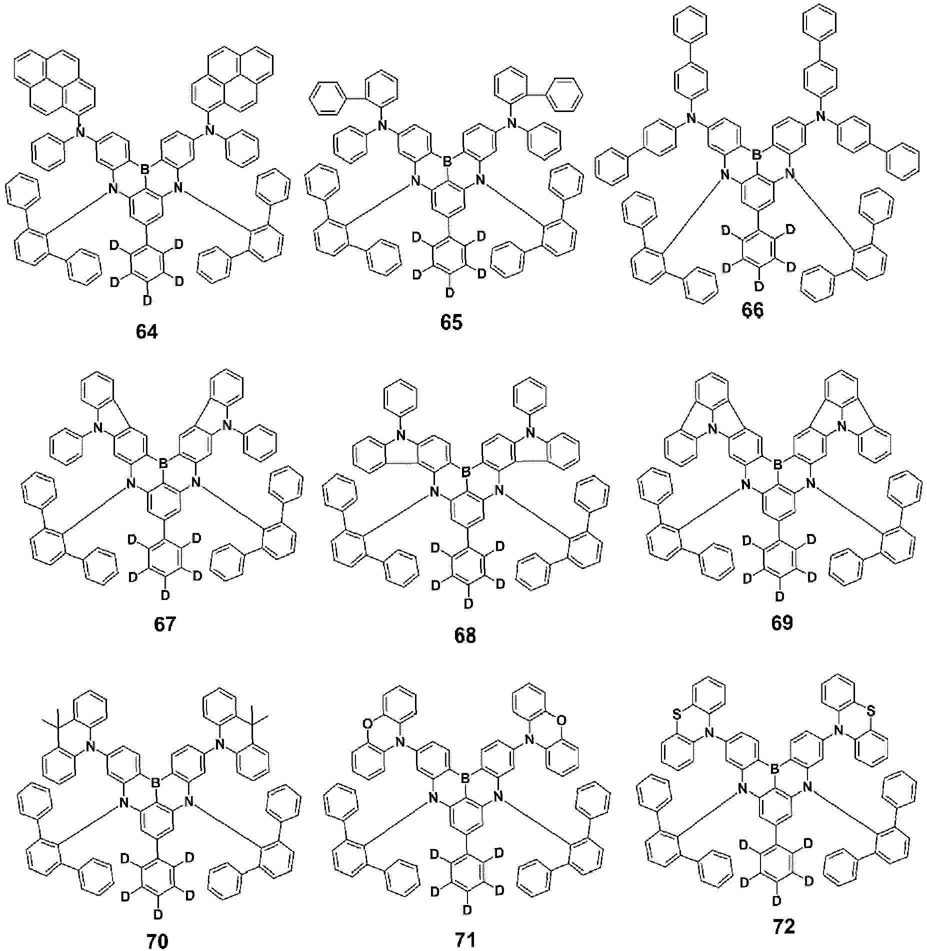

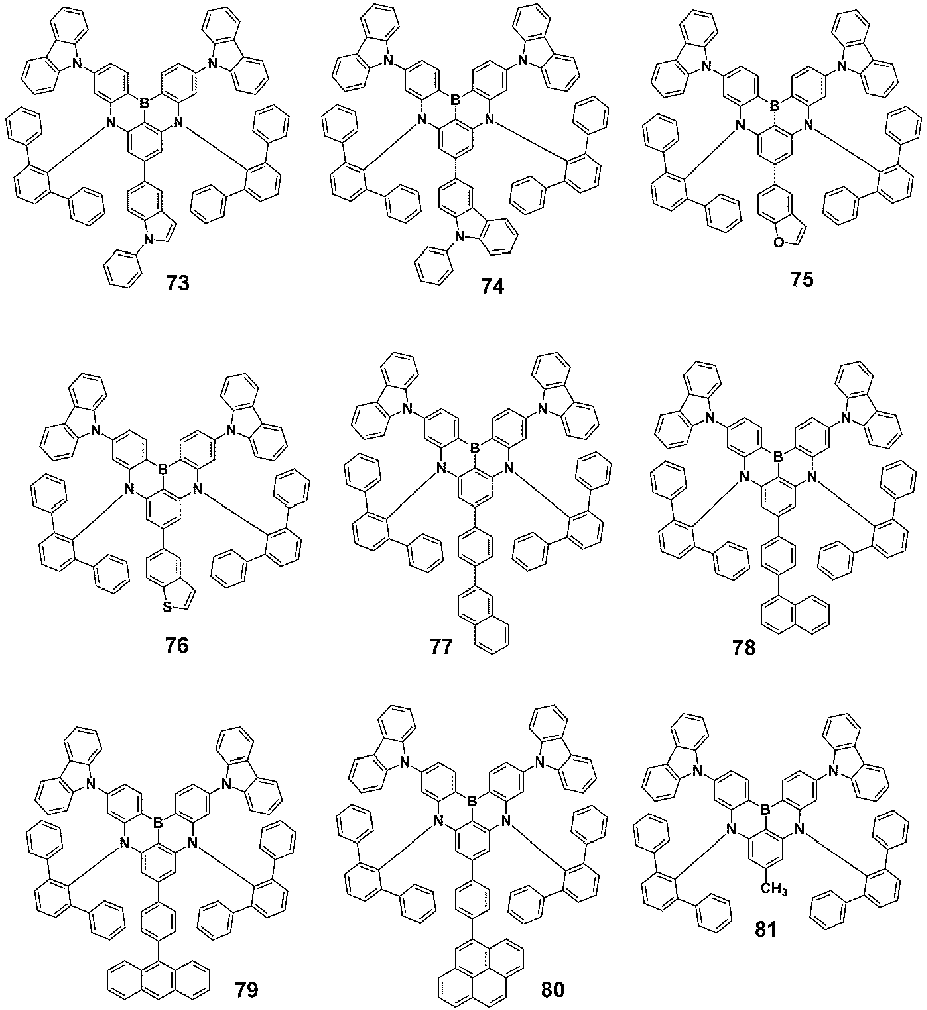

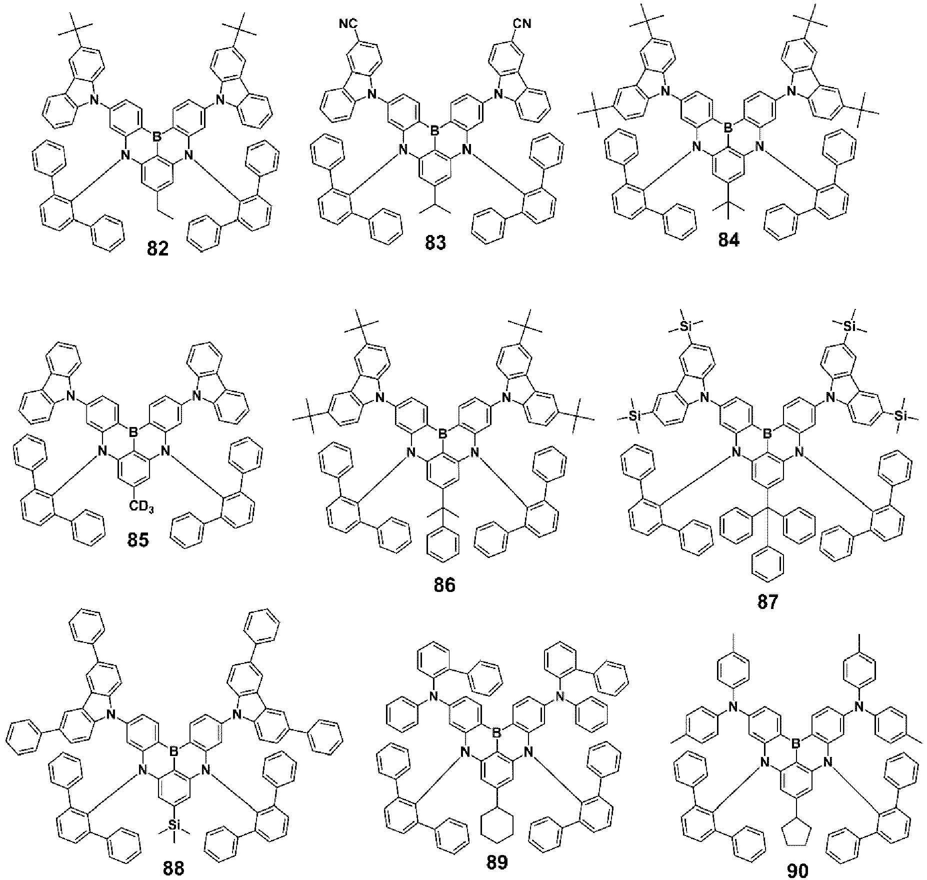

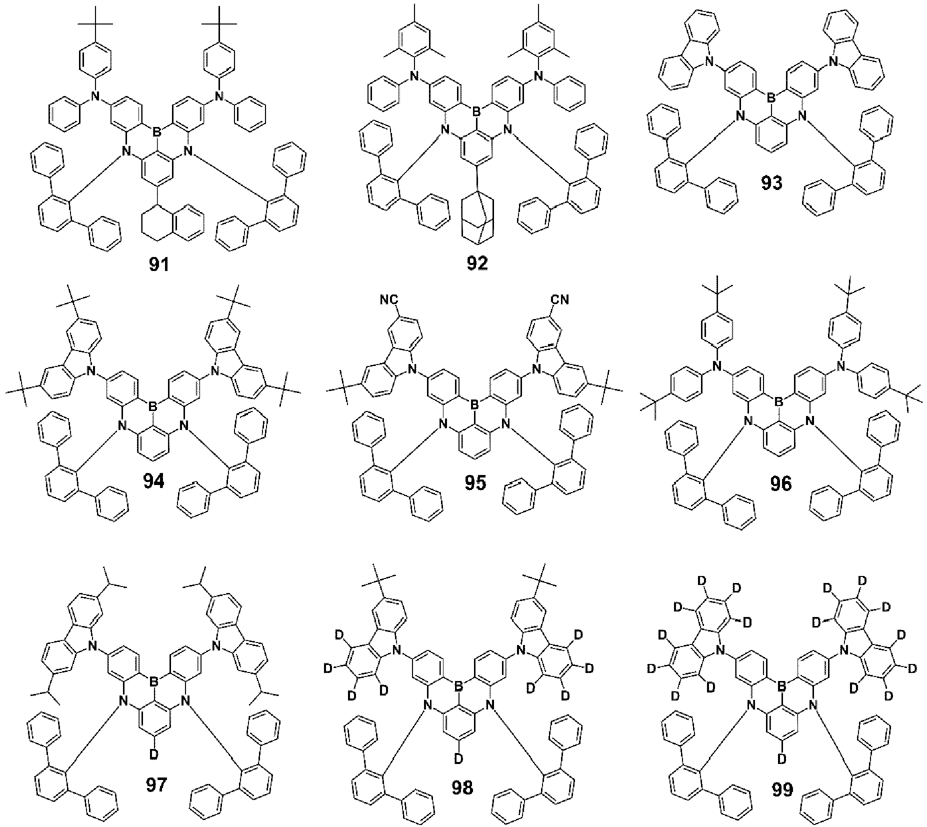

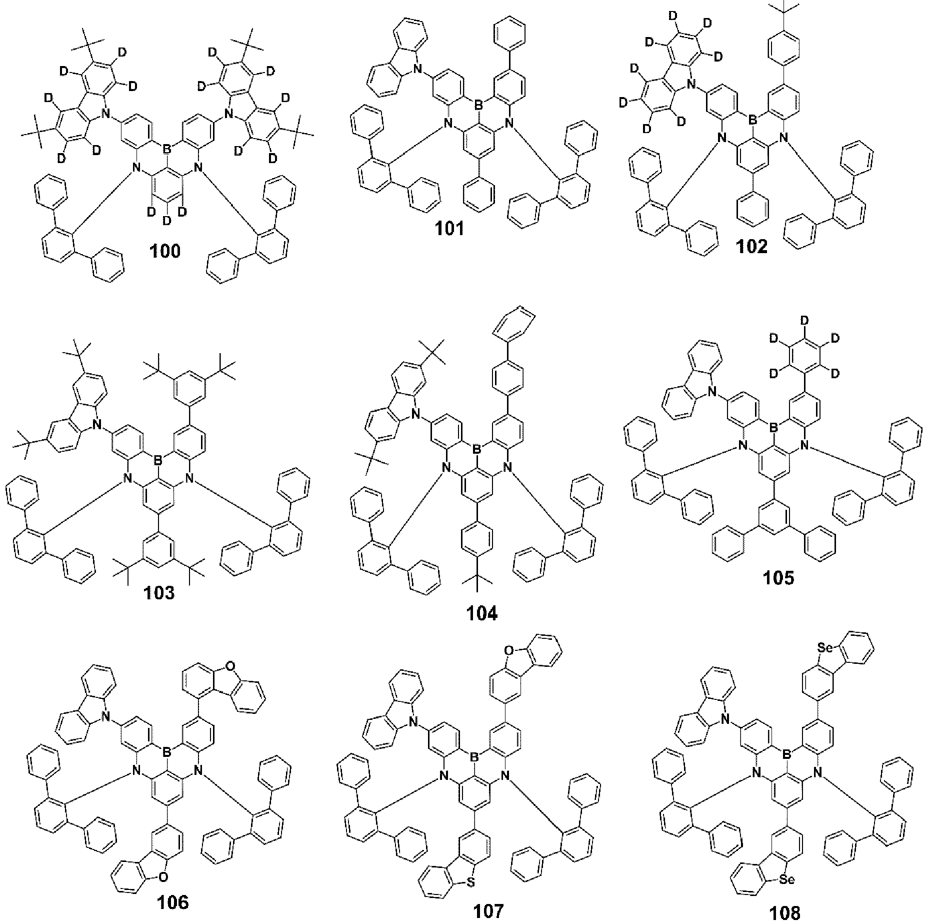

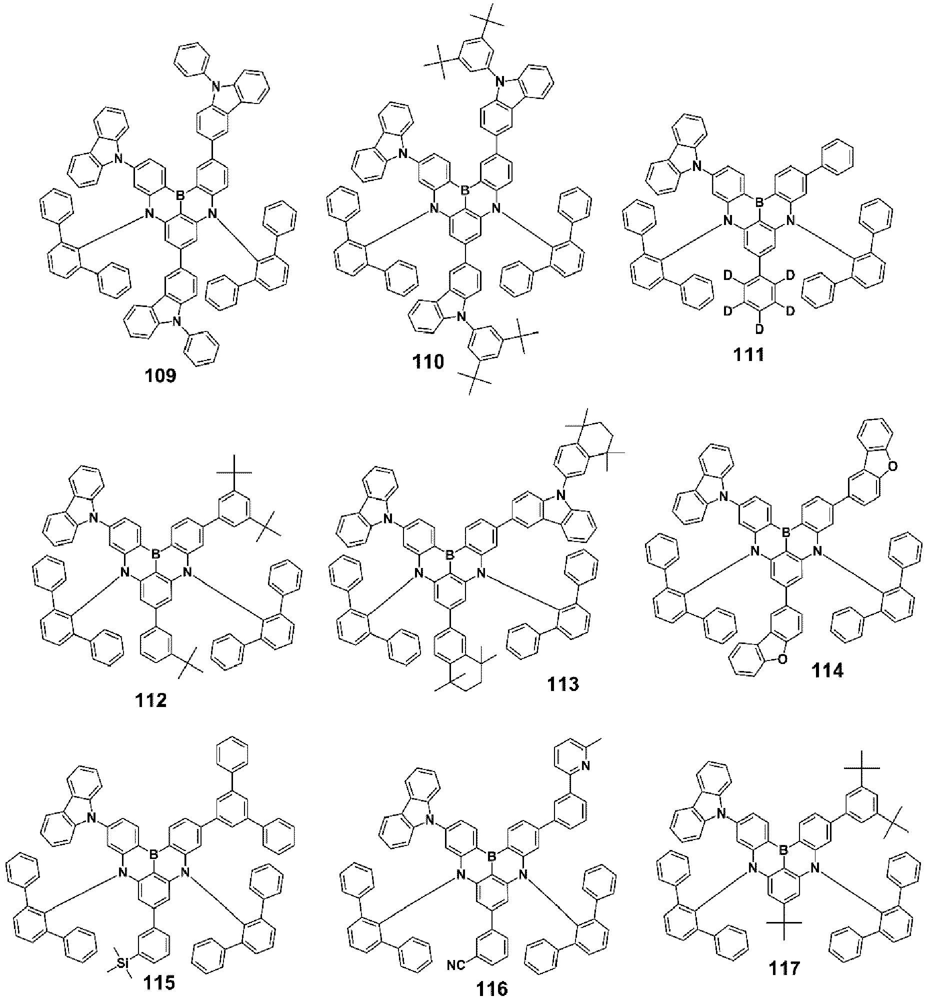

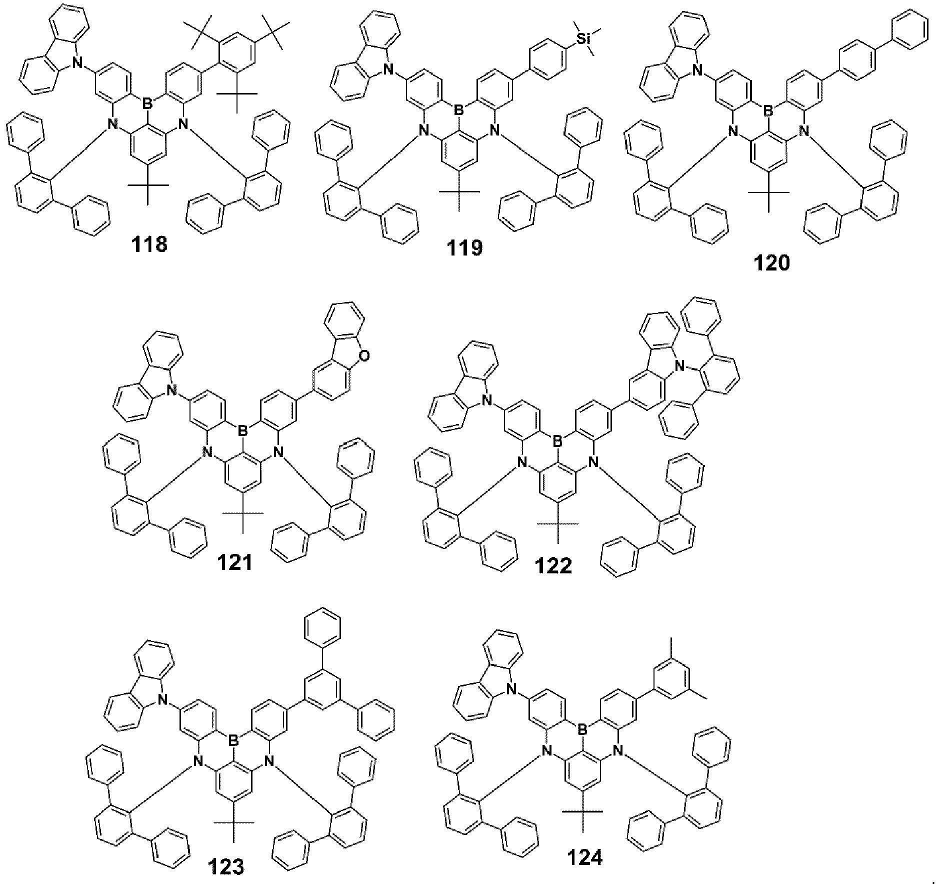

7. The fused polycyclic compound of claim 1, wherein the fused polycyclic compound emits light having a central wavelength in a range of about 430 nm to about 490 nm.

8. The fused polycyclic compound of claim 1, wherein the fused polycyclic compound emits light having a full width at half maximum (FWHM) equal to or less than about 45 nm.
